(19) Europäisches Patentamt
European Patent Office
Office européen des brevets

(11) EP 4 311 848 A1

(12) # EUROPEAN PATENT APPLICATION

(43) Date of publication:
**31.01.2024 Bulletin 2024/05**

(21) Application number: **23186328.3**

(22) Date of filing: **19.07.2023**

(51) International Patent Classification (IPC):
***C09K 11/06*** *(2006.01)* ***C07F 15/00*** *(2006.01)*

(52) Cooperative Patent Classification (CPC):
**C07F 15/0086; C09K 11/06;** C09K 2211/185

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **20.07.2022 KR 20220089879**
**17.07.2023 KR 20230092594**

(71) Applicant: **Samsung Display Co., Ltd.**
**Yongin-si, Gyeonggi-do 17113 (KR)**

(72) Inventors:
- **Ko, Soobyung**
  **17113 Yongin-si (KR)**
- **Lee, Eunyoung**
  **17113 Yongin-si (KR)**
- **Kang, Iljoon**
  **17113 Yongin-si (KR)**
- **Shin, Sujin**
  **17113 Yongin-si (KR)**
- **Lee, Youngki**
  **17113 Yongin-si (KR)**
- **Jeon, Mina**
  **17113 Yongin-si (KR)**
- **Chu, Changwoong**
  **17113 Yongin-si (KR)**

(74) Representative: **Russell, Tim et al**
**Venner Shipley LLP**
**200 Aldersgate**
**London EC1A 4HD (GB)**

(54) **COMPOSITION, LIGHT-EMITTING DEVICE, ELECTRONIC APPARATUS COMPRISING THE LIGHT-EMITTING DEVICE, AND ORGANOMETALLIC COMPOUND**

(57) An organic light-emitting device comprises a first electrode, a second electrode facing the first electrode, and an interlayer between the first electrode and the second electrode and comprising an organometallic compound represented by Formula 1. In addition, an electronic apparatus comprising the light-emitting device, a composition comprising the organometallic compound represented by Formula 1, and an organometallic compound represented by Formula 1 are also provided.

EP 4 311 848 A1

Formula 1

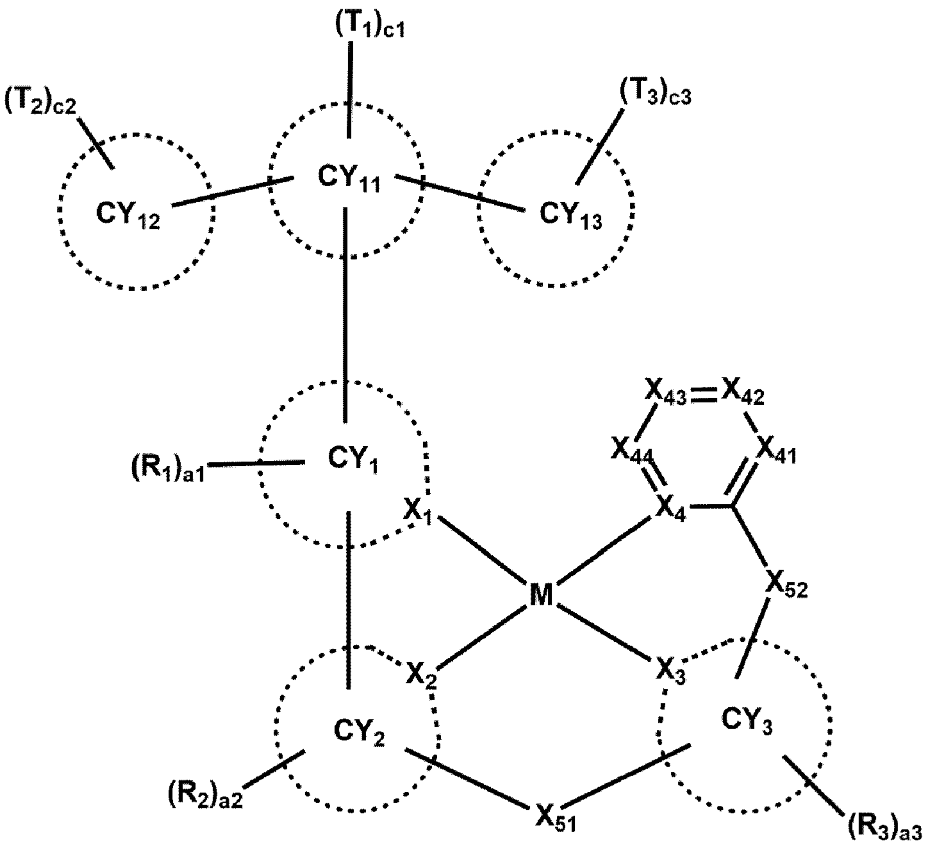

## Description

### CROSS-REFERENCE TO RELATED APPLICATION

This application claims priority to and the benefit of Korean Patent Applications Nos. 10-2022-0089879, filed on July 20, 2022, and 10-2023-0092594, filed on July 17, 2023, in the Korean Intellectual Property Office, the content of which is incorporated by reference herein in its entirety.

### BACKGROUND

One or more embodiments of the present disclosure relate to a composition, a light-emitting device, an electronic apparatus comprising the light-emitting device, and an organometallic compound.

Among light-emitting devices, self-emissive devices (for example, organic light-emitting devices, etc.) have relatively wide viewing angles, excellent or suitable contrast ratios, fast response time, and excellent or suitable characteristics in terms of luminance, driving voltage and response speed.

In a light-emitting device, a first electrode is disposed on a substrate, and a hole transport region, an emission layer, an electron transport region, and a second electrode are sequentially disposed on the first electrode. Holes provided from the first electrode may move toward the emission layer through the hole transport region, and electrons provided from the second electrode may move toward the emission layer through the electron transport region. Carriers, such as holes and electrons, may recombine in the emission layer to produce excitons. These excitons transition and relax from an excited state to a ground state to generate light.

### SUMMARY

The invention is defined by the claims.

One or more aspects of embodiments of the present disclosure are directed toward a composition capable of providing improved color purity, improved luminescence efficiency, and improved lifespan, an organometallic compound having excellent or suitable heat resistance and processibility, a light-emitting device having improved color purity, improved luminescence efficiency, and improved lifespan, and an electronic apparatus comprising the light-emitting device.

Additional aspects will be set forth in part in the description, which follows and, in part, will be apparent from the description, or may be learned by practice of the presented embodiments of the present disclosure.

According to one or more embodiments of the present disclosure,

a composition comprises an organometallic compound represented by Formula 1 (e.g., as a first compound), and a second compound comprising at least one $\pi$ electron-deficient nitrogen-containing $C_1$-$C_{60}$ heterocyclic group, a third compound comprising a group represented by Formula 3, a fourth compound capable of emitting delayed fluorescence, or any combination thereof,

wherein the organometallic compound, the second compound, the third compound, and the fourth compound are different from each other.

Formula 1

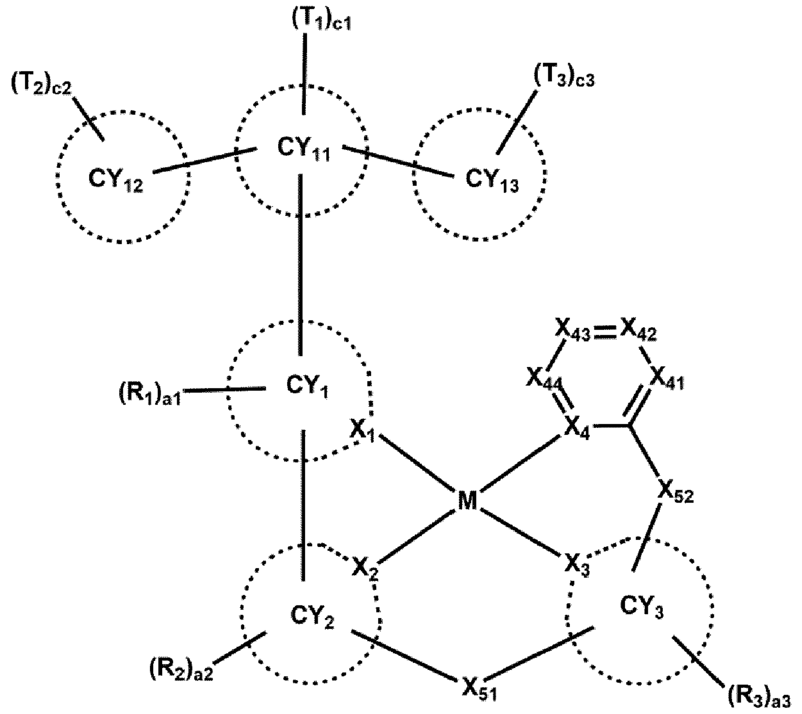

In Formula 1,

M may be platinum (Pt), palladium (Pd), gold (Au), nickel (Ni), silver (Ag), or copper (Cu),

$X_1$ to $X_4$ may each independently be C or N,

i) a bond between $X_1$ and M may be a coordinate bond, ii) one selected from among a bond between $X_2$ and M, a bond between $X_3$ and M, and a bond between $X_4$ and M may be a coordinate bond, and the other two (remainders or the remaining two) may each be a covalent bond,

ring $CY_1$ and ring $CY_2$ may each independently be a $C_3$-$C_{60}$ carbocyclic group or a $C_1$-$C_{60}$ heterocyclic group,

ring $CY_3$ may be a $C_2$-$C_8$ monocyclic group, or a $C_4$-$C_{20}$ polycyclic group in which two or three $C_2$-$C_8$ monocyclic groups are condensed together,

$X_4$, may be $C(R_{41})$ or N, $X_{42}$ may be $C(R_{42})$ or N, $X_{43}$ may be $C(R_{43})$ or N, and $X_{44}$ may be $C(R_{44})$ or N,

each of ring $CY_{11}$, ring $CY_{12}$, and ring $CY_{13}$ may be a $C_2$-$C_8$ monocyclic group,

$X_5$, may be a single bond, $*-N(Z_{51a})-*'$, $*-B(Z_{51a})-*'$, $*-P(Z_{51a})-*'$, $*-C(Z_{51a})(Z_{51b})-*'$, $*-Si(Z_{51a})(Z_{51b})-*'$, $*-Ge(Z_{51a})(Z_{51b})-*'$, *-S-*', *-Se-*', *-O-*', *-C(=O)-*', *-S(=O)-*', $*-S(=O)_2-*'$, $*-C(Z_{51a})=*'$, $*=C(Z_{51a})-*'$, $*-C(Z_{51a})=C(Z_{51b})-*'$, *-C(=S)-*', or *-C≡C-*',

$X_{52}$ may be a single bond, $*-N(Z_{52a})-*'$, $*-B(Z_{52a})-*'$, $*-P(Z_{52a})-*'$, $*-C(Z_{52a})(Z_{52b})-*'$, $*-Si(Z_{52a})(Z_{52b})-*'$, $*-Ge(Z_{52a})(Z_{52b})-*'$, *-S-*', *-Se-*', *-O-*', *-C(=O)-*', *-S(=O)-*', $*-S(=O)_2-*'$, $*-C(Z_{52a})=*'$, $*=C(Z_{52a})-*'$, $*-C(Z_{52a})=C(Z_{52b})-*'$, *-C(=S)-*', or *-C=C-*',

$R_1$ to $R_3$, $R_{41}$, $R_{42}$, $R_{44}$, $Z_{51a}$, $Z_{51b}$, $Z_{52a}$, $Z_{52b}$, and $T_1$ to $T_3$ may each independently be hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, a $C_6$-$C_{60}$ aryloxy group that is unsubstituted or substituted with at least one $R_{10a}$, a $C_6$-$C_{60}$ arylthio group that is unsubstituted or substituted with at least one $R_{10a}$, a $C_7$-$C_{60}$ aryl alkyl group that is unsubstituted or substituted with at least one $R_{10a}$, a $C_2$-$C_{60}$ heteroaryl alkyl group that is unsubstituted or substituted with at least one $R_{10a}$, - $C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or - $P(=O)(Q_1)(Q_2)$,

$R_{43}$ may be hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, $-C(Q_1)(Q_2)(Q_3)$, $-Si(Q_1)(Q_2)(Q_3)$, $-N(Q_1)(Q_2)$, - $B(Q_1)(Q_2)$, $-C(=O)(Q_1)$, $-S(=O)_2(Q_1)$, or-$P(=O)(Q_1)(Q_2)$,

a1, a2, a3, c2, and c3 may each independently be an integer selected from 0 to 10,

c1 may be an integer selected from 0 to 5,
a group represented by

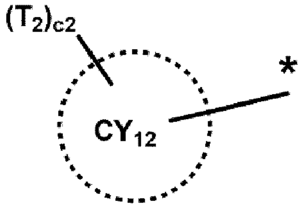

and a group represented by

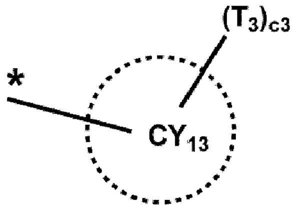

may be different from each other,
i) two or more of a1 $R_1$(s) when a1 is two or more, ii) two or more of a2 $R_2$(s) when a2 is two or more, iii) two or more of $R_{41}$ to $R_{44}$, and iv) two or more of $R_1$ to $R_3$, $R_{41}$ to $R_{44}$, $Z_{51a}$, $Z_{51b}$, $Z_{52a}$, and $Z_{52b}$ may each optionally be bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
two or more of a3 $R_3$(s) when a3 is two or more may not be linked together,
two or more of $T_1$ to $T_3$ may not be linked together,
$R_{10a}$ may be:

deuterium, -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, -Si($Q_{11}$)($Q_{12}$)($Q_{13}$), -N($Q_{11}$)($Q_{12}$), -B($Q_{11}$)($Q_{12}$), -C(=O)($Q_{11}$), -S(=O)$_2$($Q_{11}$), - P(=O)($Q_{11}$)($Q_{12}$), or any combination thereof;
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, -Si($Q_{21}$)($Q_{22}$)($Q_{23}$), -N($Q_{21}$)($Q_{22}$), -B($Q_{21}$)($Q_{22}$), -C(=O)($Q_{21}$), -S(=O)$_2$($Q_{21}$), -P(=O)($Q_{21}$)($Q_{22}$), or any combination thereof; or
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$), and
$Q_1$ to $Q_3$, $Q_{11}$ to $Q_{13}$, $Q_2$, to $Q_{23}$, and $Q_{31}$ to $Q_{33}$ may each independently be hydrogen, deuterium, -F, -Cl, -Br, -I, a hydroxyl group, a cyano group, a nitro group, or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

Formula 3

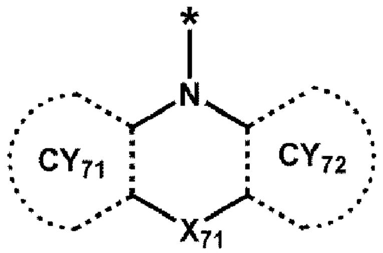

In Formula 3,

ring $CY_{71}$ and ring $CY_{72}$ may each independently be a $\pi$ electron-rich $C_3$-$C_{60}$ cyclic group or a pyridine group,

$X_{71}$ may be a single bond, or a linking group comprising O, S, N, B, C, Si, or any combination thereof, and

* indicates a binding site to an atom comprised in a remainder of the third compound, other than Formula 3.

According to one or more embodiments of the present disclosure,

a light-emitting device comprises a first electrode,

a second electrode facing the first electrode,

an interlayer between the first electrode and the second electrode and comprising an emission layer, and

an organometallic compound represented by Formula 1.

According to one or more embodiments of the present disclosure, an electronic device comprises the light-emitting device.

According to one or more embodiments of the present disclosure, an electronic apparatus comprises the light-emitting device.

According to one or more embodiments of the present disclosure, there is provided an organometallic compound represented by Formula 1.

## BRIEF DESCRIPTION OF THE DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects, features, and advantages of certain embodiments of the disclosure will be more apparent from the following description taken in conjunction with the accompanying drawings, in which:

FIG. 1 is a schematic view of a structure of a light-emitting device according to one or more embodiments of the present disclosure;

FIGs. 2 and 3 are each a schematic view of a structure of a light-emitting apparatus as one of electronic devices, according to one or more embodiments of the present disclosure;

FIGs. 4, 5, 6A, 6B, and 6C are each a schematic view of a structure of an electronic apparatus, according to one or more embodiments of the present disclosure;

FIG. 7 is a phase transition diagram of each of Compounds A, BD16, BD02, and BD119 of the present disclosure;

FIG. 8 is an electroluminescence spectrum of each of organic light-emitting devices manufactured in Examples 1 to 7, 16, and 17 of the present disclosure;

FIG. 9 is a graph of luminance-(blue conversion) luminescence efficiency of each of organic light-emitting devices manufactured in Examples 1 to 7, 16, and 17 of the present disclosure; and

FIG. 10 is a graph of time-luminance of each of organic light-emitting devices manufactured in Examples 1 to 7, 16, and 17 of the present disclosure.

## DETAILED DESCRIPTION

Reference will now be made in more detail to embodiments, examples of which are illustrated in the accompanying drawings, wherein like reference numerals refer to like elements throughout the present disclosure, and duplicative descriptions thereof may not be provided for conciseness. In this regard, the embodiments of the present disclosure may have different forms and should not be construed as being limited to the descriptions set forth herein. Accordingly,

the embodiments of the present disclosure are merely described, by referring to the drawings, to explain aspects of the present disclosure. As utilized herein, the term "and/or" or "or" may comprise any and all combinations of one or more of the associated listed items. Throughout the disclosure, the expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicates only a, only b, only c, both (e.g., simultaneously) a and b, both (e.g., simultaneously) a and c, both (e.g., simultaneously) b and c, all of a, b, and c, or variations thereof. The "j" utilized herein may be interpreted as "and" or as "or" depending on the situation.

According to one or more embodiments of the present disclosure,

there is provided a composition comprising: an organometallic compound represented by Formula 1 (e.g., as a first compound); and

a second compound comprising at least one π electron-deficient nitrogen-containing $C_1$-$C_{60}$ heterocyclic group, a third compound comprising a group represented by Formula 3, a fourth compound capable of emitting delayed fluorescence, or any combination thereof,

wherein the organometallic compound, the second compound, the third compound, and the fourth compound are different from each other:

**Formula 1**

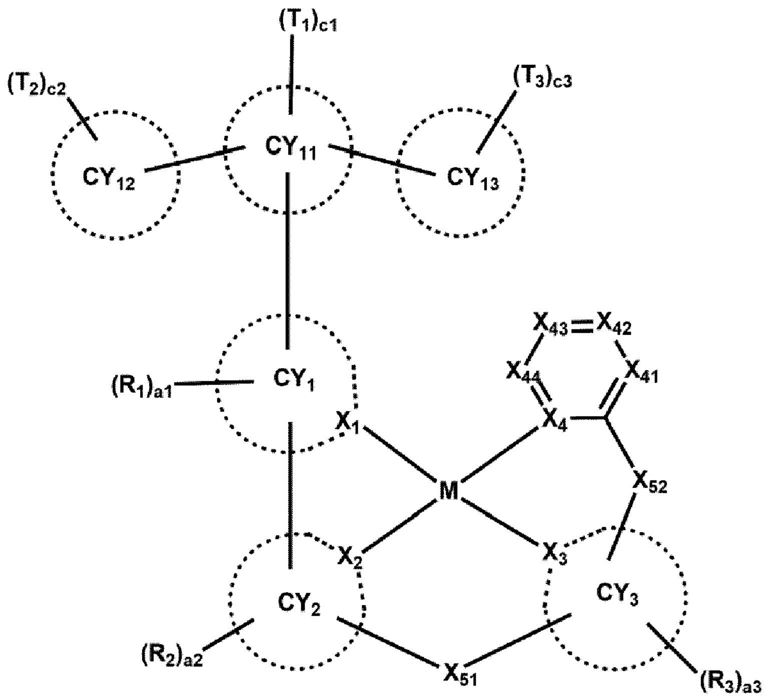

**Formula 3**

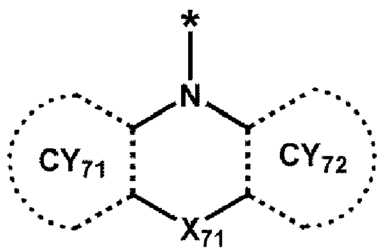

,

wherein, in Formula 3,

ring $CY_{71}$ and ring $CY_{72}$ may each independently be a π electron-rich $C_3$-$C_{60}$ cyclic group or a pyridine group,

$X_{71}$ may be a single bond, or a linking group comprising O, S, N, B, C, Si, or any combination thereof, and

* indicates a binding site to an atom included in a remainder of the third compound, other than Formula 3.

Formulae 1 and 3 may each independently be the same as described in the present disclosure.

In one or more embodiments, the composition may be comprised in a layer comprising 1) the organometallic compound and 2) the second compound, the third compound, the fourth compound, or any combination thereof. The "layer comprising the composition" may comprise a mixture comprising 1) the organometallic compound and 2) the second compound, the third compound, the fourth compound, or any combination thereof. Therefore, the "layer comprising the composition" is clearly distinguished from, for example, a double layer comprising (e.g., consisting of) 1) a first layer comprising the organometallic compound and 2) a second layer comprising the second compound, the third compound, the fourth compound, or any combination thereof.

In one or more embodiments, the composition may be a composition prepared to form a layer comprising 1) the organometallic compound and 2) the second compound, the third compound, the fourth compound, or any combination thereof by utilizing one or more suitable methods, such as a deposition method and/or a wet process. For example, the composition may be a pre-mixed mixture prepared for utilization in a deposition method (for example, a vacuum deposition method). The pre-mixed mixture may be charged, for example, into a deposition source within a vacuum chamber, and two or more compounds comprised in the pre-mixed mixture may be co-deposited.

According to one or more embodiments of the present disclosure, the composition may comprise:

the organometallic compound; and
the second compound.

In one or more embodiments, an absolute value of a difference between a phase transition temperature of the organometallic compound represented by Formula 1 under a pressure of $5.0 \times 10^{-5}$ torr to $1.0 \times 10^{-3}$ torr and a phase transition temperature of the second compound under a pressure of $5.0 \times 10^{-5}$ torr to $1.0 \times 10^{-3}$ torr may be about 10 °C or less, about 0 °C to about 10 °C, about 1 °C to about 10 °C, about 2 °C to about 10 °C, about 3 °C to about 10 °C, about 4 °C to about 10 °C, about 0 °C to about 8 °C, about 1 °C to about 8 °C, about 2 °C to about 8 °C, about 3 °C to about 8 °C, about 4 °C to about 8 °C, about 0 °C to about 5 °C, about 1 °C to about 5 °C, about 2 °C to about 5 °C, about 3 °C to about 5 °C, about 4 °C to about 5 °C, about 0 °C to about 4.5 °C, about 1 °C to about 4.5 °C, about 2 °C to about 4.5 °C, about 3 °C to about 4.5 °C, or about 4 °C to about 4.5 °C.

In one or more embodiments, an absolute value of a difference between a phase transition temperature of the organometallic compound represented by Formula 1 and a phase transition temperature of the second compound may be about 10 °C or less, about 0 °C to about 10 °C, about 1 °C to about 10 °C, about 2 °C to about 10 °C, about 3 °C to about 10 °C, about 4 °C to about 10 °C, about 0 °C to about 8 °C, about 1 °C to about 8 °C, about 2 °C to about 8 °C, about 3 °C to about 8 °C, about 4 °C to about 8 °C, about 0 °C to about 5 °C, about 1 °C to about 5 °C, about 2 °C to about 5 °C, about 3 °C to about 5 °C, about 4 °C to about 5 ° C, about 0 °C to about 4.5 °C, about 1 °C to about 4.5 °C, about 2 °C to about 4.5 °C, about 3 ° C to about 4.5 °C, or about 4 °C to about 4.5 °C, the phase transition temperatures are evaluated under the same pressure, and the pressure may be in a range of about $5.0 \times 10^{-5}$ torr to about $1.0 \times 10^{-3}$ torr.

When the organometallic compound and the second compound satisfy a phase transition temperature relationship as described above, a phase transition of each of the organometallic compound and the second compound in the composition (for example, a pre-mixed mixture) comprising the organometallic compound and the second compound may be made at substantially the same temperature within the pressure range. Therefore, when a deposition process is performed after the composition comprising the organometallic compound and the second compound is charged to a deposition source, the organometallic compound and the second compound in the composition may be vaporized (or sublimated) at substantially the same temperature, as a result, the organometallic compound and the second compound may be effectively co-deposited, and one or more electrical characteristics and durability of a layer prepared as a result of the co-deposition may be improved.

In one or more embodiments, a weight ratio of the organometallic compound to the second compound in the composition may be about 10:90 to about 90:10 or about 20:80 to about 80:20.

According to one or more embodiments of the present disclosure,
a light-emitting device may comprise:

a first electrode;
a second electrode facing the first electrode;
an interlayer between the first electrode and the second electrode and comprising an emission layer; and
an organometallic compound represented by Formula 1.

Formula 1 is the same as described in the present disclosure.

The light-emitting device comprises the organometallic compound represented by Formula 1, and thus, may have improved color purity, improved luminescence efficiency, and improved lifespan characteristics.

For example, in some embodiments, the interlayer in the light-emitting device may comprise the organometallic

compound.

In some embodiments, the emission layer in the light-emitting device may comprise the organometallic compound.

In one or more embodiments, the light-emitting device may further comprise a second compound comprising at least one $\pi$ electron-deficient nitrogen-containing $C_1$-$C_{60}$ heterocyclic group, a third compound comprising a group represented by Formula 3, a fourth compound capable of emitting delayed fluorescence, or any combination thereof, and the organometallic compound, the second compound, the third compound, and the fourth compound in the light-emitting device may be different from each other.

The second compound, the third compound, and the fourth compound in the composition and the light-emitting device are respectively the same as those described in the present disclosure.

In one or more embodiments, the organometallic compound may comprise at least one deuterium.

In one or more embodiments, the second compound, the third compound, and the fourth compound may each comprise at least one deuterium.

In one or more embodiments, the second compound may comprise at least one silicon.

In one or more embodiments, the third compound may comprise at least one silicon.

In one or more embodiments, each of the composition and the light-emitting device (for example, the emission layer in the light-emitting device) may further comprise, in addition to the organometallic compound represented by Formula 1, a second compound and a third compound, and at least one selected from the second compound and the third compound may comprise at least one deuterium, at least one silicon, or a combination thereof.

In one or more embodiments, each of the composition and the light-emitting device (for example, the emission layer in the light-emitting device) may further comprise, in addition to the organometallic compound, a second compound. At least one selected from the organometallic compound and the second compound may comprise at least one deuterium. For example, in some embodiments, each of the composition and the light-emitting device (for example, the emission layer in the light-emitting device) may further comprise, in addition to the organometallic compound and the second compound, a third compound, a fourth compound, or any combination thereof.

In one or more embodiments, each of the composition and the light-emitting device (for example, the emission layer in the light-emitting device) may further comprise, in addition to the organometallic compound, a third compound. At least one selected from the organometallic compound and the third compound may comprise at least one deuterium. For example, in some embodiments, each of the composition and the light-emitting device (for example, the emission layer in the light-emitting device) may further comprise, in addition to the organometallic compound and the third compound, a second compound, a fourth compound, or any combination thereof.

In one or more embodiments, each of the composition and the light-emitting device (for example, the emission layer in the light-emitting device) may further comprise, in addition to the organometallic compound, a fourth compound. At least one selected from the organometallic compound and the fourth compound may comprise at least one deuterium. The fourth compound may serve to improve color purity, luminescence efficiency, and lifespan characteristics of the light-emitting device. For example, in some embodiments, each of the composition and the light-emitting device (for example, the emission layer in the light-emitting device) may further comprise, in addition to the organometallic compound and the fourth compound, a second compound, a third compound, or any combination thereof.

In one or more embodiments, each of the composition and the light-emitting device (for example, the emission layer in the light-emitting device) may further comprise, in addition to the organometallic compound, a second compound and a third compound. The second compound and the third compound may form an exciplex. At least one selected from the organometallic compound, the second compound, and the third compound may comprise at least one deuterium.

In one or more embodiments, a highest occupied molecular orbital (HOMO) energy level of the organometallic compound may be about -5.35 eV to about -5.15 eV or about -5.30 eV to about -5.20 eV.

In one or more embodiments, a lowest unoccupied molecular orbital (LUMO) energy level of the organometallic compound may be about -2.20 eV to about -1.80 eV or about -2.15 eV to about -1.90 eV.

The HOMO and LUMO energy levels may be evaluated through cyclic voltammetry analysis (for example, Evaluation Example 1) of the organometallic compound.

In one or more embodiments, a maximum emission wavelength (or an emission peak wavelength) of a photoluminescence spectrum in a film comprising the organometallic compound may be about 430 nm to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, about 450 nm to about 465 nm, about 430 nm to about 460 nm, about 440 nm to about 460 nm, or about 450 nm to about 460 nm.

In one or more embodiments, a photoluminescence full width at half maximum (FWHM) of a photoluminescence spectrum in a film comprising the organometallic compound may be about 40 nm or less, about 5 nm to about 40 nm, about 10 nm to about 40 nm, about 15 nm to about 40 nm, about 20 nm to about 40 nm, about 5 nm to about 37 nm, about 10 nm to about 37 nm, about 15 nm to about 37 nm, or about 20 nm to about 37 nm.

In one or more embodiments, a photoluminescence quantum yield (PLQY) in a film comprising the organometallic compound may be about 90 % to about 99 % or about 90 % to about 97 %.

In one or more embodiments, a decay time (e.g., emission decay time) of the organometallic compound may be about 2.40 μs to about 3.5 μs, about 2.40 μs to about 3.0 μs, or about 2.40 μs to about 2.7 μs.

The maximum emission wavelength, photoluminescence FWHM, PLQY, and decay time (e.g., emission decay time) of the organometallic compound are evaluated from a film comprising the organometallic compound, and an evaluation method thereof is the same as described in connection with, for example, Evaluation Examples 2 and 3.

In one or more embodiments, i) the organometallic compound; and ii) the second compound, the third compound, the fourth compound, or any combination thereof may be comprised in the emission layer of the light-emitting device, and the emission layer may be to emit blue light.

In one or more embodiments, a maximum emission wavelength of the blue light may be about 430 nm to about 475 nm, about 440 nm to about 475 nm, about 450 nm to about 475 nm, about 430 nm to about 470 nm, about 440 nm to about 470 nm, about 450 nm to about 470 nm, about 430 nm to about 465 nm, about 440 nm to about 465 nm, about 450 nm to about 465 nm, about 430 nm to about 460 nm, about 440 nm to about 460 nm, or about 450 nm to about 460 nm.

In one or more embodiments, a photoluminescence FWHM of the blue light may be about 40 nm or less, about 5 nm to about 40 nm, about 10 nm to about 40 nm, about 15 nm to about 40 nm, about 20 nm to about 40 nm, about 5 nm to about 37 nm, about 10 nm to about 37 nm, about 15 nm to about 37 nm, or about 20 nm to about 37 nm.

In one or more embodiments, the blue light may be deep blue light.

In one or more embodiments, a CIEx coordinate (for example, a bottom emission CIEx coordinate of a bottom-emitting device) of the blue light may be about 0.125 to about 0.140 or about 0.130 to about 0.140.

In an embodiment, a CIEy coordinate (for example, a bottom emission CIEy coordinate of a bottom-emitting device) of the blue light may be about 0.120 to about 0.200.

Examples of the maximum emission wavelength and the CIEx and CIEy coordinates of the blue light may be referred to data shown in Tables 10 and 11 of the present disclosure.

For example, in one or more embodiments, the second compound may comprise a pyridine group, a pyrimidine group, a pyrazine group, a pyridazine group, a triazine group, or any combination thereof.

In one or more embodiments, the following compounds may be excluded from the third compound.

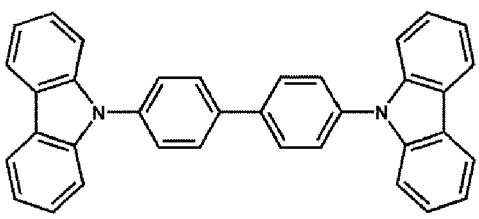

CBP

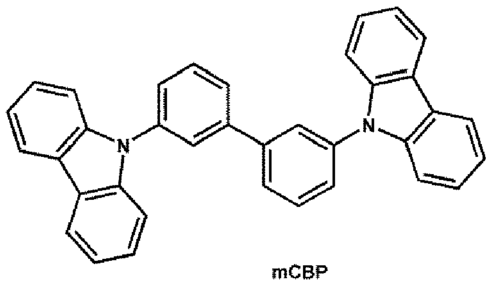

mCBP

In one or more embodiments, a difference between a triplet energy level (unit: eV) of the fourth compound and a singlet energy level (eV) of the fourth compound may be about 0 eV or higher and about 0.5 eV or lower (or, about 0 eV or higher and about 0.3 eV or lower).

In one or more embodiments, the fourth compound may comprise at least one cyclic group comprising both (e.g., simultaneously) boron (B) and nitrogen (N) as ring-forming atoms.

In one or more embodiments, the fourth compound may be a $C_8$-$C_{60}$ polycyclic group-containing compound comprising at least two cyclic groups that are condensed with each other with sharing boron (B).

In one or more embodiments, the fourth compound may comprise a condensed ring in which at least one third ring may be condensed with at least one fourth ring, for example, to form the condensed ring comprising four or more rings,

the third ring may be a cyclopentane group, a cyclohexane group, a cycloheptane group, a cyclooctane group, a cyclopentene group, a cyclohexene group, a cycloheptene group, a cyclooctene group, an adamantane group, a norbornene group, a norbornane group, a bicyclo[1.1.1]pentane group, a bicyclo[2.1.1]hexane group, a bicyclo[2.2.2]octane group, a benzene group, a pyridine group, a pyrimidine group, a pyridazine group, a pyrazine group, or a triazine group, and

the fourth ring may be a 1,2-azaborinine group, a 1,3-azaborinine group, a 1,4-azaborinine group, a 1,2-dihydro-1,2-azaborinine group, a 1,4-oxaborinine group, a 1,4-thiaborinine group, or a 1,4-dihydroborinine group.

For example, in some embodiments, the third compound may not comprise (e.g., may exclude) a compound represented by Formula 3-1 in the present disclosure.

In one or more embodiments, the second compound may comprise a compound represented by Formula 2:

Formula 2

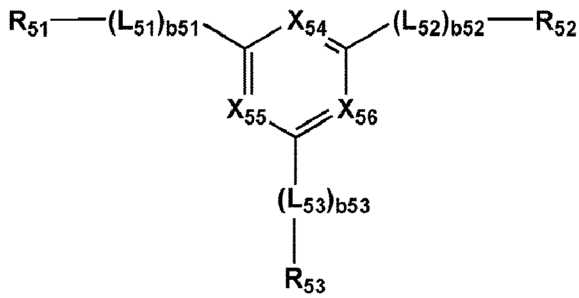

,

wherein, in Formula 2,
$L_{51}$ to $L_{53}$ may each independently be a single bond, a $C_3$-$C_{60}$ carbocyclic group that is unsubstituted or substituted with at least one $R_{10a}$, or a $C_1$-$C_{60}$ heterocyclic group that is unsubstituted or substituted with at least one $R_{10a}$,
b51 to b53 may each independently be an integer selected from 1 to 5,
$X_{54}$ may be N or C($R_{54}$), $X_{55}$ may be N or C($R_{55}$), $X_{56}$ may be N or C($R_{56}$), and at least one selected from among $X_{54}$ to $X_{56}$ may be N, and
$R_{51}$ to $R_{56}$ and $R_{10a}$ may each be the same as described in the present disclosure.

In one or more embodiments, the third compound may comprise a compound represented by Formula 3-1, a compound represented by Formula 3-2, a compound represented by Formula 3-3, a compound represented by Formula 3-4, a compound represented by Formula 3-5, or any combination thereof:

Formula 3-1

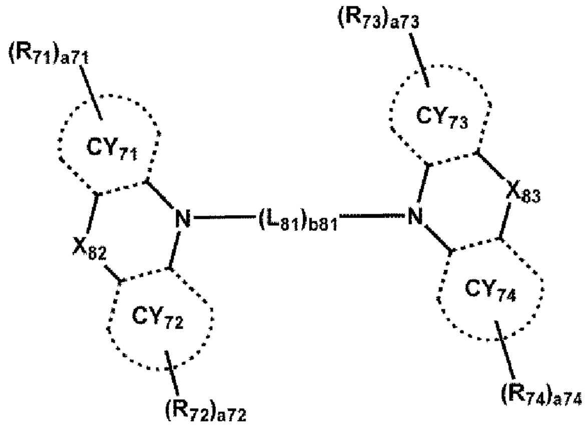

Formula 3-2

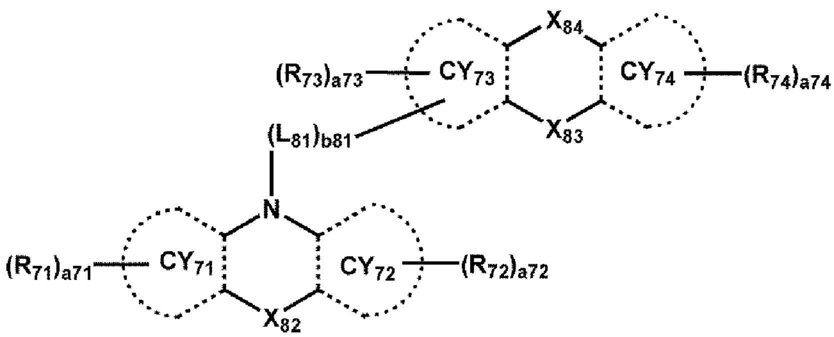

Formula 3-3

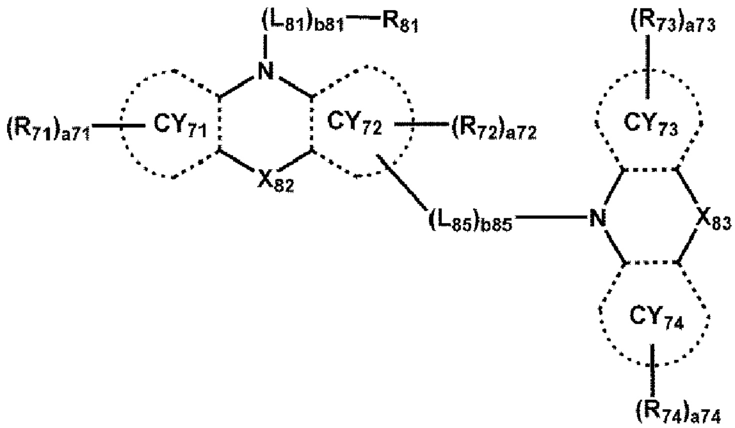

Formula 3-4

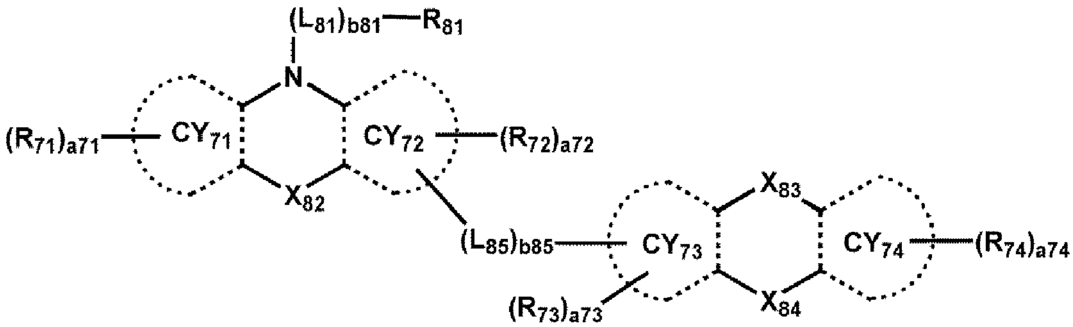

Formula 3-5

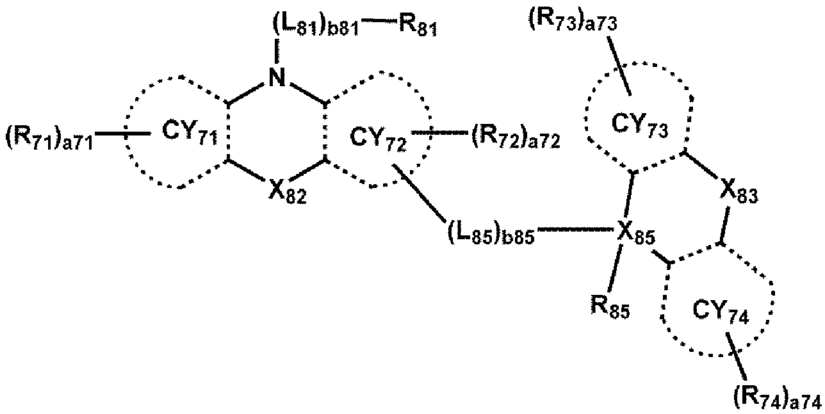

,

wherein, in Formulae 3-1 to 3-5,

ring $CY_{71}$ to ring $CY_{74}$ may each independently be a $\pi$ electron-rich $C_3$-$C_{60}$ cyclic group or a pyridine group,

$X_{82}$ may be a single bond, O, S, N-[$(L_{82})_{b82}$-$R_{82}$], $C(R_{82a})(R_{82b})$, or $Si(R_{82a})(R_{82b})$,

$X_{83}$ may be a single bond, O, S, N-[$(L_{83})_{b83}$-$R_{83}$], $C(R_{83a})(R_{83b})$, or $Si(R_{83a})(R_{83b})$,

$X_{84}$ may be O, S, N-[$(L_{84})_{b84}$-$R_{84}$], $C(R_{84a})(R_{84b})$, or $Si(R_{84a})(R_{84b})$,

$X_{85}$ may be C or Si,

$L_{81}$ to $L_{85}$ may each independently be a single bond, *-C($Q_4$)($Q_5$)-*', *-Si($Q_4$)($Q_5$)-*', a $\pi$ electron-rich $C_3$-$C_{60}$ cyclic group that is unsubstituted or substituted with at least one $R_{10a}$, or a pyridine group that is unsubstituted or substituted with at least one $R_{10a}$, and $Q_4$ and $Q_5$ may each be the same as described with respect to $Q_1$,

b81 to b85 may each independently be an integer selected from 1 to 5,

$R_{71}$ to $R_{74}$, $R_{81}$ to $R_{85}$, $R_{82a}$, $R_{82b}$, $R_{83a}$, $R_{83b}$, $R_{84a}$, and $R_{84b}$ are respectively the same as those described in the present disclosure,

a71 to a74 may each independently be an integer selected from 0 to 20, and

$R_{10a}$ is the same as described in the present disclosure.

In one or more embodiments, the fourth compound may comprise a compound represented by Formula 502, a compound represented by Formula 503, or any combination thereof:

**Formula 502**

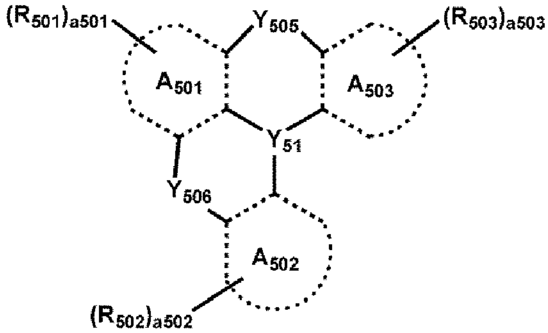

**Formula 503**

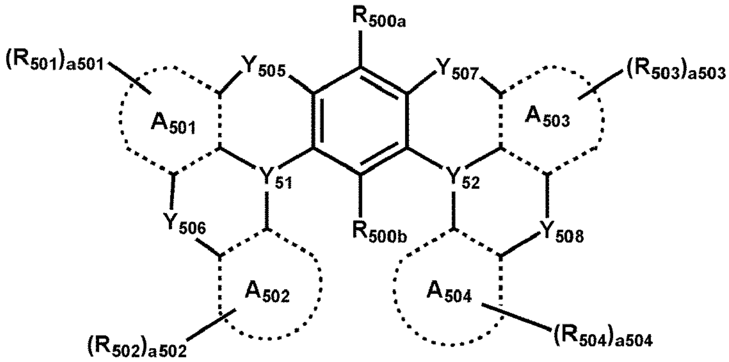

,

wherein, in Formulae 502 and 503,
ring $A_{501}$ to ring $A_{504}$ may each independently be a Cs-Ceo carbocyclic group or a $C_1$-$C_{60}$ heterocyclic group,
$Y_{505}$ may be O, S, $N(R_{505})$, $B(R_{505})$, $C(R_{505a})(R_{505b})$, or $Si(R_{505a})(R_{505b})$,
$Y_{506}$ may be O, S, $N(R_{506})$, $B(R_{506})$, $C(R_{506a})(R_{506b})$, or $Si(R_{5061})(R_{506b})$,
$Y_{507}$ may be O, S, $N(R_{507})$, $B(R_{507})$, $C(R_{507a})(R_{507b})$, or $Si(R_{507a})(R_{507b})$,
$Y_{508}$ may be O, S, $N(R_{508})$, $B(P_{508})$, $C(R_{508a})(R_{508b})$, or $Si(R_{508a})(R_{508b})$,
$Y_{51}$ and $Y_{52}$ may each independently be B, P(=O), or S(=O),
$R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ are respectively the same as those described in the present disclosure.
a501 to a504 may each independently be an integer selected from 0 to 20.

In one or more embodiments, the light-emitting device may satisfy at least one selected from among Condition 1 to Condition 4.

**Condition 1**
LUMO energy level (eV) of third compound > LUMO energy level (eV) of organometallic compound
**Condition 2**
LUMO energy level (eV) of organometallic compound > LUMO energy level (eV) of second compound
**Condition 3**
HOMO energy level (eV) of organometallic compound > HOMO energy level (eV) of third compound
**Condition 4**
HOMO energy level (eV) of third compound > HOMO energy level (eV) of second compound

The HOMO energy level and LUMO energy level of each of the organometallic compound, the second compound, and the third compound are each a negative value, and may be measured according to a suitable method, for example, a method described in Evaluation Example 1 in the present disclosure.

In one or more embodiments, an absolute value of a difference between a LUMO energy level of the organometallic compound and a LUMO energy level of the second compound may be about 0.1 eV or higher and about 1.0 eV or lower, an absolute value of a difference between a LUMO energy level of the organometallic compound and a LUMO energy level of the third compound may be about 0.1 eV or higher and about 1.0 eV or lower, an absolute value of a difference between a HOMO energy level of the organometallic compound and a HOMO energy level of the second compound may be about 1.25 eV or lower (for example, about 1.25 eV or lower and about 0.2 eV or higher), and an absolute value of a difference between a HOMO energy level of the organometallic compound and a HOMO energy level of the third compound may be about 1.25 eV or lower (for example, about 1.25 eV or lower and about 0.2 eV or higher).

When the relationships between the LUMO energy level and the HOMO energy level satisfy the conditions as described above, the balance between holes and electrons injected into the emission layer may be achieved.

The light-emitting device may have a structure of a first embodiment or a second embodiment:

**First** embodiment

According to the first embodiment, the organometallic compound may be comprised in the emission layer in the interlayer of the light-emitting device, wherein the emission layer may further comprise a host, the organometallic compound may be different from the host, and the emission layer may be to emit phosphorescence or fluorescence emitted from the organometallic compound. In other words, according to the first embodiment, the organometallic compound may be a dopant or an emitter. For example, in some embodiments, the organometallic compound may be a phosphorescent dopant or a phosphorescent emitter.

Phosphorescence or fluorescence emitted from the organometallic compound may be blue light.

In some embodiments, the emission layer may further comprise an auxiliary dopant. The auxiliary dopant may serve to improve luminescence efficiency of the organometallic compound by effectively transferring energy to the organometallic compound as a dopant or an emitter.

The auxiliary dopant may be different from each of the organometallic compound and the host.

For example, in some embodiments, the auxiliary dopant may be a delayed fluorescence-emitting compound.

In some embodiments, the auxiliary dopant may be a compound comprising at least one cyclic group comprising both (e.g., simultaneously) boron (B) and nitrogen (N) as ring-forming atoms.

Second embodiment

According to the second embodiment, the organometallic compound may be comprised in the emission layer in the interlayer of the light-emitting device, wherein the emission layer may further comprise a host and a dopant, the organometallic compound, the host, and the dopant may be different from one another, and the emission layer may be to emit phosphorescence or fluorescence (for example, delayed fluorescence) from the dopant.

For example, in some embodiments, the organometallic compound in the second embodiment may serve as an auxiliary dopant that transfers energy to a dopant (or an emitter), not as a dopant.

In some embodiments, the organometallic compound in the second embodiment may serve as an emitter and also serve as an auxiliary dopant that transfers energy to a dopant (or an emitter).

For example, phosphorescence or fluorescence emitted from the dopant (or the emitter) in the second embodiment may be blue phosphorescence or blue fluorescence (for example, blue delayed fluorescence).

The dopant (or the emitter) in the second embodiment may be any phosphorescent dopant material (for example, the organometallic compound represented by Formula 1, an organometallic compound represented by Formula 401, or any combination thereof) or any fluorescent dopant material (for example, the compound represented by Formula 501, the compound represented by Formula 502, the compound represented by Formula 503, or any combination thereof).

In the first embodiment and the second embodiment, the blue light may have a maximum emission wavelength of about 390 nm to about 500 nm, about 410 nm to about 490 nm, about 430 nm to about 480 nm, about 440 nm to about 475 nm, or about 455 nm to about 470 nm.

The auxiliary dopant in the first embodiment may comprise, for example, the fourth compound represented by Formula 502 or 503.

The host in the first embodiment and the second embodiment may be any host material (for example, a compound represented by Formula 301, a compound represented by 301-1, a compound represented by Formula 301-2, or any combination thereof).

In one or more embodiments, the host in the first embodiment and the second embodiment may be the second compound, the third compound, or any combination thereof.

In one or more embodiments, the light-emitting device may further comprise a capping layer located outside the first electrode and/or outside the second electrode.

In one or more embodiments, the light-emitting device may further comprise at least one of a first capping layer

located outside the first electrode or a second capping layer located outside the second electrode, and the organometallic compound represented by Formula 1 may be comprised in at least one of the first capping layer or the second capping layer. The first capping layer and/or the second capping layer may respectively be the same as those described in the present disclosure.

In one or more embodiments, the light-emitting device may further comprise:

a first capping layer located outside the first electrode and comprising the organometallic compound represented by Formula 1;
a second capping layer located outside the second electrode and comprising the organometallic compound represented by Formula 1; or
the first capping layer and the second capping layer.

The expression "(interlayer and/or capping layer) comprises an organometallic compound represented by Formula 1" as utilized herein may refer to that the (interlayer and/or capping layer) may comprise one kind of organometallic compound represented by Formula 1 or two or more different kinds of organometallic compounds, each represented by Formula 1.

For example, in some embodiments, the interlayer and/or capping layer may comprise only Compound BD01 of the present disclosure as the organometallic compound. In this regard, Compound BD01 may be present in the emission layer of the light-emitting device. In some embodiments, the interlayer may comprise, as the organometallic compound, Compound BD01 and Compound BD02 of the present disclosure. In this regard, Compound BD01 and Compound BD02 may be present in an identical layer (for example, both (e.g., simultaneously) Compound BD01 and Compound BD02 may be present in the emission layer), or may be present in different layers (for example, Compound BD01 may be present in the emission layer and Compound BD02 may be present in an electron transport region).

The term "interlayer" as utilized herein refers to a single layer and/or all of a plurality of layers between the first electrode and the second electrode of the light-emitting device.

According to one or more embodiments of the present disclosure, there is provided an electronic device comprising the light-emitting device. In one or more embodiments, the electronic device may further comprise a thin-film transistor. For example, in some embodiments, the electronic device may further comprise a thin-film transistor comprising a source electrode and a drain electrode, and the first electrode of the light-emitting device may be electrically connected to the source electrode or the drain electrode of the thin-film transistor. In some embodiments, the electronic device may further comprise a color filter, a color conversion layer, a touch screen layer, a polarizing layer, or any combination thereof. More details for the electronic device are as described in the present disclosure.

According to one or more embodiments of the present disclosure, there is provided an electronic apparatus comprising the light-emitting device.

For example, the electronic apparatus may be at least one selected from a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and a signboard.

According to one or more embodiments of the present disclosure, there is provided an organometallic compound represented by Formula 1. Formula 1 is the same as described in the present disclosure.

Methods of synthesizing the organometallic compound may be easily understood to those of ordinary skill in the art by referring to Synthesis Examples and/or Examples described herein.

Description of Formula

In Formula 1, M may be platinum (Pt), palladium (Pd), gold (Au), nickel (Ni), silver (Ag), or copper (Cu).

In one or more embodiments, M may be Pt.

In Formula 1, $X_1$ to $X_4$ may each independently be C or N.

For example, in some embodiments, $X_1$ may be C. For example, in some embodiments, $X_1$ in Formula 1 may be C, and C may be carbon of a carbene moiety.

In one or more embodiments, $X_1$ in Formula 1 may be N.

In one or more embodiments, $X_2$ and $X_3$ may each be C, and $X_4$ may be N.

In Formula 1, i) a bond between $X_1$ and M may be a coordinate bond, ii) one selected from among a bond between $X_2$ and M, a bond between $X_3$ and M, and a bond between $X_4$ and M may be a coordinate bond, and the other two (remainders or the remaining two) may each be a covalent bond.

In one or more embodiments, a bond between $X_2$ and M and a bond between $X_3$ and M may each be a covalent bond, and a bond between $X_4$ and M may be a coordinate bond.

In one or more embodiments, $X_4$ may be N, and a bond between $X_4$ and M may be a coordinate bond.

In Formula 1, ring $CY_1$ and ring $CY_2$ may each independently be a $C_3$-$C_{60}$ carbocyclic group or a $C_1$-$C_{60}$ heterocyclic group.

For example, in some embodiments, ring $CY_1$ may be a nitrogen-containing $C_1$-$C_{60}$ heterocyclic group.

Ring $CY_1$ in Formula 1 may be i) an $X_1$-containing 5-membered ring, ii) an $X_1$-containing 5-membered ring in which at least one 6-membered ring is condensed, or iii) an $X_1$-containing 6-membered ring. In one or more embodiments, ring $CY_1$ in Formula 1 may be i) an $X_1$-containing 5-membered ring or ii) an $X_1$-containing 5-membered ring in which at least one 6-membered ring is condensed. In other words, ring $CY_1$ may comprise a 5-membered ring bonded to M in Formula 1 via $X_1$. In this regard, the $X_1$-containing 5-membered ring may be a pyrrole group, a pyrazole group, an imidazole group, a triazole group, an oxazole group, an iso-oxazole group, a thiazole group, an isothiazole group, an oxadiazole group, or a thiadiazole group, and the $X_1$-containing 6-membered ring and the 6-membered ring which may be optionally condensed to the $X_1$-containing 5-membered ring may each independently be a benzene group, a pyridine group, or a pyrimidine group.

In one or more embodiments, ring $CY_1$ may be an $X_1$-containing 5-membered ring, and the $X_1$-containing 5-membered ring may be an imidazole group or a triazole group.

In one or more embodiments, ring $CY_1$ may be an $X_1$-containing 5-membered ring in which at least one 6-membered ring is condensed, and the $X_1$-containing 5-membered ring in which the at least one 6-membered ring is condensed may be a benzimidazole group or an imidazopyridine group.

In one or more embodiments, ring $CY_1$ may be an imidazole group, a triazole group, a benzimidazole group, a naphthoimidazole group, or an imidazopyridine group.

In one or more embodiments, $X_1$ may be C, and ring $CY_1$ may be an imidazole group, a triazole group, a benzimidazole group, a naphthoimidazole group, or an imidazopyridine group.

In one or more embodiments, ring $CY_2$ may be a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenzosilole group, an azadinaphthofuran group, an azadinaphthothiophene group, an azadibenzocarbazole group, an azadibenzofluorene group, or an azadinaphthosilole group.

For example, in some embodiments, ring $CY_2$ may be a benzene group, a pyridine group, a pyrimidine group, a naphthalene group, a dibenzofuran group, a dibenzothiophene group, a carbazole group, a fluorene group, or a dibenzosilole group.

In Formula 1, ring $CY_3$ may be: a $C_2$-$C_8$ monocyclic group; or a $C_4$-$C_{20}$ polycyclic group in which two or three $C_2$-$C_8$ monocyclic groups are condensed together.

For example, in some embodiments, in Formula 1, ring $CY_3$ may be: a $C_4$-$C_6$ monocyclic group; or a $C_4$-$C_8$ polycyclic group in which two or three $C_4$-$C_6$ monocyclic groups are condensed together.

The $C_2$-$C_8$ monocyclic group in the present disclosure may refer to a noncondensed ring group, and may be, for example, a cyclopentadiene group, a pyrrole group, a pyrazole group, an imidazole group, a triazole group, an oxazole group, an isoxazole group, a thiazole group, an isothiazole group, an oxadiazole group, a thiadiazole group, a benzene group, a pyridine group, a pyrimidine group, a pyrazine group, a pyridazine group, a triazine group, a cycloheptadiene group, or cyclooctadiene group.

For example, in some embodiments, ring $CY_3$ may be a benzene group, a pyridine group, a pyrimidine group, a naphthalene group, a dibenzofuran group, a dibenzothiophene group, a carbazole group, a fluorene group, a dibenzosilole group, an azadibenzofuran group, an azadibenzothiophene group, an azacarbazole group, an azafluorene group, or an azadibenzosilole group.

In Formula 1, $X_{41}$ may be $C(R_{41})$ or N, $X_{42}$ may be $C(R_{42})$ or N, $X_{43}$ may be $C(R_{43})$ or N, and $X_{44}$ may be $C(R_{44})$ or N.

For example, in some embodiments, $X_{41}$ may be $C(R_{41})$, $X_{42}$ may be $C(R_{42})$, $X_{43}$ may be $C(R_{43})$, and $X_{44}$ may be $C(R_{44})$.

In Formula 1, ring $CY_{11}$, ring $CY_{12}$, and ring $CY_{13}$ may each be a $C_2$-$C_8$ monocyclic group.

For example, in some embodiments, ring $CY_{11}$, ring $CY_{12}$, and ring $CY_{13}$ may each independently be a cyclopentadiene group, a pyrrole group, a pyrazole group, an imidazole group, a triazole group, an oxazole group, an isoxazole group, a thiazole group, an isothiazole group, an oxadiazole group, a thiadiazole group, a benzene group, a pyridine group, a pyrimidine group, a pyrazine group, a pyridazine group, a triazine group, a cycloheptadiene group, or

a cyclooctadiene group.

In some embodiments, ring $CY_{11}$, ring $CY_{12}$, and ring $CY_{13}$ may each independently be a benzene group, a pyridine group, a pyrimidine group, a pyrazine group, or a pyridazine group.

In one or more embodiments, ring $CY_{11}$, ring $CY_{12}$, and ring $CY_{13}$ in Formula 1 may be identical to each other.

In one or more embodiments, ring $CY_{11}$, ring $CY_{12}$, and ring $CY_{13}$ in Formula 1 may each be a benzene group.

$X_{51}$ in Formula 1 may be a single bond, *-N($Z_{51a}$)-*', *-B($Z_{51a}$)-*', *-P($Z_{51a}$)-*', *-C($Z_{51a}$)($Z_{51b}$)-*', *-Si($Z_{51a}$)($Z_{51b}$)-*', *-Ge($Z_{51a}$)($Z_{51b}$)-*', *-S-*', *-Se-*', *-O-*', *-C(=O)-*', *-S(=O)-*', *-S(=O)$_2$-*', *-C($Z_{51a}$)=*', *=C($Z_{51a}$)-*', *-C($Z_{51a}$)=C($Z_{51b}$)-*', *-C(=S)-*', or *-C≡C-*'. $Z_{51a}$ and $Z_{51b}$ may respectively be the same as those described in the present disclosure. $Z_{51a}$ and $Z_{51b}$ may optionally be bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$.

For example, in some embodiments, $X_{51}$ may be *-N($Z_{51a}$)-*', *-B($Z_{51a}$)-*', *-P($Z_{51a}$)-*', *-C($Z_{51a}$)($Z_{51b}$)-*', *-Si($Z_{51a}$)($Z_{51b}$)-*', *-Ge($Z_{51a}$)($Z_{51b}$)-*', *-S-*', *-Se-*', or *-O-*'.

$X_{52}$ in Formula 1 may be a single bond, *-N($Z_{52a}$)-*', *-B($Z_{52a}$)-*', *-P($Z_{52a}$)-*', *-C($Z_{52a}$)($Z_{52b}$)-*', *-Si($Z_{52a}$)($Z_{52b}$)-*', *-Ge($Z_{52a}$)($Z_{52b}$)-*', *-S-*', *-Se-*', *-O-*', *-C(=O)-*', *-S(=O)-*', *-S(=O)$_2$-*', *-C($Z_{52a}$)=*', *=C($Z_{52a}$)-*', *-C($Z_{52a}$)=C($Z_{52b}$)-*', *-C(=S)-*', or *-C≡C-*'. $Z_{52a}$ and $Z_{52b}$ may respectively be the same as those described in the present disclosure. $Z_{52a}$ and $Z_{52b}$ may optionally be bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$.

In some embodiments, $X_{52}$ in Formula 1 may be a single bond, *-N($Z_{52a}$)-*', *-B($Z_{52a}$)-*', *-P($Z_{52a}$)-*', *-C($Z_{52a}$)($Z_{52b}$)-*', *-Si($Z_{52a}$)($Z_{52b}$)-*', *-Ge($Z_{52a}$)($Z_{52b}$)-*', *-S-*', *-Se-*', or *-O-*'.

In one or more embodiments, in Formula 1,

i) $X_{52}$ is a single bond, and a group represented by

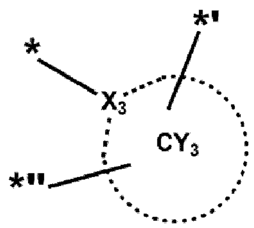

is a group represented by Formula CY3A or CY3B,

ii) $X_{52}$ is not a single bond, and a group represented by

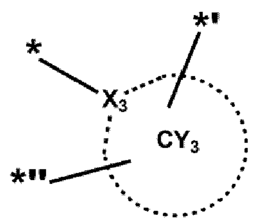

is a group represented by Formula CY3C, or

iii) $X_{52}$ may be *-N($R_{52a}$)-*', and $R_{52a}$ and $R_3$ may be bonded to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$:

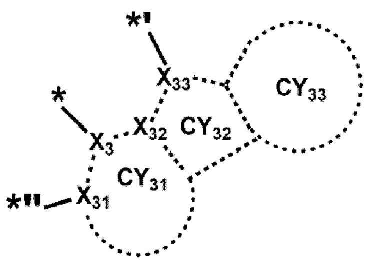
CY3A

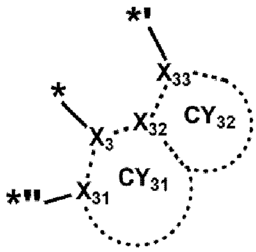
CY3B

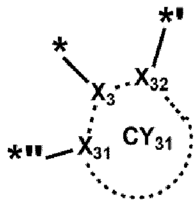
CY3C ,

wherein, in Formulae CY3A to CY3C,

$X_3$ and $X_{31}$ to $X_{33}$ may each independently be C or N,
rings $CY_{31}$, $CY_{32}$ and $CY_{33}$ may each be a $C_2$-$C_8$ monocyclic group,
a bond between $X_{31}$ and $X_3$, a bond between $X_3$ and $X_{32}$, and a bond between $X_{32}$ and $X_{33}$ may each be a chemical bond,
*" indicates a binding site to $X_{51}$,
* indicates a binding site to M in Formula 1, and
*' indicates a binding site to $X_{52}$.

For example, in some embodiments, in Formulae CY3A and CY3B, $X_{31}$, $X_3$, and $X_{32}$ may each be C, and $X_{33}$ may be N.
In some embodiments, $X_{31}$, $X_3$, and $X_{32}$ in Formula CY3C may each be C.
In Formula 1,

$R_1$ to $R_3$, $R_{41}$, $R_{42}$, $R_{44}$, $Z_{51a}$, $Z_{51b}$, $Z_{52a}$, $Z_{52b}$, and $T_1$ to $T_3$ may each independently be hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, a $C_6$-$C_{60}$ aryloxy group that is unsubstituted or substituted with at least one $R_{10a}$, a $C_6$-$C_{60}$ arylthio group that is unsubstituted or substituted with at least one $R_{10a}$, a $C_{7}$-$C_{60}$ aryl alkyl group that is unsubstituted or substituted with at least one $R_{10a}$, a $C_2$-$C_{60}$ heteroaryl alkyl group that is unsubstituted or substituted with at least one $R_{10a}$, - $C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or-$P(=O)(Q_1)(Q_2)$, and
$R_{43}$ may be hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, $-C(Q_1)(Q_2)(Q_3)$, $-Si(Q_1)(Q_2)(Q_3)$, $-N(Q_1)(Q_2)$, - $B(Q_1)(Q_2)$, $-C(=O)(Q_1)$, $-S(=O)_2(Q_1)$, or-$P(=O)(Q_1)(Q_2)$.
$Q_1$ to $Q_3$ may respectively be the same as those described in the present disclosure.

In one or more embodiments, $R_1$ to $R_3$, $R_{41}$, $R_{42}$, $R_{44}$, $Z_{51a}$, $Z_{51b}$, $Z_{52a}$, $Z_{52b}$, and $T_1$ to $T_3$ may each independently be:

hydrogen, deuterium, -F, or a cyano group;
a $C_1$-$C_{20}$ alkyl group that is unsubstituted or substituted with deuterium, -F, a cyano group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, or any combination thereof; or
a $C_3$-$C_{10}$ cycloalkyl group, a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl) phenyl group, a biphenyl group, a deuterated biphenyl group, a fluorinated biphenyl group, a ($C_1$-$C_{20}$ alkyl)biphenyl group, or any combination thereof.

In one or more embodiments, $R_{43}$ may be:

hydrogen, deuterium, -F, or a cyano group; or

a $C_1$-$C_{20}$ alkyl group that is unsubstituted or substituted with deuterium, -F, a cyano group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, or any combination thereof.

In one or more embodiments, $X_{42}$ in Formula 1 may be $C(R_{42})$, $R_{42}$ may be a group represented by *-$C(R_{42a})(R_{42b})(R_{42c})$, and $R_{42a}$, $R_{42b}$, and $R_{42}$, may each independently be hydrogen, deuterium, -F, a cyano group, a $C_1$-$C_{19}$ alkyl group, a deuterated $C_1$-$C_{19}$ alkyl group, a fluorinated $C_1$-$C_{19}$ alkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, or a ($C_1$-$C_{20}$ alkyl)biphenyl group.

For example, in some embodiments, at least one selected from among $R_{42a}$, $R_{42b}$, and $R_{42}$, may not be hydrogen.

A1, a2, a3, c2, and c3 in Formula 1 indicate numbers of $R_1$, $R_2$, $R_3$, $T_2$, and $T_3$, respectively, and may each independently an integer selected from 0 to 10 (for example, an integer selected from 0 to 5). When a1 is 2 or more, two or more $R_1$(s) may be identical to or different from each other, when a2 is 2 or more, two or more $R_2$(s) may be identical to or different from each other, when a3 is 2 or more, two or more $R_3$(s) may be identical to or different from each other, when c2 is 2 or more, two or more $T_2$(s) may be identical to or different from each other, and when c3 is 2 or more, two or more $T_3$(s) may be identical to or different from each other.

c1 in Formula 1 indicates the number of $T_1$, and may be an integer selected from 0 to 5 (for example, 0, 1, or 2). When c1 is 2 or more, two or more $T_1$(s) may be identical to or different from each other.

In one or more embodiments, the organometallic compound represented by Formula 1 may satisfy at least one selected from among Condition A1 to Condition A10.

**Condition A1**

a1 is not 0, and $R_1$ is not hydrogen.

**Condition A2**

a2 is not 0, and $R_2$ is not hydrogen.

**Condition A3**

a3 is not 0, and $R_3$ is not hydrogen.

**Condition A4**

$X_{41}$ is $C(R_{41})$, and $R_{41}$ is not hydrogen.

**Condition A5**

$X_{42}$ is $C(R_{42})$, and $R_{42}$ is not hydrogen.

**Condition A6**

$X_{43}$ is $C(R_{43})$, and $R_{43}$ is not hydrogen.

**Condition A7**

$X_{44}$ is $C(R_{44})$, and $R_{44}$ is not hydrogen.

**Condition A8**

c1 is not 0, and $T_1$ is not hydrogen.

**Condition A9**

c2 is not 0, and $T_2$ is not hydrogen.

**Condition A10**

c3 is not 0, and $T_3$ is not hydrogen.

In one or more embodiments, the organometallic compound represented by Formula 1 may comprise at least one deuterium.

In one or more embodiments, the organometallic compound represented by Formula 1 may satisfy at least one selected from among Condition B1 to Condition B10.

**Condition B1**

a1 is not 0, and at least one $R_1$ is deuterium or a deuterium-containing group.

**Condition B2**

a2 is not 0, and at least one $R_2$ is deuterium or a deuterium-containing group.

**Condition B3**

a3 is not 0, and at least one $R_3$ is deuterium or a deuterium-containing group.

**Condition B4**

$X_{41}$ is $C(R_{41})$, and $R_{41}$ is deuterium or a deuterium-containing group.

**Condition B5**

$X_{42}$ is $C(R_{42})$, and $R_{42}$ is deuterium or a deuterium-containing group.

**Condition B6**

$X_{43}$ is $C(R_{43})$, and $R_{43}$ is deuterium or a deuterium-containing group.

**Condition B7**

$X_{44}$ is $C(R_{44})$, and $R_{44}$ is deuterium or a deuterium-containing group.

**Condition B8**

c1 is not 0, and at least one $T_1$ is deuterium or a deuterium-containing group.

**Condition B9**

c2 is not 0, and at least one $T_2$ is deuterium or a deuterium-containing group.

**Condition B10**

c3 is not 0, and at least one $T_3$ is deuterium or a deuterium-containing group.

The term "deuterium-containing group" utilized herein refers to any group comprising at least one deuterium, and may be further substituted with substituents other than deuterium. For example, the deuterium-containing group may be a $C_1$-$C_{20}$ alkyl group, a fluorinated $C_1$-$C_{20}$ alkyl group, a phenyl group, a fluorinated phenyl group, a ($C_1$-$C_{20}$ alkyl)phenyl group, a biphenyl group, a fluorinated biphenyl group, a ($C_1$-$C_{20}$ alkyl)biphenyl group, a $C_3$-$C_{10}$ cycloalkyl group, a naphthyl group, a dibenzofuranyl group, or a dibenzothiophenyl group, each substituted with at least one deuterium.

In Formula 1, a group represented by

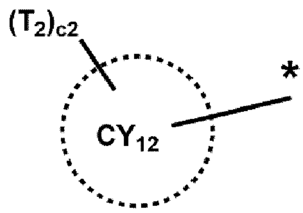

and a group represented by

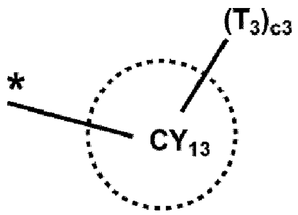

may be different from each other.

In one or more embodiments, a group represented by

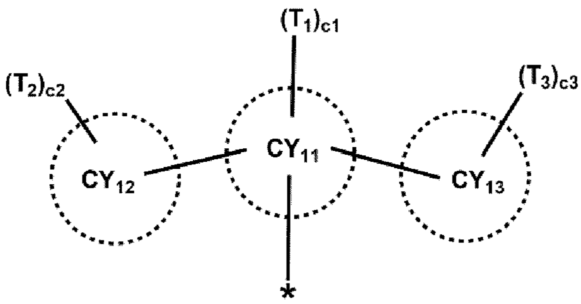

in Formula 1 may be a group represented by Formula AS1:

Formula AS1

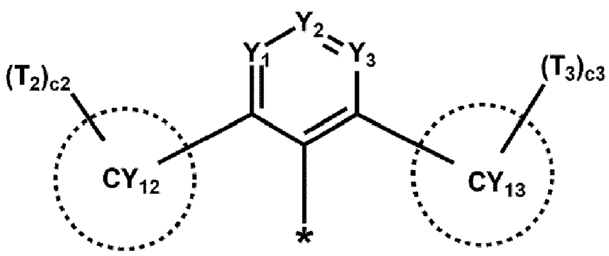

,

wherein, in Formula AS1,
ring $CY_{12}$, ring $CY_{13}$, $T_2$, $T_3$, c2, and c3 are respectively the same as those described in the present disclosure,
$Y_1$ may be $C(T_{11})$ or N, $Y_2$ may be $C(T_{12})$ or N, and $Y_3$ may be $C(T_{13})$ or N,
$T_{11}$ to $T_{13}$ may each be the same as described with respect to $T_1$, and
* is a binding site to ring $CY_1$ in Formula 1.

For example, in some embodiments, $Y_2$ in Formula AS1 may be $C(T_{12})$, and $T_{12}$ may not be hydrogen.

In one or more embodiments, in Formula 1, a group represented by

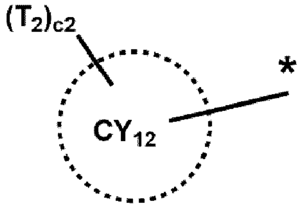

may be one selected from groups represented by Formulae AS2-1 to AS2-20:

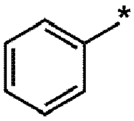
AS2-1

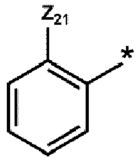
AS2-2

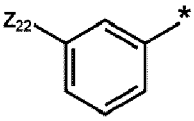
AS2-3

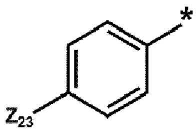
AS2-4

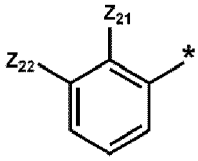
AS2-5

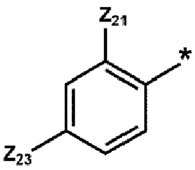
AS2-6

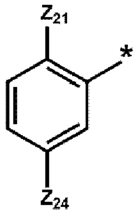
AS2-7

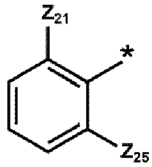
AS2-8

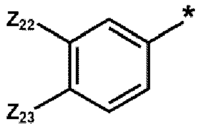
AS2-9

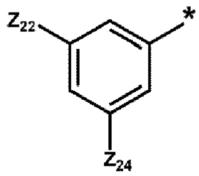
AS2-10

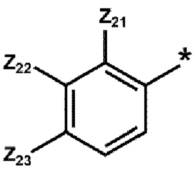
AS2-11

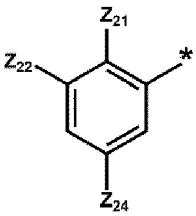
AS2-12

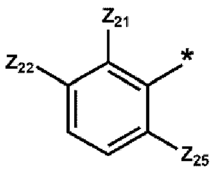
AS2-13

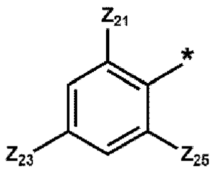
AS2-14

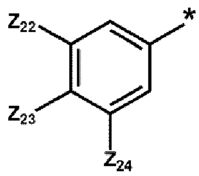
AS2-15

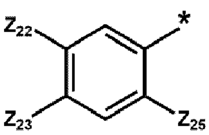
AS2-16

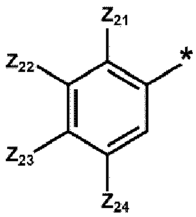
AS2-17

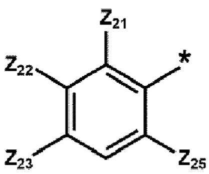
AS2-18

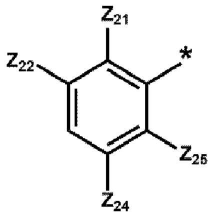
AS2-19

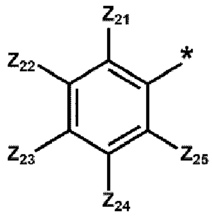
AS2-20

,

wherein, in Formulae AS2-1 to AS2-20,

$Z_{21}$ to $Z_{25}$ may each be the same as described with respect to $T_2$, wherein $Z_{21}$ to $Z_{25}$ may each not be hydrogen, and

*indicates a binding site to ring $CY_{11}$.

In one or more embodiments, in Formula 1, a group represented by

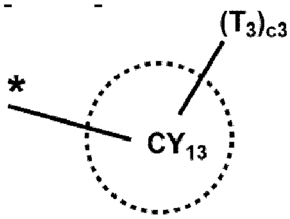

may be one selected from groups represented by Formulae AS3-1 to AS3-20:

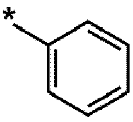
AS3-1

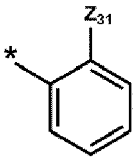
AS3-2

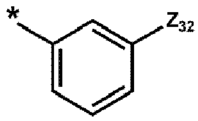
AS3-3

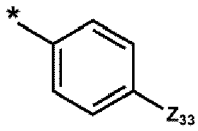
AS3-4

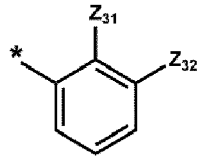
AS3-5

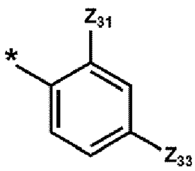
AS3-6

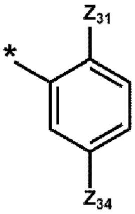
AS3-7

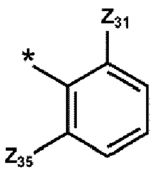
AS3-8

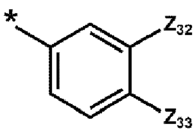
AS3-9

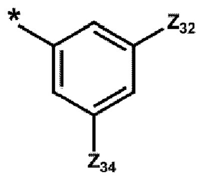
AS3-10

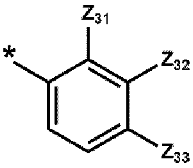
AS3-11

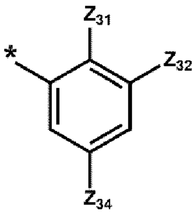
AS3-12

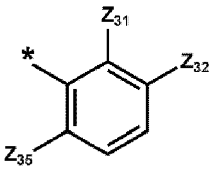
AS3-13

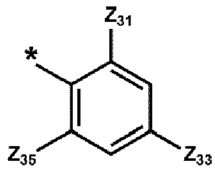
AS3-14

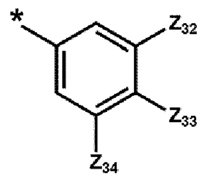
AS3-15

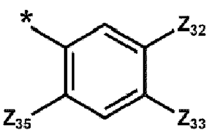
AS3-16

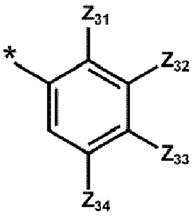
AS3-17

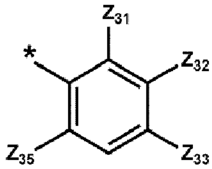
AS3-18

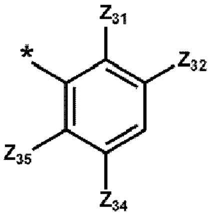
AS3-19

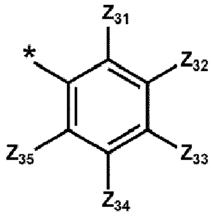
AS3-20

,

wherein, in Formulae AS3-1 to AS3-20,

$Z_{31}$ to $Z_{35}$ may each be the same as described with respect to $T_3$, wherein $Z_{31}$ to $Z_{35}$ may each not be hydrogen, and

*indicates a binding site to ring $CY_{11}$.

In one or more embodiments, in Formula 1,

i) c2 and c3 may be different from each other, or

ii) c2 and c3 may each not be 0, and one of c2 $T_2$(s) and one of c3 $T_3$(s) may be different from each other.

In one or more embodiments, in Formula 1,

c2 and c3 may each not be 0,

at least one of c2 $T_2$(s) may be deuterium or a deuterium-containing group, and

c3 $T_3$ may each not comprise deuterium.

In one or more embodiments, in Formula 1,

c2 and c3 may each not be 0,
at least one of c2 $T_2$(s) may be deuterium, and
at least one of c3 $T_3$(s) may be a deuterium-containing group (for example, a $C_1$-$C_{20}$ alkyl group, a fluorinated $C_1$-$C_{20}$ alkyl group, a phenyl group, a fluorinated phenyl group, a ($C_1$-$C_{20}$ alkyl)phenyl group, a biphenyl group, a fluorinated biphenyl group, a ($C_1$-$C_{20}$ alkyl)biphenyl group, a $C_3$-$C_{10}$ cycloalkyl group, a naphthyl group, a dibenzofuranyl group, or a dibenzothiophenyl group, each substituted with at least one deuterium).

In one or more embodiments, in Formula 1,

a group represented by

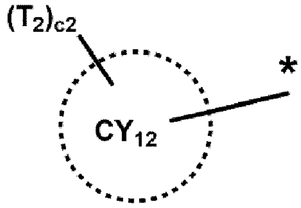

is a group represented by Formula AS2,
a group represented by

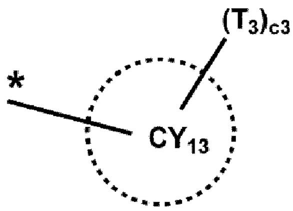

may be a group represented by Formula AS3, and
the organometallic compound represented by Formula 1 may satisfy i) Condition C1, or may satisfy ii) at least one selected from among Condition C2 to Condition C6.

Formula AS2

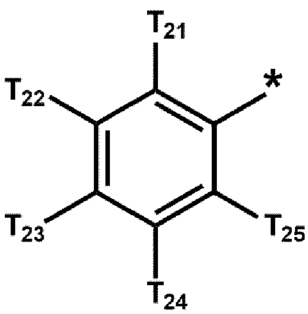

Formula AS3

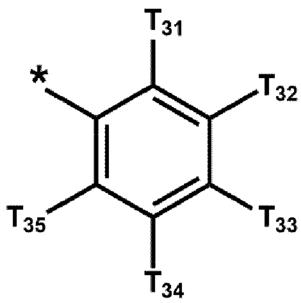

.

In Formula AS2, $T_{21}$ to $T_{25}$ may each be the same as described with respect to $T_2$, and * indicates a binding site to ring $CY_{11}$, and
in Formula AS3, $T_{31}$ to $T_{35}$ may each be the same as described with respect to $T_3$, and * indicates a binding site to ring $CY_{11}$.

**Condition C1**

The number of groups that are not hydrogen among $T_{21}$ to $T_{25}$ in Formula AS2 and the number of groups that

are not hydrogen among $T_{31}$ to $T_{35}$ in Formula AS3 are different from each other.

**Condition C2**

$T_{21}$ and $T_{31}$ are different from each other.

**Condition C3**

$T_{22}$ and $T_{32}$ are different from each other.

**Condition C4**

$T_{23}$ and $T_{33}$ are different from each other.

**Condition C5**

$T_{24}$ and $T_{34}$ are different from each other.

**Condition C6**

$T_{25}$ and $T_{35}$ are different from each other.

In one or more embodiments, $T_{21}$ to $T_{25}$ in Formula AS2 may each not be hydrogen, and Formula AS3 may satisfy Condition D1 or Condition D2.

**Condition D1**

Each of $T_{31}$, $T_{33}$, and $T_{35}$ is hydrogen, and each of $T_{32}$ and $T_{34}$ is not hydrogen.

**Condition D2**

Each of $T_{31}$, $T_{33}$, $T_{34}$, and $T_{35}$ is hydrogen, and $T_{32}$ is not hydrogen.

In Formula 1, i) two or more of a1 $R_1$(s) when a1 is two or more, ii) two or more of a2 $R_2$(s) when a2 is two or more, iii) two or more of $R_{41}$ to $R_{44}$, and iv) two or more of $R_1$ to $R_3$, $R_{41}$ to $R_{44}$, $Z_{51a}$, $Z_{51b}$, $Z_{52a}$, and $Z_{52b}$ may each optionally be bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$. In other words, in Formula 1, i) two or more of a1 $R_1$(s) when a1 is two or more may optionally be bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$, ii) two or more of a2 $R_2$(s) when a2 is two or more may optionally be bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$, iii) two or more of $R_{41}$ to $R_{44}$ may optionally be bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$, and iv) two or more of $R_1$ to $R_3$, $R_{41}$ to $R_{44}$, $Z_{51a}$, $Z_{51b}$, $Z_{52a}$, and $Z_{52b}$ may optionally bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$.

In Formula 1, two or more of a3 $R_3$(s) when a3 is two or more may not be linked together, and two or more of $T_1$ to $T_3$ may not be linked together.

In one or more embodiments, the organometallic compound represented by Formula 1 may be an organometallic compound represented by Formula 1-1 or an organometallic compound represented by Formula 1-2:

Formula 1-1

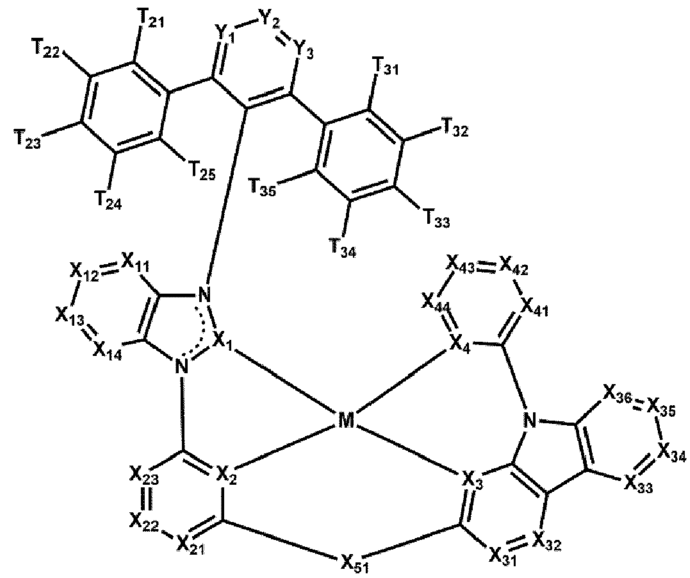

Formula 1-2

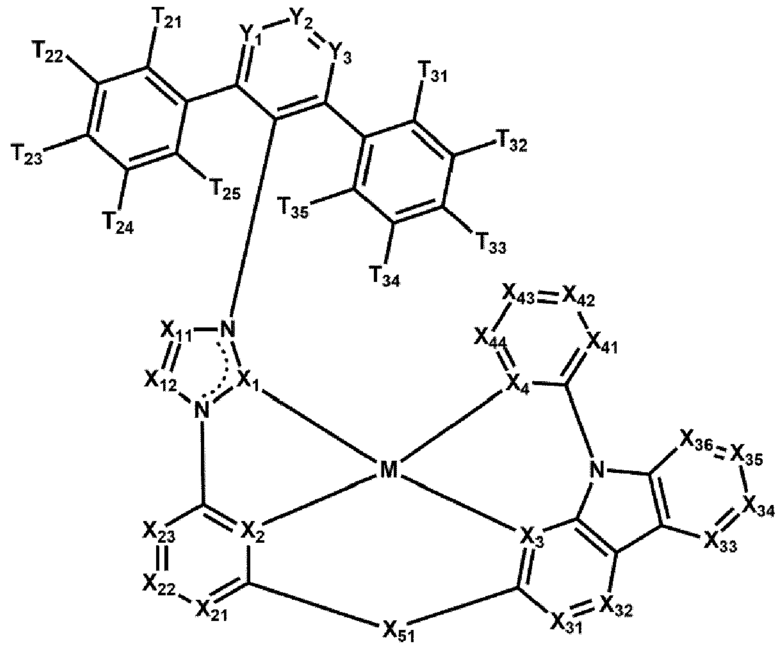

,

wherein, in Formulae 1-1 and 1-2,

M, $X_1$ to $X_4$, $X_{41}$ to $X_{44}$, and $X_5$, may respectively be the same as those described in the present disclosure,

$X_{11}$ may be C($R_{11}$) or N, $X_{12}$ may be C($R_{12}$) or N, $X_{13}$ may be C($R_{13}$) or N, and $X_{14}$ may be C($R_{14}$) or N,

$R_{11}$ to $R_{14}$ may each be the same as described with respect to $R_1$, and two or more of $R_{11}$ to $R_{14}$ may optionally be bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,

$X_2$, may be C($R_{21}$) or N, $X_{22}$ may be C($R_{22}$) or N, and $X_{23}$ may be C($R_{23}$) or N,

$R_{21}$ to $R_{23}$ may each be the same as described with respect to $R_2$, and two or more of $R_{21}$ to $R_{23}$ may optionally be bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,

$X_{31}$ may be C($R_{31}$) or N, $X_{32}$ may be C($R_{32}$) or N, $X_{33}$ may be C($R_{33}$) or N, $X_{34}$ may be C($R_{34}$) or N, $X_{35}$ may be C($R_{35}$) or N, and $X_{36}$ may be C($R_{36}$) or N,

$R_{31}$ to $R_{36}$ may each be the same as described with respect to $R_3$, and two or more of $R_{31}$ to $R_{36}$ may not be linked

together,
$Y_1$ may be $C(T_{11})$ or N, $Y_2$ may be $C(T_{12})$ or N, and $Y_3$ may be $C(T_{13})$ or N,
$T_{11}$ to $T_{13}$ may each be the same as described with respect to $T_1$,
$T_{21}$ to $T_{25}$ may each be the same as described with respect to $T_2$,
$T_{31}$ to $T_{35}$ may each be the same as described with respect to $T_3$,
two or more of $T_{11}$ to $T_{13}$, $T_{21}$ to $T_{25}$, and $T_{31}$ to $T_{35}$ may not be linked together, and
a group represented by

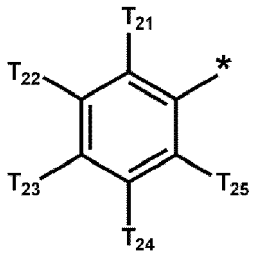

and a group represented by

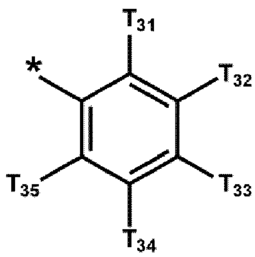

may be different from each other.

All descriptions of Formula 1 may be applied to Formulae 1-1 and 1-2.

In one or more embodiments, $X_{34}$ in Formulae 1-1 and 1-2 may be $C(R_{34})$, and $R_{34}$ may not be hydrogen.

In one or more embodiments, in Formulae 1-1 and 1-2, $X_{11}$ may be $C(R_{11})$, $X_{12}$ may be $C(R_{12})$, $X_{13}$ may be $C(R_{13})$, $X_{14}$ may be $C(R_{14})$, $X_{21}$ may be $C(R_{21})$, $X_{22}$ may be $C(R_{22})$, $X_{23}$ may be $C(R_{23})$, $X_{31}$ may be $C(R_{31})$, $X_{32}$ may be $C(R_{32})$, $X_{33}$ may be $C(R_{33})$, $X_{34}$ may be $C(R_{34})$, $X_{35}$ may be $C(R_{35})$, $X_{36}$ may be $C(R_{36})$, $Y_1$ may be $C(T_{11})$, $Y_2$ may be $C(T_{12})$, and $Y_3$ may be $C(T_{13})$, and
each of Formulae 1-1 and 1-2 may satisfy at least one selected from among Condition E1 to Condition E7.

Condition E1

At least one selected from among $R_{11}$ to $R_{14}$ in Formula 1-1 is deuterium or a deuterium-containing group, and at least one selected from among $R_{11}$ and $R_{12}$ in Formula 1-2 is deuterium or a deuterium-containing group.

**Condition E2**

At least one selected from among $R_{21}$ to $R_{23}$ is deuterium or a deuterium-containing group.

**Condition E3**

At least one selected from among $R_{31}$ to $R_{36}$ is deuterium or a deuterium-containing group.

**Condition E4**

At least one selected from among $R_{41}$ to $R_{44}$ is deuterium or a deuterium-containing group.

**Condition E5**

At least one selected from among $T_{11}$ to $T_{13}$ is deuterium or a deuterium-containing group.

**Condition E6**

At least one selected from among $T_{21}$ to $T_{25}$ is deuterium or a deuterium-containing group.

**Condition E7**

At least one selected from among $T_{31}$ to $T_{35}$ is deuterium or a deuterium-containing group.

In one or more embodiments, in Formulae 1-1 and 1-2, at least one selected from among $T_{21}$ to $T_{25}$ is deuterium or a deuterium-containing group, and $T_{31}$ to $T_{35}$ may each not comprise deuterium.

In one or more embodiments, in Formulae 1-1 and 1-2, at least one selected from among $T_{21}$ to $T_{25}$ is deuterium, and at least one selected from among $T_{31}$ to $T_{35}$ is a deuterium-containing group (for example, a $C_1$-$C_{20}$ alkyl group, a fluorinated $C_1$-$C_{20}$ alkyl group, a phenyl group, a fluorinated phenyl group, a ($C_1$-$C_{20}$ alkyl)phenyl group, a biphenyl group, a fluorinated biphenyl group, a ($C_1$-$C_{20}$ alkyl)biphenyl group, a $C_3$-$C_{10}$ cycloalkyl group, a naphthyl group, a dibenzofuranyl group, or a dibenzothiophenyl group, each substituted with at least one deuterium).

In one or more embodiments, a group represented by

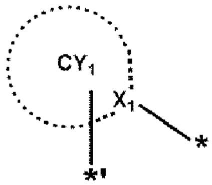

in Formula 1 may be a group represented by one selected from Formulae CY1-1 to CY1-42:

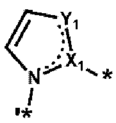
CY1-1

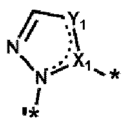
CY1-2

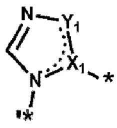
CY1-3

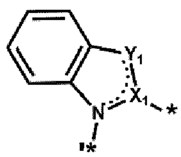
CY1-4

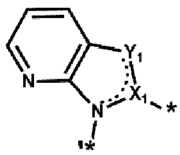
CY1-5

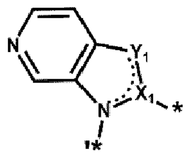
CY1-6

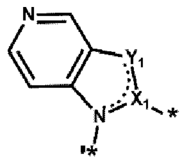
CY1-7

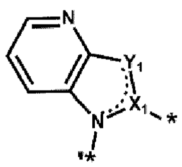
CY1-8

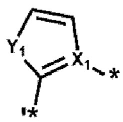
CY1-9

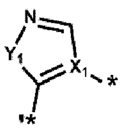
CY1-10

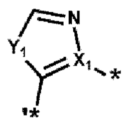
CY1-11

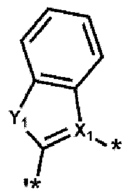
CY1-12

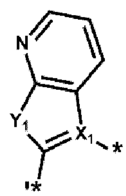
CY1-13

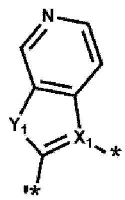
CY1-14

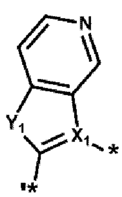
CY1-15

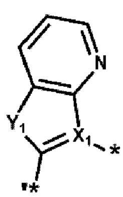
CY1-16

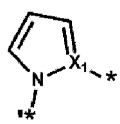
CY1-17

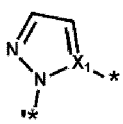
CY1-18

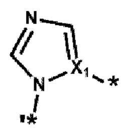
CY1-19

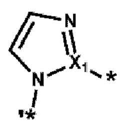
CY1-20

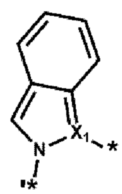
CY1-21

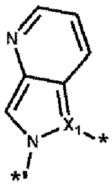
CY1-22
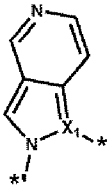
CY1-23
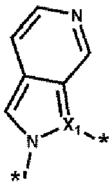
CY1-24
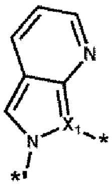
CY1-25
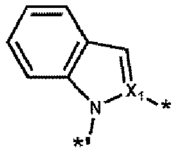
CY1-26
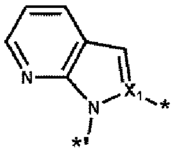
CY1-27
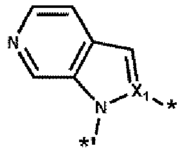
CY1-28

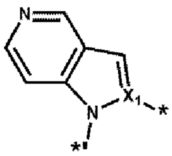
CY1-29
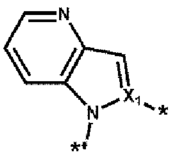
CY1-30
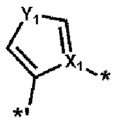
CY1-31
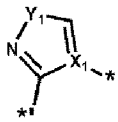
CY1-32
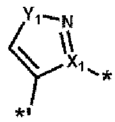
CY1-33
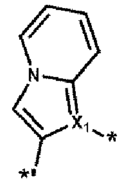
CY1-34
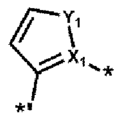
CY1-35

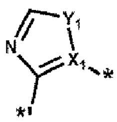
CY1-36
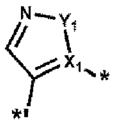
CY1-37
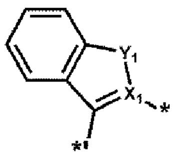
CY1-38
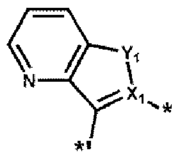
CY1-39
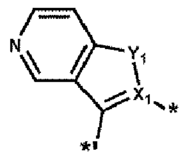
CY1-40
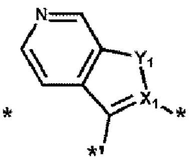
CY1-41
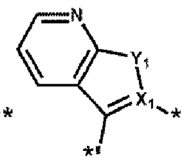
CY1-42
,

wherein, in Formulae CY1-1 to CY1-42,
$X_1$ may be the same as described in the present disclosure,
$Y_1$ may comprise O, S, N, C, or Si,
* indicates a binding site to M in Formula 1, and
*' indicates a binding site to a neighboring atom in Formula 1, such as to ring $CY_2$ in Formula 1.

For example, in one or more embodiments, $X_1$ in Formulae CY1-1 to CY1-8 may be C, and $X_1$ in Formulae CY1-9 to CY1-42 may be N.

In one or more embodiments, a group represented by

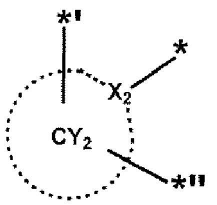

in Formula 1 may be a group represented by one selected from Formulae CY2-1 to CY2-11:

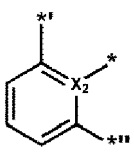
CY2-1
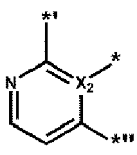
CY2-2
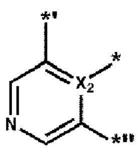
CY2-3
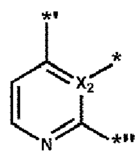
CY2-4
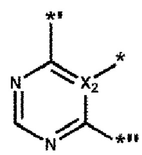
CY2-5
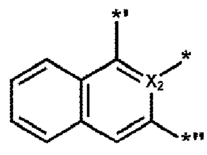
CY2-6

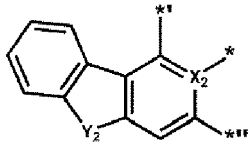
CY2-7

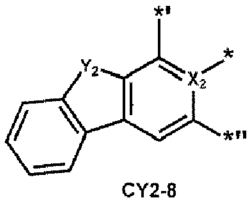
CY2-8

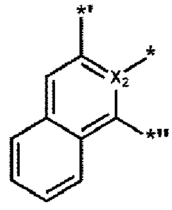
CY2-9

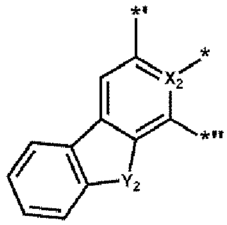
CY2-10

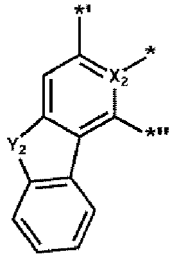
CY2-11

wherein, in Formulae CY2-1 to CY2-11,
$X_2$ may be the same as described in the present disclosure,
$Y_2$ may comprise O, S, N, C, or Si,
* indicates a binding site to M in Formula 1,
*' indicates a binding site to ring $CY_1$ in Formula 1, and
*" indicates a binding site to $X_{51}$ in Formula 1.

In one or more embodiments, a group represented by

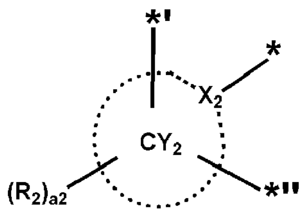

in Formula 1 and a group represented by

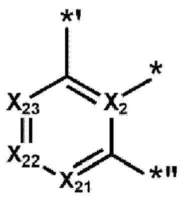

in Formulae 1-1 and 1-2 may each independently be a group represented by one selected from among Formulae CY2(1) to CY2(26):

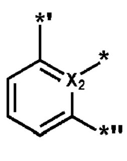
CY2(1)

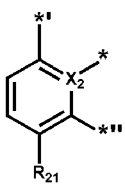
CY2(2)

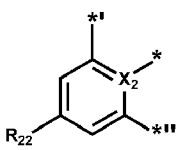
CY2(3)

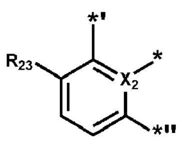
CY2(4)

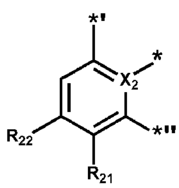
CY2(5)

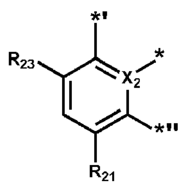
CY2(6)

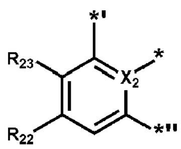
CY2(7)
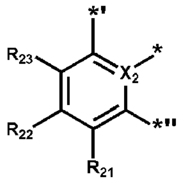
CY2(8)
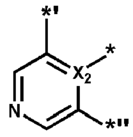
CY2(9)
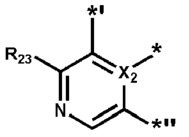
CY2(10)
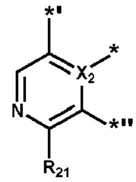
CY2(11)
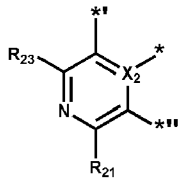
CY2(12)

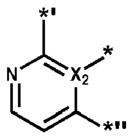
CY2(13)
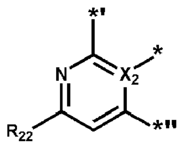
CY2(14)
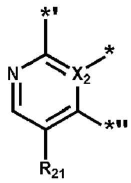
CY2(15)
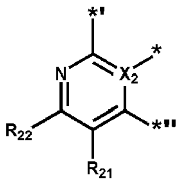
CY2(16)
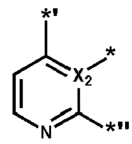
CY2(17)
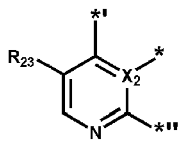
CY2(18)

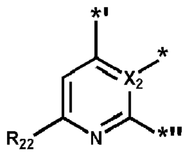
CY2(19)
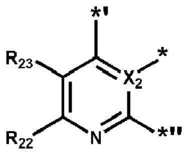
CY2(20)
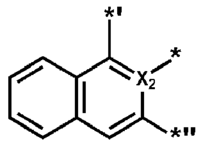
CY2(21)
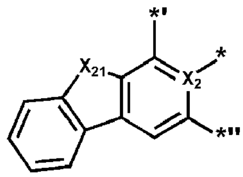
CY2(22)
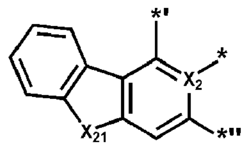
CY2(23)

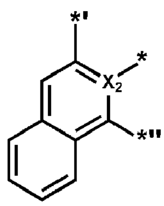
CY2(24)
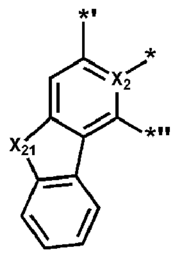
CY2(25)
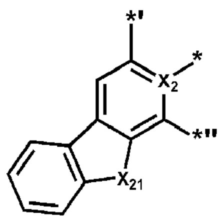
CY2(26)

wherein, in Formulae CY2(1) to CY2(26),

$X_2$ may be the same as described in the present disclosure,

$X_{21}$ may be O, S, $N(R_{20})$, $C(R_{20a})(R_{20b})$, or $Si(R_{20a})(R_{20b})$,

$R_{20}$, $R_{20a}$, $R_{20b}$, and $R_{21}$ to $R_{23}$ may each be the same as described with respect to $R_2$, wherein $R_{21}$ to $R_{23}$ may each not be hydrogen,

* indicates a binding site to M in Formula 1,

*' indicates a binding site to ring $CY_1$ in Formula 1, and

*" indicates a binding site to $X_{51}$ in Formula 1.

In one or more embodiments, a group represented by

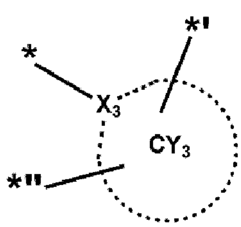

in Formula 1 may be a group represented by one selected from among Formulae CY3-1 to CY3-23:

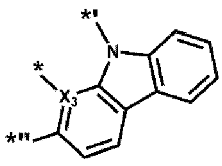
CY3-1

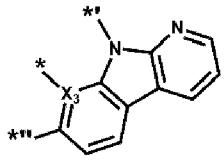
CY3-2

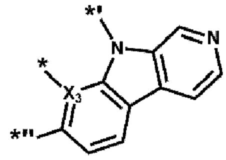
CY3-3

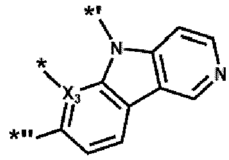
CY3-4

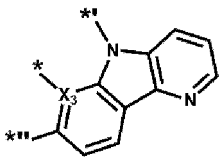
CY3-5

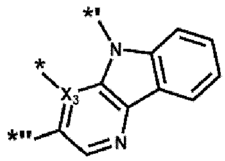
CY3-6

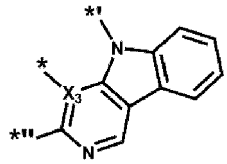
CY3-7

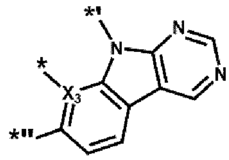
CY3-8

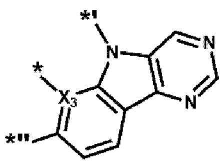
CY3-9

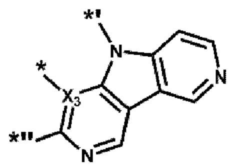
CY3-10

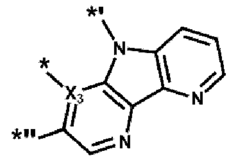
CY3-11

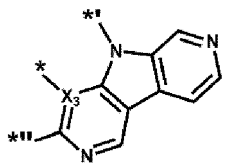
CY3-12

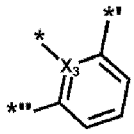
CY3-13

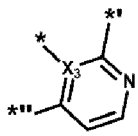
CY3-14

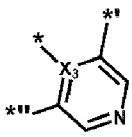
CY3-15

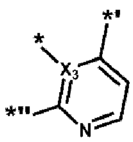
CY3-16

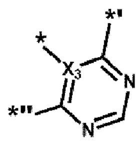
CY3-17

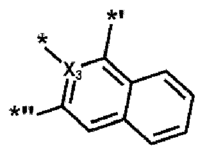
CY3-18

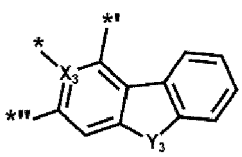
CY3-19

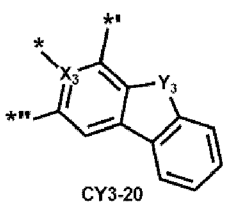
CY3-20

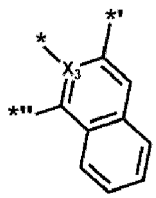
CY3-21

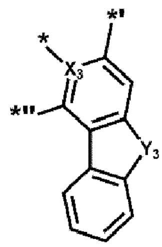
CY3-22

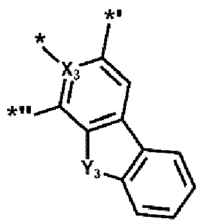
CY3-23

,

wherein, in Formulae CY3-1 to CY3-23,

$X_3$ may be the same as described in the present disclosure,

$Y_3$ may comprise O, S, N, C, or Si,

* indicates a binding site to M in Formula 1,

*' indicates a binding site to $X_{52}$ in Formula 1, and

*" indicates a binding site to $X_{51}$ in Formula 1.

In one or more embodiments, a group represented by

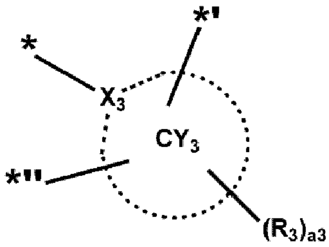

in Formula 1 may be a group represented by one selected from among Formulae CY3(1) to CY3(20), and a group represented by

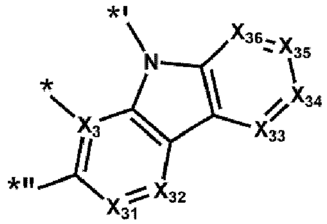

in Formulae 1-1 and 1-2 may be a group represented by one selected from among Formulae CY3(1) to CY3(12):

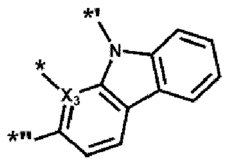

CY3(1)

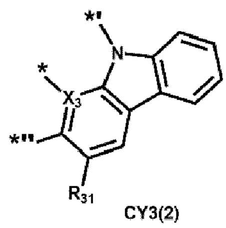

CY3(2)

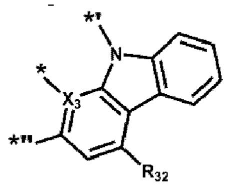

CY3(3)

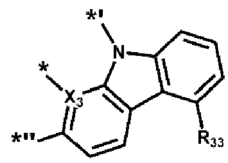

CY3(4)

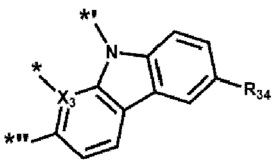

CY3(5)

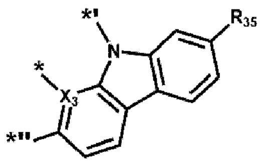

CY3(6)

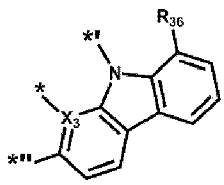

CY3(7)

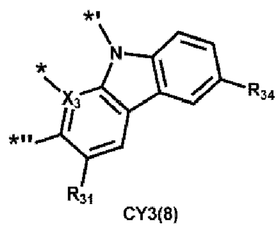

CY3(8)

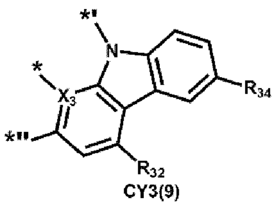

CY3(9)

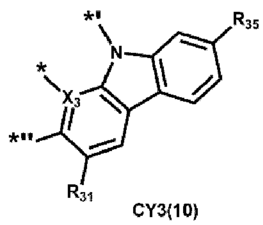

CY3(10)

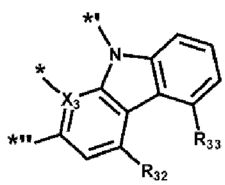

CY3(11)

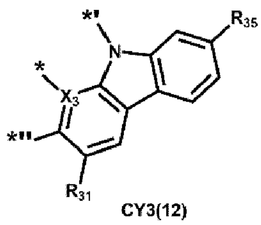

CY3(12)

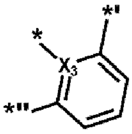

CY3(13)

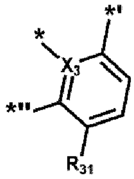

CY3(14)

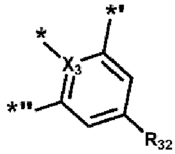

CY3(15)

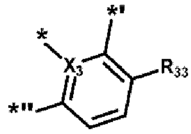

CY3(16)

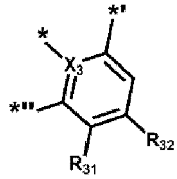

CY3(17)

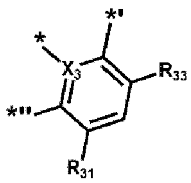
CY3(18)

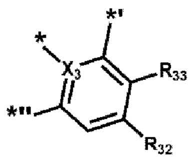
CY3(19)

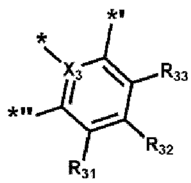
CY3(20)

wherein, in Formulae CY3(1) to CY3(20),

$X_3$ may be the same as described in the present disclosure,

$R_{31}$ to $R_{36}$ may each be the same as described with respect to $R_3$, wherein $R_{31}$ to $R_{36}$ may each not be hydrogen,

* indicates a binding site to M in Formula 1,

*' indicates a binding site to $X_{52}$ or the $X_4$-containing ring in Formula 1, and

*" indicates a binding site to $X_{51}$ in Formula 1.

A group represented by

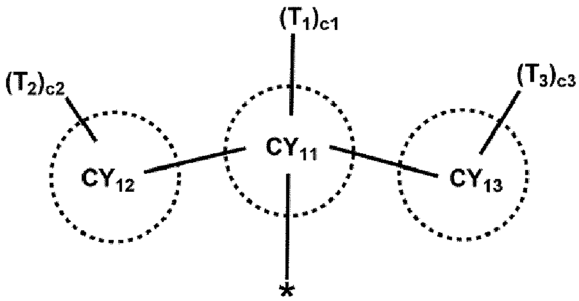

in Formula 1 may have an "asymmetric" structure comprising "three monocyclic groups linked together via a single bond" in which i) a group represented by

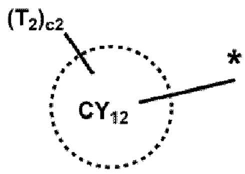

and a group represented by

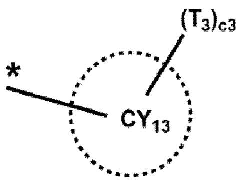

are different from each other, and ii) ring $CY_{11}$, ring $CY_{12}$, and ring $CY_{13}$ are each a $C_2$-$C_8$ monocyclic group.

**1.** Because the group represented by

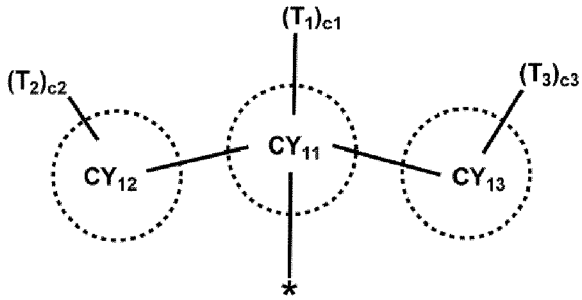

in Formula 1 has the "asymmetric" structure as described above, the transition energy (e.g., optical transition energy) in the group represented by

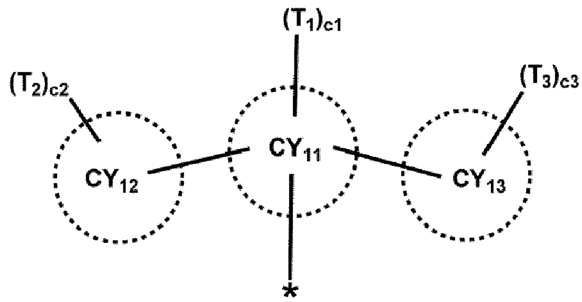

is increased (for example, increased by about 0.1 eV or more), and thus, the selective electron density in a 6-membered ring moiety comprising $X_4$ and $X_{41}$ to $X_{44}$, which may be a chromophoric region in Formula 1, may be increased. Accordingly, a maximum emission wavelength (or emission peak wavelength) of light (for example, blue light) that may be emitted from the organometallic compound represented by Formula 1 may be shifted to a relatively short wavelength, and color purity of light (for example, blue light) that may be emitted from the organometallic compound represented by Formula 1 may be increased.

2. In addition, because the group represented by

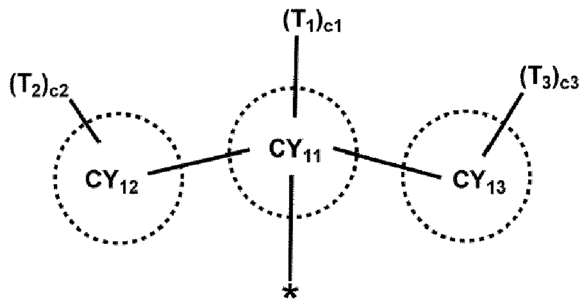

in Formula 1 has the "asymmetric" structure as described above,

in Formula 1, the strength of at least one chemical bond selected from among i) a bond between an atom bonded to ring $CY_{11}$ and $X_1$ in ring $CY_1$ (for example, a first bond between a nitrogen atom represented by "$N_1$" and $X_1$ in Formula 1-1'), ii) a bond between $X_1$ and an atom bonded to ring $CY_2$ in ring $CY_1$ (for example, a second bond between $X_1$ and a nitrogen atom represented by "$N_2$" in Formula 1-1'), iii) a bond between an atom bonded to ring $CY_2$ in ring $CY_1$ and an atom bonded to ring $CY_1$ in ring $CY_2$ (for example, a third bond between a nitrogen atom represented by "$N_2$" and a carbon atom represented by "$C_1$" in Formula 1-1'), and iv) a bond between an atom bonded to ring $CY_1$ in ring $CY_2$ and $X_2$ in ring $CY_2$ (for example, a fourth bond between a carbon atom represented by "$C_1$" and $X_2$ in Formula 1-1') is relatively increased, and thus,

in Formula 1, the length of at least one selected from among a) a distance between an atom bonded to ring $CY_{11}$ and $X_1$ in ring $CY_1$ (for example, a first distance between a nitrogen atom represented by "$N_1$" and $X_1$ in Formula 1-1'), b) a distance between $X_1$ and an atom bonded to ring $CY_2$ in ring $CY_1$ (for example, a second distance between $X_1$ and a nitrogen atom represented by "$N_2$" in Formula 1-1'), c) a distance between an atom bonded to ring $CY_2$ in ring

$CY_1$ and an atom bonded to ring $CY_1$ in ring $CY_2$ (for example, a third distance between a nitrogen atom represented by "$N_2$" and a carbon atom represented by "$C_1$" in Formula 1-1'), and d) a distance between an atom bonded to ring $CY_1$ in ring $CY_2$ and $X_2$ in ring $CY_2$ (for example, a fourth distance between a carbon atom represented by "$C_1$" and $X_2$ in Formula 1-1') may be relatively decreased.

As a result, in the excited triplet energy state of the organometallic compound represented by Formula 1, a dihedral angle (hereinafter, referred to as "dihedral angle A") between a plane to which a group represented by

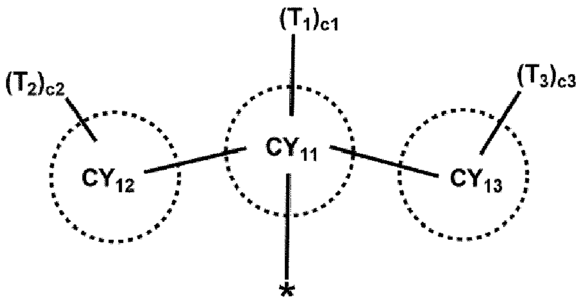

belongs (for example, a plane to which a group represented by

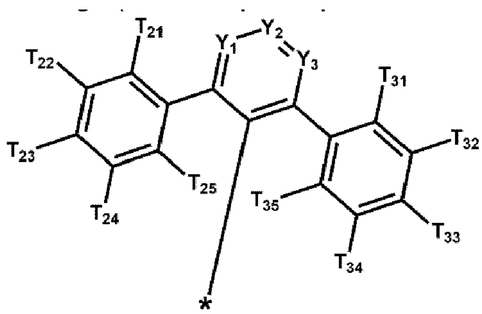

in Formula 1-1' belongs) and a plane comprising ring $CY_1$ (for example, a plane to which a group represented by

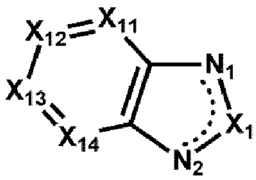

in Formula 1-1' belongs) is relatively reduced, and thus distortion between the planes may be minimized or reduced.

Table 1 summarizes the dihedral angle A, the first distance, and the sum of the first and second distances of each of Compounds BD16, BD02, and BD10. The dihedral angle A, the first distance, and the second distance may each be the same as described in connection with Formula 1-1'.

Table 1

| | BD16 | BD02 | BD10 |
|---|---|---|---|
| Dihedral angle A (°) | 69.483 | 70.105 | 70.046 |
| First distance (Å) | 1.39230 | 1.39082 | 1.38911 |
| Sum of the first and second distances (Å) | 2.21164 | 2.20942 | 2.20748 |

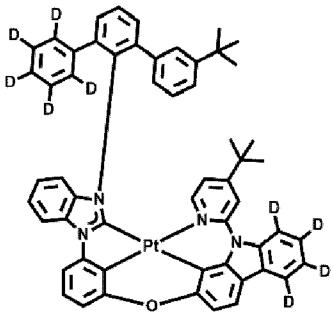

BD16

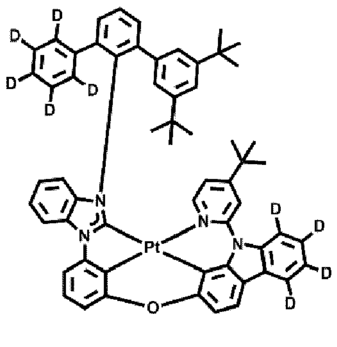

BD02

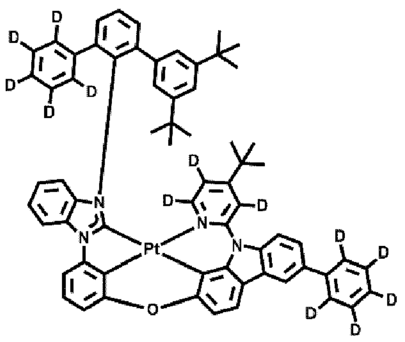

BD10

The dihedral angle A, the first distance, and the sum of the first and second distances of each of Compounds BD16, BD02, and BD10 are evaluated by performing density functional theory (DFT) calculation by utilizing Opt/Freq/TD calculation after optimizing each molecular structure (see the following molecular structure) by utilizing B3LYP/6-31 1g(d,p) function with respect to C, H, O, and N and utilizing B3LYP/LANL2DZ function with respect to Pt.

BD16 BD02 BD10

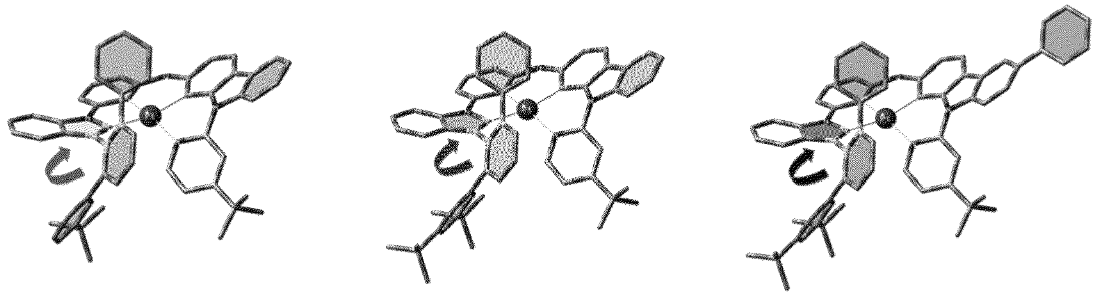

Accordingly, because the stability of ring $CY_1$ comprising $X_1$ in Formula 1 may be significantly increased, the stability of the entire organometallic compound represented by Formula 1 may also be increased, and thus, the lifespan of a light-emitting device comprising the organometallic compound represented by Formula 1 may be increased.

## Formula 1-1'

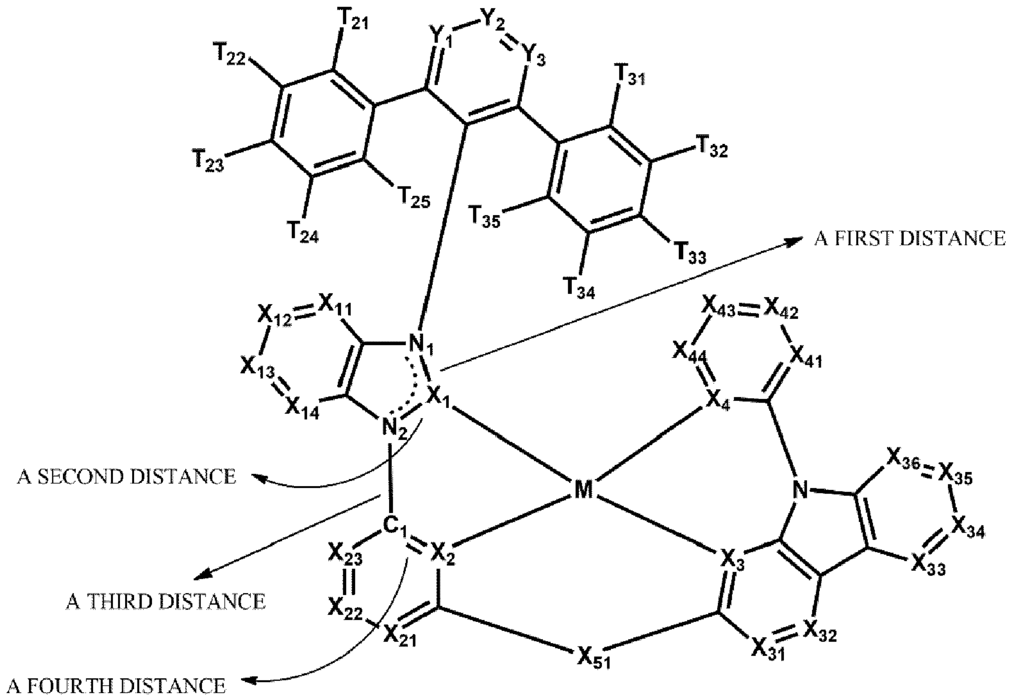


3. Furthermore, because the group represented by

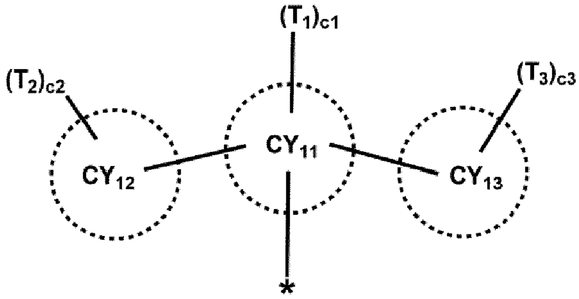

in Formula 1 has the "asymmetric" structure as described above, the steric shielding effect (SSE), which is a stereoscopic effect, in the group represented by

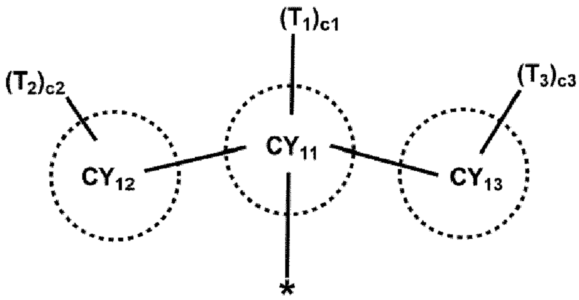

is enhanced, and thus, formation of excimer and/or formation of exciplex with a host material in a light-emitting device comprising the organometallic compound may be substantially suppressed or reduced. As a result, the internal quantum efficiency of the light-emitting device may be increased, and excellent or suitable color purity may be effectively maintained.

**4.** Finally, because the group represented by

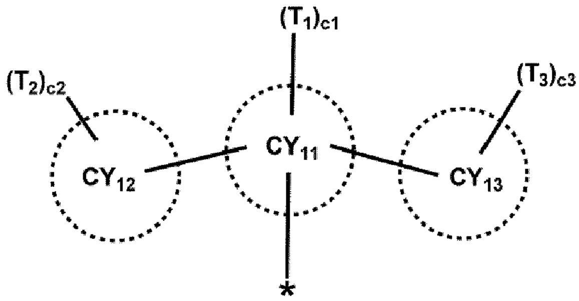

in Formula 1 has the "asymmetric" structure as described above, the organometallic compound represented by Formula 1 may have significantly increased processibility and heat resistance, which may be clearly found from Evaluation Example 4 (phase transition temperature evaluation), Evaluation Example 5 (evaluation of amount of change in purity), and Evaluation Example 8 (evaluation of rates of change in luminescence efficiency and change in lifespan after heat treatment) of the present disclosure.

For example, a temperature at a vaporization pressure, for example, at a pressure of about 5.0 x $10^{-5}$ torr to about 1.0 x $10^{-3}$ torr (as another example, 6.4 x $10^{-4}$ torr), of the organometallic compound (that is, a vaporization temperature of the organometallic compound or a phase transition temperature of the organometallic compound) may be 320 °C or less, for example, about 250 °C to about 320 °C, about 260 °C to about 320 °C, about 270 °C to about 320 °C , about 250 °C to about 310 °C, about 260 °C to about 310 °C , about 270 °C to about 310 °C, about 250 °C to about 305 °C, about 260 °C to about 305 °C , or about 270 °C to about 305 °C.

In one or more embodiments, the organometallic compound may have a purity change amount after heat treatment of about -3.0 % to about 0 %, about -2.0 % to about 0 %, about -1.0 % to about 0 %, about -0.5 % to about 0 %, about -0.4 % to about 0 %, about -0.208 % to about 0 %, about -3.0 % to about -0.002 %, about -2.0 % to about -0.002 %, about -1.0 % to about -0.002 %, about -0.5 % to about -0.002 %, about -0.4 % to about -0.002 %, or about -0.208 % to about -0.002 %. In this regard, the purity change amount (%) after heat treatment of the organometallic compound is evaluated by the following Equation P:

**Equation P**

Purity change amount (%) after heat treatment of organometallic compound =

P(360Hr) - P(0Hr)

wherein, in Equation P,

P(0Hr) is the purity of the organometallic compound before heat treatment, evaluated utilizing high performance liquid chromatography (HPLC), and

P(360Hr) is the purity of the organometallic compound heat-treated for 360 hours in a chamber in which an internal temperature at a vaporization pressure (at 6.4 x $10^{-4}$ torr) are maintained, evaluated utilizing HPLC.

In one or more embodiments, b51 to b53 in Formula 2 indicate numbers of $L_{51}$ to $L_{53}$, respectively, and may each be an integer selected from 1 to 5. When b51 is 2 or more, two or more $L_{51}(_s)$ may be identical to or different from each other, when b52 is 2 or more, two or more $L_{52}$(s) may be identical to or different from each other, and when b53 is 2 or more, two or more $L_{53}$(s) may be identical to or different from each other. For example, b51 to b53 may each independently be 1 or 2.

$L_{51}$ to $L_{53}$ in Formula 2 may each independently be:

a single bond; or

a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole

group, an oxadiazole group, a thiadiazole group, a benzopyrazole group, a benzimidazole group, a benzoxazole group, a benzothiazole group, a benzoxadiazole group, a benzothiadiazole group, a dibenzooxacilline group, a dibenzothiacilline group, a dibenzodihydroazacilline group, a dibenzodihydrodicilline group, a dibenzodihydrocilline group, a dibenzodioxane group, a dibenzooxathiene group, a dibenzooxazine group, a dibenzopyran group, a dibenzodithiine group, a dibenzothiazine group, a dibenzothiopyran group, a dibenzocyclohexadiene group, a dibenzodihydropyridine group, or a dibenzodihydropyrazine group, each unsubstituted or substituted with deuterium, -F, -Cl, -Br, -I, a hydroxyl group, a cyano group, a nitro group, a $C_1$-$C_{20}$ alkyl group, a $C_1$-$C_{20}$ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -O($Q_{31}$), -S($Q_{31}$), - Si($Q_{31}$)($Q_{32}$)($Q_{33}$), -N($Q_{31}$)($Q_{32}$), -B($Q_{31}$)($Q_{32}$), -P($Q_{31}$)($Q_{32}$), -C(=O)($Q_{31}$), -S(=O)$_2$($Q_{31}$), - P(=O)($Q_{31}$)($Q_{32}$), or any combination thereof, and

$Q_{31}$ to $Q_{33}$ may each independently be hydrogen, deuterium, a $C_1$-$C_{20}$ alkyl group, a $C_1$-$C_{20}$ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, in Formula 2, a bond between $L_{51}$ and $R_{51}$, a bond between $L_{52}$ and $R_{52}$, a bond between $L_{53}$ and $R_{53}$, a bond between two or more $L_{51}$(s), a bond between two or more $L_{52}$(s), a bond between two or more $L_{53}$(s), a bond between $L_{51}$ and carbon between $X_{54}$ and $X_{55}$ in Formula 2, a bond between $L_{52}$ and carbon between $X_{54}$ and $X_{56}$ in Formula 2, and a bond between $L_{53}$ and carbon between $X_{55}$ and $X_{56}$ in Formula 2 may each be a "carbon-carbon single bond".

In Formula 2, $X_{54}$ may be N or C($R_{54}$), $X_{55}$ may be N or C($R_{55}$), $X_{56}$ may be N or C($R_{56}$), and at least one selected from among $X_{54}$ to $X_{56}$ may be N. $R_{54}$ to $R_{56}$ may each independently be the same as described in the present disclosure. In some embodiments, two or three selected from among $X_{54}$ to $X_{56}$ may be N.

$R_{51}$ to $R_{56}$, $R_{71}$ to $R_{74}$, $R_{81}$ to $R_{85}$, $R_{82a}$, $R_{82b}$, $R_{83a}$, $R_{83b}$, $R_{84a}$, $R_{84b}$, $R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ in the present disclosure may each independently be hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, a $C_6$-$C_{60}$ aryloxy group that is unsubstituted or substituted with at least one $R_{10a}$, a $C_6$-$C_{60}$ arylthio group that is unsubstituted or substituted with at least one $R_{10a}$, a $C_7$-$C_{60}$ aryl alkyl group that is unsubstituted or substituted with at least one $R_{10a}$, a $C_2$-$C_{60}$ heteroaryl alkyl group that is unsubstituted or substituted with at least one $R_{10a}$, -C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$), or-P(=O)($Q_1$)($Q_2$). $Q_1$ to $Q_3$ may respectively be the same as those described in the present disclosure.

For example, in one or more embodiments, i) $R_1$ to $R_3$, $R_{41}$, $R_{42}$, $R_{44}$, $Z_{51a}$, $Z_{51b}$, $Z_{52a}$, $Z_{52b}$, and $T_1$ to $T_3$ in Formula 1, ii) $R_{51}$ to $R_{56}$, $R_{71}$ to $R_{74}$, $R_{81}$ to $R_{85}$, $R_{82a}$, $R_{82b}$, $R_{83a}$, $R_{83b}$, $R_{84a}$ and $R_{84b}$, $R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ in Formulae 2, 3-1 to 3-5, 502, and 503, and iii) $R_{10a}$ may each independently be:

hydrogen, deuterium, -F, -Cl, -Br, -I, a hydroxyl group, a cyano group, a nitro group, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F, - Cl, -Br, -I, -$CD_3$, -$CD_2H$, -$CDH_2$, -$CF_3$, -$CF_2H$, -$CFH_2$, a hydroxyl group, a cyano group, a nitro group, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a

triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoisoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, $-O(Q_{31})$, $-S(Q_{31})$, $-Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, $-P(=O)(Q_{31})(Q_{32})$, or any combination thereof; or
$-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or $-P(=O)(Q_1)(Q_2)$, and
$Q_1$ to $Q_3$ and $Q_{31}$ to $Q_{33}$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$; or
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a $C_1$-$C_{10}$ alkyl group, a phenyl group, a biphenyl group, a pyridinyl group, a pyrimidinyl group, a pyridazinyl group, a pyrazinyl group, a triazinyl group, or any combination thereof:

**Formula 91**

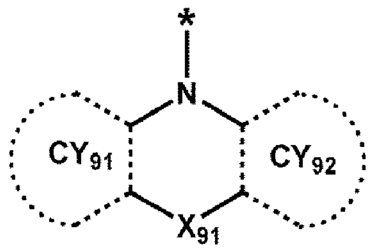
,

wherein, in Formula 91,
ring $CY_{91}$ and ring $CY_{92}$ may each independently be a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$,
$X_{91}$ may be a single bond, O, S, $N(R_{91})$, $B(R_{91})$, $C(R_{91a})(R_{91b})$, or $Si(R_{91a})(R_{91b})$,
$R_{91}$, $R_{91a}$, and $R_{91b}$ may be the same as described with respect to $R_{82}$, $R_{82a}$, and $R_{82b}$, respectively,
$R_{10a}$ may be the same as described in the present disclosure, and
* indicates a binding site to a neighboring atom.

For example, in one or more embodiments, in Formula 91,

ring $CY_{91}$ and ring $CY_{92}$ may each independently be a benzene group, a pyridine group, a pyrimidine group, a pyrazine group, a pyridazine group, or a triazine group, each unsubstituted or substituted with at least one $R_{10a}$, and
$R_{91}$, $R_{91a}$, and $R_{91b}$ may each independently be:
hydrogen or a $C_1$-$C_{10}$ alkyl group; or
a phenyl group, a pyridinyl group, a pyrimidinyl group, a pyridazinyl group, a pyrazinyl group, or a triazinyl group, each unsubstituted or substituted with deuterium, a $C_1$-$C_{10}$ alkyl group, a phenyl group, a biphenyl group, a pyridinyl group, a pyrimidinyl group, a pyridazinyl group, a pyrazinyl group, a triazinyl group, or any combination thereof.

In one or more embodiments, i) $R_1$ to $R_3$, $R_{41}$, $R_{42}$, $R_{44}$, $Z_{51a}$, $Z_{51b}$, $Z_{52a}$, $Z_{52b}$, and $T_1$ to $T_3$ in Formula 1, ii) $R_{51}$ to $R_{56}$, $R_{71}$ to $R_{74}$, $R_{81}$ to $R_{85}$, $R_{82a}$, $R_{82b}$, $R_{83a}$, $R_{83b}$, $R_{84a}$ and $R_{84b}$, $R_{500a}$, $R_{500b}$, $R_{501}$ to $R_{508}$, $R_{505a}$, $R_{505b}$, $R_{506a}$, $R_{506b}$, $R_{507a}$, $R_{507b}$, $R_{508a}$, and $R_{508b}$ in Formulae 2, 3-1 to 3-5, 502, and 503, and iii) $R_{10a}$ may each independently be hydrogen, deuterium, -F, a cyano group, a nitro group, $-CH_3$, $-CD_3$, $-CD_2H$, $-CDH_2$, $-CF_3$, $-CF_2H$, $-CFH_2$, a group represented by one selected from among Formulae 9-1 to 9-19, a group represented by one selected from among Formulae 10-1 to 10-246, $-C(Q_1)(Q_2)(Q_3)$, $-Si(Q_1)(Q_2)(Q_3)$, or $-P(=O)(Q_1)(Q_2)$ (wherein $Q_1$ to $Q_3$ are respectively the same as those described in the present disclosure):

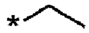
9-1
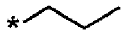
9-2
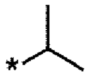
9-3
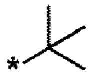
9-4
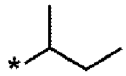
9-5
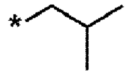
9-6
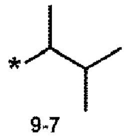
9-7

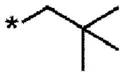
9-8
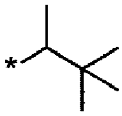
9-9
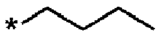
9-10
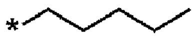
9-11
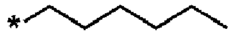
9-12

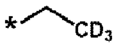
9-13
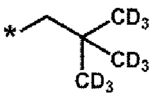
9-14
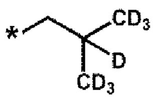
9-15
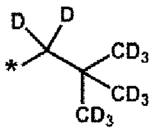
9-16
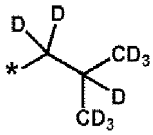
9-17
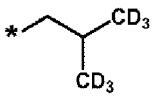
9-18

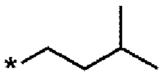
9-19

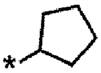
10-1
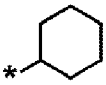
10-2
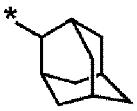
10-3
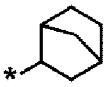
10-4
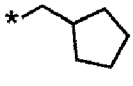
10-5
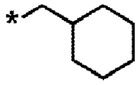
10-6
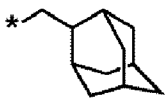
10-7

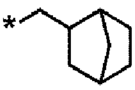
10-8
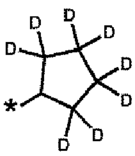
10-9
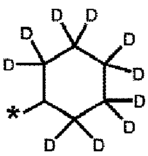
10-10
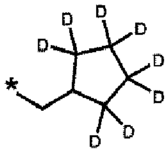
10-11
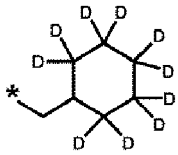
10-12
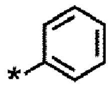
10-13

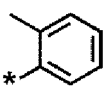
10-14
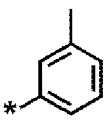
10-15
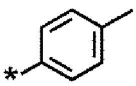
10-16
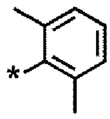
10-17
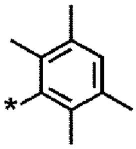
10-18
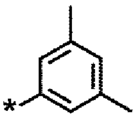
10-19
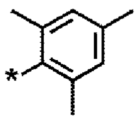
10-20

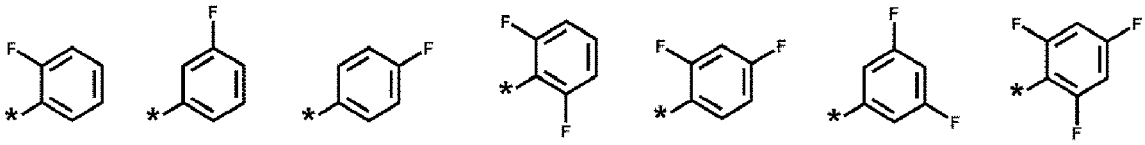
10-21 10-22 10-23 10-24 10-25 10-26 10-27

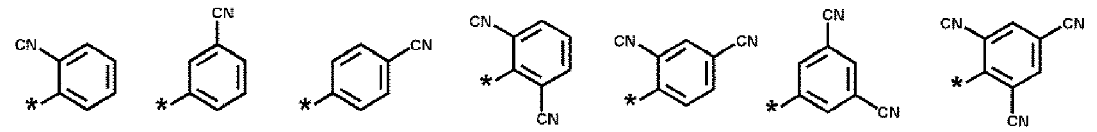
10-28 10-29 10-30 10-31 10-32 10-33 10-34

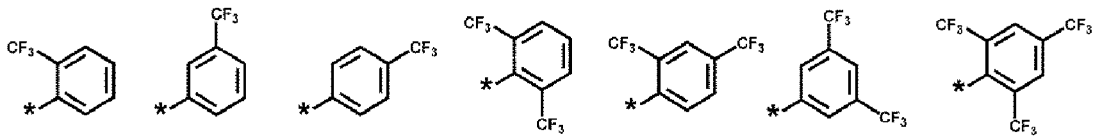
10-35 10-36 10-37 10-38 10-39 10-40 10-41

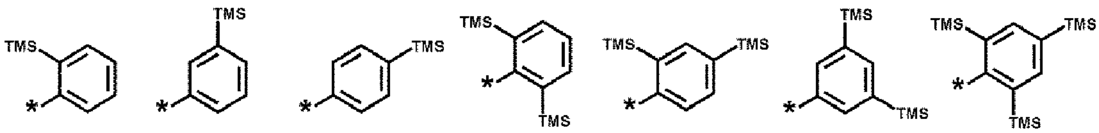
10-42 10-43 10-44 10-45 10-46 10-47 10-48

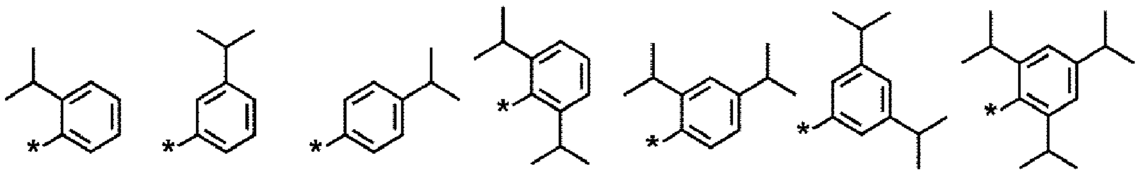
10-49 10-50 10-51 10-52 10-53 10-54 10-55

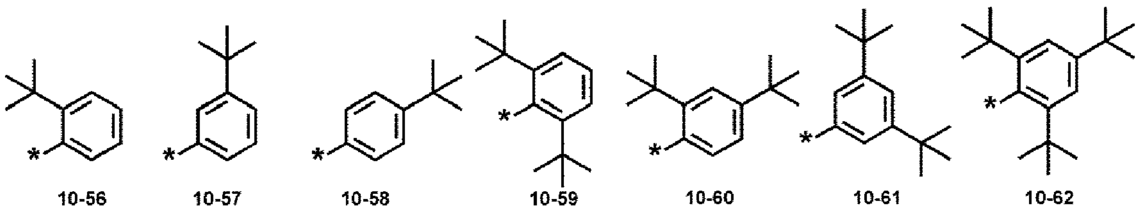
10-56 10-57 10-58 10-59 10-60 10-61 10-62

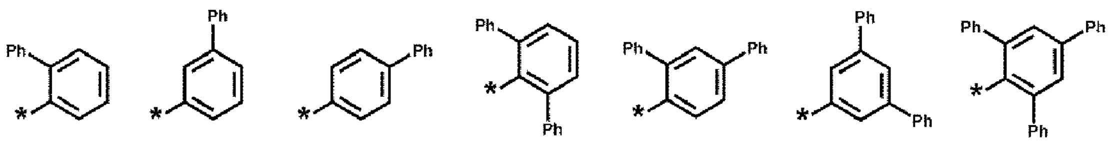
10-63 10-64 10-65 10-66 10-67 10-68 10-69

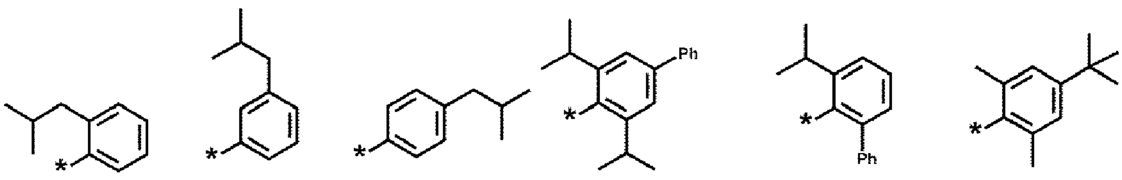
10-70 10-71 10-72 10-73 10-74 10-75

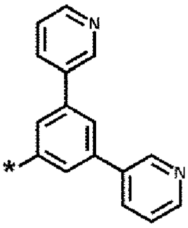
10-76
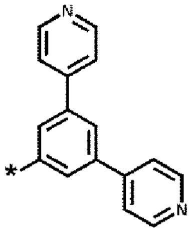
10-77
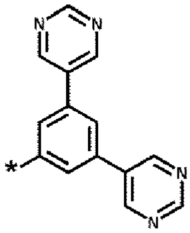
10-78
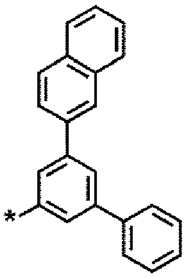
10-79
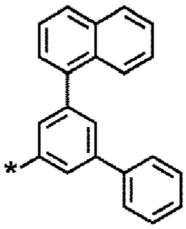
10-80

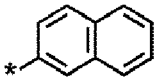
10-81
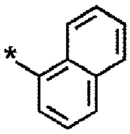
10-82
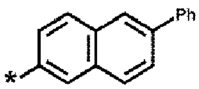
10-83
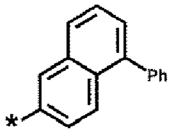
10-84
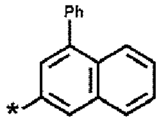
10-85

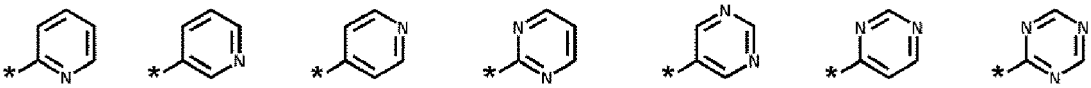
10-86 10-87 10-88 10-89 10-90 10-91 10-92

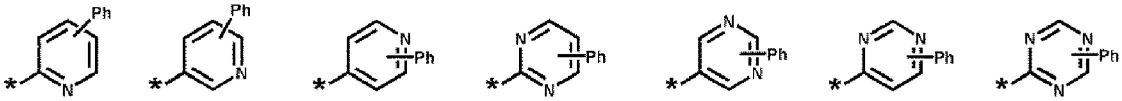
10-93 10-94 10-95 10-96 10-97 10-98 10-99

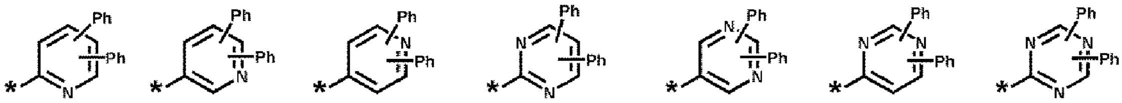
10-100 10-101 10-102 10-103 10-104 10-105 10-106

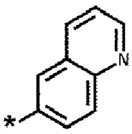
10-107
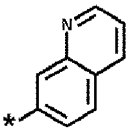
10-108
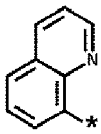
10-109
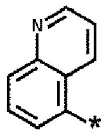
10-110
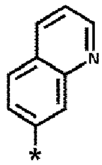
10-111
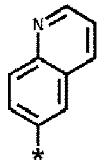
10-112

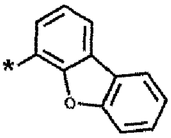
10-113
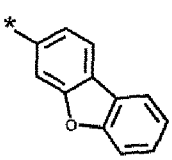
10-114
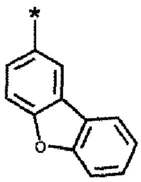
10-115
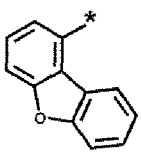
10-116
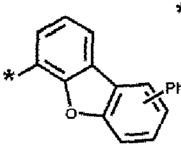
10-117
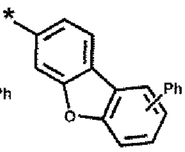
10-118

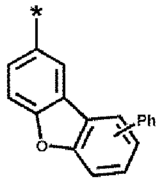
10-119

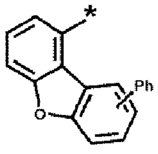
10-120

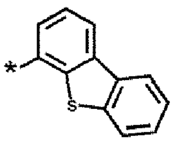
10-121

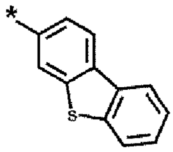
10-122

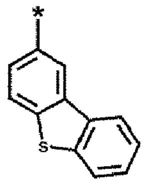
10-123

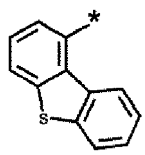
10-124

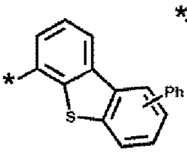
10-125

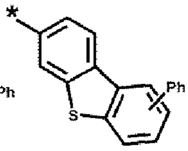
10-126

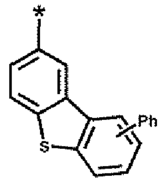
10-127

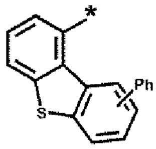
10-128

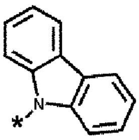
10-129

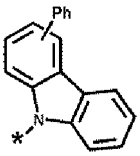
10-130

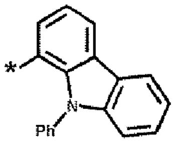
10-131

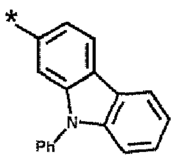
10-132

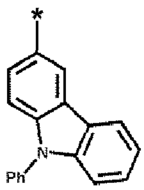
10-133

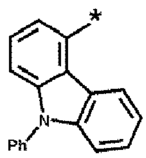
10-134

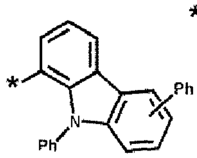
10-135

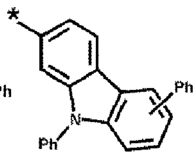
10-136

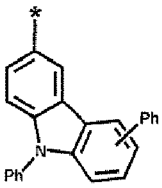
10-137

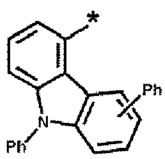
10-138

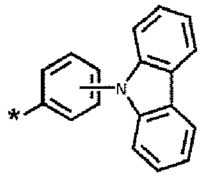
10-139

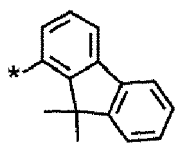
10-140

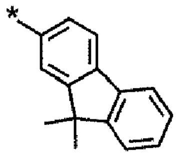
10-141

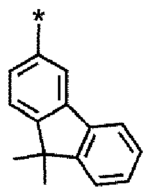
10-142

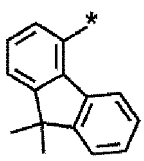
10-143

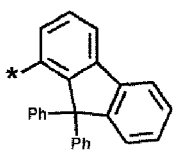
10-144

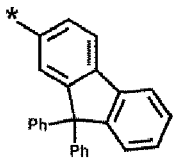
10-145

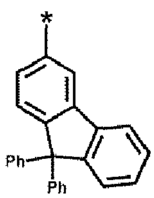
10-146

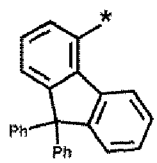
10-147

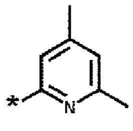
10-148

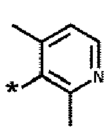
10-149

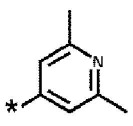
10-150

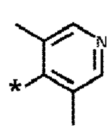
10-151

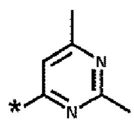
10-152

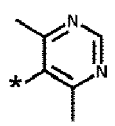
10-153

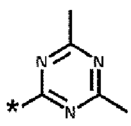
10-154

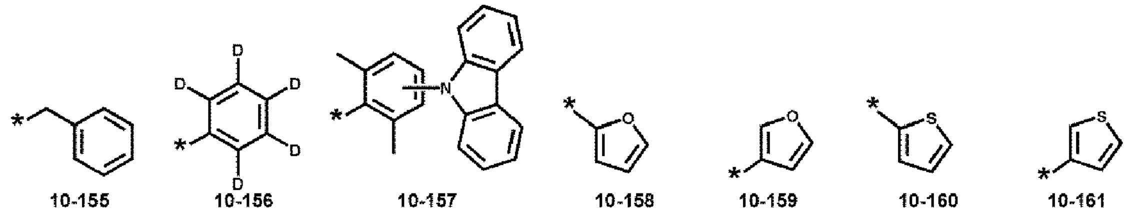

10-155 10-156 10-157 10-158 10-159 10-160 10-161

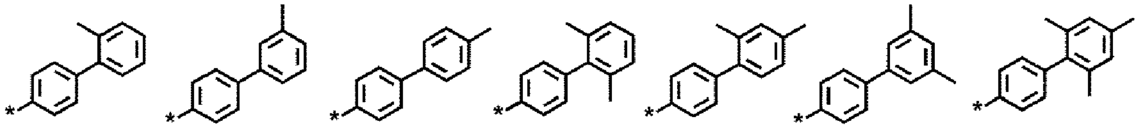

10-162 10-163 10-164 10-165 10-166 10-167 10-168

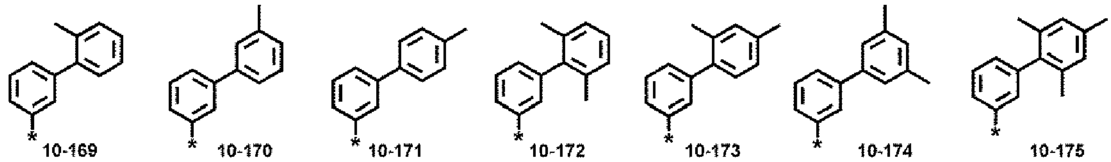

10-169 10-170 10-171 10-172 10-173 10-174 10-175

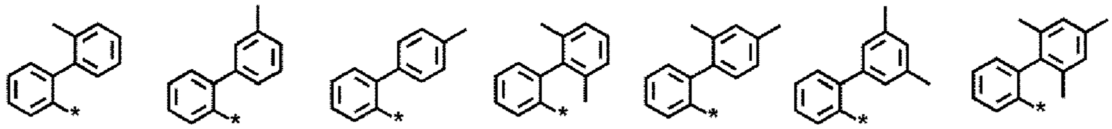

10-176 10-177 10-178 10-179 10-180 10-181 10-182

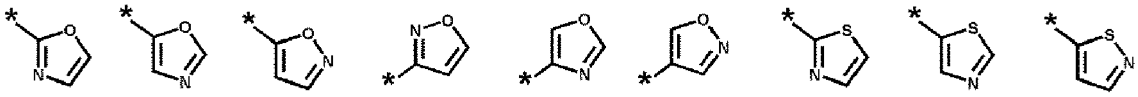

10-183 10-184 10-185 10-186 10-187 10-188 10-189 10-190 10-191

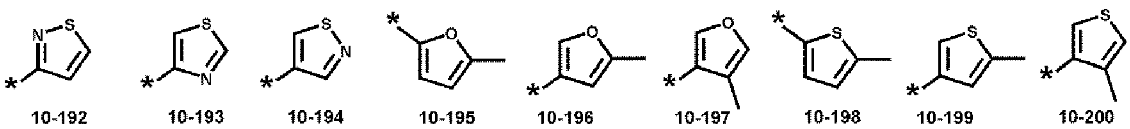

10-192 10-193 10-194 10-195 10-196 10-197 10-198 10-199 10-200

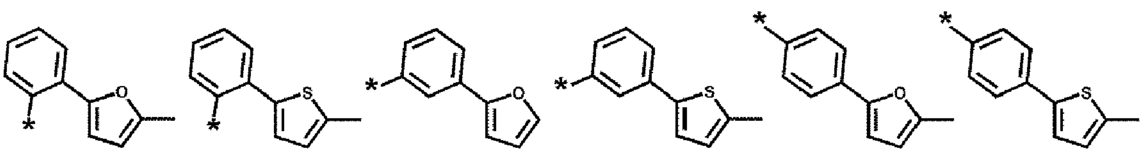

10-201 10-202 10-203 10-204 10-205 10-206

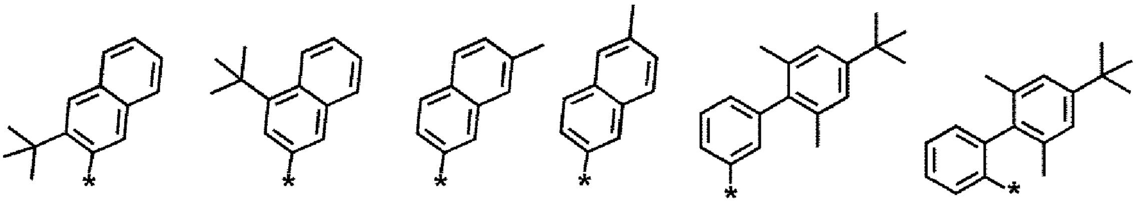

10-207 10-208 10-209 10-210 10-211 10-212

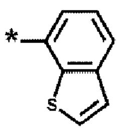
10-213
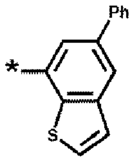
10-214
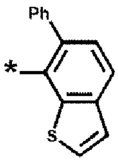
10-215
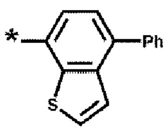
10-216
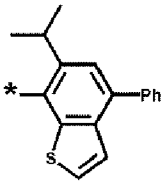
10-217
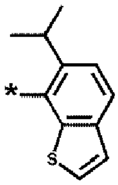
10-218
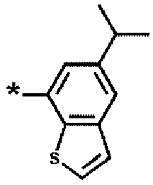
10-219

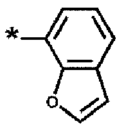
10-220
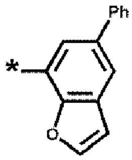
10-221
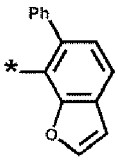
10-222
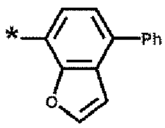
10-223
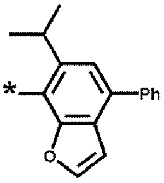
10-224
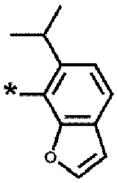
10-225
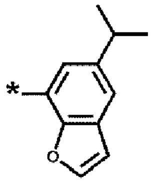
10-226

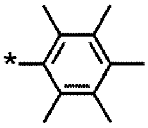
10-227
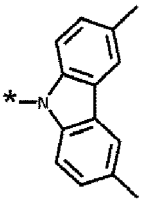
10-228
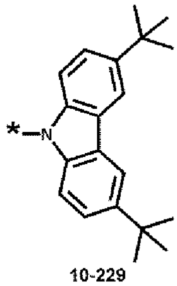
10-229
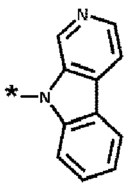
10-230
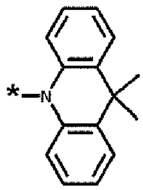
10-231
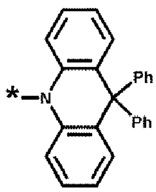
10-232
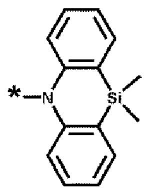
10-233

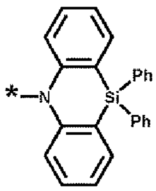
10-234
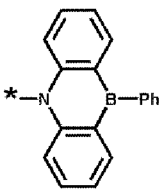
10-235
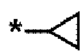
10-236
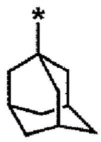
10-237
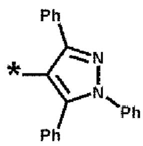
10-238
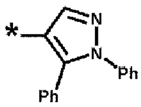
10-239
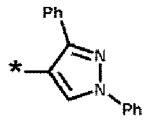
10-240

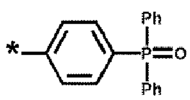
10-241
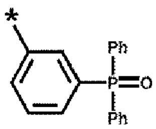
10-242
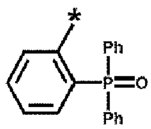
10-243
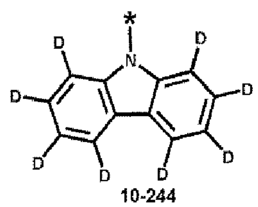
10-244
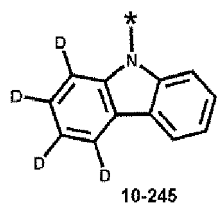
10-245

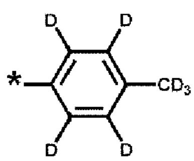
10-246 ,

wherein, in Formulae 9-1 to 9-19 and 10-1 to 10-246, "*" indicates a binding site to a neighboring atom, "Ph" represents a phenyl group, "D" represents deuterium, and "TMS" represents a trimethylsilyl group.

In Formulae 3-1 to 3-5, 502, and 503, a71 to a74 and a501 to a504 indicate numbers of $R_{71}$ to $R_{74}$ and $R_{501}$ to $R_{504}$, respectively, and may each independently be an integer selected from 0 to 20. When a71 is 2 or greater, two or more $R_{71}$(s) may be identical to or different from each other, when a72 is 2 or greater, two or more $R_{72}$(s) may be

identical to or different from each other, when a73 is 2 or greater, two or more $R_{73}$(s) may be identical to or different from each other, when a74 is 2 or greater, two or more $R_{74}$(s) may be identical to or different from each other, when a501 is 2 or greater, two or more $R_{501}$(s) may be identical to or different from each other, when a502 is 2 or greater, two or more $R_{502}$(s) may be identical to or different from each other, when a503 is 2 or greater, two or more $R_{503}$(s) may be identical to or different from each other, and when a504 is 2 or greater, two or more $R_{504}$(s) may be identical to or different from each other. In some embodiments, a71 to a74 and a501 to a504 may each independently be an integer selected from 0 to 8.

In Formula 2, a group represented by $*-(L_{51})_{b51}-R_{51}$ and a group represented by $*-(L_{52})_{b52}-R_{52}$ may each not be a phenyl group.

In one or more embodiments, a group represented by $*-(L_{51})_{b51}-R_{51}$ and a group represented by $*-(L_{52})_{b52}-R_{52}$ in Formula 2 may be identical to each other.

In one or more embodiments, a group represented by $*-(L_{51})_{b51}-R_{51}$ and a group represented by $*-(L_{52})_{b52}-R_{52}$ in Formula 2 may be different from each other.

In one or more embodiments, b51 and b52 in Formula 2 may each be 1, 2, or 3, and $L_{51}$ and $L_{52}$ may each independently be a benzene group, a pyridine group, a pyrimidine group, a pyridazine group, a pyrazine group, or a triazine group, each unsubstituted or substituted with at least one $R_{10a}$.

In one or more embodiments, $R_{51}$ and $R_{52}$ in Formula 2 may each independently be a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, a $C_6$-$C_{60}$ aryloxy group that is unsubstituted or substituted with at least one $R_{10a}$, a $C_6$-$C_{60}$ arylthio group that is unsubstituted or substituted with at least one $R_{10a}$, $-C(Q_1)(Q_2)(Q_3)$, or $-Si(Q_1)(Q_2)(Q_3)$, and

$Q_1$ to $Q_3$ may each independently be a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

In one or more embodiments,

a group represented by $*-(L_{51})_{b51}-R_{51}$ in Formula 2 may be a group represented by one selected from among Formulae CY51-1 to CY51-26, and/or
a group represented by $*-(L_{52})_{b52}-R_{52}$ in Formula 2 may be a group represented by one selected from among Formulae CY52-1 to CY52-26, and/or
a group represented by $*-(L_{53})_{b53}-R_{53}$ in Formula 2 may be a group represented by one selected from among Formulae CY53-1 to CY53-27, $-C(Q_1)(Q_2)(Q_3)$, or $-Si(Q_1)(Q_2)(Q_3)$:

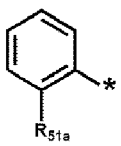
CY51-1

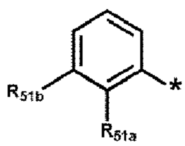
CY51-2

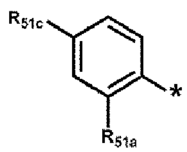
CY51-3

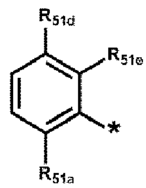
CY51-4

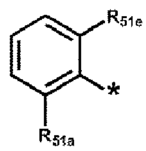
CY51-5

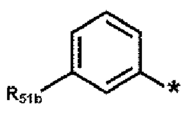
CY51-6

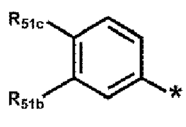
CY51-7

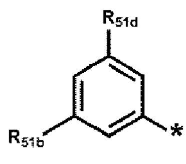
CY51-8

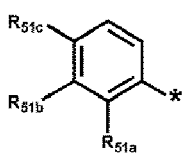
CY51-9

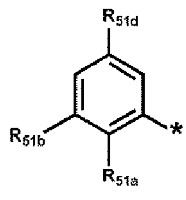
CY51-10

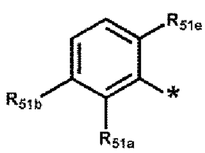
CY51-11

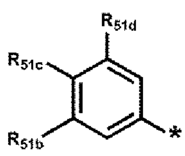
CY51-12

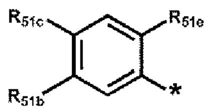
CY51-13

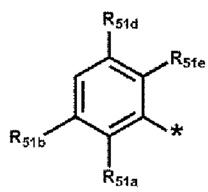
CY51-14

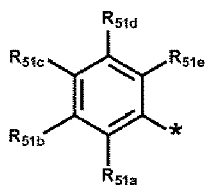
CY51-15

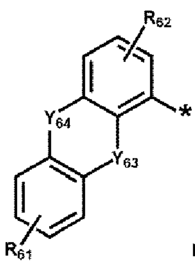
CY51-16

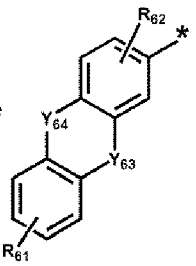
CY51-17

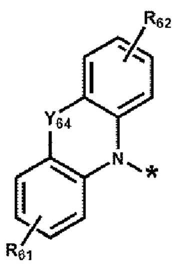
CY51-18

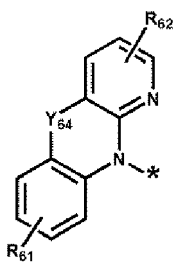
CY51-19

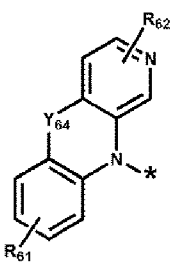
CY51-20

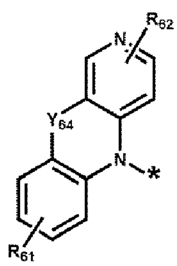
CY51-21

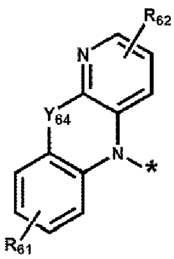
CY51-22

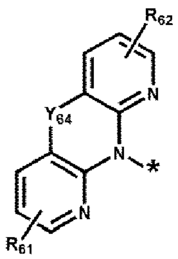
CY51-23

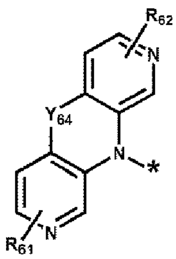
CY51-24

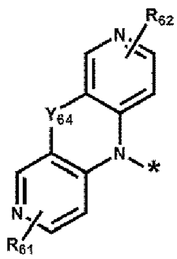
CY51-25

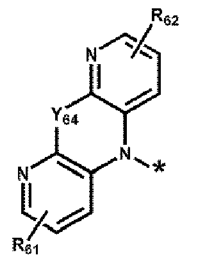
CY51-26

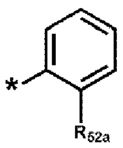
CY52-1

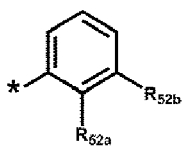
CY52-2

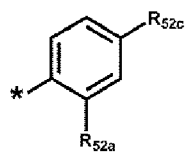
CY52-3

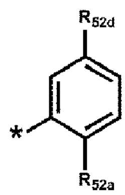
CY52-4

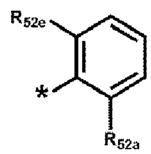
CY52-5

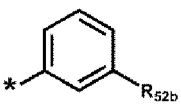
CY52-6

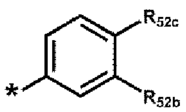
CY52-7

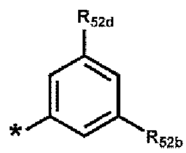
CY52-8

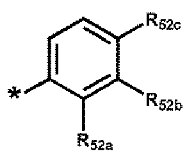
CY52-9

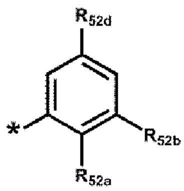
CY52-10

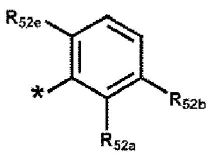
CY52-11

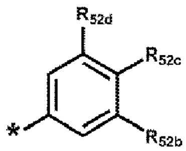
CY52-12

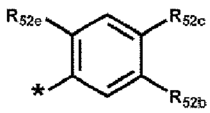
CY52-13

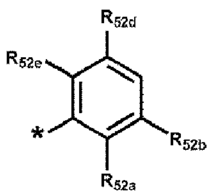
CY52-14

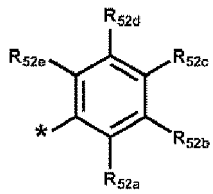
CY52-15

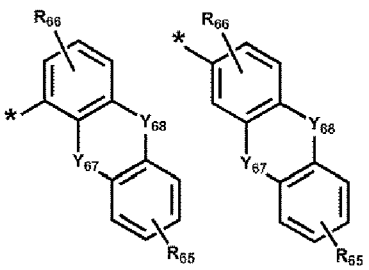
CY52-16 CY52-17

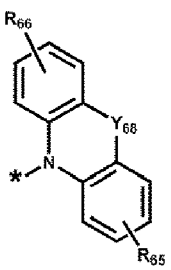
CY52-18

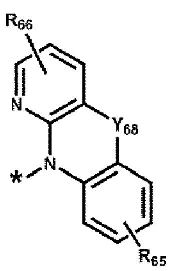
CY52-19

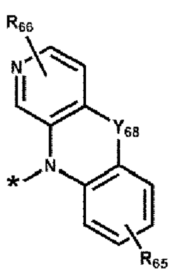
CY52-20

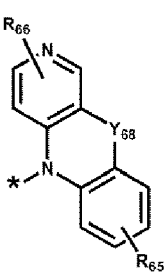
CY52-21

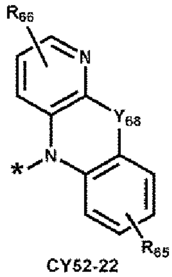
CY52-22

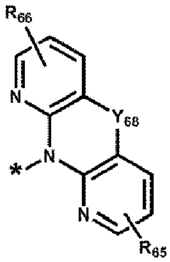
CY52-23

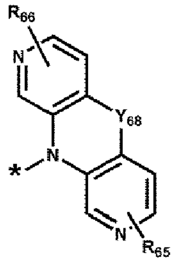
CY52-24

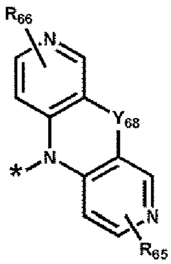
CY52-25

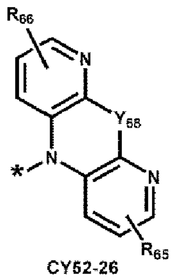
CY52-26

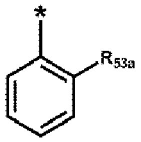
CY53-1

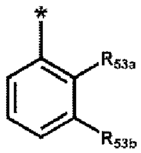
CY53-2

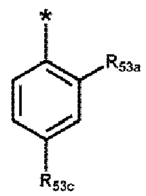
CY53-3

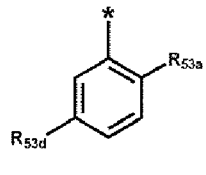
CY53-4

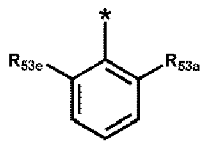
CY53-5

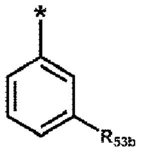
CY53-6

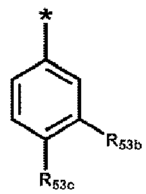
CY53-7

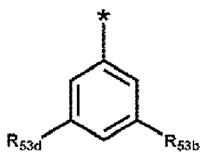
CY53-8

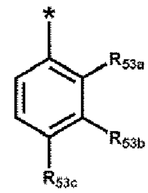
CY53-9

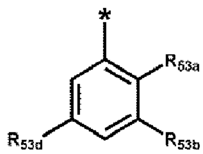
CY53-10

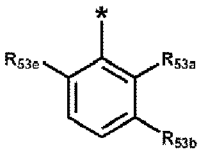
CY53-11

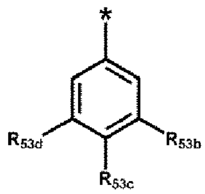
CY53-12

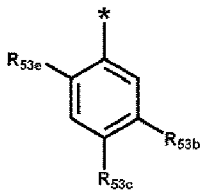
CY53-13

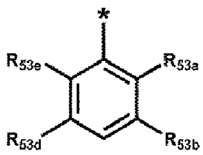
CY53-14

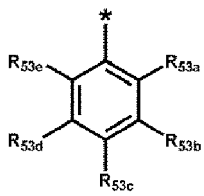
CY53-15

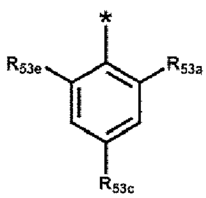
CY53-16

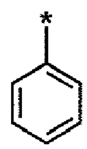
CY53-17

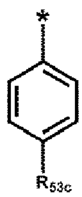
CY53-18

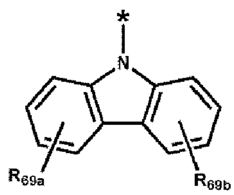
CY53-19

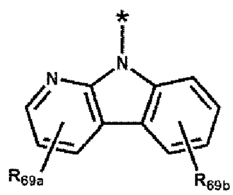
CY53-20

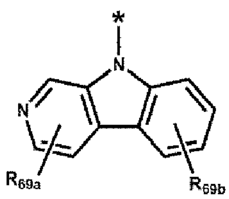
CY53-21

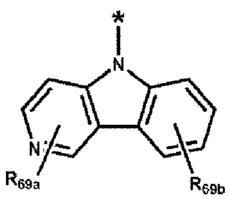
CY53-22

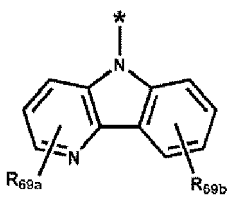
CY53-23

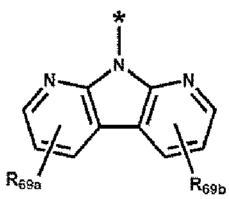
CY53-24

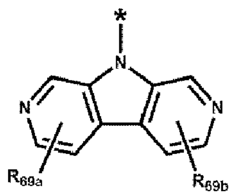
CY53-25

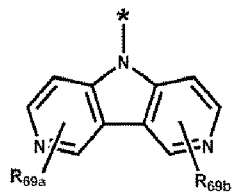
CY53-26

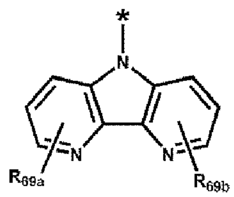
CY53-27

wherein, in Formulae CY51-1 to CY51-26, CY52-1 to CY52-26, and CY53-1 to CY53-27,
$Y_{63}$ may be a single bond, O, S, $N(R_{63})$, $B(R_{63})$, $C(R_{63a})(R_{63b})$, or $Si(R_{63a})(R_{63b})$,
$Y_{64}$ may be a single bond, O, S, $N(R_{64})$, $B(R_{64})$, $C(R_{64a})(R_{64b})$, or $Si(R_{64a})(R_{64b})$,
$Y_{67}$ may be a single bond, O, S, $N(R_{67})$, $B(R_{67})$, $C(R_{67a})(R_{67b})$, or $Si(R_{67a})(R_{67b})$,
$Y_{68}$ may be a single bond, O, S, $N(R_{68})$, $B(R_{68})$, $C(R_{68a})(R_{68b})$, or $Si(R_{68a})(R_{68b})$,
$Y_{63}$ and $Y_{64}$ in Formulae CY51-16 and CY51-17 may not be a single bond at the same time,
$Y_{67}$ and $Y_{68}$ in Formulae CY52-16 and CY52-17 may not be a single bond at the same time,
$R_{51a}$ to $R_{51e}$, $R_{61}$ to $R_{64}$, $R_{63a}$, $R_{63b}$, $R_{64a}$, and $R_{64b}$ may each be the same as described with respect to $R_{51}$, wherein $R_{51a}$ to $R_{51e}$ may each not be hydrogen,
$R_{52a}$ to $R_{52e}$, $R_{65}$ to $R_{68}$, $R_{67a}$, $R_{67b}$, $R_{68a}$, and $R_{68b}$ may each be the same as described with respect to $R_{52}$, wherein $R_{52a}$ to $R_{52e}$ may each not be hydrogen,
$R_{53a}$ to $R_{53e}$, $R_{69a}$, and $R_{69b}$ may each be the same as described with respect to $R_{53}$, wherein $R_{53a}$ to $R_{53e}$ may each not be hydrogen, and
* indicates a binding site to a neighboring atom.

For example, in one or more embodiments,
in Formulae CY51-1 to CY51-26 and Formulae CY52-1 to CY52-26, $R_{51a}$ to $R_{51e}$ and $R_{52a}$ to $R_{52e}$ may each independently be:

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a ($C_1$-$C_{10}$ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, or any combination thereof; or
$-C(Q_1)(Q_2)(Q_3)$ or $-Si(Q_1)(Q_2)(Q_3)$,
$Q_1$ to $Q_3$ may each independently be a phenyl group, a naphthyl group, a pyridinyl group, a pyrimidinyl group, a pyridazinyl group, a pyrazinyl group, or a triazinyl group, each unsubstituted or substituted with deuterium, a $C_1$-$C_{10}$

alkyl group, a phenyl group, a biphenyl group, a pyridinyl group, a pyrimidinyl group, a pyridazinyl group, a pyrazinyl group, a triazinyl group, or any combination thereof,

in Formulae CY51-16 and CY51-17, i) $Y_{63}$ may be O or S and $Y_{64}$ may be $Si(R_{64a})(R_{64b})$, or ii) $Y_{63}$ may be $Si(R_{63a})(R_{63b})$ and $Y_{64}$ may be O or S, and

in Formulae CY52-16 and CY52-17, i) $Y_{67}$ may be O or S, and Yes may be $Si(R_{68a})(R_{68b})$, or ii) $Y_{67}$ may be $Si(R_{67a})(R_{67b})$, and $Y_{68}$ may be O or S.

In one or more embodiments, in Formulae 3-1 to 3-5, $L_{81}$ to $L_{85}$ may each independently be:

a single bond; or

*-$C(Q_4)(Q_5)$-*' or *-$Si(Q_4)(Q_5)$-*'; or

a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, -F, -Cl, -Br, -I, a hydroxyl group, a cyano group, a nitro group, a $C_1$-$C_{20}$ alkyl group, a $C_1$-$C_{20}$ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, $-O(Q_{31})$, $-S(Q_{31})$, $- Si(Q_{31})(Q_{32})(Q_{33})$, $-N(Q_{31})(Q_{32})$, $-B(Q_{31})(Q_{32})$, $-P(Q_{31})(Q_{32})$, $-C(=O)(Q_{31})$, $-S(=O)_2(Q_{31})$, $- P(=O)(Q_{31})(Q_{32})$, or any combination thereof, and

$Q_4$, $Q_5$, and $Q_{31}$ to $Q_{33}$ may each independently be hydrogen, deuterium, a $C_1$-$C_{20}$ alkyl group, a $C_1$-$C_{20}$ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, a group represented by

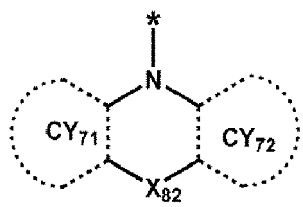

in Formulae 3-1 and 3-2 may be a group represented by one selected from among Formulae CY71-1(1) to CY71-1(8), and/or

a group represented by

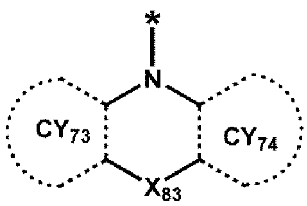

in Formulae 3-1 and 3-3 may be a group represented by one selected from among Formulae CY71-2(1) to CY71-2(8), and/or

a group represented by

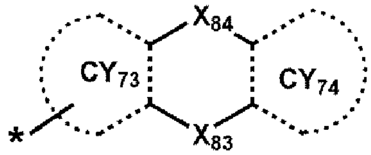

in Formulae 3-2 and 3-4 may be a group represented by one selected from among Formulae CY71-3(1) to CY71-3(32), and/or
a group represented by

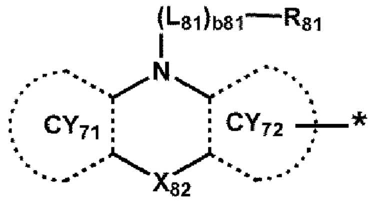

in Formulae 3-3 to 3-5 may be a group represented by one selected from among Formulae CY71-4(1) to CY71-4(32), and/or
a group represented by

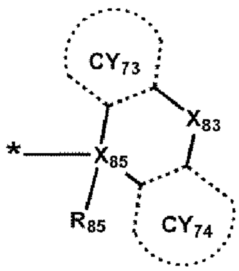

in Formula 3-5 may be a group represented by one selected from among Formulae CY71-5(1) to CY71-5(8):

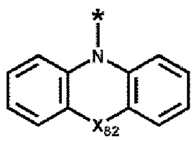

CY71-1(1)

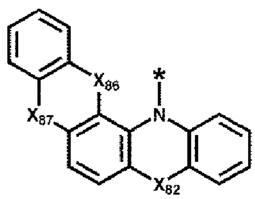

CY71-1(2)

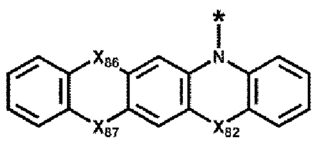

CY71-1(3)

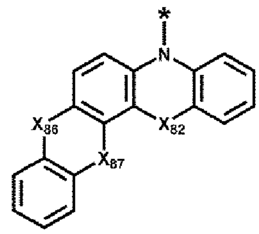

CY71-1(4)

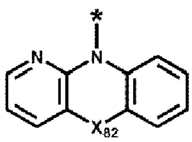

CY71-1(5)

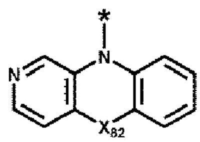

CY71-1(6)

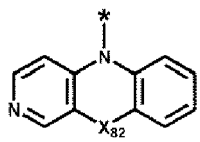

CY71-1(7)

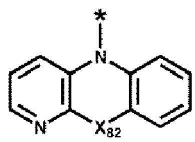

CY71-1(8)

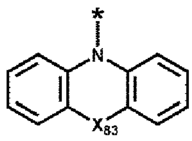
CY71-2(1)

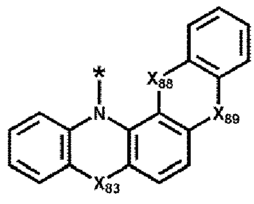
CY71-2(2)

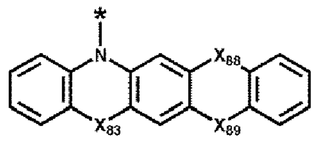
CY71-2(3)

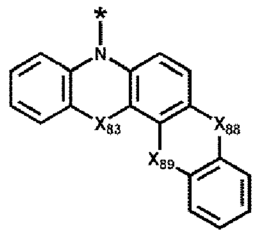
CY71-2(4)

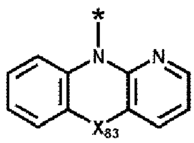
CY71-2(5)

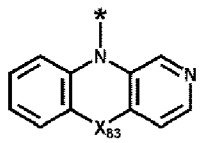
CY71-2(6)

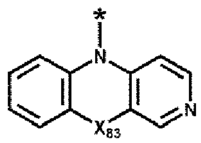
CY71-2(7)

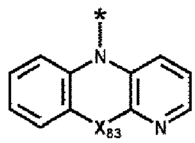
CY71-2(8)

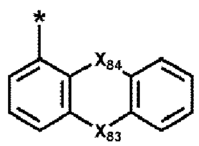
CY71-3(1)

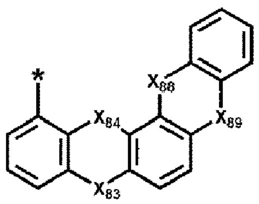
CY71-3(2)

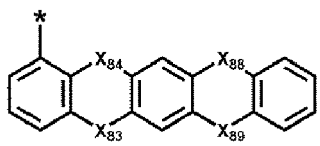
CY71-3(3)

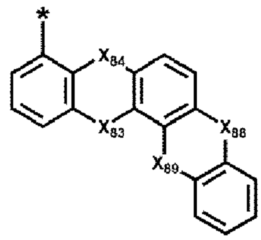
CY71-3(4)

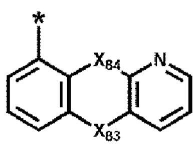
CY71-3(5)

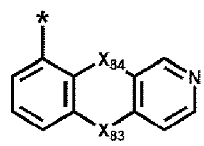
CY71-3(6)

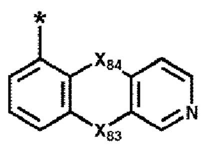
CY71-3(7)

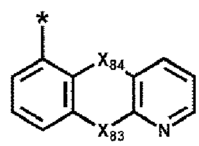
CY71-3(8)

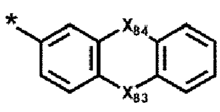
CY71-3(9)

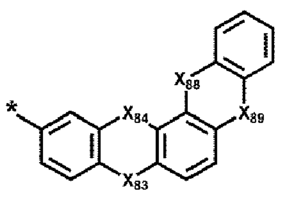
CY71-3(10)

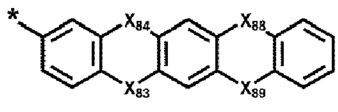
CY71-3(11)

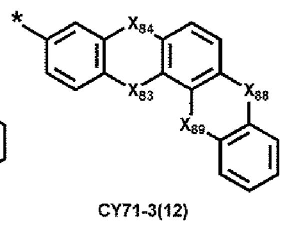
CY71-3(12)

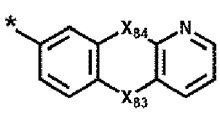
CY71-3(13)

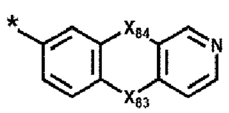
CY71-3(14)

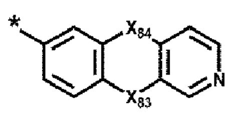
CY71-3(15)

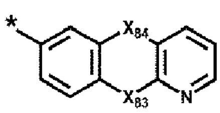
CY71-3(16)

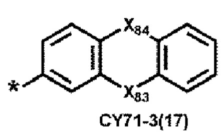
CY71-3(17)

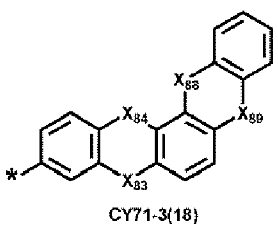
CY71-3(18)

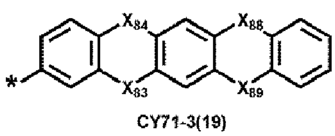
CY71-3(19)

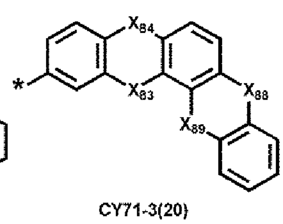
CY71-3(20)

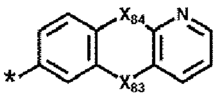
CY71-3(21)

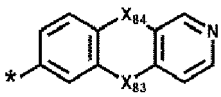
CY71-3(22)

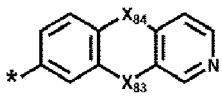
CY71-3(23)

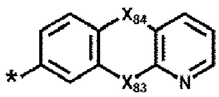
CY71-3(24)

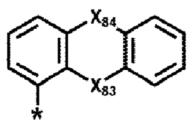
CY71-3(25)

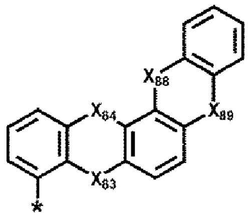
CY71-3(26)

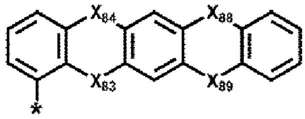
CY71-3(27)

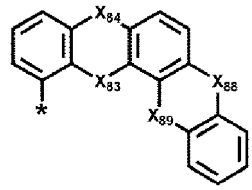
CY71-3(28)

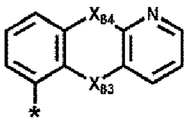
CY71-3(29)

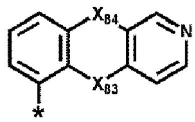
CY71-3(30)

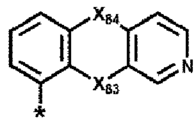
CY71-3(31)

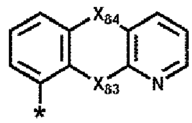
CY71-3(32)

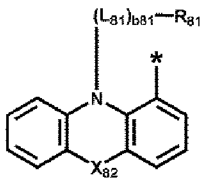
CY71-4(1)

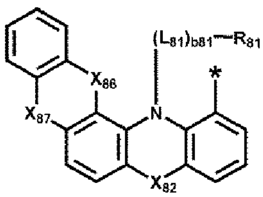
CY71-4(2)

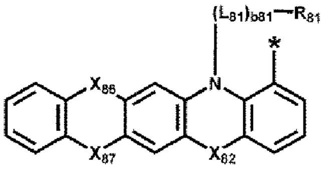
CY71-4(3)

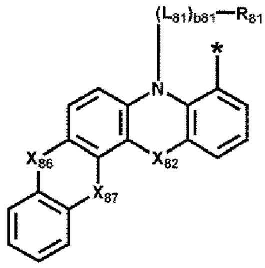
CY71-4(4)

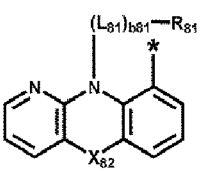
CY71-4(5)

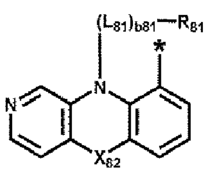
CY71-4(6)

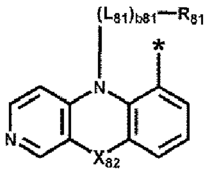
CY71-4(7)

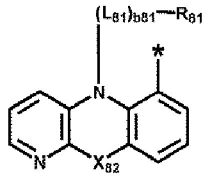
CY71-4(8)

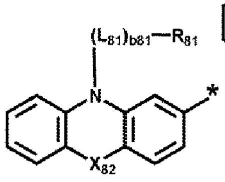
CY71-4(9)

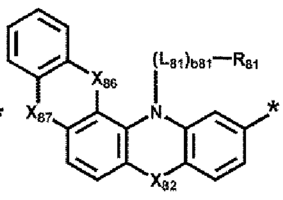
CY71-4(10)

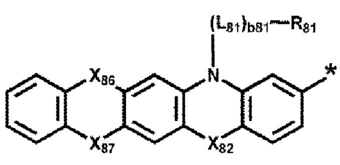
CY71-4(11)

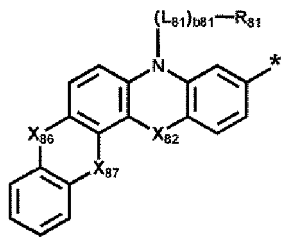
CY71-4(12)

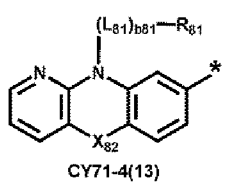
CY71-4(13)

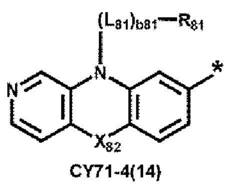
CY71-4(14)

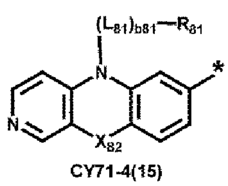
CY71-4(15)

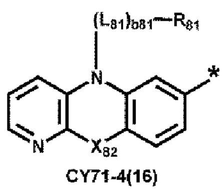
CY71-4(16)

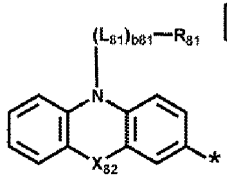
CY71-4(17)

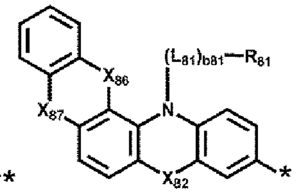
CY71-4(18)

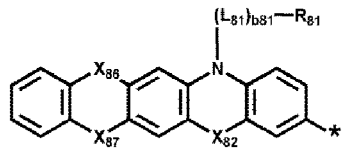
CY71-4(19)

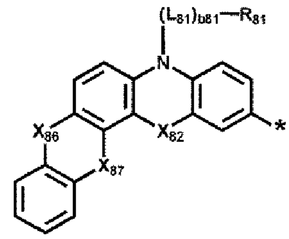
CY71-4(20)

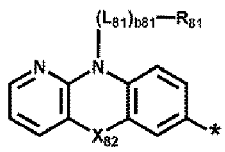
CY71-4(21)

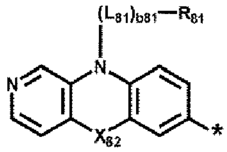
CY71-4(22)

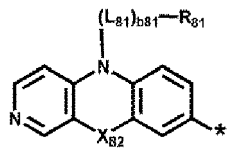
CY71-4(23)

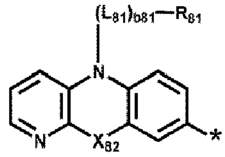
CY71-4(24)

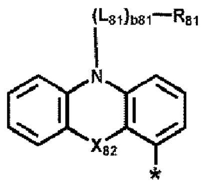
CY71-4(25)

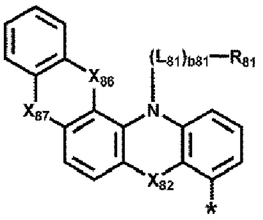
CY71-4(26)

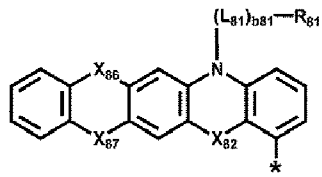
CY71-4(27)

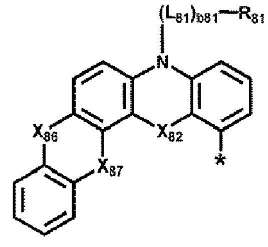
CY71-4(28)

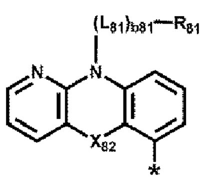
CY71-4(29)

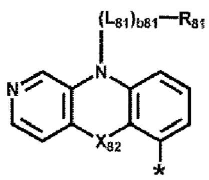
CY71-4(30)

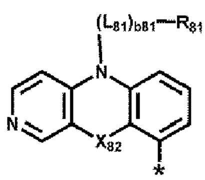
CY71-4(31)

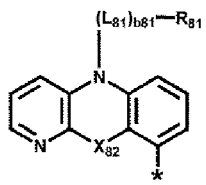
CY71-4(32)

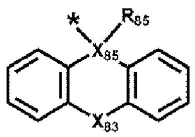
CY71-5(1)

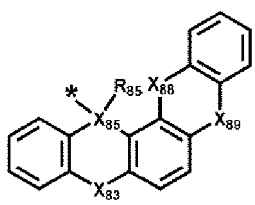
CY71-5(2)

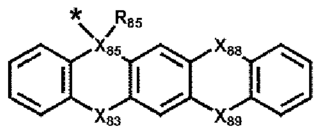
CY71-5(3)

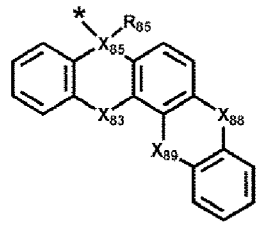
CY71-5(4)

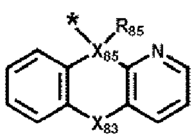
CY71-5(5)

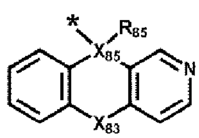
CY71-5(6)

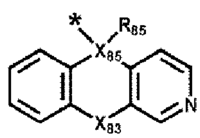
CY71-5(7)

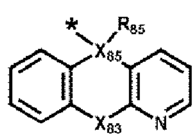
CY71-5(8)

wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
$X_{81}$ to $X_{85}$, $L_{81}$, b81, $R_{81}$, and $R_{85}$ may each be the same as described herein,
$X_{30}$ may be a single bond, O, S, $N(R_{86})$, $B(R_{86})$, $C(R_{88a})(R_{86b})$, or $Si(R_{86a})(R_{86b})$,
$X_{87}$ may be a single bond, O, S, $N(R_{87})$, $B(R_{87})$, $C(R_{87a})(R_{87b})$, or $Si(R_{87a})(R_{87b})$,

in Formulae CY71-1(1) to CY71-1(8) and CY71-4(1) to CY71-4(32), $X_{86}$ and $X_{87}$ may not be a single bond at the same time,

$X_{88}$ may be a single bond, O, S, N($R_{88}$), B($R_{88}$), C($R_{88a}$)($R_{88b}$), or Si($R_{88a}$)($R_{88b}$),

$X_{89}$ may be a single bond, O, S, N($R_{89}$), B($R_{89}$), C($R_{89a}$)($R_{89b}$), or Si($R_{89a}$)($R_{89b}$),

in Formulae CY71-2(1) to CY71-2(8), CY71-3(1) to CY71-3(32), and CY71-5(1) to CY71-5(8), $X_{88}$ and $X_{89}$ may not be a single bond at the same time, and

$R_{86}$ to $R_{89}$, $R_{86a}$, $R_{86b}$, $R_{87a}$, $R_{87b}$, $R_{88a}$, $R_{88b}$, $R_{89a}$, and $R_{89b}$ may each be the same as described with respect to $R_{81}$.

**Examples of compounds**

In one or more embodiments, the organometallic compound represented by Formula 1 may be one selected from Compounds BD01 to BD122:

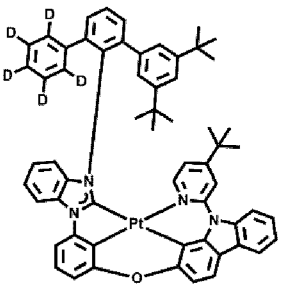

**BD01**

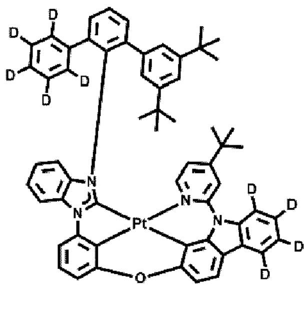

**BD02**

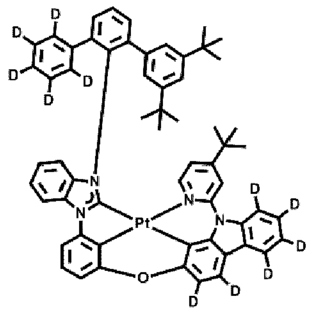

**BD03**

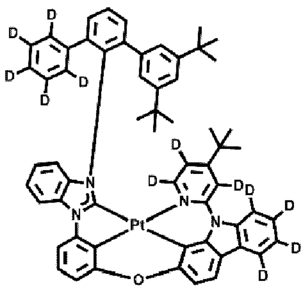

**BD04**

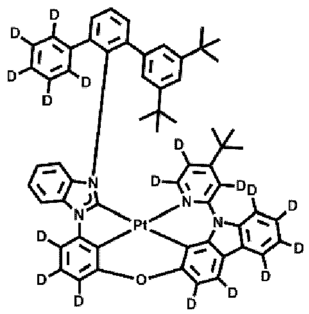

**BD05**

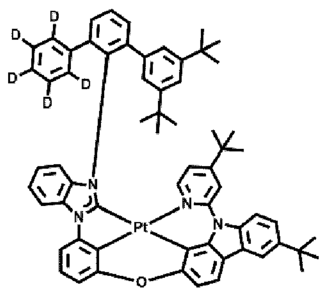

**BD06**

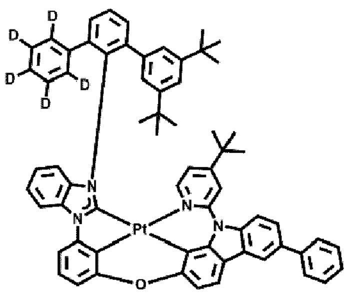

**BD07**

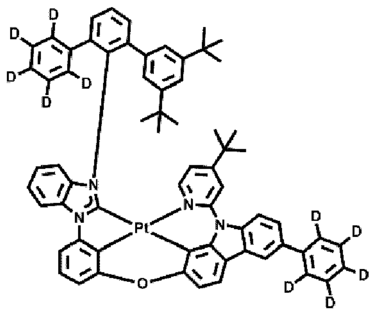

**BD08**

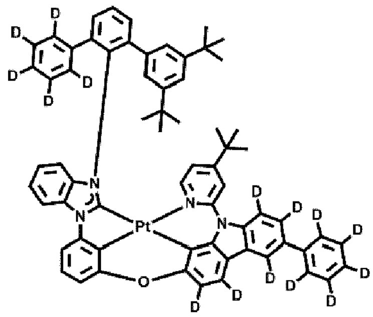

**BD09**

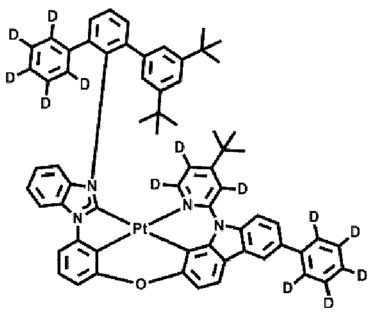

BD10

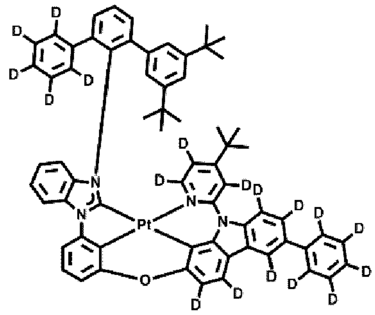

BD11

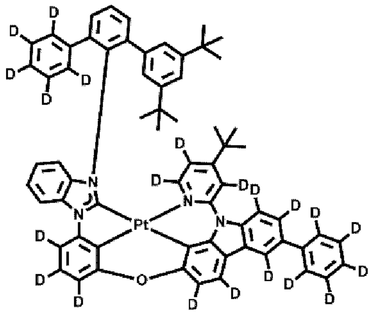

BD12

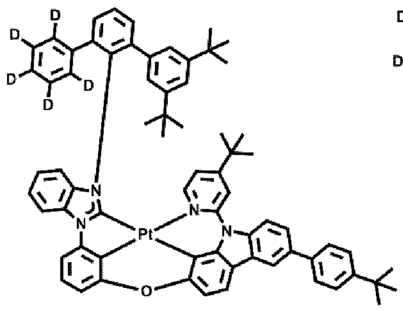

BD13

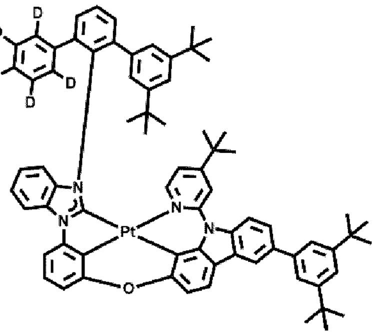

BD14

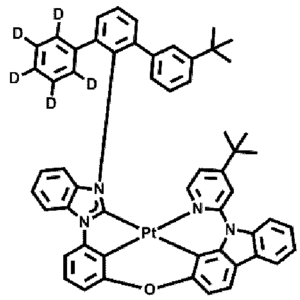

BD15

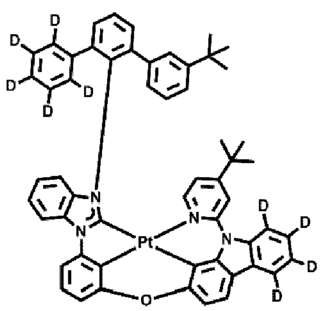

BD16

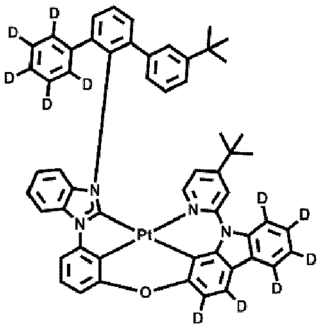

BD17

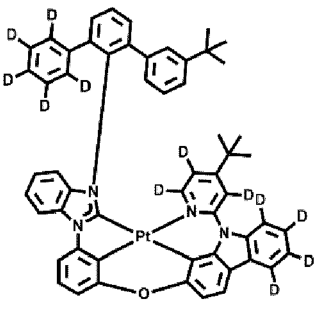

BD18

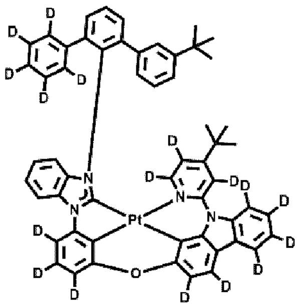

BD19

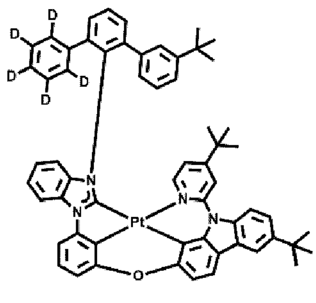

BD20

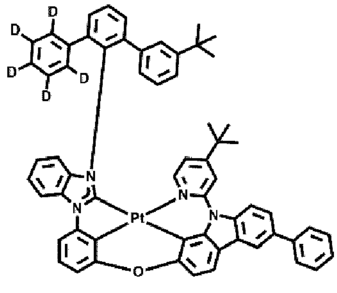

BD21

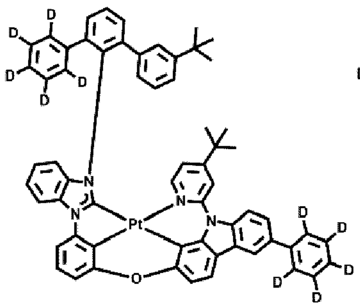

BD22

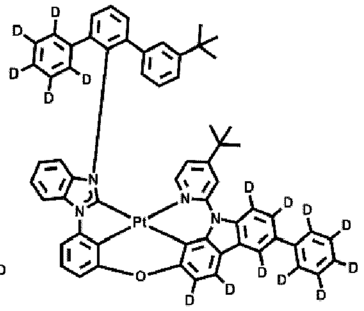

BD23

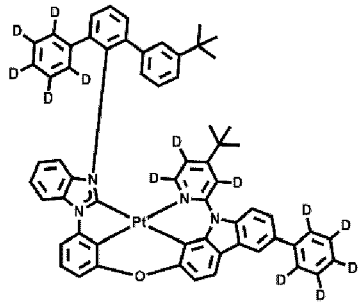

BD24

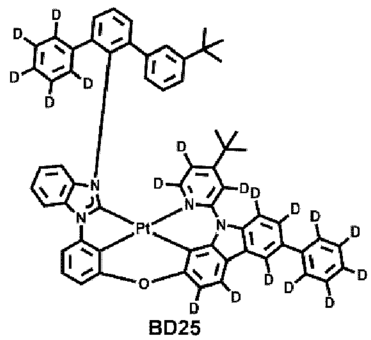

BD25

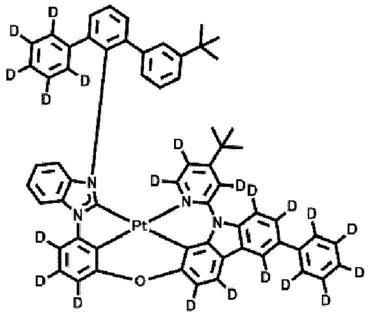

BD26

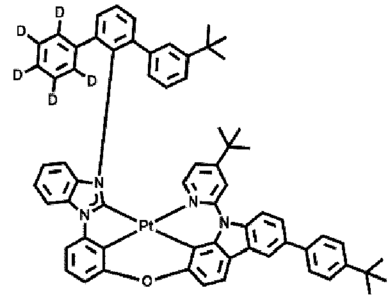

BD27

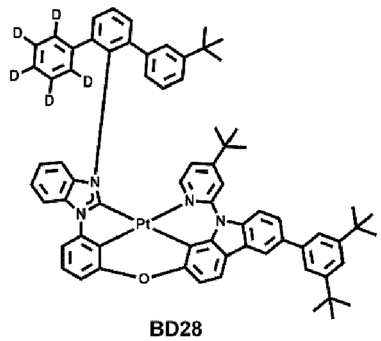

BD28

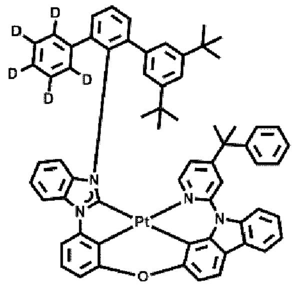

BD029

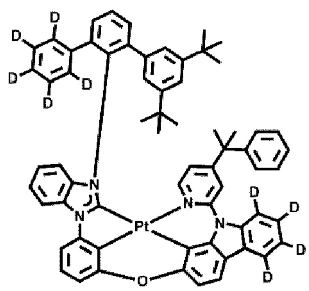

BD30

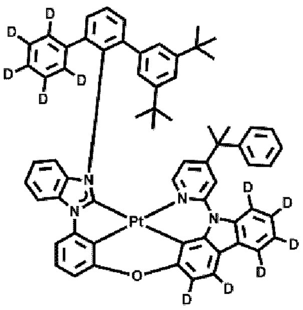

BD31

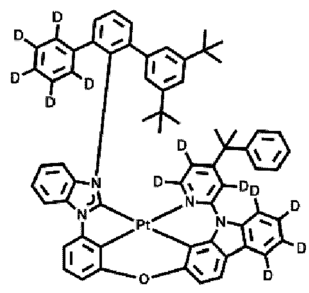

BD32

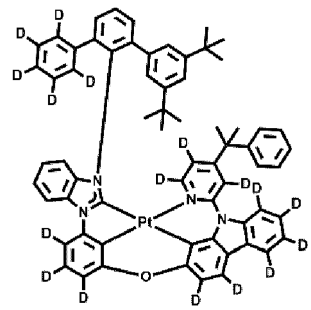

BD33

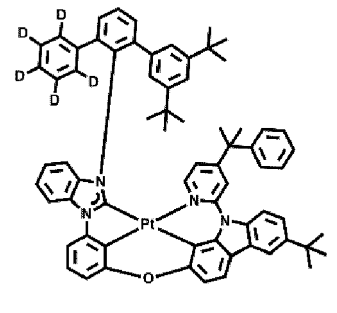

BD34

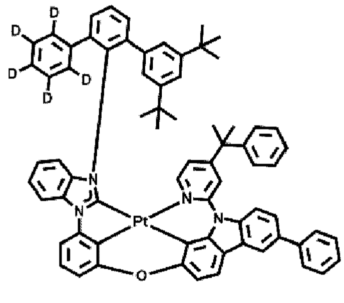

BD35

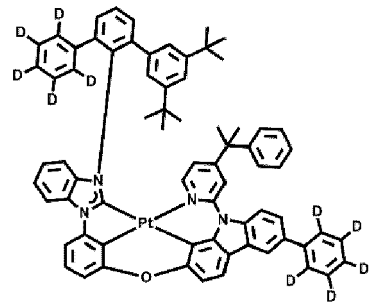

BD36

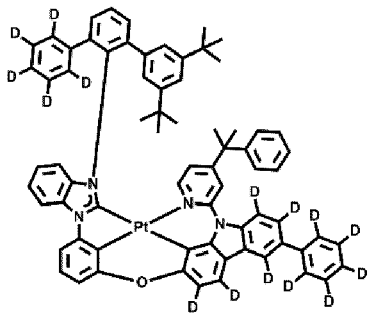

BD37

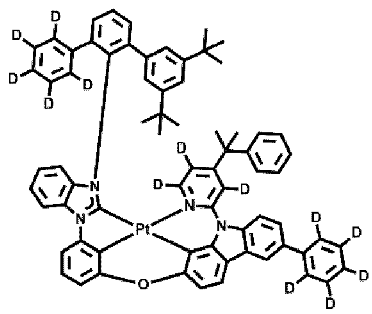

BD38

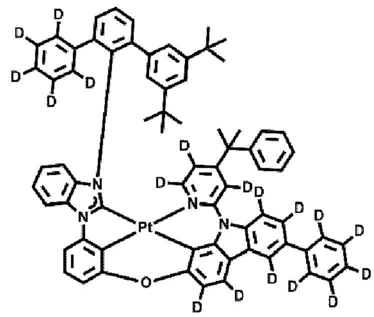

BD39

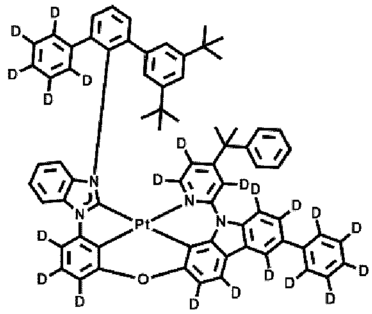

BD40

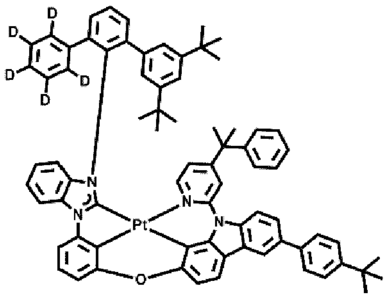

BD41

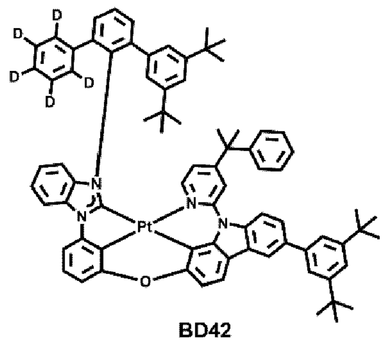

BD42

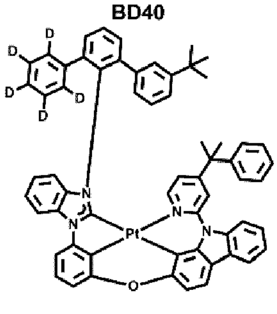

BD43

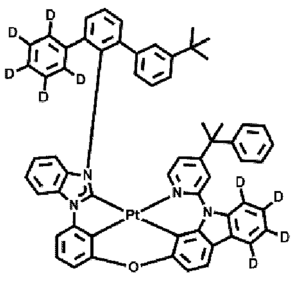

BD44

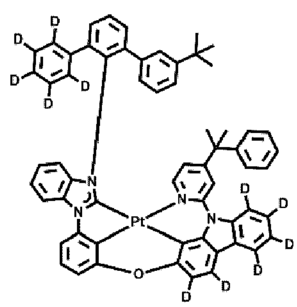

BD45

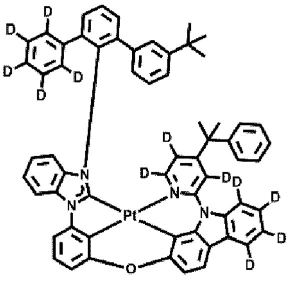

BD46

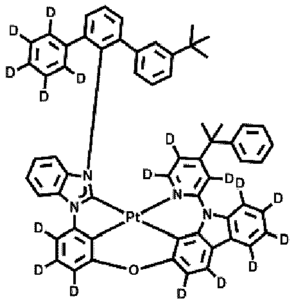

BD47

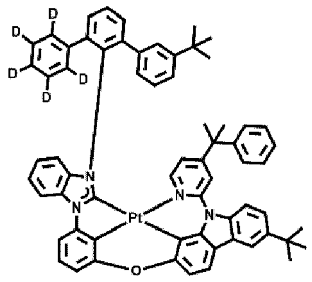

BD48

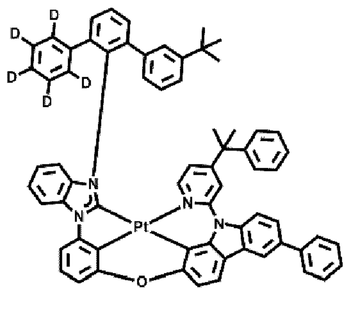

BD49

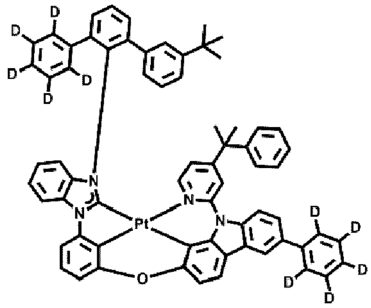

BD50

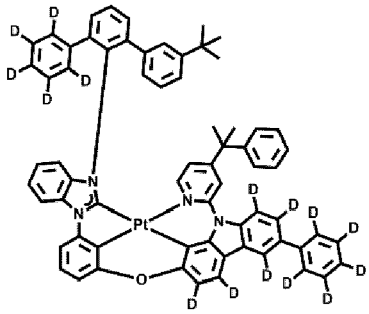

BD51

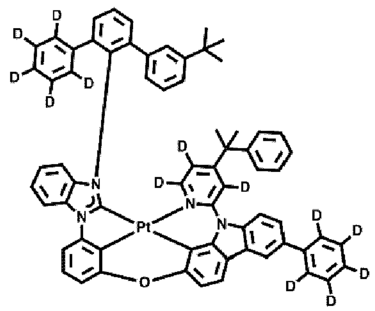

BD52

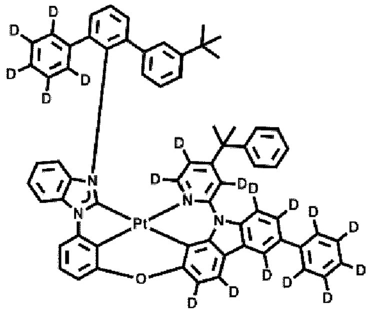

BD53

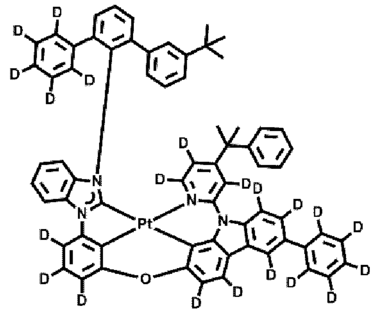

BD54

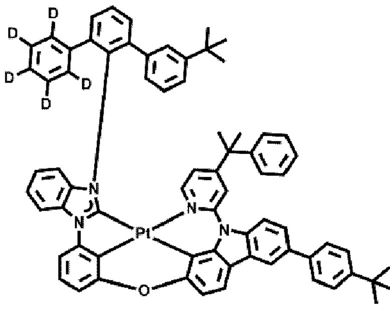

BD55

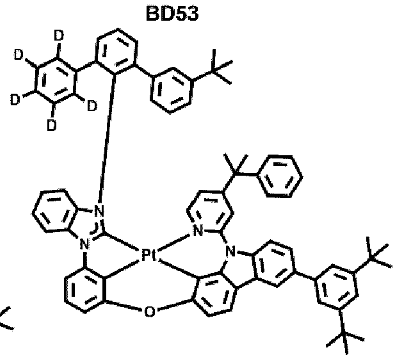

BD56

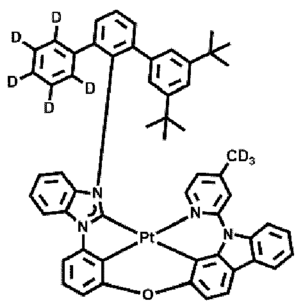

BD57

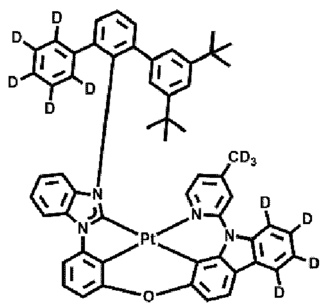

BD58

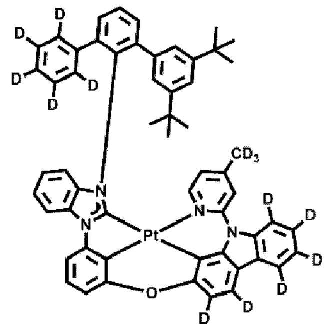

BD59

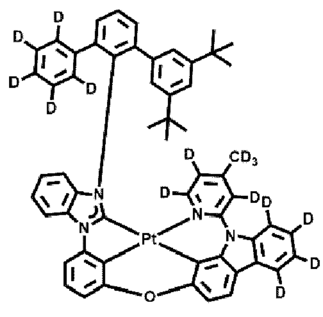

BD60

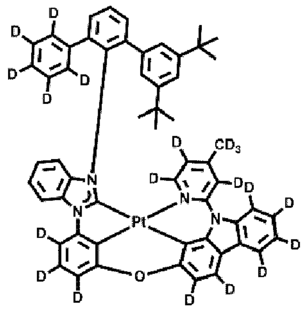

BD61

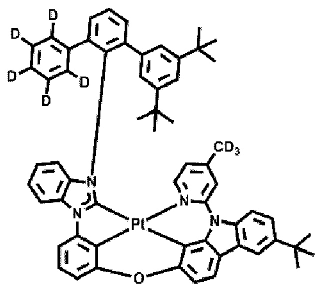

BD62

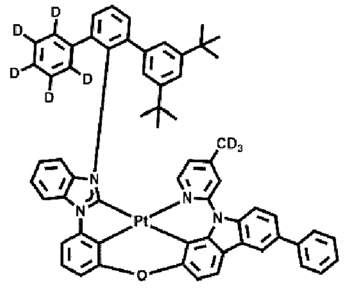

BD63

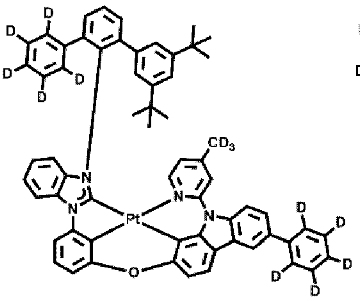

BD64

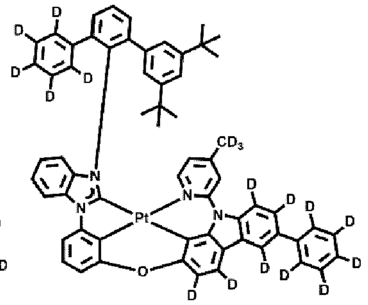

BD65

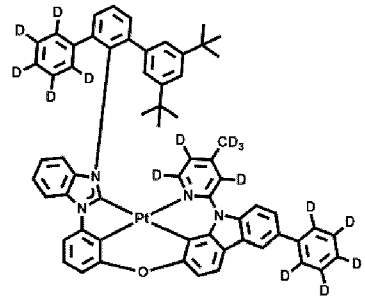

BD66

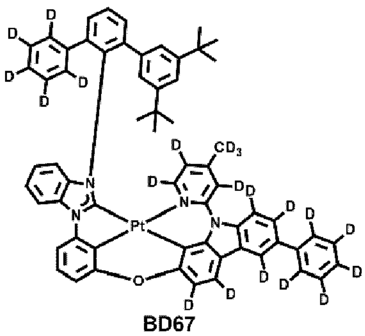

BD67

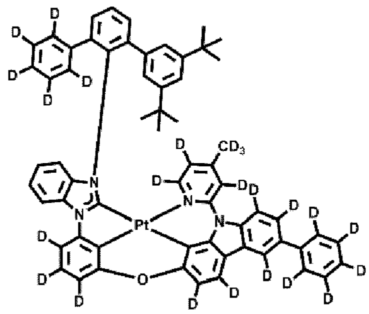

BD68

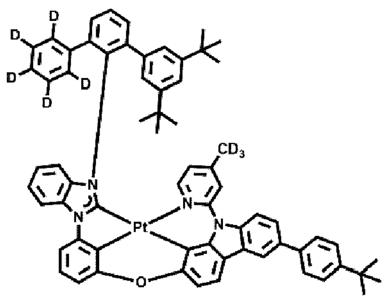

BD69

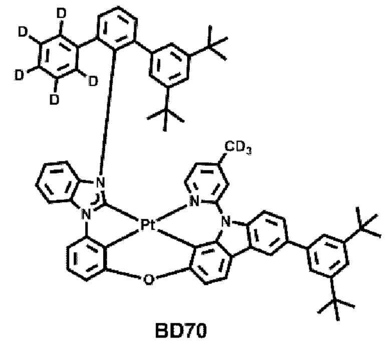

BD70

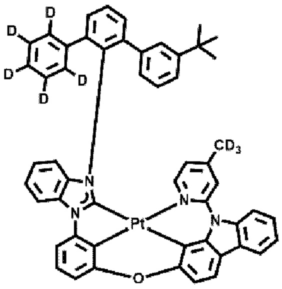

BD071

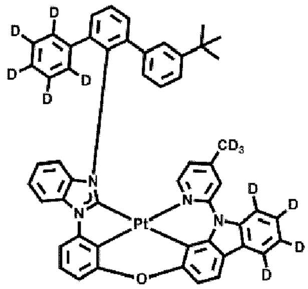

BD72

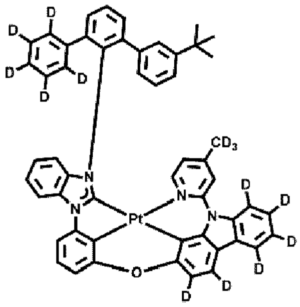

BD73

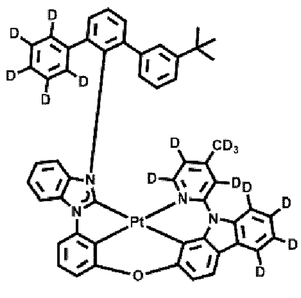

BD74

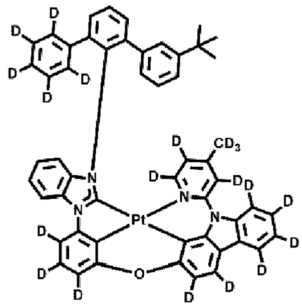

BD75

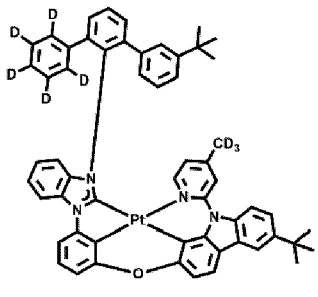

BD76

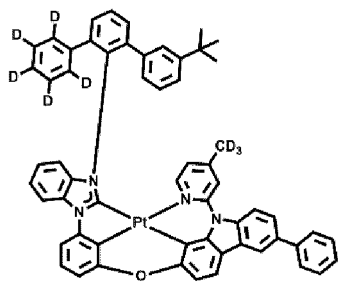

BD77

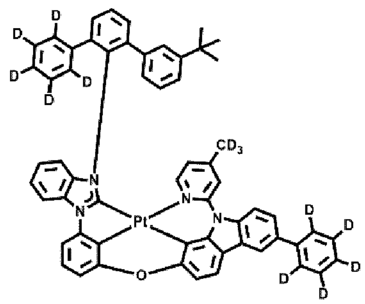

BD78

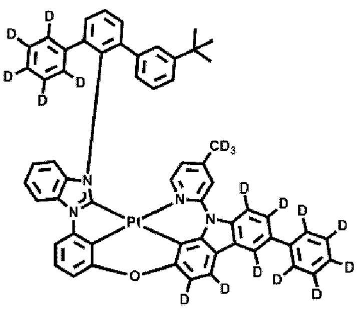

BD79

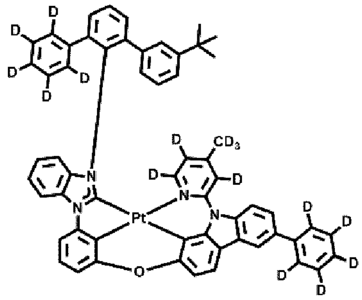

BD80

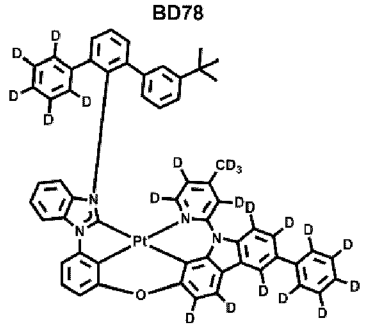

BD81

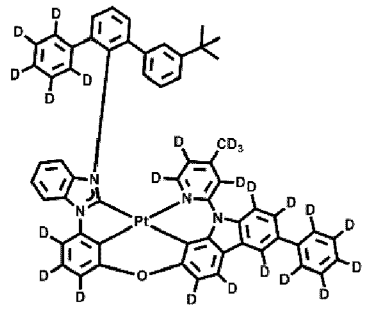

BD82

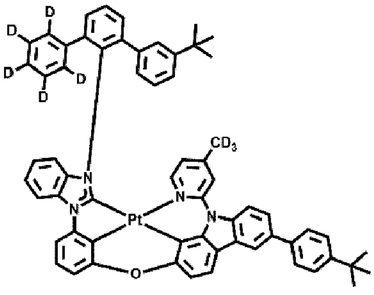

BD83

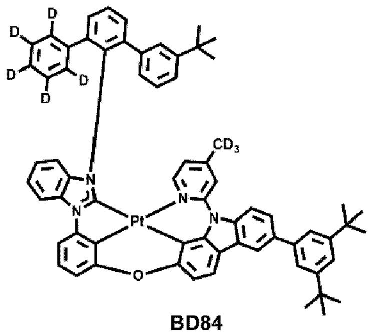

BD84

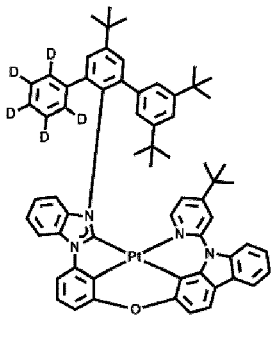

BD85

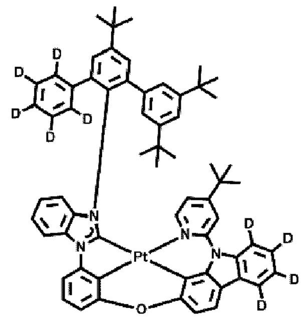

BD86

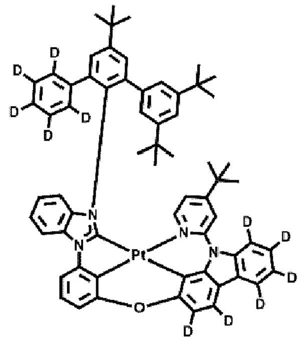

BD87

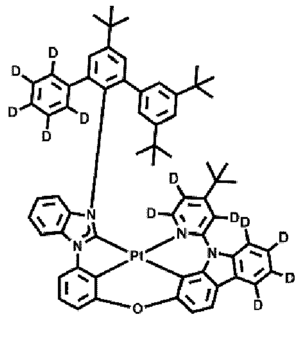

BD88

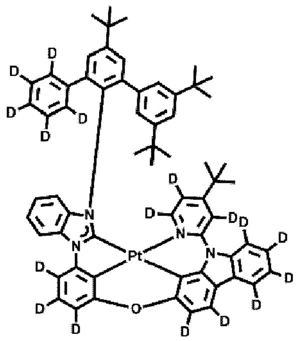

BD89

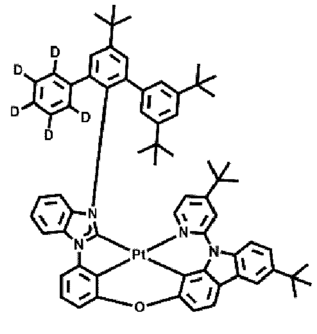

BD90

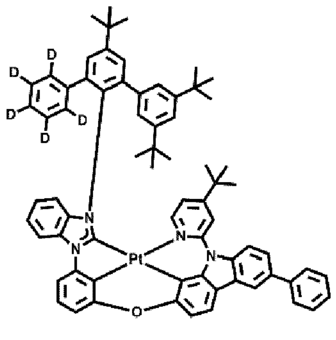

BD91

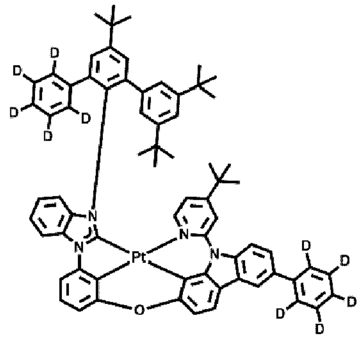

BD92

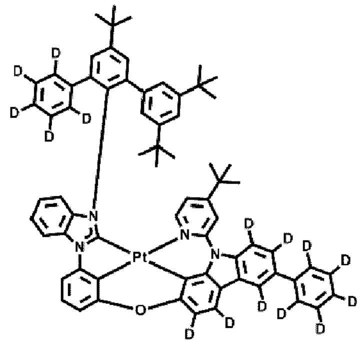

BD93

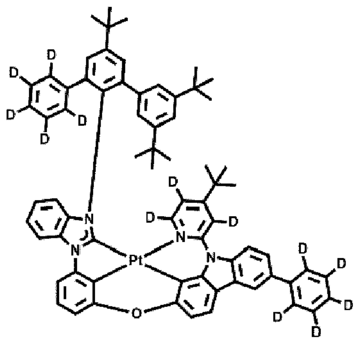

BD94

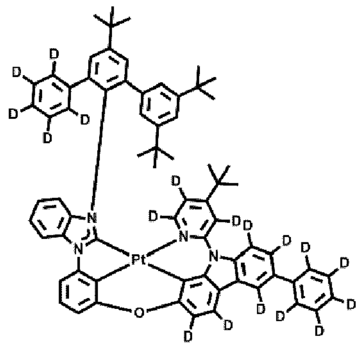

BD95

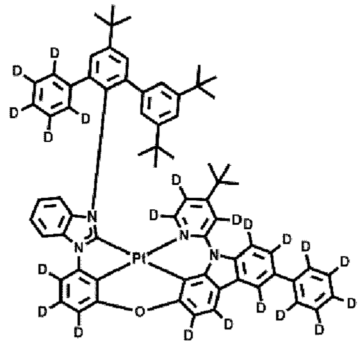

BD96

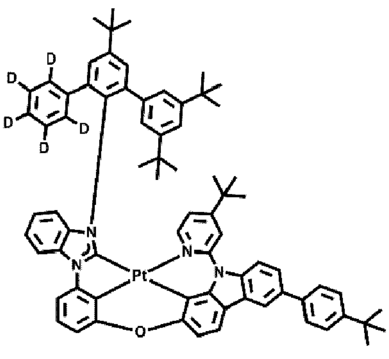

BD97

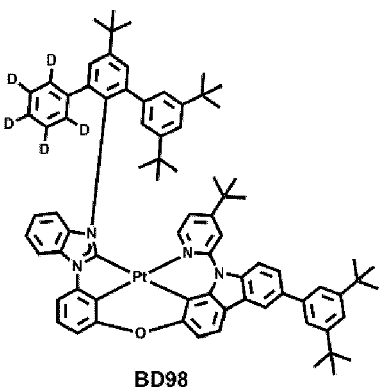

BD98

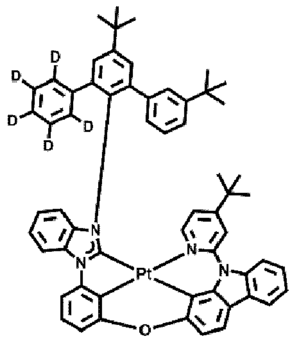

BD99

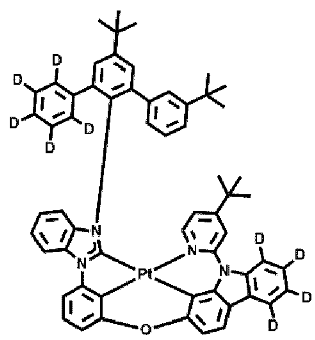

BD100

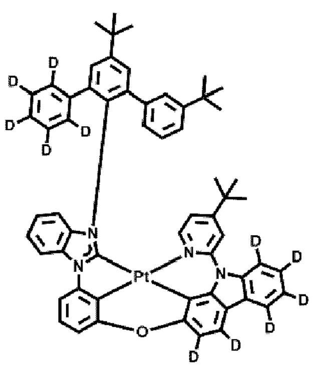

BD101

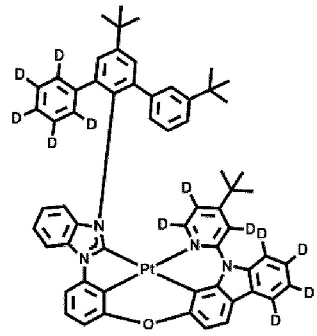

BD102

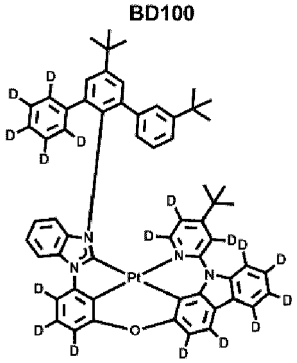

BD103

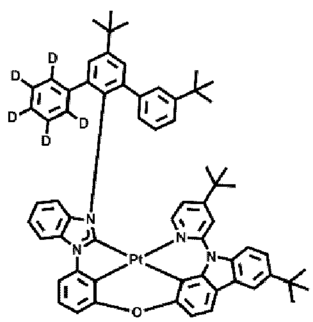

BD104

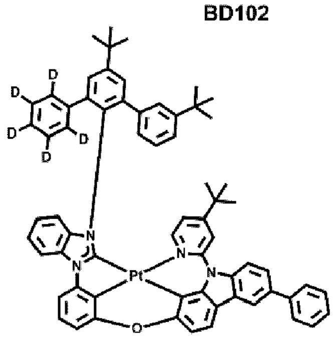

BD105

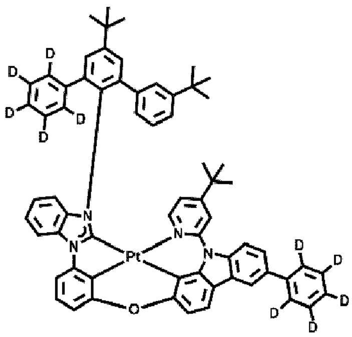

BD106

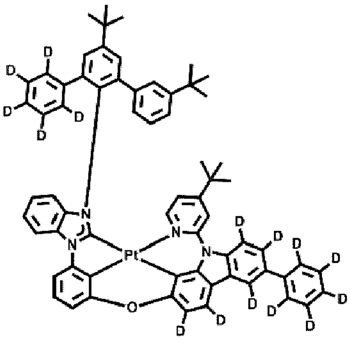

BD107

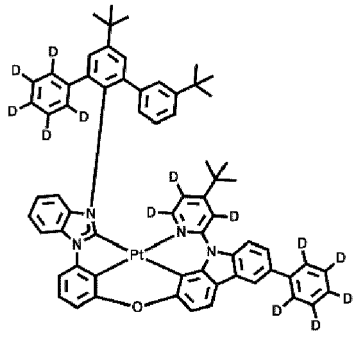

BD108

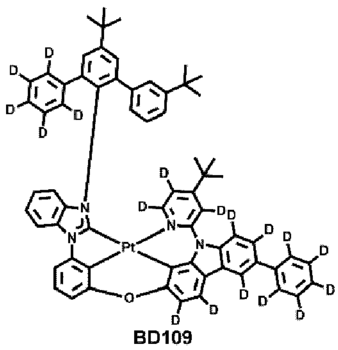

BD109

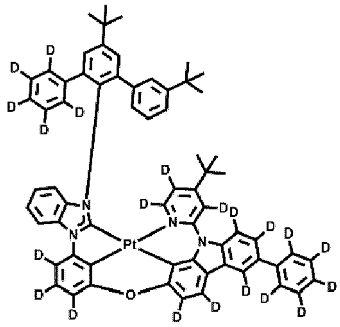

BD110

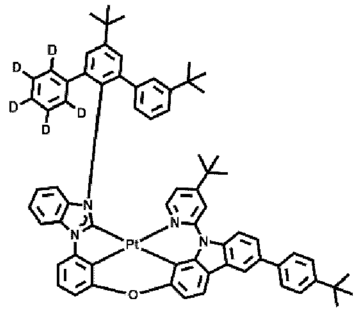

BD111

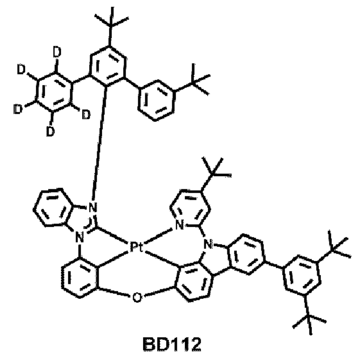

BD112

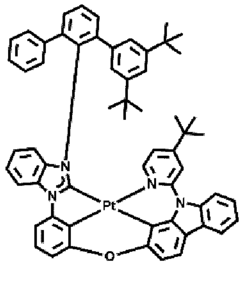

BD113

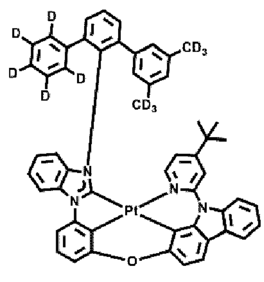

BD114

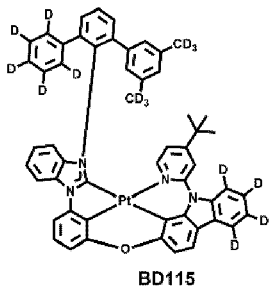

BD115

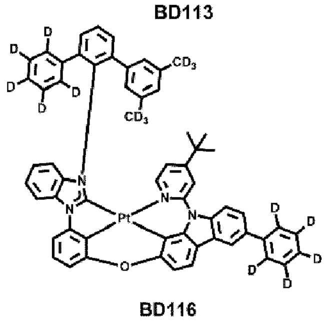

BD116

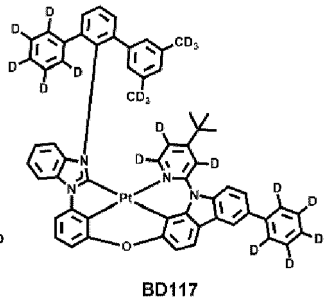

BD117

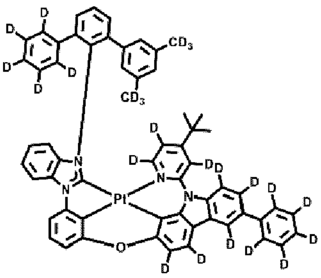
BD118

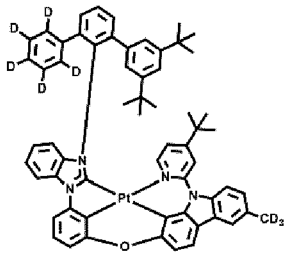
BD119

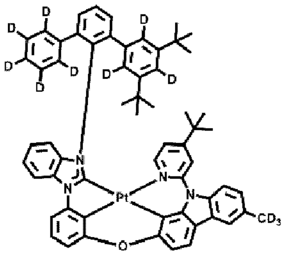
BD120

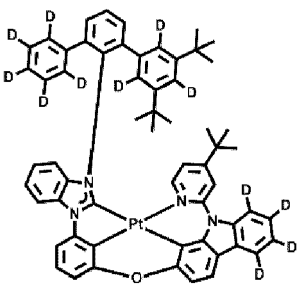
BD121

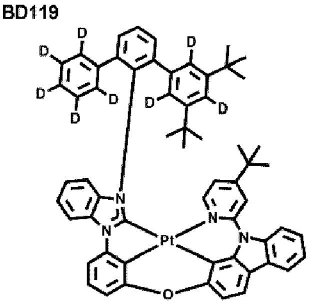
BD122 .

In one or more embodiments, the second compound may be at least one selected from among Compounds ETH1 to ETH100:

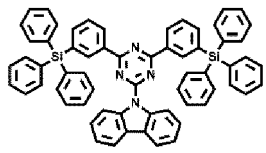
ETH1

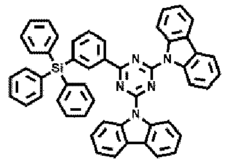
ETH2

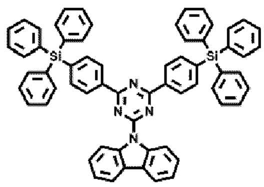
ETH3

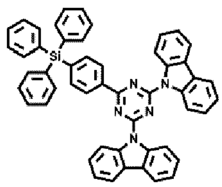
ETH4

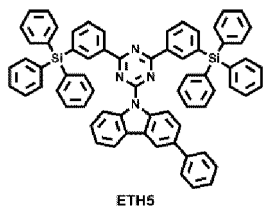
ETH5

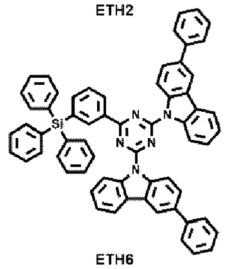
ETH6

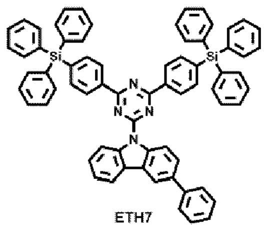
ETH7

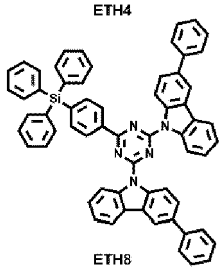
ETH8

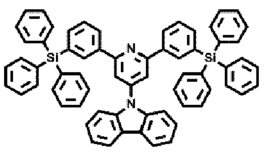
ETH9

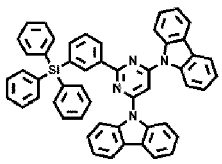
ETH10

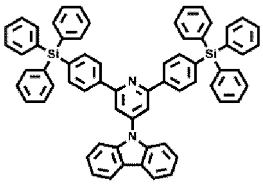
ETH11

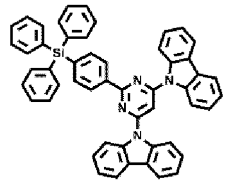
ETH12

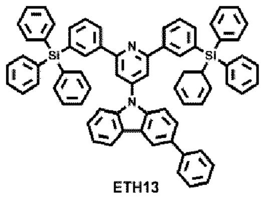
ETH13

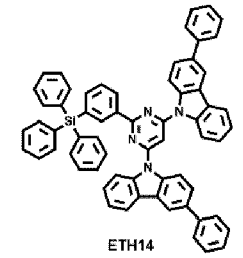
ETH14

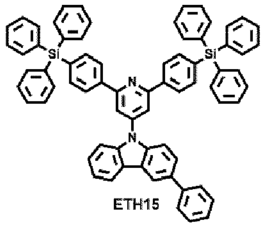
ETH15

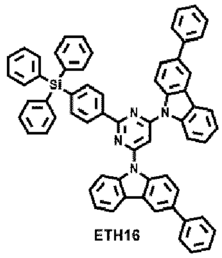
ETH16

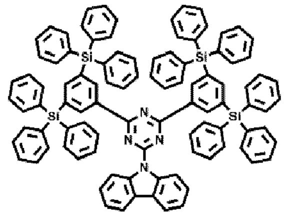
ETH17

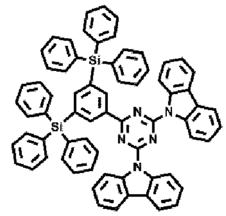
ETH18

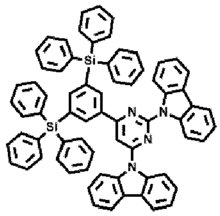
ETH19

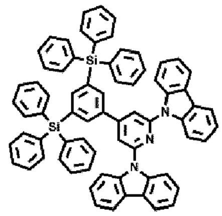
ETH20

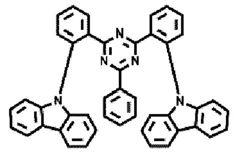
ETH21

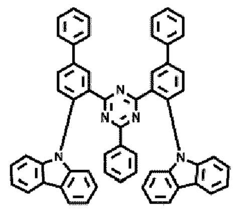
ETH22

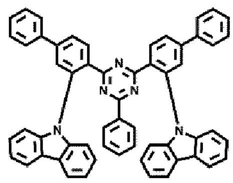
ETH23

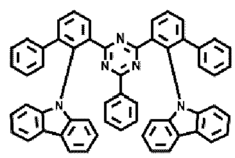
ETH24

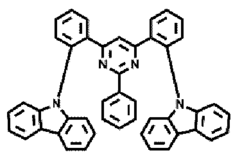
ETH25

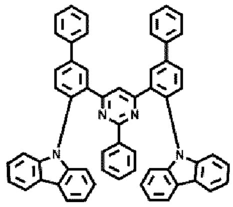
ETH26

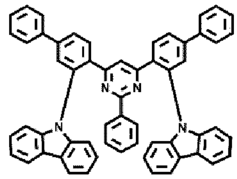
ETH27

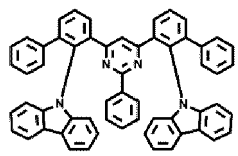
ETH28

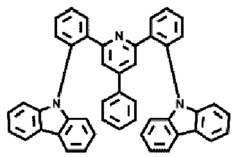
ETH29

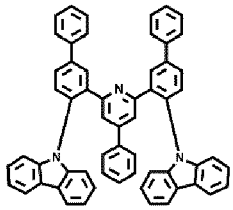
ETH30

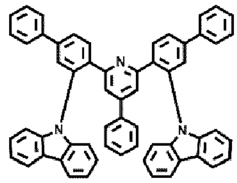
ETH31

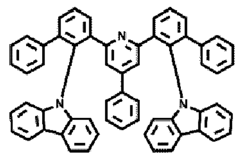
ETH32

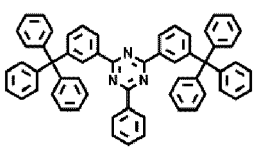
ETH33

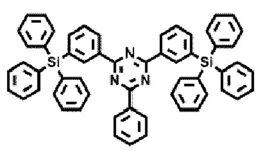
ETH34

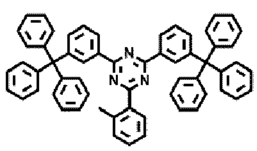
ETH5

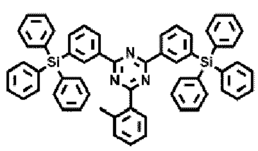
ETH36

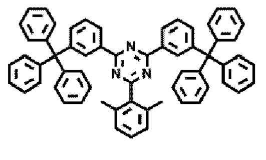

ETH37

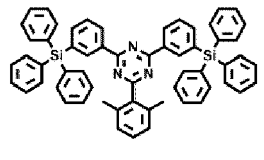

ETH38

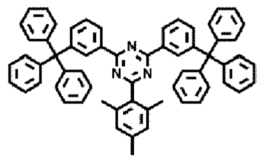

ETH39

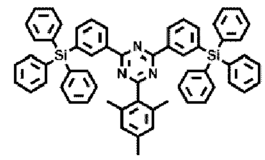

ETH40

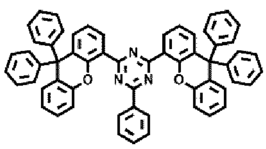

ETH41

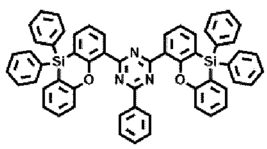

ETH42

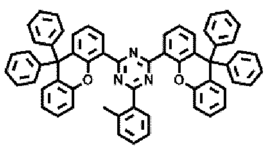

ETH43

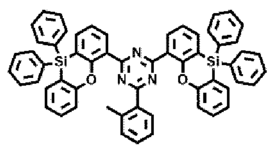

ETH44

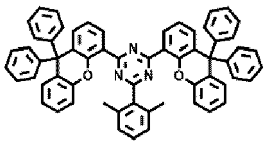

ETH45

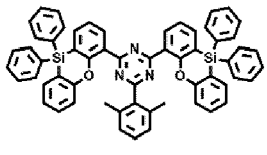

ETH46

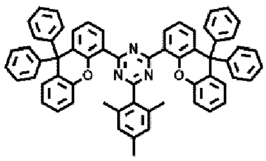

ETH47

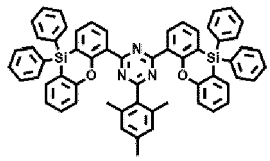

ETH48

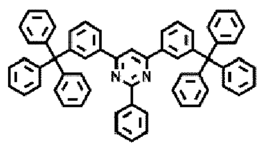

ETH49

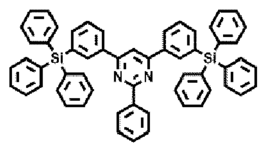

ETH50

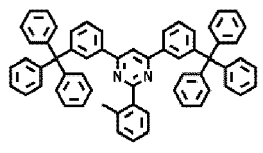

ETH51

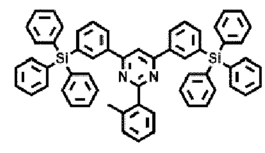

ETH52

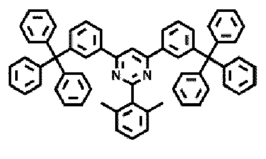

ETH53

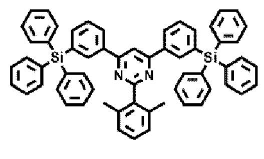

ETH54

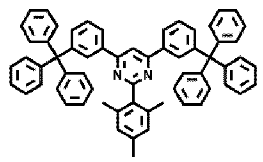

ETH55

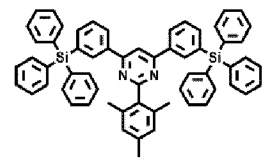

ETH56

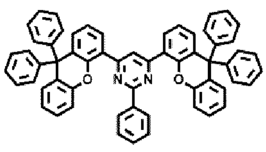

ETH57

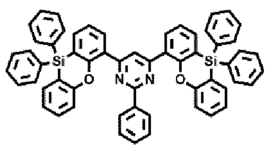

ETH58

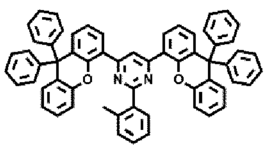

ETH59

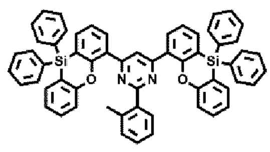

ETH60

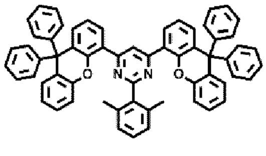

ETH61

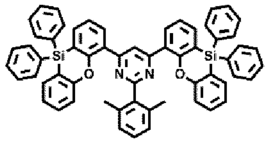

ETH62

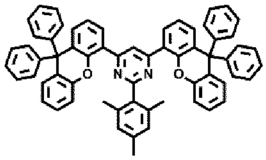

ETH63

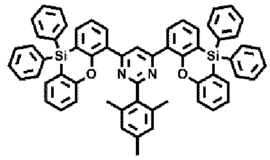

ETH64

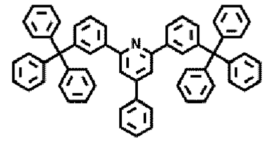

ETH65

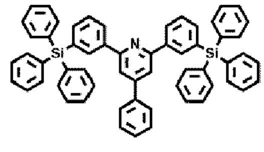

ETH66

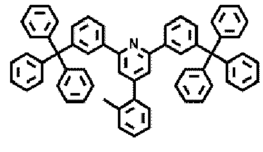

ETH67

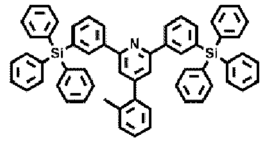

ETH68

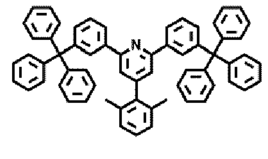

ETH69

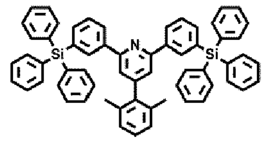

ETH70

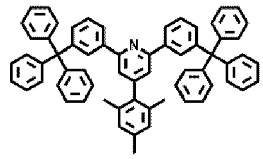

ETH71

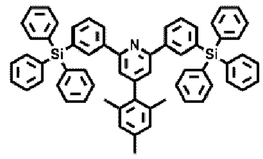

ETH72

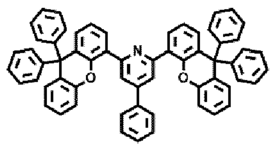

ETH73

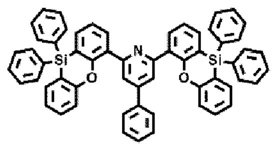

ETH74

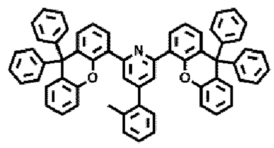

ETH75

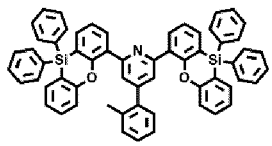

ETH76

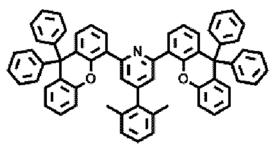

ETH77

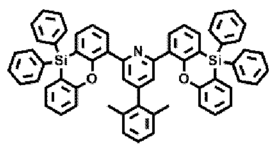

ETH78

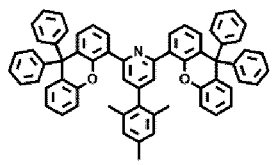

ETH79

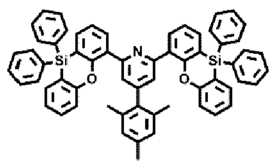

ETH80

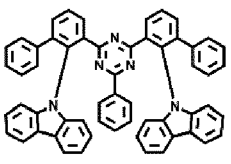

ETH81

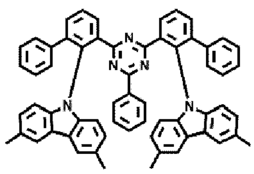

ETH82

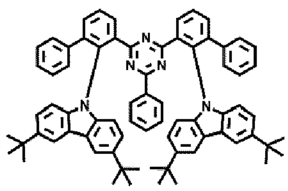

ETH83

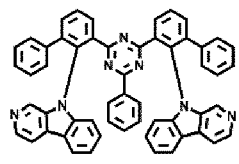

ETH84

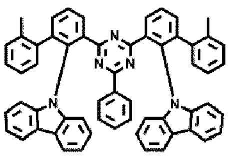

ETH85

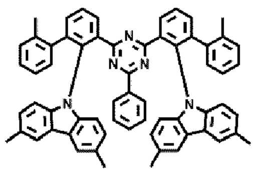

ETH86

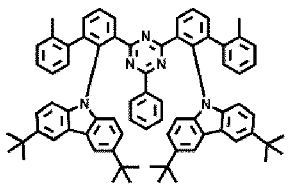

ETH87

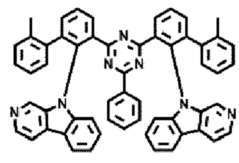

ETH88

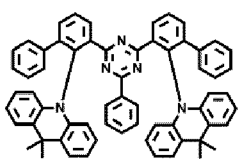

ETH89

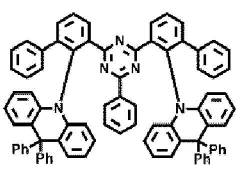

ETH90

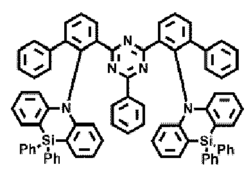

ETH91

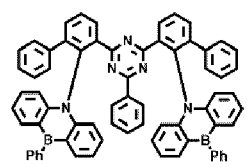

ETH92

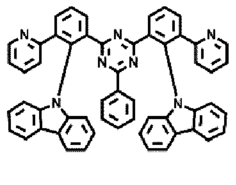
ETH93

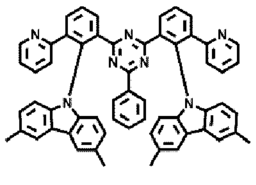
ETH94

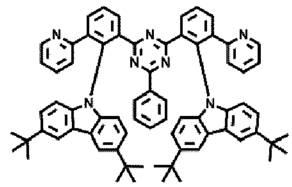
ETH95

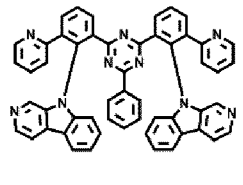
ETH96

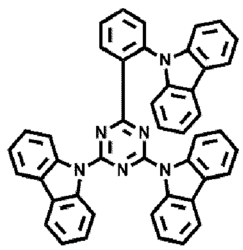
ETH97

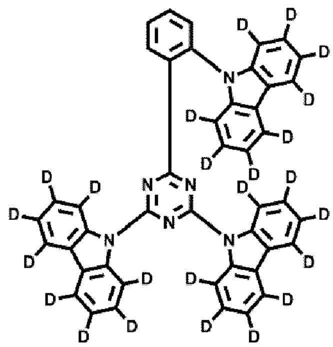
ETH98

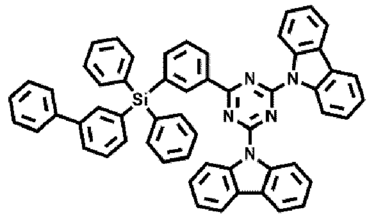
ETH99

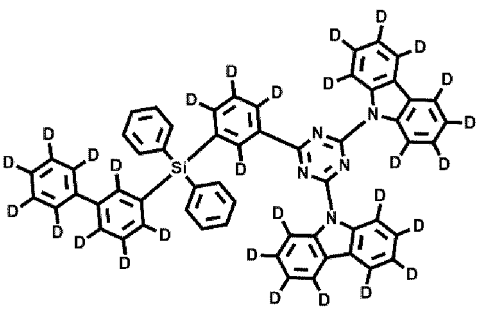
ETH100

In one or more embodiments, the third compound may be at least one selected from among Compounds HTH1 to HTH46:

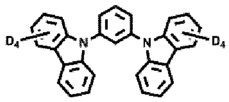
HTH1

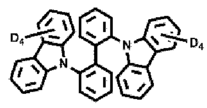
HTH2

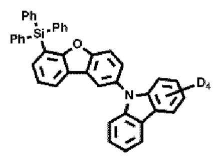
HTH3

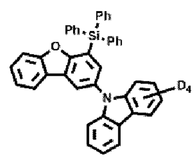
HTH4

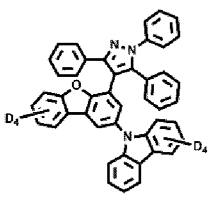
HTH5

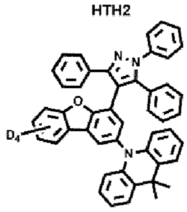
HTH6

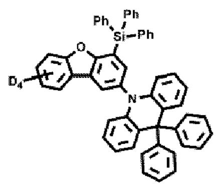
HTH7

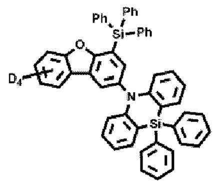
HTH8

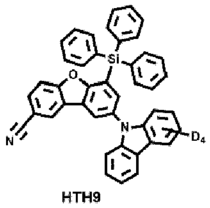
HTH9

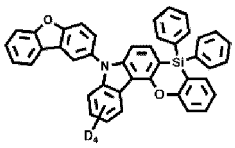
HTH10

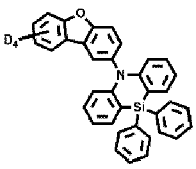
HTH11

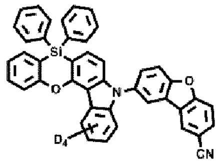
HTH12

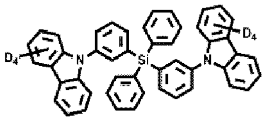
HTH13

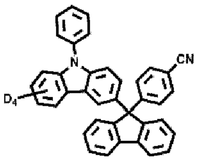
HTH14

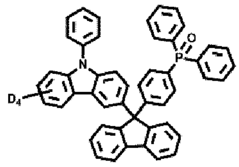
HTH15

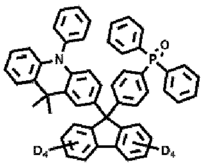
HTH16

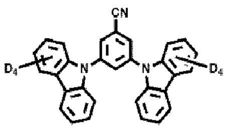
HTH17

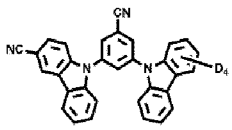
HTH18

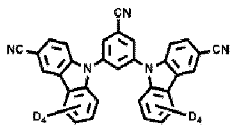
HTH19

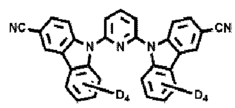
HTH20

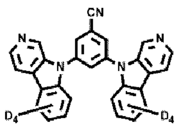
HTH21

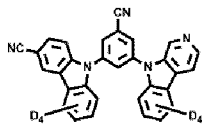
HTH22

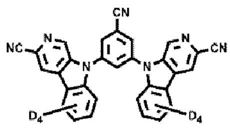
HTH23

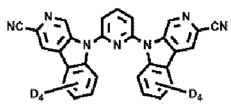
HTH24

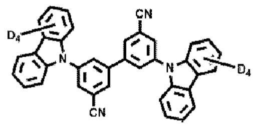
HTH25

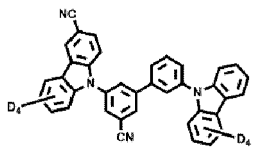
HTH26

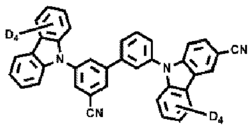
HTH27

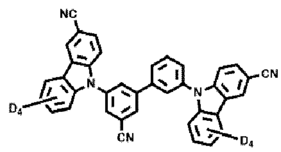
HTH28

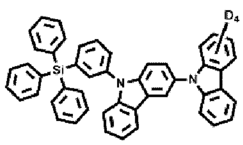
HTH29

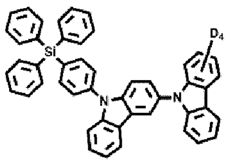
HTH30

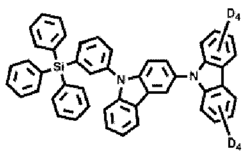
HTH31

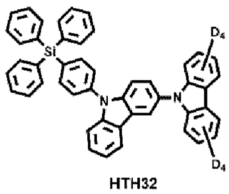
HTH32

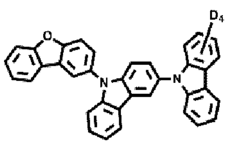
HTH33

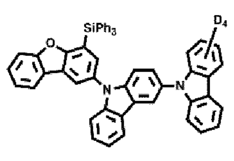
HTH34

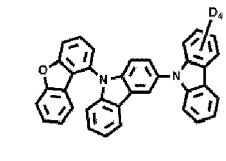
HTH35

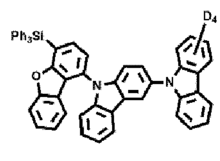
HTH36

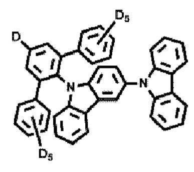

HTH37

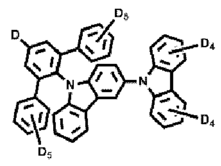

HTH38

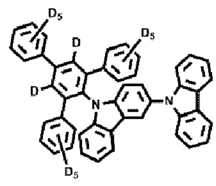

HTH39

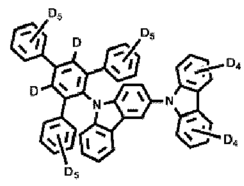

HTH40

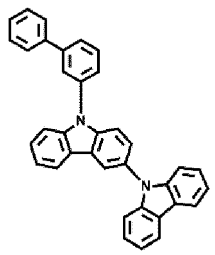

HTH41

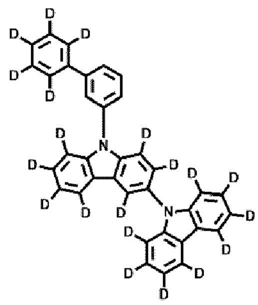

HTH42

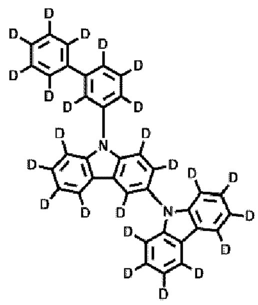

HTH43

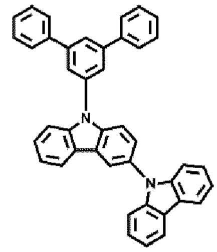

HTH44

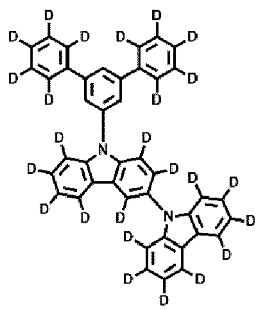

HTH45

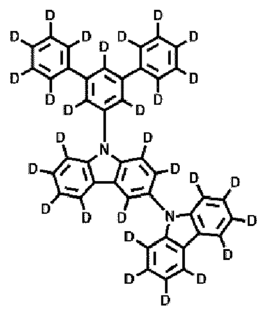

HTH46

In one or more embodiments, the fourth compound may be at least one selected from among the following Compounds DFD1 to DFD29:

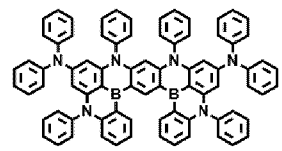

DFD1

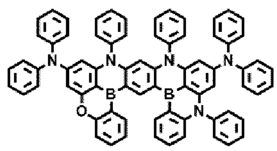

DFD2

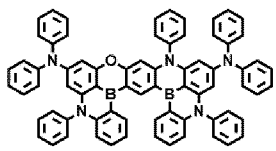

DFD3

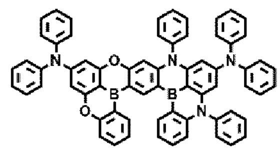

DFD4

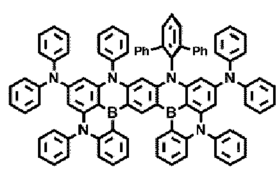

DFD5

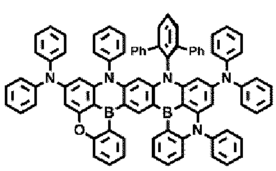

DFD6

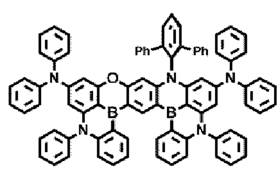

DFD7

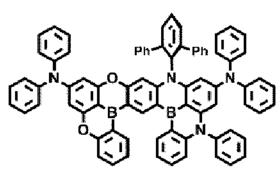

DFD8

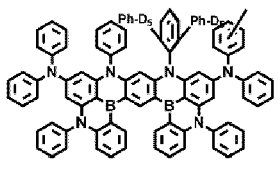

DFD9

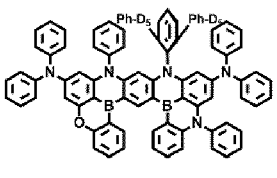

DFD10

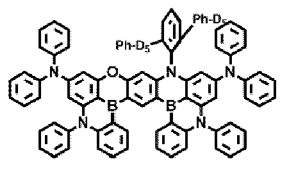

DFD11

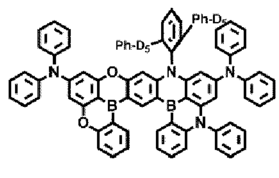

DFD12

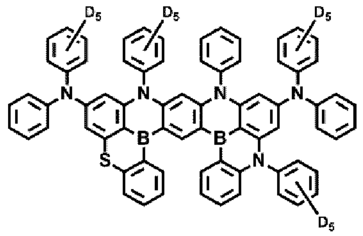

DFD13

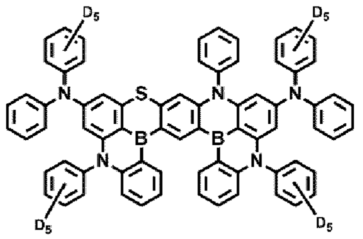

DFD14

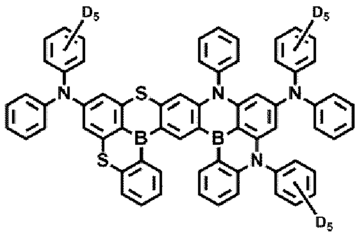

DFD15

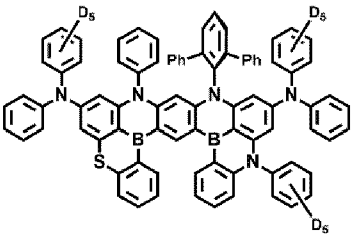

DFD16

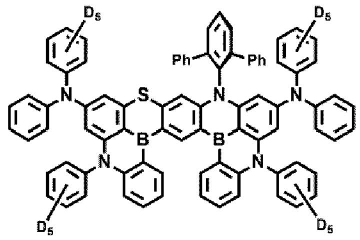

DFD17

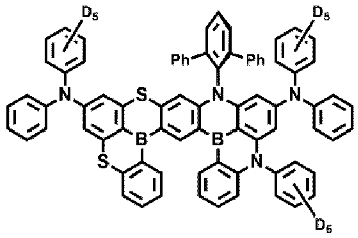

DFD18

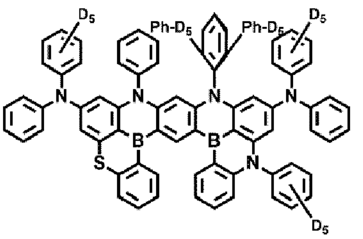

DFD19

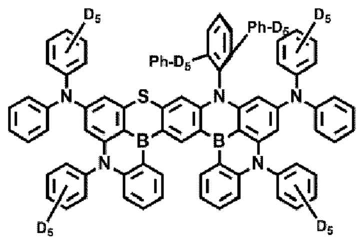

DFD20

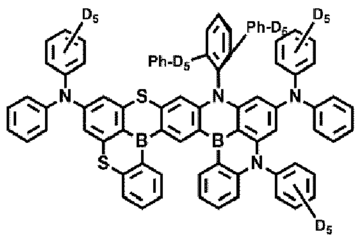

DFD21

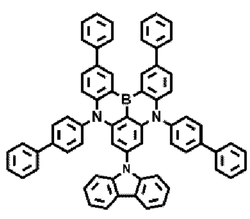

DFD22

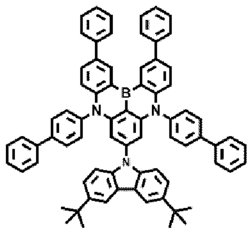

DFD23

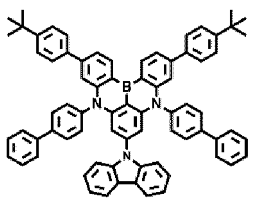

DFD24

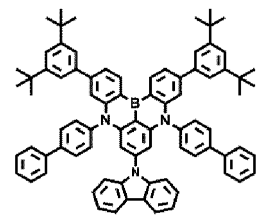

DFD25

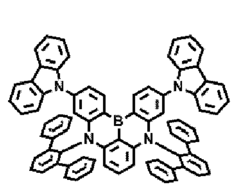

DFD26

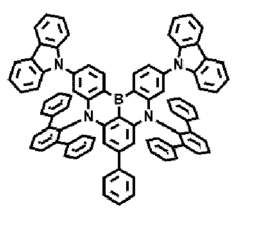

DFD27

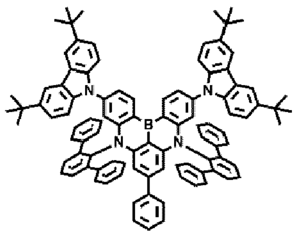

DFD28

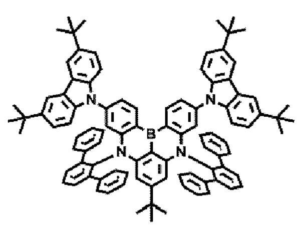

DFD29 .

In the compounds described above, Ph represents a phenyl group, $D_5$ represents substitution with five deuterium, and $D_4$ represents substitution with four deuterium. For example, a group represented by

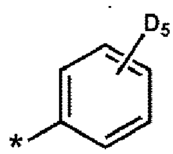

may be identical to a group represented by

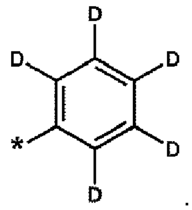

**Description of FIG. 1**

FIG. 1 is a schematic cross-sectional view of a light-emitting device 10 according to one or more embodiments of the present disclosure. The light-emitting device 10 may comprise a first electrode 110, an interlayer 130, and a second electrode 150.

Hereinafter, the structure of the light-emitting device 10 according to one or more embodiments and a method of manufacturing the light-emitting device 10 will be described in more detail with reference to FIG. 1.

**First electrode 110**

In FIG. 1, in one or more embodiments, a substrate may be additionally provided and disposed under the first electrode 110 and/or on the second electrode 150. As the substrate, a glass substrate or a plastic substrate may be utilized. In some embodiments, the substrate may be a flexible substrate, and may comprise plastics with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, applying a material for forming the first electrode 110 onto the substrate by utilizing a deposition or sputtering method. When the first electrode 110 is an anode, a material for forming the first electrode 110 may be a high work function material to facilitate injection of holes.

The first electrode 110 may be a reflective electrode, a semi-transmissive electrode, or a transmissive electrode. In one or more embodiments, when the first electrode 110 is a transmissive electrode, a material for forming the first electrode 110 may comprise indium tin oxide (ITO), indium zinc oxide (IZO), tin oxide ($SnO_2$), zinc oxide (ZnO), or any combination thereof. In one or more embodiments, when the first electrode 110 is a semi-transmissive electrode or a reflective electrode, a material for forming the first electrode 110 may comprise magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layered structure comprising (e.g., consisting of) a single layer, or a multilayer structure comprising a plurality of layers. For example, in some embodiments, the first electrode 110 may have a three-layered structure of ITO/Ag/ITO.

**Interlayer 130**

The interlayer 130 may be located on the first electrode 110. The interlayer 130 may comprise an emission layer.

In one or more embodiments, the interlayer 130 may further comprise a hole transport region located between the first electrode 110 and the emission layer and an electron transport region located between the emission layer and the second electrode 150.

In one or more embodiments, the interlayer 130 may further comprise a metal-containing compound such as an organometallic compound, an inorganic material such as a quantum dot, and/or the like, in addition to one or more suitable organic materials.

In one or more embodiments, the interlayer 130 may comprise i) two or more emitting units sequentially stacked between the first electrode 110 and the second electrode 150, and ii) a charge generation layer located between two neighboring emitting units. When the interlayer 130 comprises emitting units and a charge generation layer as described

above, the light-emitting device 10 may be a tandem light-emitting device.

**Hole transport region in interlayer 130**

The hole transport region may have: i) a single-layered structure comprising (e.g., consisting of) a single layer comprising (e.g., consisting of) a single material, ii) a single-layered structure comprising (e.g., consisting of) a single layer comprising (e.g., consisting of) a plurality of different materials, or iii) a multilayer structure comprising a plurality of layers comprising different materials.

The hole transport region may comprise a hole injection layer, a hole transport layer, an emission auxiliary layer, an electron blocking layer, or any combination thereof.

For example, in one or more embodiments, the hole transport region may have a multilayer structure comprising a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, the constituting layers of each structure being stacked sequentially from the first electrode 110 in each stated order.

In one or more embodiments, the hole transport region may comprise a compound represented by Formula 201, a compound represented by Formula 202, or any combination thereof:

Formula 201

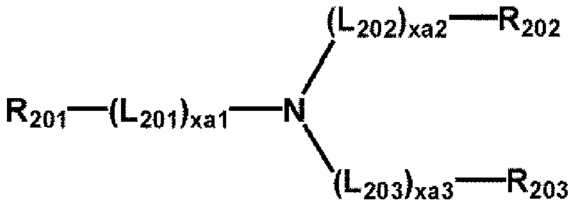

Formula 202

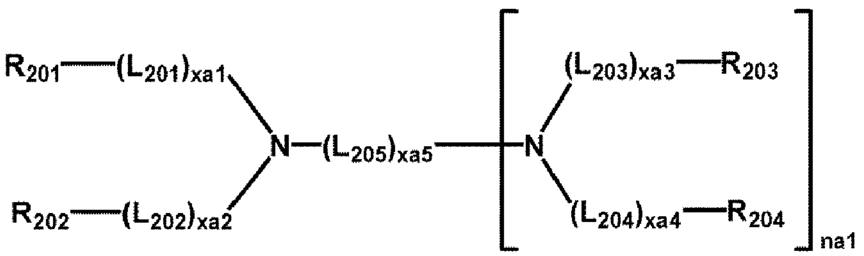

wherein, in Formulae 201 and 202,

$L_{201}$ to $L_{204}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,

$L_{205}$ may be *-O-*', *-S-*', *-N($Q_{201}$)-*', a $C_1$-$C_{20}$ alkylene group that is unsubstituted or substituted with at least one $R_{10a}$, a $C_2$-$C_{20}$ alkenylene group that is unsubstituted or substituted with at least one $R_{10a}$, a $C_3$-$C_{60}$ carbocyclic group that is unsubstituted or substituted with at least one $R_{10a}$, or a $C_1$-$C_{60}$ heterocyclic group that is unsubstituted or substituted with at least one $R_{10a}$,

xa1 to xa4 may each independently be an integer selected from 0 to 5,

xa5 may be an integer selected from 1 to 10,

$R_{201}$ to $R_{204}$ and $Q_{201}$ may each independently be a $C_3$-$C_{60}$ carbocyclic group that is unsubstituted or substituted with at least one $R_{10a}$, or a $C_1$-$C_{60}$ heterocyclic group that is unsubstituted or substituted with at least one $R_{10a}$,

$R_{201}$ and $R_{202}$ may optionally be linked to each other via a single bond, a $C_1$-$C_5$ alkylene group that is unsubstituted or substituted with at least one $R_{10a}$, or a $C_2$-$C_5$ alkenylene group that is unsubstituted or substituted with at least one $R_{10a}$, to form a $C_8$-$C_{60}$ polycyclic group (for example, a carbazole group and/or the like) that is unsubstituted or substituted with at least one $R_{10a}$ (for example, see Compound HT16),

$R_{203}$ and $R_{204}$ may optionally be linked to each other via a single bond, a $C_1$-$C_5$ alkylene group that is unsubstituted or substituted with at least one $R_{10a}$, or a $C_2$-$C_5$ alkenylene group that is unsubstituted or substituted with at least one $R_{10a}$, to form a $C_8$-$C_{60}$ polycyclic group unsubstituted or substituted with at least one $R_{10a}$, and

na1 may be an integer selected from 1 to 4.

For example, in some embodiments, each of Formulae 201 and 202 may comprise at least one selected from groups represented by Formulae CY201 to CY217:

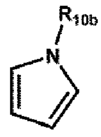
CY201

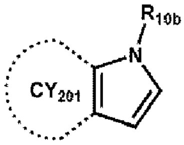
CY202

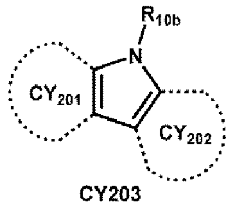
CY203

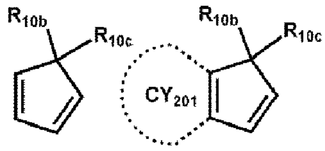
CY204 CY205

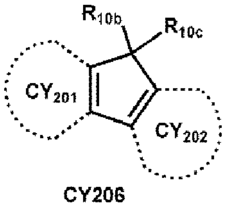
CY206

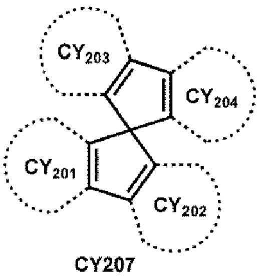
CY207

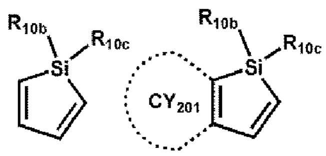
CY208 CY209

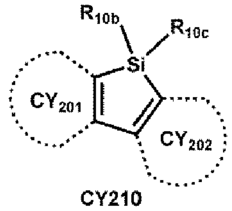
CY210

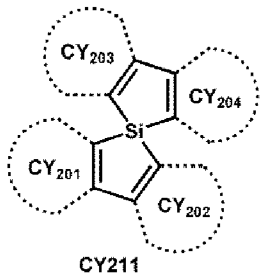
CY211

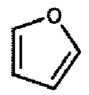
CY212

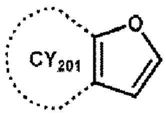
CY213

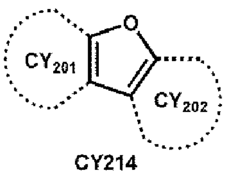
CY214

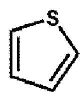
CY215

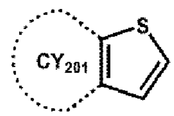
CY216

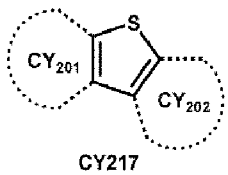
CY217

$R_{10b}$ and $R_{10c}$ in Formulae CY201 to CY217 may each be the same as defined with respect to $R_{10a}$, ring $CY_{201}$ to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with $R_{10a}$.

In one or more embodiments, ring $CY_{201}$ to ring $CY_{204}$ in Formulae CY201 to CY217 may each independently be a benzene group, a naphthalene group, a phenanthrene group, or an anthracene group.

In one or more embodiments, each of Formulae 201 and 202 may comprise at least one selected from groups represented by Formulae CY201 to CY203.

In one or more embodiments, Formula 201 may comprise at least one selected from groups represented by Formulae CY201 to CY203 and at least one selected from groups represented by Formulae CY204 to CY217.

In one or more embodiments, xa1 in Formula 201 may be 1, $R_{201}$ may be a group represented by one selected from Formulae CY201 to CY203, xa2 may be 0, and $R_{202}$ may be a group represented by one selected from Formulae CY204 to CY207.

In one or more embodiments, each of Formulae 201 and 202 may not comprise (e.g., may exclude any) groups represented by Formulae CY201 to CY203.

In one or more embodiments, each of Formulae 201 and 202 may not comprise (e.g., may exclude any) groups represented by Formulae CY201 to CY203, and may comprise at least one selected from groups represented by Formulae CY204 to CY217.

In one or more embodiments, each of Formulae 201 and 202 may not comprise (e.g., may exclude any) groups represented by Formulae CY201 to CY217.

In one or more embodiments, the hole transport region may comprise at least one selected from Compounds HT1 to HT46, 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), N,N'-di(naphthalen-1-yl)-N,N'-diphenyl-benzidine (NPB(NPD)), β-NPB, N,N'-bis(3-methylphenyl)-N,N'-diphenyl-[1,1'-biphenyl]-4,4'-diamine (TPD), Spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzene sulfonic acid (PANI/DBSA), poly(3,4-ethylene dioxythiophene)/poly(4-styrene sulfonate) (PEDOT/PSS), polyaniline/camphor sulfonic acid (PANI/CSA), polyaniline/poly(4-styrene sulfonate) (PANI/PSS), and/or any combination thereof:

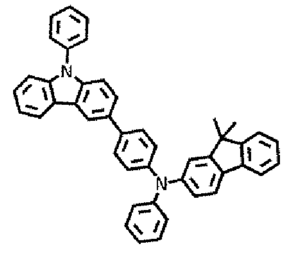

HT1

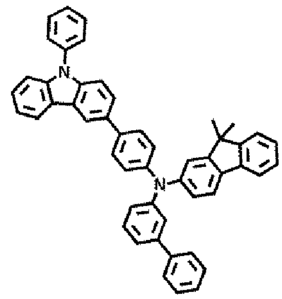

HT2

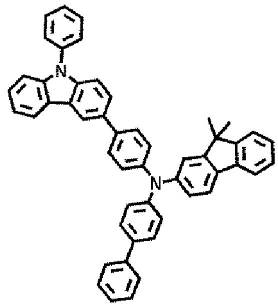

HT3

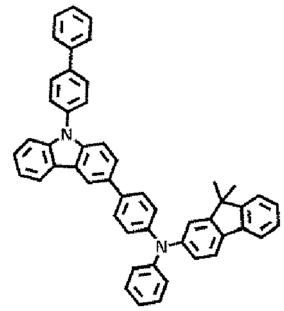

HT4

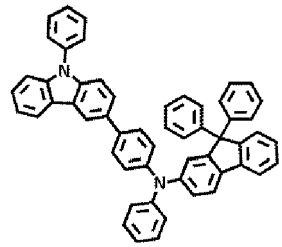

HT5

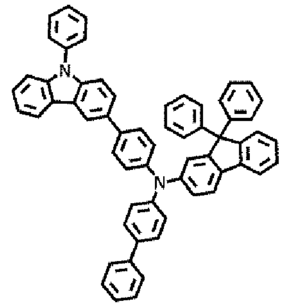

HT6

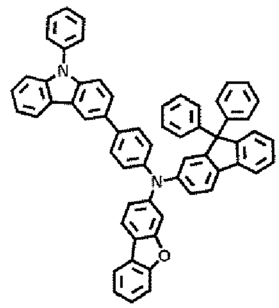

HT7

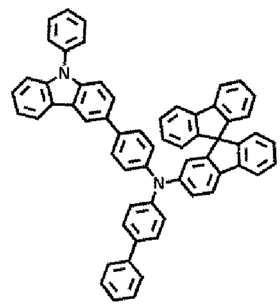

HT8

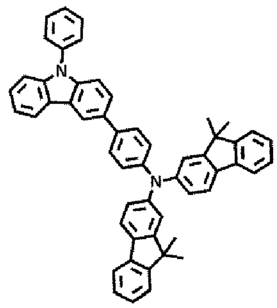

HT9

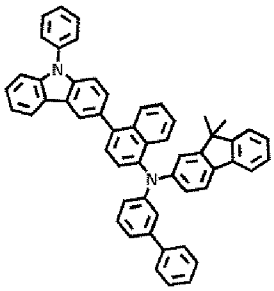

HT10

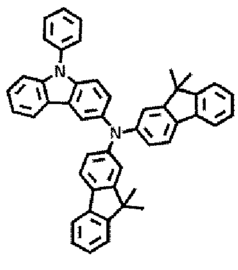

HT11

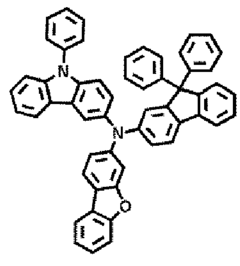

HT12

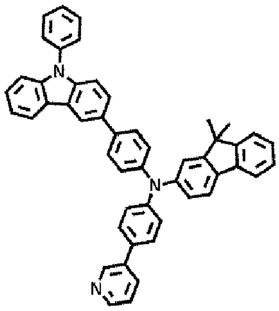
HT13

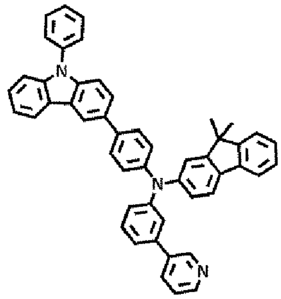
HT14

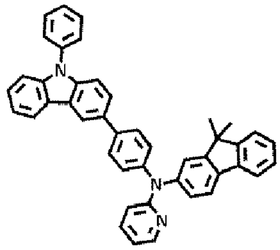
HT15

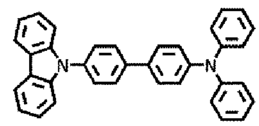
HT16

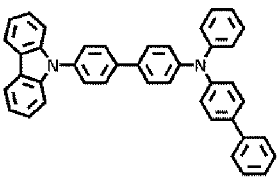
HT17

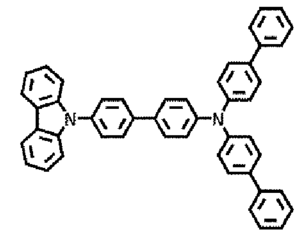
HT18

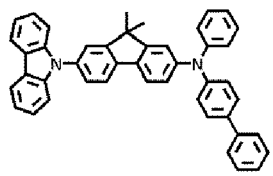
HT19

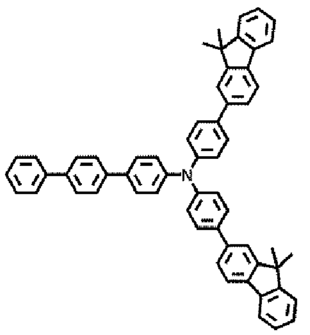
HT20

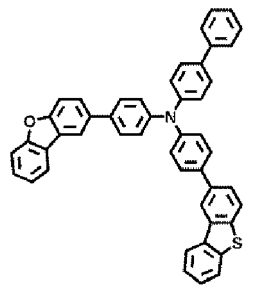
HT21

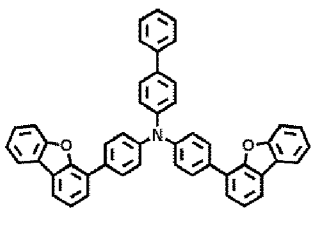
HT22

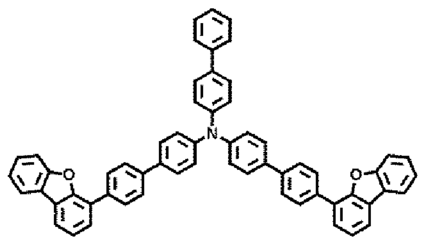
HT23

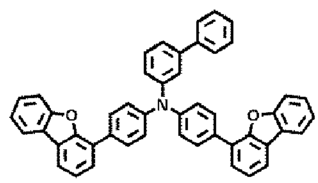
HT24

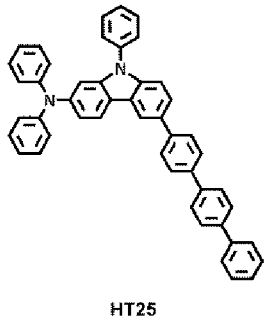
HT25

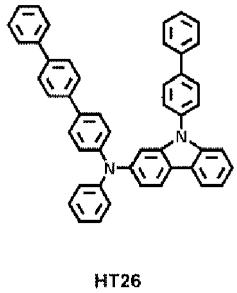
HT26

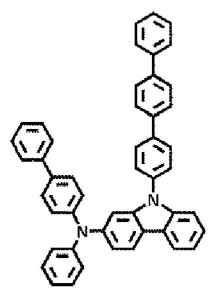
HT27

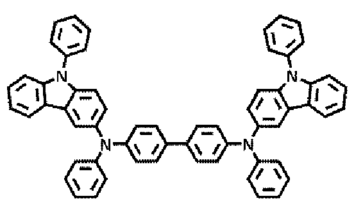
HT28

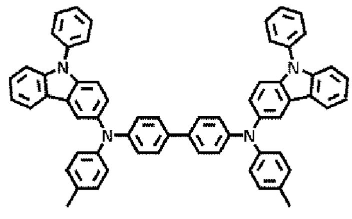
HT29

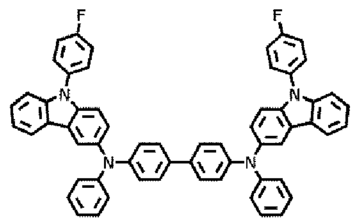
HT30

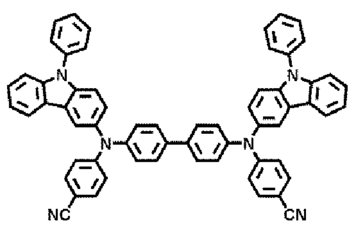
HT31

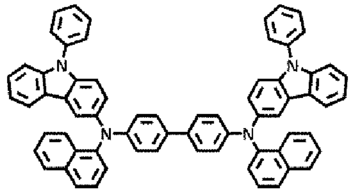
HT32

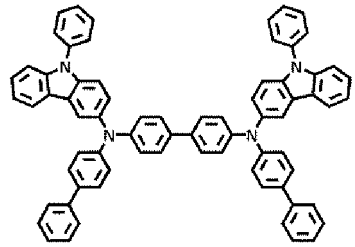
HT33

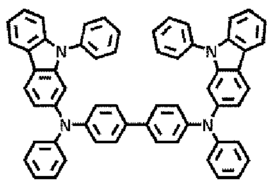
HT34

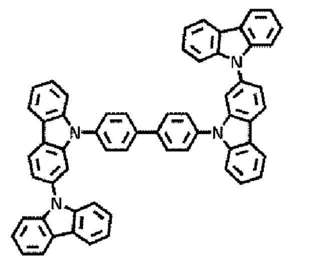
HT35

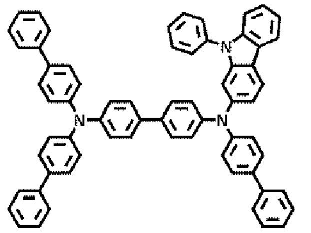
HT36

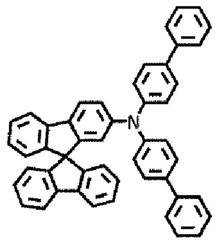
HT37

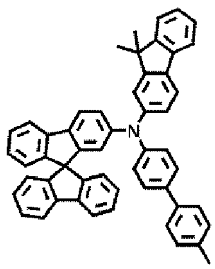
HT38

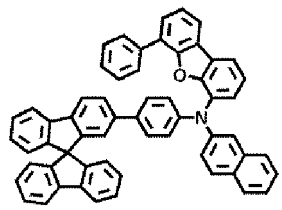
HT39

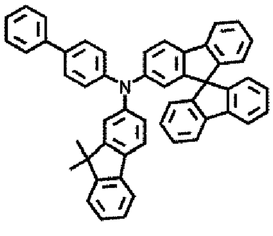
HT40

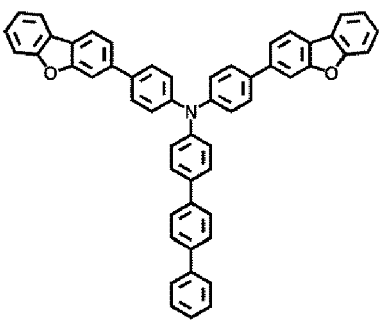
HT41

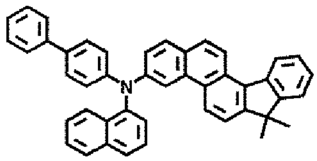
HT42

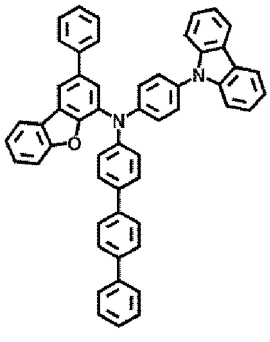

HT43

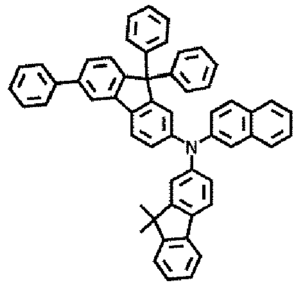

HT44

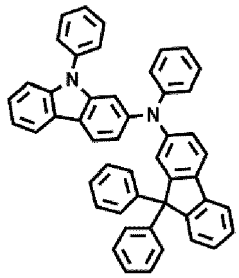

HT45

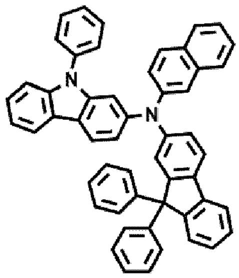

HT46

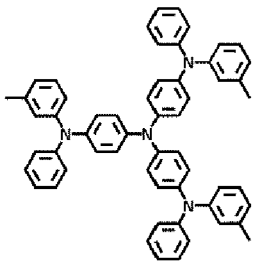

m-MTDATA

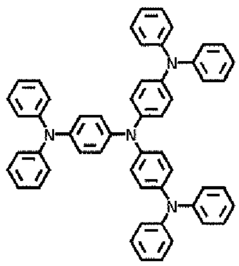

TDATA

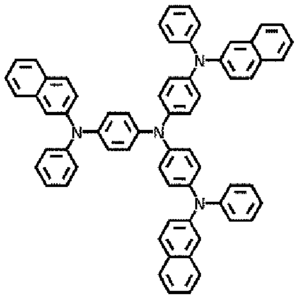

2-TNATA

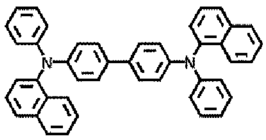

NPB

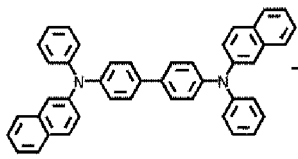

β-NPB

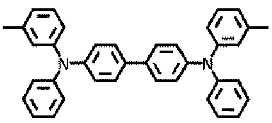

TPD

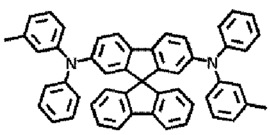

Spiro-TPD

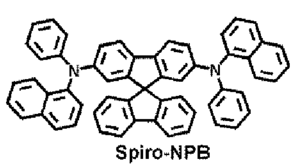

Spiro-NPB

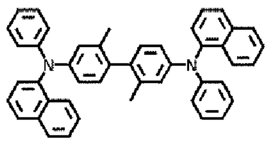

methylated-NPB

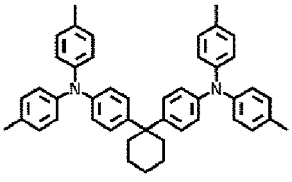

TAPC

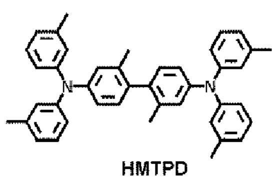

HMTPD

A thickness of the hole transport region may be about 50 Å to about 10,000 Å, for example, about 100 Å to about 4,000 Å. When the hole transport region comprises a hole injection layer, a hole transport layer, or any combination thereof, a thickness of the hole injection layer may be about 100 Å to about 9,000 Å, for example, about 100 Å to about 1,000 Å, and a thickness of the hole transport layer may be about 50 Å to about 2,000 Å, for example, about 100 Å to about 1,500 Å. When the thicknesses of the hole transport region, the hole injection layer, and the hole transport layer

are within these ranges, satisfactory hole-transporting characteristics may be obtained without a substantial increase in driving voltage.

The emission auxiliary layer may increase light-emission efficiency by compensating for an optical resonance distance according to the wavelength of light emitted by the emission layer, and the electron blocking layer may block or reduce the leakage of electrons from the emission layer to the hole transport region. Materials that may be included in the hole transport region may be included in the emission auxiliary layer and the electron blocking layer.

**p-dopant**

In one or more embodiments, the hole transport region may further comprise, in addition to these aforementioned materials, a charge-generation material for the improvement of conductive properties. The charge-generation material may be substantially uniformly or non-uniformly dispersed in the hole transport region (for example, in the form of a single layer comprising (e.g., consisting of) a charge-generation material).

The charge-generation material may be, for example, a p-dopant.

For example, in some embodiments, a LUMO energy level of the p-dopant may be about -3.5 eV or less.

In one or more embodiments, the p-dopant may comprise a quinone derivative, a cyano group-containing compound, a compound containing an element EL1 and an element EL2, or any combination thereof.

Non-limiting examples of the quinone derivative may comprise tetracyanoquinodimethane (TCNQ), 2,3,5,6-tetrafluoro-7,7,8,8-tetracyanoquinodimethane (F4-TCNQ), and/or the like.

Non-limiting examples of the cyano group-containing compound may comprise dipyrazino[2,3-f: 2',3'-h] quinoxaline-2,3,6,7,10,11-hexacarbonitrile (HAT-CN), a compound represented by Formula 221, and/or the like.

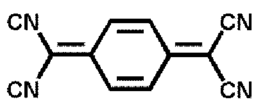

TCNQ

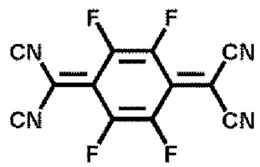

F4-TCNQ

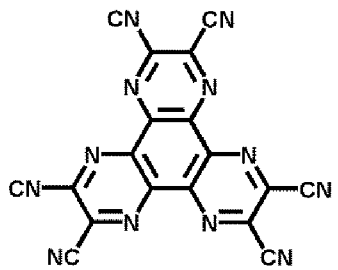

HAT-CN

Formula 221

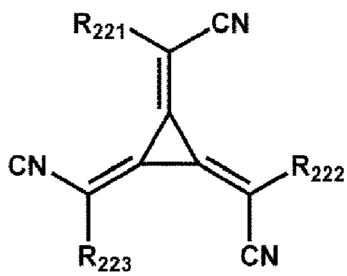

.

In Formula 221,

$R_{221}$ to $R_{223}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$, and

at least one selected from among $R_{221}$ to $R_{223}$ may each independently be a $C_3$-$C_{60}$ carbocyclic group or a $C_1$-$C_{60}$ heterocyclic group, each substituted with: a cyano group; -F; -Cl; -Br; -I; a $C_1$-$C_{20}$ alkyl group substituted with a cyano group, -F, -Cl, -Br, -I, or any combination thereof; or any combination thereof.

In the compound containing the element EL1 and the element EL2, the element EL1 may be metal, metalloid, or a combination thereof, and the element EL2 may be non-metal, metalloid, or a combination thereof.

Non-limiting examples of the metal may comprise an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium

(Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); and/or a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.).

Non-limiting examples of the metalloid may comprise silicon (Si), antimony (Sb), and/or tellurium (Te).

Non-limiting examples of the non-metal may comprise oxygen (O) and/or halogen (for example, F, Cl, Br, I, etc.).

For example, in one or more embodiments, the compound containing the element EL1 and the element EL2 may comprise a metal oxide, a metal halide (for example, a metal fluoride, a metal chloride, a metal bromide, or a metal iodide), a metalloid halide (for example, a metalloid fluoride, a metalloid chloride, a metalloid bromide, or a metalloid iodide), a metal telluride, or any combination thereof.

Non-limiting examples of the metal oxide may comprise a tungsten oxide (for example, WO, $W_2O_3$, $WO_2$, $WO_3$, $W_2O_5$, etc.), a vanadium oxide (for example, VO, $V_2O_3$, $VO_2$, $V_2O_5$, etc.), a molybdenum oxide (MoO, $Mo_2O_3$, $MoO_2$, MoOs, $Mo_2O_5$, etc.), and/or a rhenium oxide (for example, ReOs, etc.).

Non-limiting examples of the metal halide may comprise an alkali metal halide, an alkaline earth metal halide, a transition metal halide, a post-transition metal halide, and/or a lanthanide metal halide.

Non-limiting examples of the alkali metal halide may comprise LiF, NaF, KF, RbF, CsF, LiCl, NaCl, KCl, RbCl, CsCl, LiBr, NaBr, KBr, RbBr, CsBr, LiI, NaI, KI, RbI, and/or CsI.

Non-limiting examples of the alkaline earth metal halide may comprise $BeF_2$, $MgF_2$, $CaF_2$, $SrF_2$, $BaF_2$, $BeCl_2$, $MgCl_2$, $CaCl_2$, $SrCl_2$, $BaCl_2$, $BeBr_2$, $MgBr_2$, $CaBr_2$, $SrBr_2$, $BaBr_2$, $BeI_2$, $MgI_2$, $CaI_2$, $SrI_2$, and/or $BaI_2$.

Non-limiting examples of the transition metal halide may comprise a titanium halide (for example, $TiF_4$, TiCla, $TiBr_4$, $TiI_4$, etc.), a zirconium halide (for example, $ZrF_4$, ZrCl4, $ZrBr_4$, $ZrI_4$, etc.), a hafnium halide (for example, $HfF_4$, $HfCl_4$, $HfBr_4$, $HfI_4$, etc.), a vanadium halide (for example, $VF_3$, $VCl_3$, $VBr_3$, $VI_3$, etc.), a niobium halide (for example, $NbF_3$, $NbCl_3$, $NbBr_3$, $NbI_3$, etc.), a tantalum halide (for example, $TaF_3$, $TaCl_3$, $TaBr_3$, $TaI_3$, etc.), a chromium halide (for example, $CrF_3$, $CrCl_3$, $CrBr_3$, $CrI_3$, etc.), a molybdenum halide (for example, $MoF_3$, $MoCl_3$, $MoBr_3$, $MoI_3$, etc.), a tungsten halide (for example, $WF_3$, $WCl_3$, $WBr_3$, $WI_3$, etc.), a manganese halide (for example, $MnF_2$, $MnCl_2$, $MnBr_2$, $MnI_2$, etc.), a technetium halide (for example, $TcF_2$, $TcCl_2$, $TcBr_2$, $TcI_2$, etc.), a rhenium halide (for example, $ReF_2$, $ReCl_2$, $ReBr_2$, $ReI_2$, etc.), an iron halide (for example, $FeF_2$, $FeCl_2$, $FeBr_2$, $FeI_2$, etc.), a ruthenium halide (for example, $RuF_2$, $RuCl_2$, $RuBr_2$, $RuI_2$, etc.), an osmium halide (for example, $OsF_2$, $OsCl_2$, $OsBr_2$, $OsI_2$, etc.), a cobalt halide (for example, $CoF_2$, $CoCl_2$, $CoBr_2$, $CoI_2$, etc.), a rhodium halide (for example, $RhF_2$, $RhCl_2$, $RhBr_2$, $RhI_2$, etc.), an iridium halide (for example, $IrF_2$, $IrCl_2$, $IrBr_2$, $IrI_2$, etc.), a nickel halide (for example, $NiF_2$, $NiCl_2$, $NiBr_2$, $NiI_2$, etc.), a palladium halide (for example, $PdF_2$, $PdCl_2$, $PdBr_2$, $PdI_2$, etc.), a platinum halide (for example, $PtF_2$, $PtCl_2$, $PtBr_2$, $PtI_2$, etc.), a copper halide (for example, CuF, CuCl, CuBr, CuI, etc.), a silver halide (for example, AgF, AgCl, AgBr, AgI, etc.), and/or a gold halide (for example, AuF, AuCl, AuBr, AuI, etc.).

Non-limiting examples of the post-transition metal halide may comprise a zinc halide (for example, $ZnF_2$, $ZnCl_2$, $ZnBr_2$, $ZnI_2$, etc.), an indium halide (for example, $InI_3$, etc.), and/or a tin halide (for example, $SnI_2$, etc.).

Non-limiting examples of the lanthanide metal halide may comprise YbF, $YbF_2$, $YbF_3$, $SmF_3$, YbCl, $YbCl_2$, $YbCl_3$ $SmCl_3$, YbBr, $YbBr_2$, $YbBr_3$, $SmBr_3$, YbI, $YbI_2$, $YbI_3$, and/or $SmI_3$.

Non-limiting examples of the metalloid halide may comprise an antimony halide (for example, $SbCl_5$, etc.).

Non-limiting examples of the metal telluride may comprise an alkali metal telluride (for example, $Li_2Te$, $Na_2Te$, $K_2Te$, $Rb_2Te$, $Cs_2Te$, etc.), an alkaline earth metal telluride (for example, BeTe, MgTe, CaTe, SrTe, BaTe, etc.), a transition metal telluride (for example, $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, etc.), a post-transition metal telluride (for example, ZnTe, etc.), and/or a lanthanide metal telluride (for example, LaTe, CeTe, PrTe, NdTe, PmTe, EuTe, GdTe, TbTe, DyTe, HoTe, ErTe, TmTe, YbTe, LuTe, etc.).

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and/or a blue emission layer, in which the two or more layers may contact each other or may be separated from each other, to emit white light (e.g., combined white light). In one or more embodiments, the emission layer may comprise two or more materials of a red light-emitting material, a green light-emitting material, and/or a blue light-emitting material, in which the two or more materials may be mixed with each other in a single layer, to emit white light (e.g., combined white light).

In one or more embodiments, the emission layer may comprise a host and a dopant (or emitter). In some

embodiments, the emission layer may further comprise an auxiliary dopant that promotes energy transfer to a dopant (or emitter), in addition to the host and the dopant (or emitter). When the emission layer comprises the dopant (or emitter) and the auxiliary dopant, the dopant (or emitter) and the auxiliary dopant are different from each other.

In one or more embodiments, the organometallic compound represented by Formula 1 in the present disclosure may serve as the dopant (or emitter), or may serve as the auxiliary dopant.

An amount (weight) of the dopant (or emitter) in the emission layer may be about 0.01 parts by weight to about 15 parts by weight based on 100 parts by weight of the host.

In one or more embodiments, the emission layer may comprise the organometallic compound represented by Formula 1. An amount (weight) of the organometallic compound in the emission layer may be about 0.01 parts by weight to about 30 parts by weight, about 0.1 parts by weight to about 20 parts by weight, or about 0.1 parts by weight to about 15 parts by weight, based on 100 parts by weight of the emission layer.

A thickness of the emission layer may be about 100 Å to about 1,000 Å, for example, about 200 Å to about 600 Å. When the thickness of the emission layer is within the range, excellent or suitable light-emission characteristics may be obtained without a substantial increase in driving voltage.

**Host**

In one or more embodiments, the host in the emission layer may comprise the second compound or the third compound described in the present disclosure, or any combination thereof.

In one or more embodiments, the host may comprise a compound represented by Formula 301.

**Formula 301** $[Ar_{301}]_{xb11}-[(L_{301})_{xb1}-R_{301}]_{xb21}$.

In Formula 301,

$Ar_{301}$ and $L_{301}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
xb11 may be 1, 2, or 3,
xb1 may be an integer selected from 0 to 5,
$R_{301}$ may be hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$,-Si($Q_{301}$)($Q_{302}$)($Q_{303}$), -N($Q_{301}$)($Q_{302}$), - B($Q_{301}$)($Q_{302}$), -C(=O)($Q_{301}$), -S(=O)$_2$($Q_{301}$), or -P(=O)($Q_{301}$)($Q_{302}$),
xb21 may be an integer selected from 1 to 5, and
$Q_{301}$ to $Q_{303}$ may each be the same as described with respect to $Q_1$.

For example, in some embodiments, when xb11 in Formula 301 is 2 or more, two or more $Ar_{301}$(s) may be linked to each other via a single bond.

In one or more embodiments, the host may comprise a compound represented by Formula 301-1, a compound represented by Formula 301-2, or any combination thereof:

**Formula 301-1**

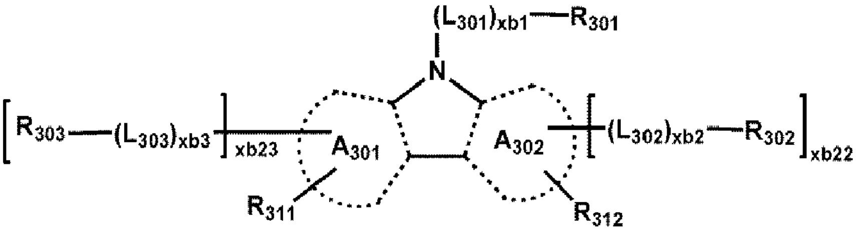

**Formula 301-2**

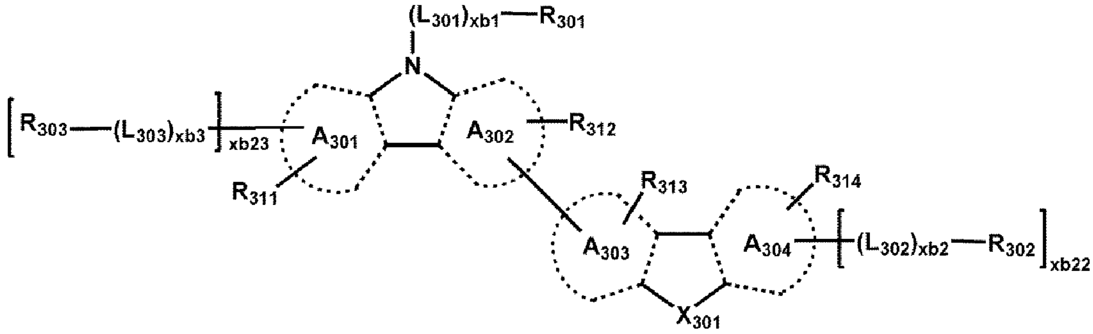

,

wherein, in Formulae 301-1 and 301-2,

rings $A_{301}$ to $A_{304}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,

$X_{301}$ may be O, S, N-[$(L_{304})_{xb4}$-$R_{304}$], $C(R_{304})(R_{305})$, or $Si(R_{304})(R_{305})$,

xb22 and xb23 may each independently be 0, 1, or 2,

$L_{301}$, xb1, and $R_{301}$ may each independently be the same as described in the present disclosure,

$L_{302}$ to $L_{304}$ may each be the same as described with respect to $L_{301}$,

xb2 to xb4 may each be the same as described with respect to xb1, and

$R_{302}$ to $R_{305}$ and $R_{311}$ to $R_{314}$ may each be the same as described with respect to R301 .

In one or more embodiments, the host may comprise an alkaline earth metal complex, a post-transition metal complex, or any combination thereof. For example, the host may comprise a Be complex (for example, Compound H55), an Mg complex, a Zn complex, or any combination thereof.

In one or more embodiments, the host may comprise at least one selected from among Compounds H1 to H130, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di(carbazol-9-yl)benzene (mCP), 1,3,5-tri(carbazol-9-yl)benzene (TCP), and/or any combination thereof:

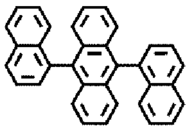

H1

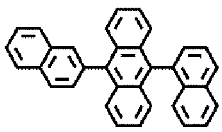

H2

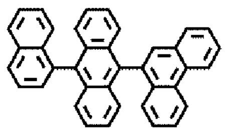

H3

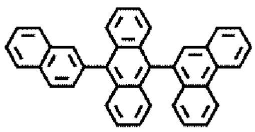

H4

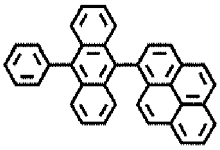

H5

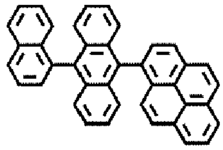

H6

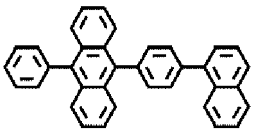

H7

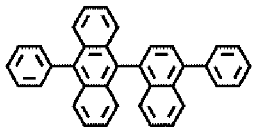

H8

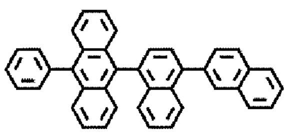

H9

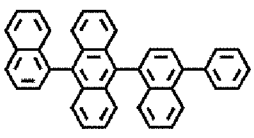

H10

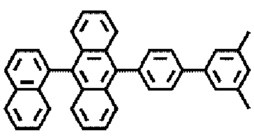

H11

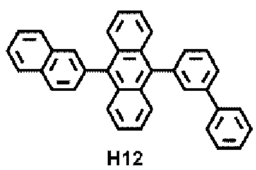

H12

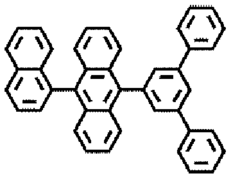
H13

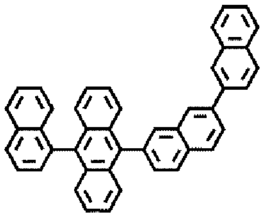
H14

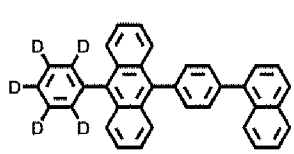
H15

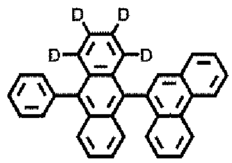
H16

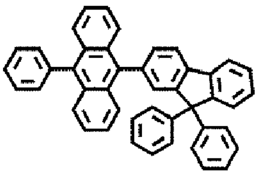
H17

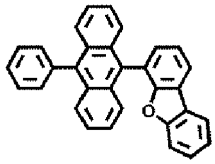
H18

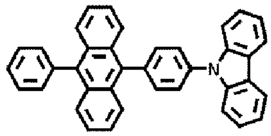
H19

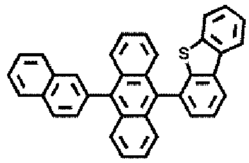
H20

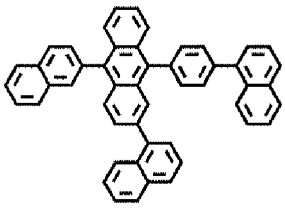
H21

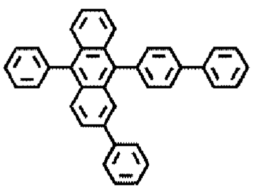
H22

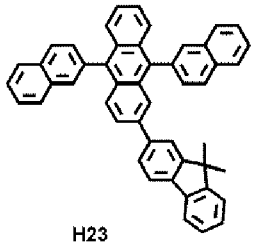
H23

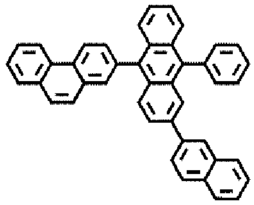
H24

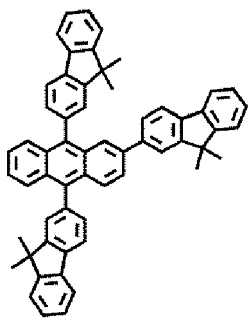
H25

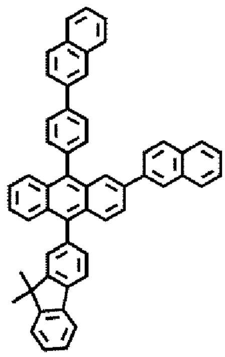
H26

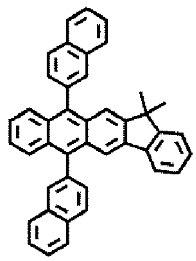
H27

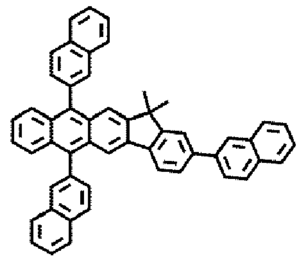
H28

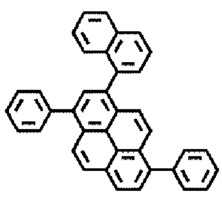
H29

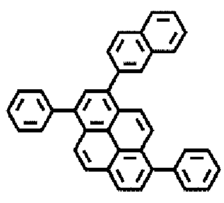
H30

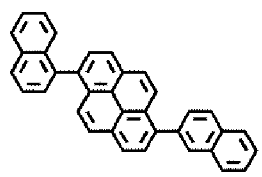
H31

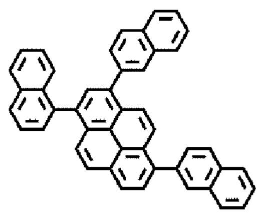
H32

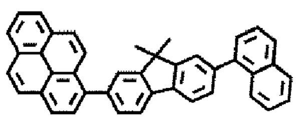
H33

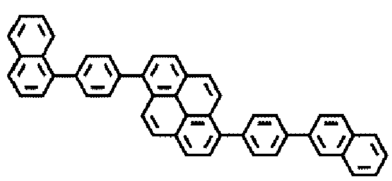
H34

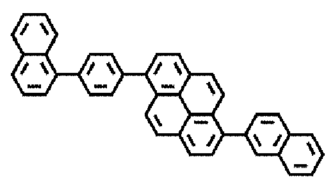
H35

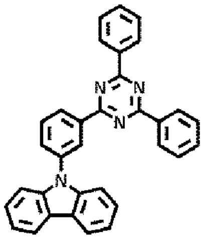
H36

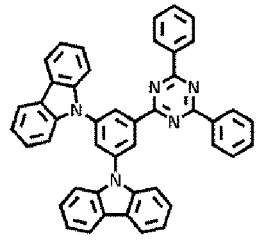
H37

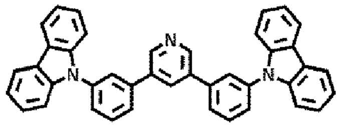
H38

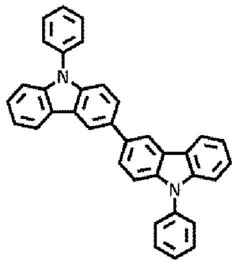
H39

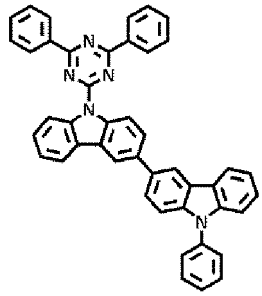
H40

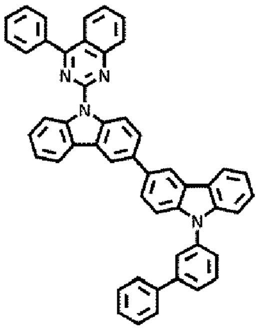
H41

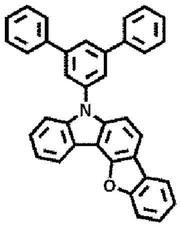
H42

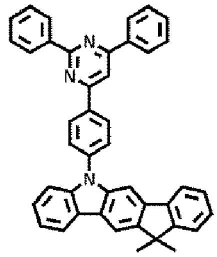
H43

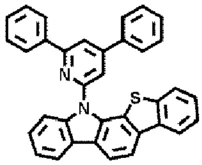
H44

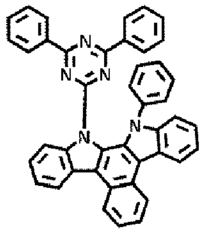
H45

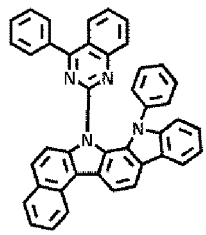
H46

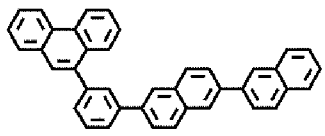
H47

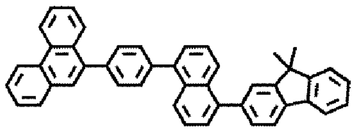
H48

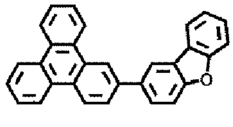
H49

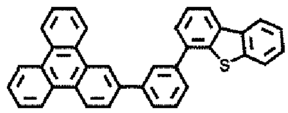
H50

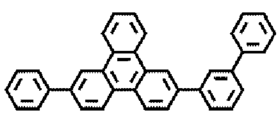
H51

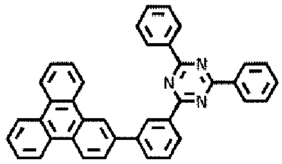
H52

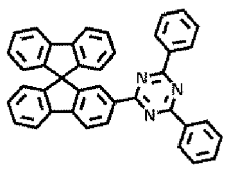
H53

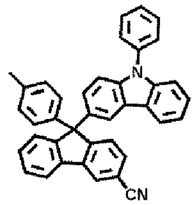
H54

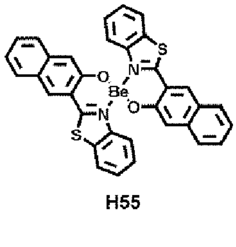
H55

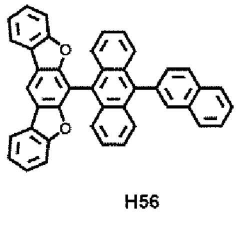
H56

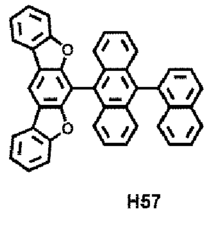
H57

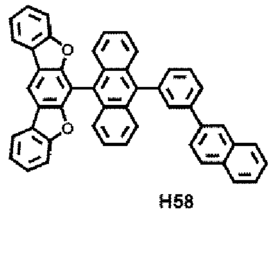
H58

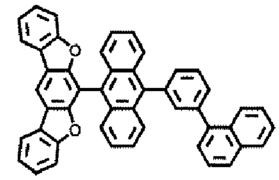

H59

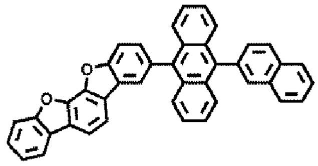

H60

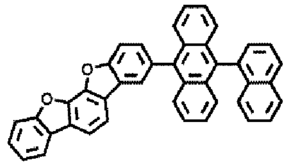

H61

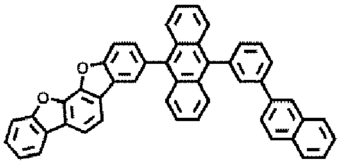

H62

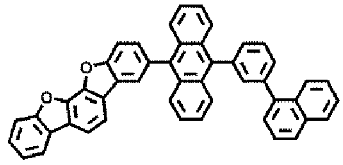

H63

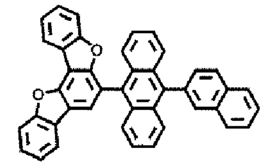

H64

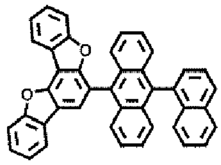

H65

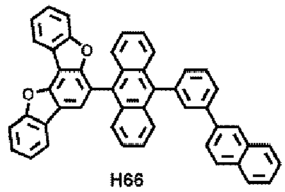

H66

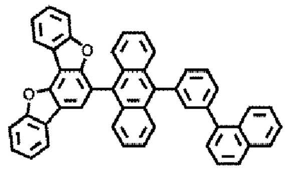

H67

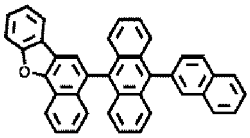

H68

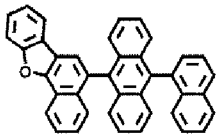

H69

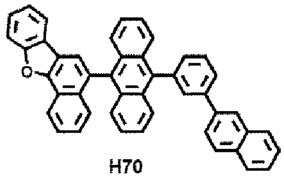

H70

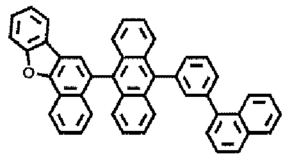

H71

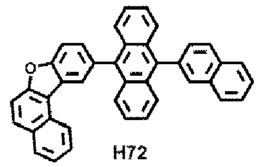

H72

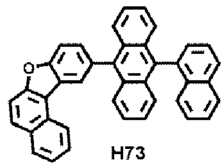

H73

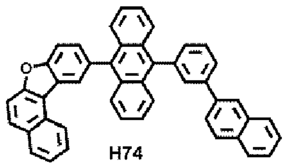

H74

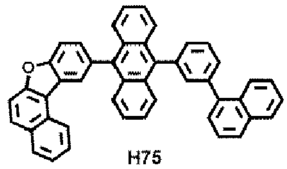

H75

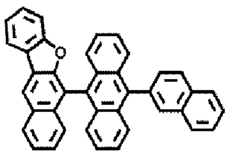

H76

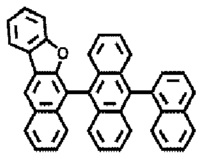

H77

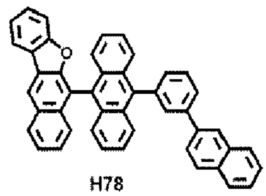

H78

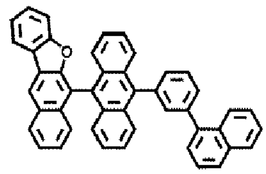

H79

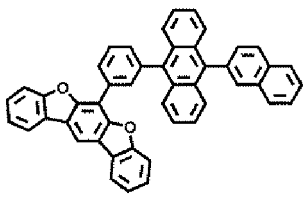

H80

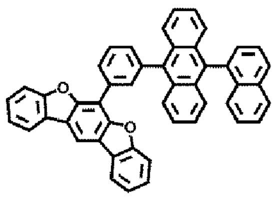

H81

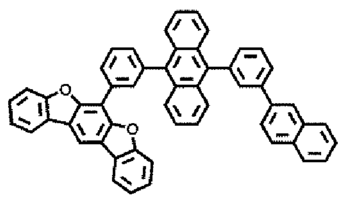

H82

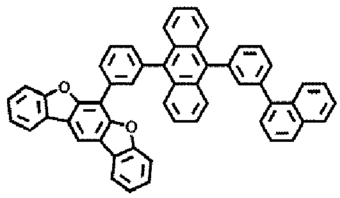
H83

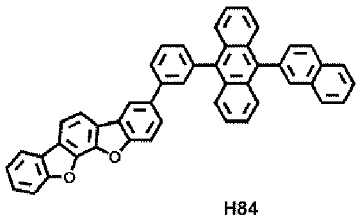
H84

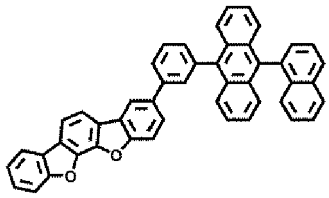
H85

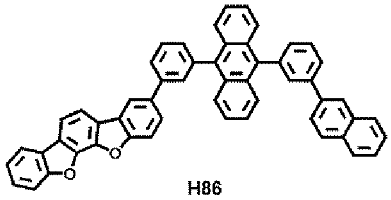
H86

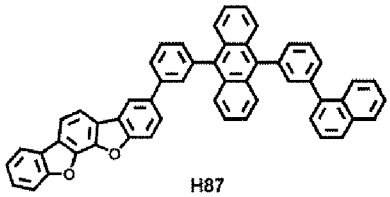
H87

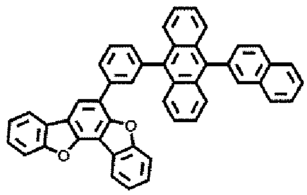
H88

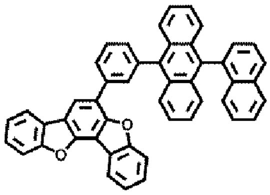
H89

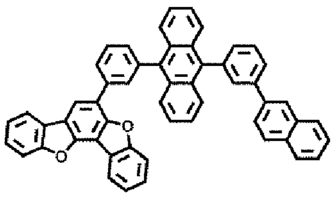
H90

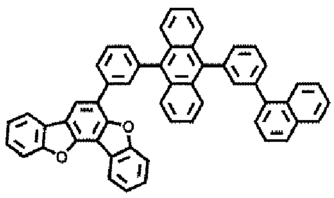
H91

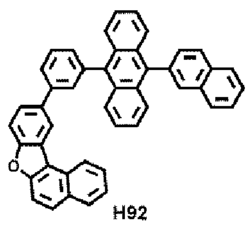
H92

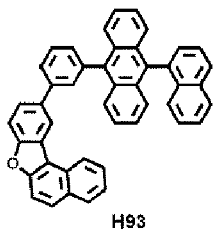
H93

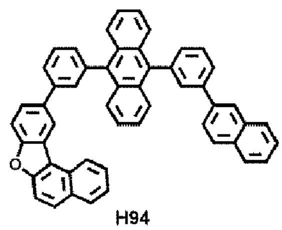
H94

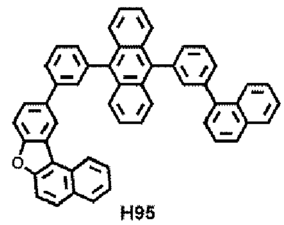
H95

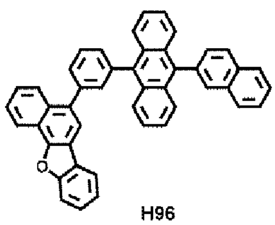
H96

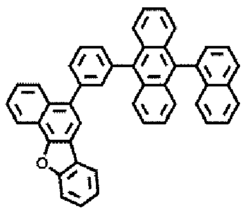
H97

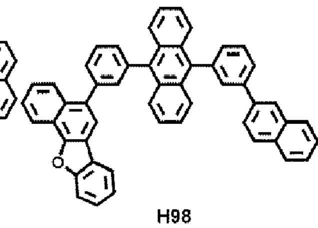
H98

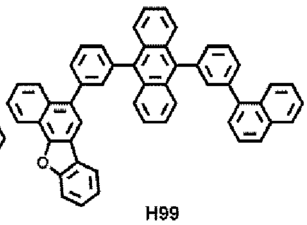
H99

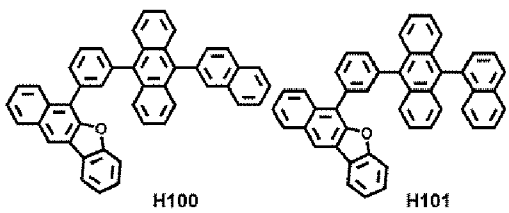
H100

H101

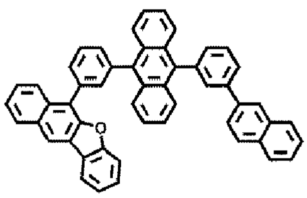
H102

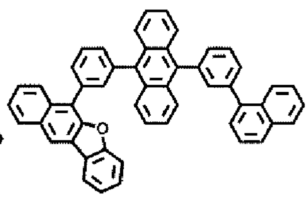
H103

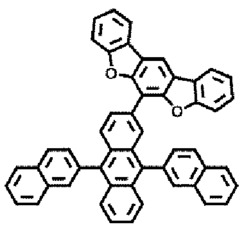

H104

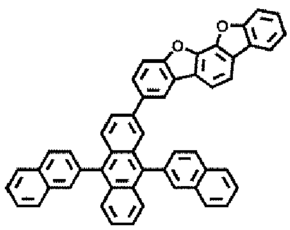

H105

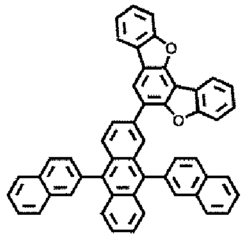

H106

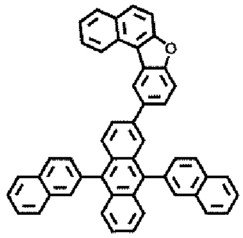

H107

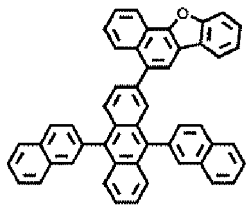

H108

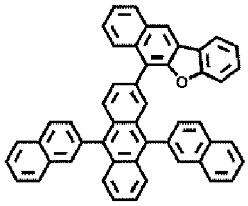

H109

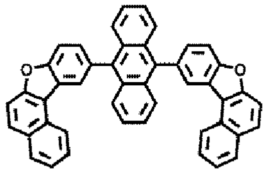

H110

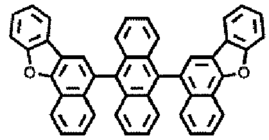

H111

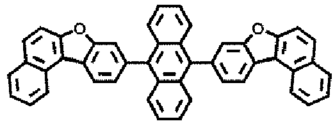

H112

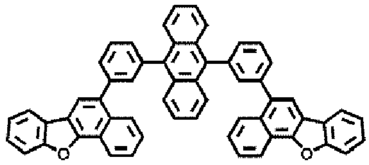

H113

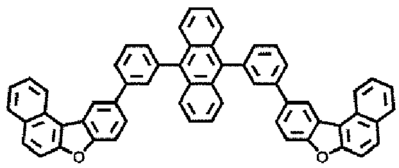

H114

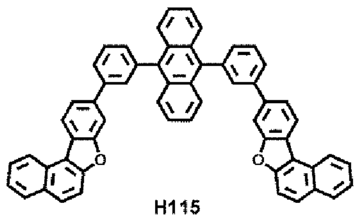

H115

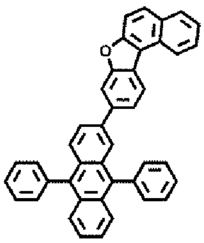

H116

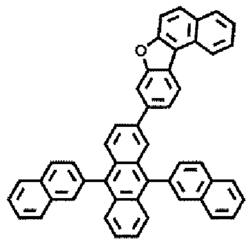

H117

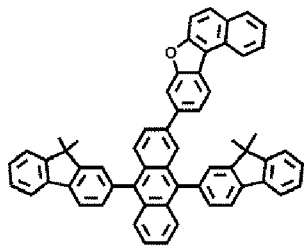

H118

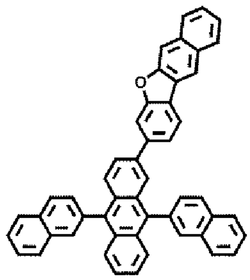

H119

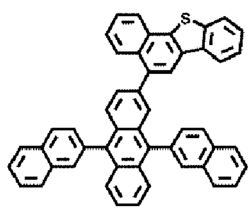

H120

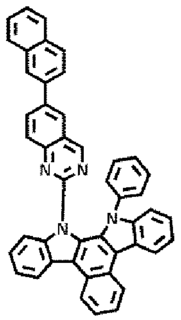 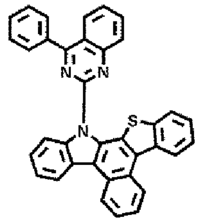 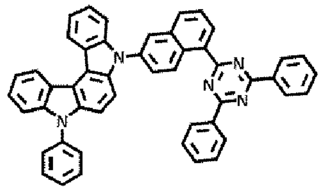 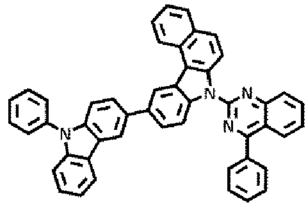

H121 H122 H123 H124

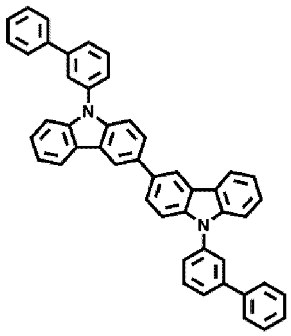 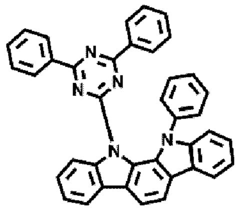 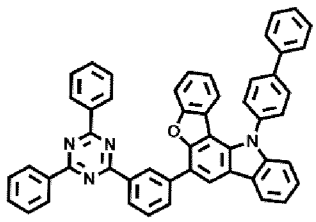

H125 H126 H127

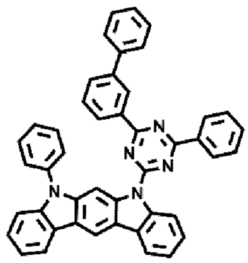 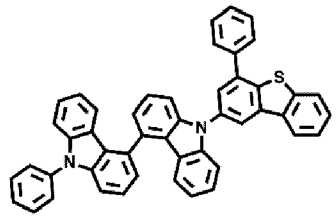 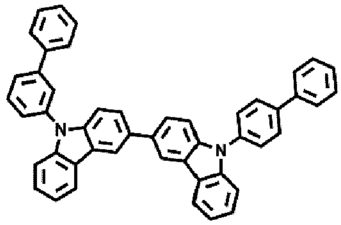

H128 H129 H130

In one or more embodiments, the host may comprise a silicon-containing compound, a phosphine oxide-containing compound, or any combination thereof.

The host may have one or more suitable modifications. For example, the host may comprise only one kind of compound, or may comprise two or more kinds of different compounds.

**Phosphorescent dopant**

The emission layer may comprise, as a phosphorescent dopant, the organometallic compound represented by Formula 1 as described in the present disclosure.

In one or more embodiments, the emission layer may comprise the organometallic compound represented by Formula 1, and when the organometallic compound represented by Formula 1 serves as an auxiliary dopant, the emission layer may comprise a phosphorescent dopant.

The phosphorescent dopant may comprise at least one transition metal as a central metal.

The phosphorescent dopant may comprise a monodentate ligand, a bidentate ligand, a tridentate ligand, a tetradentate ligand, a pentadentate ligand, a hexadentate ligand, or any combination thereof.

In some embodiments, the phosphorescent dopant may be electrically neutral.

For example, in one or more embodiments, the phosphorescent dopant may comprise an organometallic compound represented by Formula 401:

**Formula 401** $M(L_{401})_{xc1}(L_{402})_{xc2}$

**Formula 402**

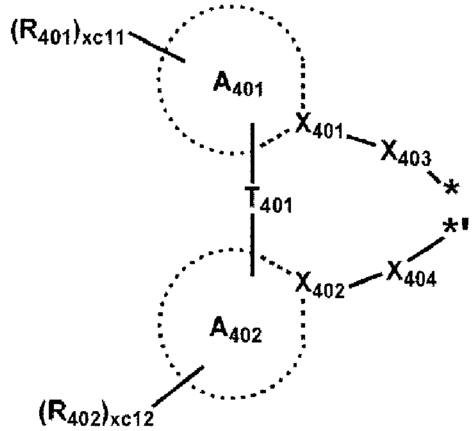

,

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
$L_{401}$ may be a ligand represented by Formula 402, and xc1 may be 1, 2, or 3, wherein, when xc1 is two or more, two or more $L_{401}$(s) may be identical to or different from each other,
$L_{402}$ may be an organic ligand, and xc2 may be 0, 1, 2, 3, or 4, wherein, when xc2 is 2 or more, two or more $L_{402}$(s) may be identical to or different from each other,
$X_{401}$ and $X_{402}$ may each independently be nitrogen or carbon,
ring $A_{401}$ and ring $A_{402}$ may each independently be a $C_3$-$C_{60}$ carbocyclic group or a $C_1$-$C_{60}$ heterocyclic group,
$T_{401}$ may be a single bond, *-O-*', *-S-*', *-C(=O)-*', *-N($Q_{411}$)-*', *-C($Q_{411}$)($Q_{412}$)-*',*-C($Q_{411}$)=C($Q_{412}$)-*', *-C($Q_{411}$)=*', or *=C($Q_{411}$)-*',
$X_{403}$ and $X_{404}$ may each independently be a chemical bond (for example, a covalent bond or a coordinate bond), O, S, N($Q_{413}$), B($Q_{413}$), P($Q_{413}$), C($Q_{413}$)($Q_{414}$), or Si($Q_{413}$)($Q_{414}$),
$Q_{411}$ to $Q_{414}$ may each be the same as described with respect to $Q_1$,
$R_{401}$ and $R_{402}$ may each independently be hydrogen, deuterium, -F, -Cl, -Br, -I, a hydroxyl group, a cyano group, a nitro group, a $C_1$-$C_{20}$ alkyl group that is unsubstituted or substituted with at least one $R_{10a}$, a $C_1$-$C_{20}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, -Si($Q_{401}$)($Q_{402}$)($Q_{403}$), -N($Q_{401}$)($Q_{402}$), -B($Q_{401}$)($Q_{402}$), -C(=O)($Q_{401}$), -S(=O)$_2$($Q_{401}$), or-P(=O)($Q_{401}$)($Q_{402}$),
$Q_{401}$ to $Q_{403}$ may each be the same as described with respect to $Q_1$,
xc11 and xc12 may each independently be an integer selected from 0 to 10, and
* and *' in Formula 402 may each indicate a binding site to M in Formula 401.

For example, in one or more embodiments, in Formula 402, i) $X_{401}$ may be nitrogen, and $X_{402}$ may be carbon, or ii) each of $X_{401}$ and $X_{402}$ may be nitrogen.

In one or more embodiments, when xc1 in Formula 402 is 2 or more, two ring $A_{401}$(s) in two or more $L_{401}$(s) may be optionally linked to each other via $T_{402}$, which is a linking group, and/or two ring $A_{402}$(s) may optionally be linked to each other via $T_{403}$, which is a linking group (see Compounds PD1 to PD4 and PD7). $T_{402}$ and $T_{403}$ may each be the same as described with respect to $T_{401}$.

$L_{402}$ in Formula 401 may be an organic ligand. For example, in one or more embodiments, $L_{402}$ may comprise a halogen, a diketone group (for example, an acetylacetonate group), a carboxylic acid group (for example, a picolinate group), -C(=O), an isonitrile group, -CN group, a phosphorus group (for example, a phosphine group, a phosphite group, etc.), or any combination thereof.

In one or more embodiments, the phosphorescent dopant may comprise, for example, at least one selected from among Compounds PD1 to PD25, and/or any combination thereof:

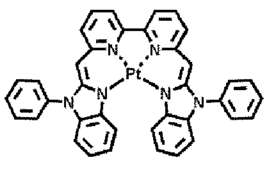
PD1
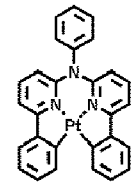
PD2
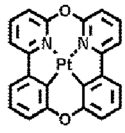
PD3
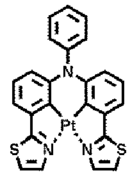
PD4
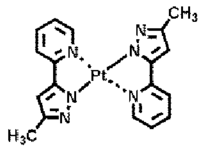
PD5
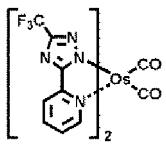
PD6
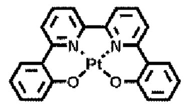
PD7
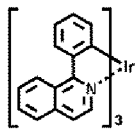
PD8
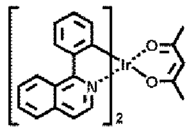
PD9
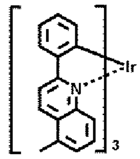
PD10
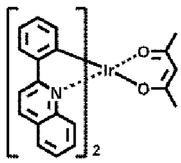
PD11
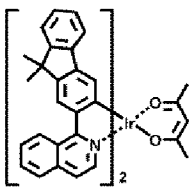
PD12
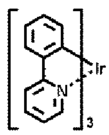
PD13
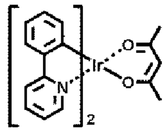
PD14
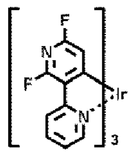
PD15
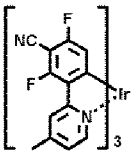
PD16
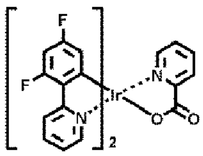
PD17
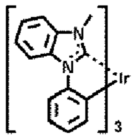
PD18
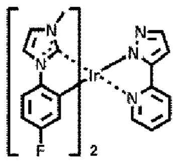
PD19
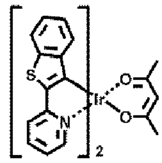
PD20
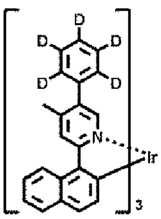
PD21
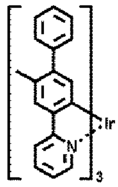
PD22
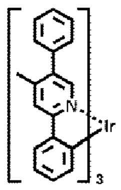
PD23
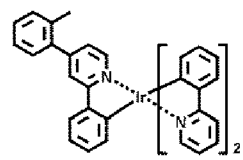
PD24
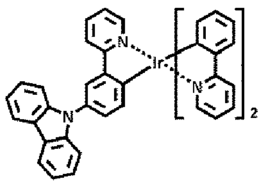
PD25

**Fluorescent dopant**

In one or more embodiments, the emission layer may comprise the organometallic compound represented by Formula 1, and when the organometallic compound represented by Formula 1 serves as an auxiliary dopant, the emission layer may further comprise a fluorescent dopant.

In one or more embodiments, the emission layer may comprise the organometallic compound represented by Formula 1, and when the organometallic compound represented by Formula 1 serves as a phosphorescent dopant, the emission layer may further comprise an auxiliary dopant.

The fluorescent dopant and the auxiliary dopant may each independently comprise an arylamine compound, a styrylamine compound, a boron-containing compound, or any combination thereof.

In one or more embodiments, the fluorescent dopant and the auxiliary dopant may each independently comprise a compound represented by Formula 501:

**Formula 501**

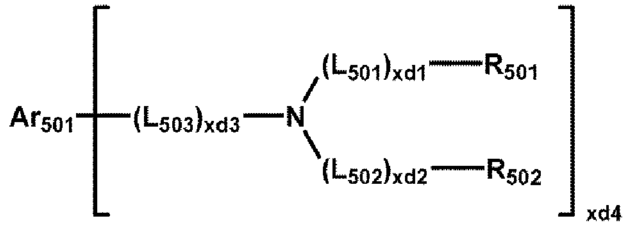

wherein, in Formula 501,

$Ar_{501}$, $L_{501}$ to $L_{503}$, $R_{501}$, and $R_{502}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,

xd1 to xd3 may each independently be 0, 1, 2, or 3, and

xd4 may be 1, 2, 3, 4, 5, or 6.

For example, in one or more embodiments, $Ar_{501}$ in Formula 501 may be a condensed cyclic group (for example, an anthracene group, a chrysene group, or a pyrene group) in which three or more monocyclic groups are condensed together.

In one or more embodiments, xd4 in Formula 501 may be 2.

For example, in one or more embodiments, the fluorescent dopant and the auxiliary dopant may each comprise at least one selected from among Compounds FD1 to FD36, 4,4'-bis(2,2-diphenylvinyl)-1,1'-biphenyl (DPVBi), 4,4'-bis[4-(di-phenylamino)styryl]biphenyl (DPAVBi), and/or any combination thereof:

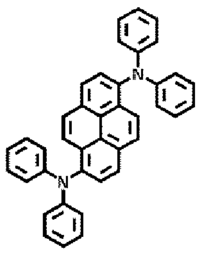

FD1

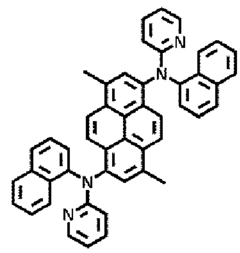

FD2

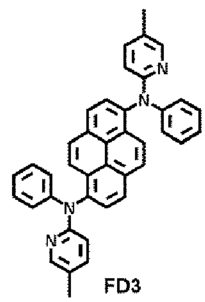

FD3

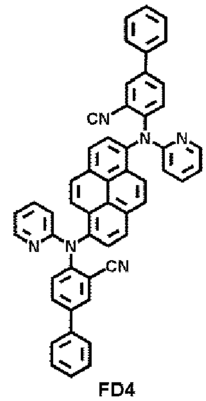

FD4

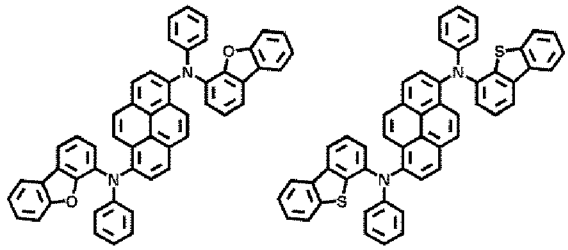

FD5

FD6

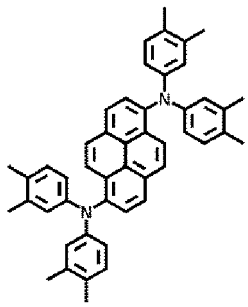

FD7

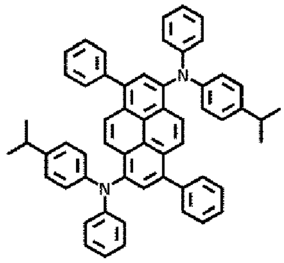

FD8

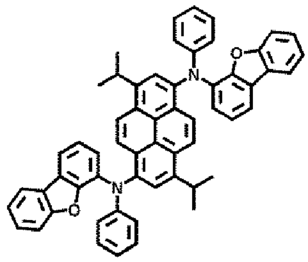

FD9

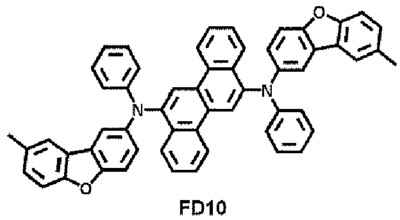

FD10

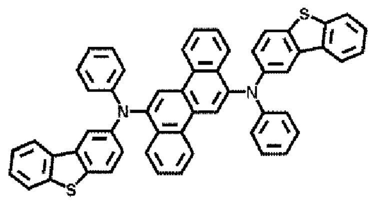

FD11

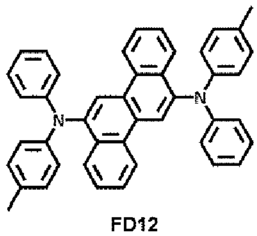

FD12

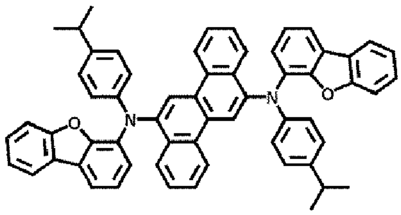

FD13

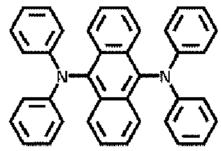

FD14

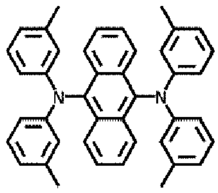

FD15

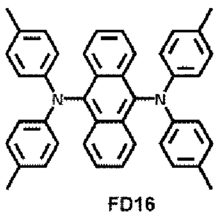

FD16

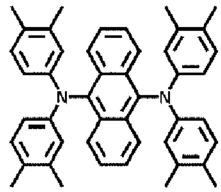

FD17

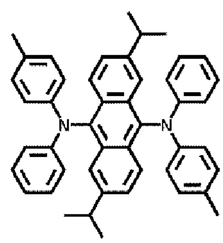

FD18

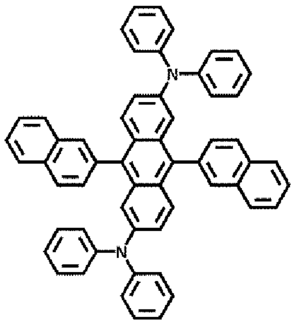

FD19

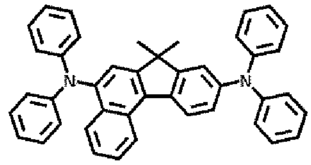

FD20

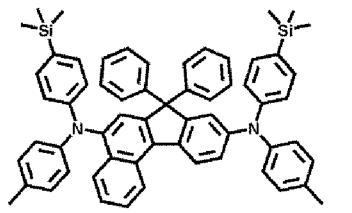

FD21

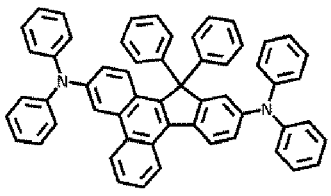

FD22

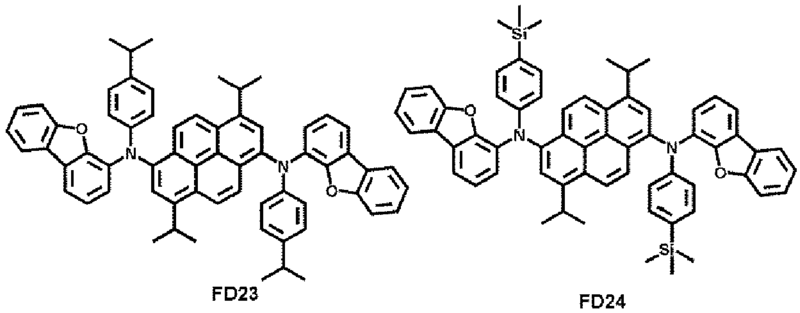

FD23

FD24

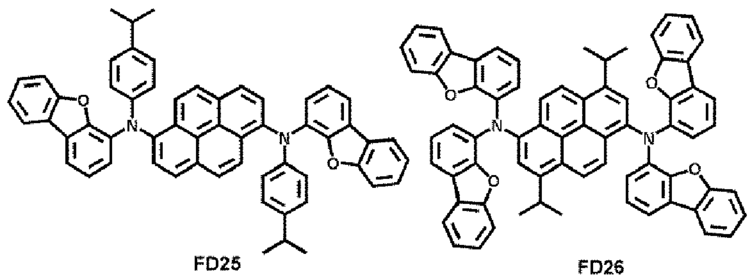

FD25 FD26

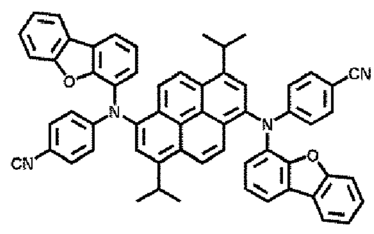

FD27

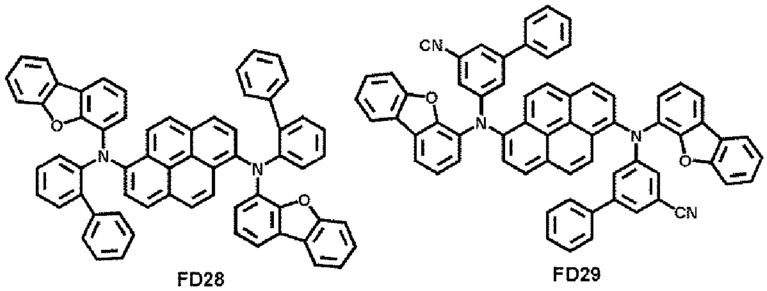

FD28 FD29

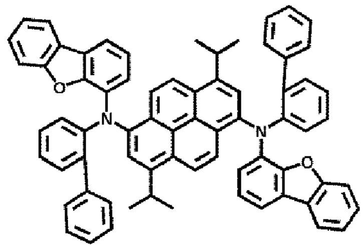

FD30

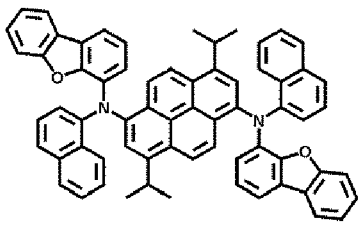

FD31

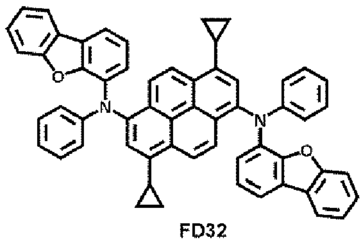

FD32

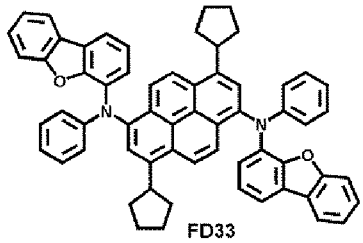

FD33

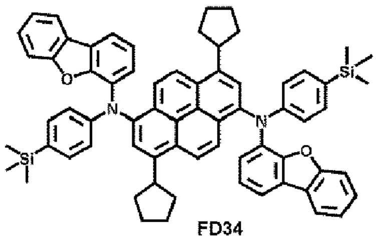

FD34

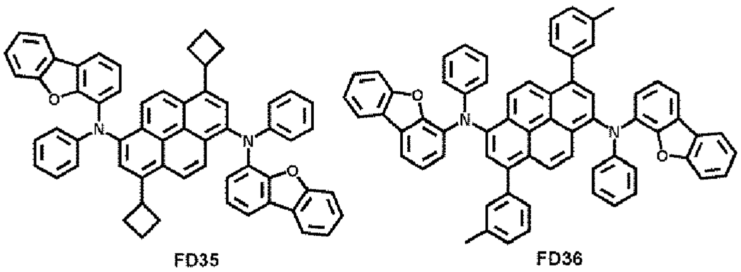

FD35 FD36

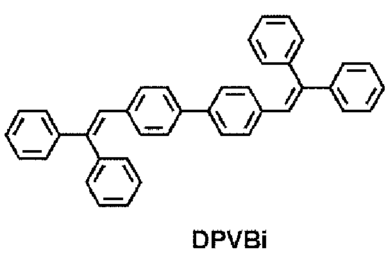

DPVBi

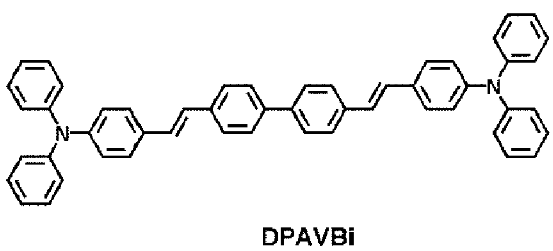

DPAVBi

In one or more embodiments, the fluorescent dopant and the auxiliary dopant may each independently comprise the fourth compound represented by Formula 502 or 503 as described herein.

**Electron transport region in interlayer 130**

The electron transport region may have: i) a single-layered structure comprising (e.g., consisting of) a single

layer comprising (e.g., consisting of) a single material, ii) a single-layered structure comprising (e.g., consisting of) a single layer comprising (e.g., consisting of) a plurality of different materials, or iii) a multilayer structure comprising a plurality of layers comprising different materials.

The electron transport region may comprise a buffer layer, a hole blocking layer, an electron control layer, an electron transport layer, an electron injection layer, or any combination thereof.

In one or more embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, the constituting layers of each structure being sequentially stacked from the emission layer in each stated order.

The electron transport region (for example, a buffer layer, a hole blocking layer, an electron control layer, or an electron transport layer in the electron transport region) may comprise a metal-free compound comprising at least one $\pi$ electron-deficient nitrogen-containing $C_1$-$C_{60}$ heterocyclic group.

In one or more embodiments, the electron transport region may comprise a compound represented by Formula 601:

**Formula 601** $[Ar_{601}]_{xe11}$-$[(L_{601})_{xe1}$-$R_{601}]_{xe21}$,

wherein, in Formula 601,

$Ar_{601}$ and $L_{601}$ may each independently be a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,

xe11 may be 1, 2, or 3,

xe1 may be 0, 1, 2, 3, 4, or 5,

$R_{601}$ may be a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, -Si($Q_{601}$)($Q_{602}$)($Q_{603}$), -C(=O)($Q_{601}$), -S(=O)$_2$($Q_{601}$), or -P(=O)($Q_{601}$)($Q_{602}$),

$Q_{601}$ to $Q_{603}$ may each be the same as described with respect to $Q_1$,

xe21 may be 1, 2, 3, 4, or 5, and

at least one selected from $Ar_{601}$, $L_{601}$, and $R_{601}$ may each independently be a $\pi$ electron-deficient nitrogen-containing $C_1$-$C_{60}$ heterocyclic group that is unsubstituted or substituted with at least one $R_{10a}$.

For example, in some embodiments, when xe11 in Formula 601 is 2 or more, two or more $Ar_{601}$(s) may be linked to each other via a single bond.

In one or more embodiments, $Ar_{601}$ in Formula 601 may be a substituted or unsubstituted anthracene group.

In one or more embodiments, the electron transport region may comprise a compound represented by Formula 601-1:

**Formula 601-1**

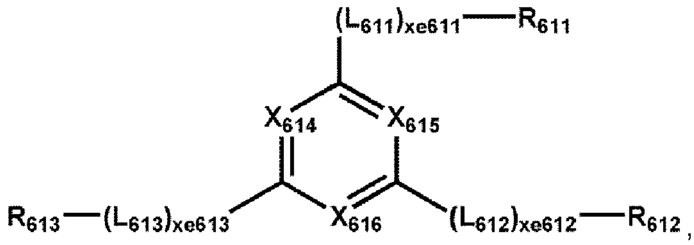

wherein, in Formula 601-1,

$X_{614}$ may be N or C($R_{614}$), $X_{615}$ may be N or C($R_{615}$), $X_{616}$ may be N or C($R_{616}$), and at least one selected from among $X_{614}$ to $X_{616}$ may be N,

$L_{611}$ to $L_{613}$ may each be the same as described with respect to $L_{601}$,

xe611 to xe613 may each be the same as described with respect to xe1,

$R_{611}$ to $R_{613}$ may each be the same as described with respect to $R_{601}$, and

$R_{614}$ to $R_{616}$ may each independently be hydrogen, deuterium, -F, -Cl, -Br, -I, a hydroxyl group, a cyano group, a nitro group, a $C_1$-$C_{20}$ alkyl group, a $C_1$-$C_{20}$ alkoxy group, a $C_3$-$C_{60}$ carbocyclic group that is unsubstituted or substituted with at least one $R_{10a}$, or a $C_1$-$C_{60}$ heterocyclic group that is unsubstituted or substituted with at least one $R_{10a}$.

In one or more embodiments, xe1 and xe611 to xe613 in Formulae 601 and 601-1 may each independently be 0, 1, or 2.

In one or more embodiments, the electron transport region may comprise at least one selected from among Compounds ET1 to ET46, 2,9-dimethyl-4,7-diphenyl-1,10-phenanthroline (BCP), 4,7-diphenyl-1,10-phenanthroline (Bphen), tris(8-hydroxyquinolinato)aluminum ($Alq_3$), bis(2-methyl-8-quinolinolato-N1,O8)-(1,1'-biphenyl-4-olato)aluminum (BAlq), 3-(4-biphenyl)-4-phenyl-5-tert-butylphenyl-1,2,4-triazole (TAZ), 4-(naphthalen-1-yl)-3,5-diphenyl-4H-1,2,4-triazole (NTAZ), and/or any combination thereof:

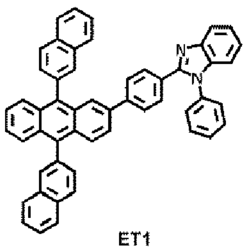
ET1

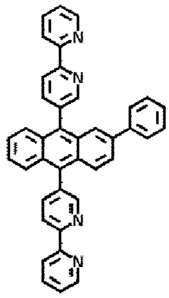
ET2

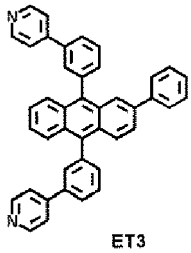
ET3

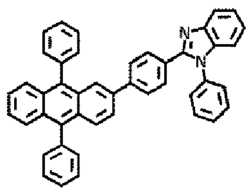
ET4

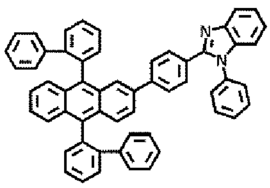
ET5

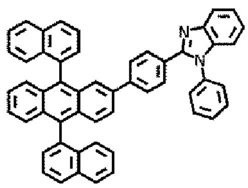
ET6

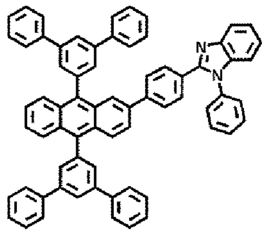
ET7

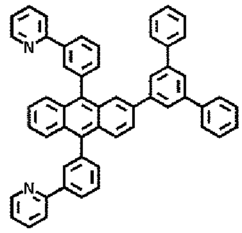
ET8

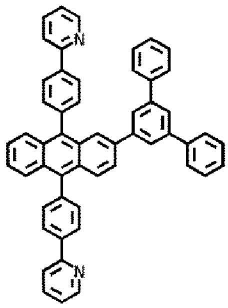
ET9

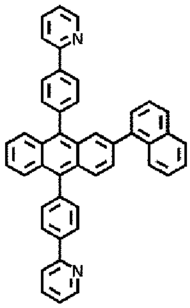
ET10

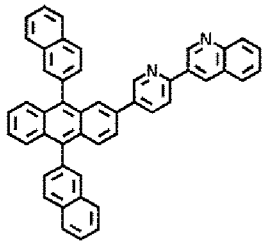
ET11

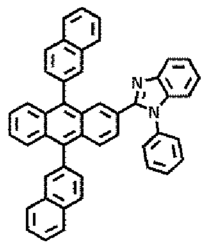
ET12

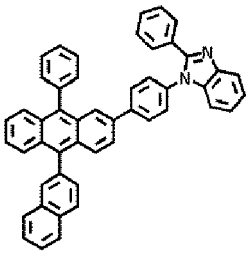
ET13

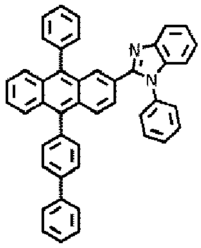
ET14

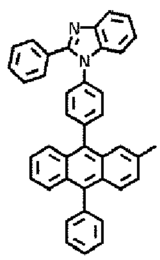
ET15

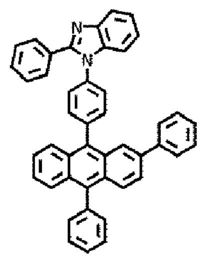
ET16

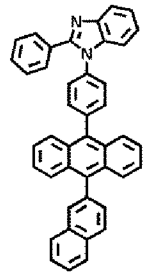
ET17

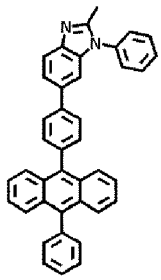
ET18

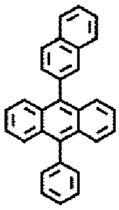
ET19

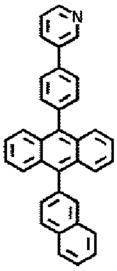
ET20

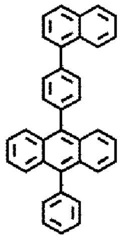
ET21

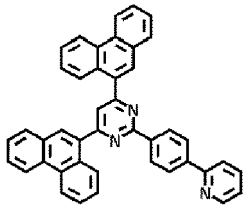
ET22

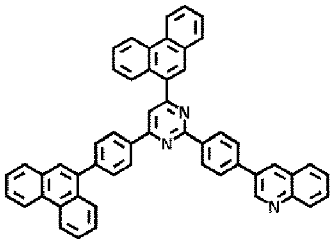
ET23

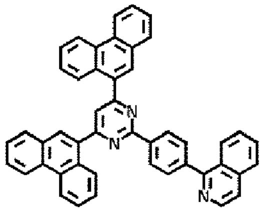
ET24

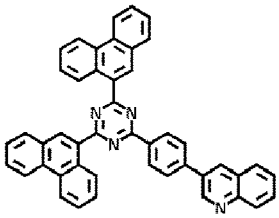
ET25

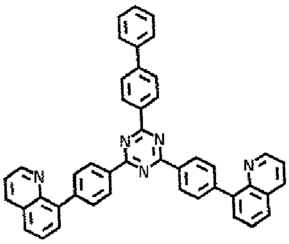
ET26

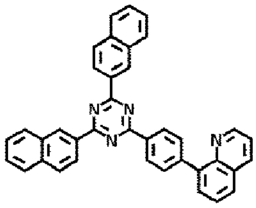
ET27

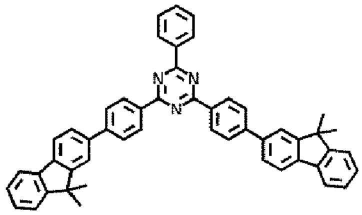
ET28

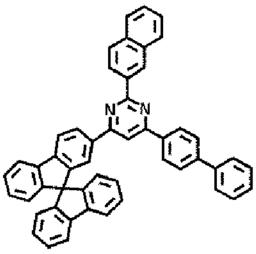
ET29

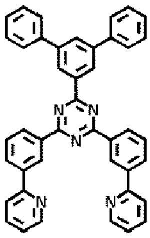
ET30

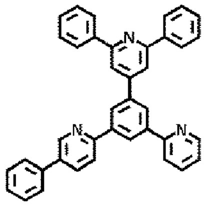
ET31

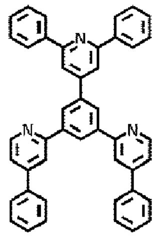
ET32

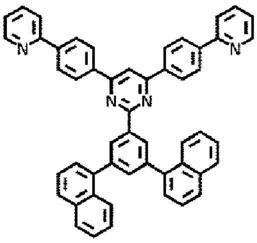
ET33

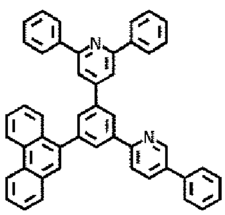
ET34

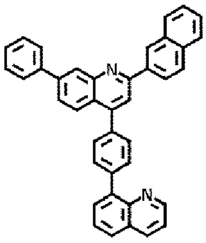
ET35

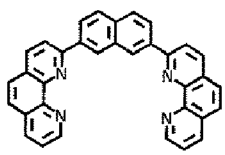
ET36

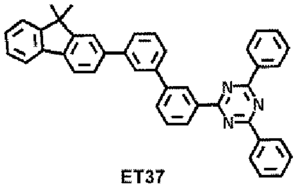
ET37

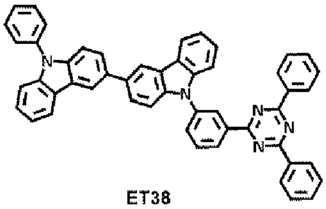
ET38

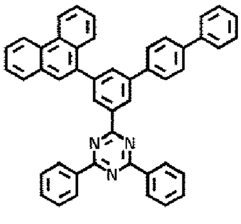
ET39

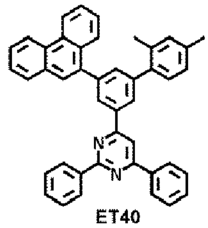
ET40

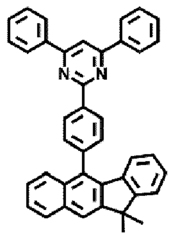
ET41

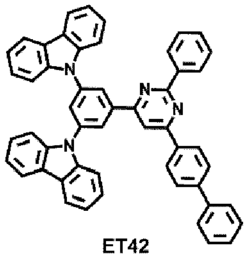
ET42

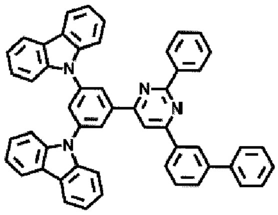
ET43

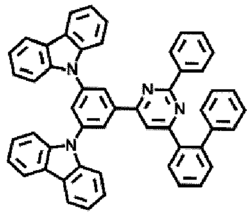
ET44

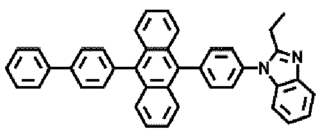
ET45

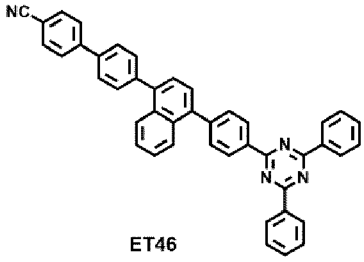
ET46

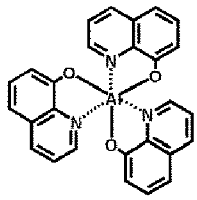
Alq3

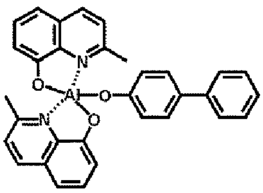
BAlq

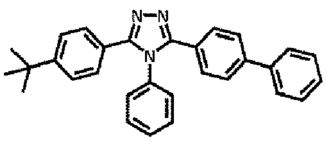
TAZ

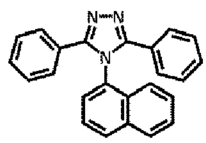
NTAZ .

A thickness of the electron transport region may be about 100 Å to about 5,000 Å, for example, about 160 Å to about 4,000 Å. When the electron transport region comprises a buffer layer, a hole blocking layer, an electron control layer, an electron transport layer, or any combination thereof, the thickness of the buffer layer, the hole blocking layer, or the electron control layer may each independently be about 20 Å to about 1,000 Å, for example, about 30 Å to about 300 Å, and the thickness of the electron transport layer may be about 100 Å to about 1,000 Å, for example, about 150 Å to about 500 Å. When the thicknesses of the buffer layer, the hole blocking layer, the electron control layer, the electron transport layer, and/or the electron transport region are within these ranges, satisfactory or suitable electron-transporting characteristics may be obtained without a substantial increase in driving voltage.

In one or more embodiments, the electron transport region (for example, the electron transport layer in the electron transport region) may further comprise, in addition to the materials described above, a metal-containing material.

The metal-containing material may comprise an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the alkaline earth-metal complex may comprise a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, in some embodiments, the metal-containing material may comprise a Li complex. The Li complex may comprise, for example, Compound ET-D1 (LiQ) or ET-D2:

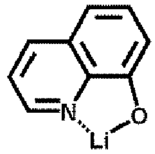

ET-D1

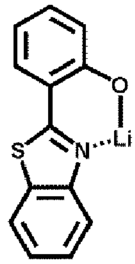

ET-D2 .

In one or more embodiments, the electron transport region may comprise an electron injection layer to facilitate the injection of electrons from the second electrode 150. The electron injection layer may be in direct contact with the second electrode 150.

The electron injection layer may have: i) a single-layered structure comprising (e.g., consisting of) a single layer comprising (e.g., consisting of) a single material, ii) a single-layered structure comprising (e.g., consisting of) a single layer comprising (e.g., consisting of) a plurality of different materials, or iii) a multilayer structure comprising a plurality of layers comprising different materials.

The electron injection layer may comprise an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may comprise Li, Na, K, Rb, Cs, or any combination thereof. The alkaline earth metal may comprise Mg, Ca, Sr, Ba, or any combination thereof. The rare earth metal may comprise Sc, Y, Ce, Tb, Yb, Gd, or any combination thereof.

The alkali metal-containing compound, the alkaline earth metal-containing compound, and the rare earth metal-containing compound may comprise oxides, halides (for example, fluorides, chlorides, bromides, or iodides), or tellurides of the alkali metal, the alkaline earth metal, and the rare earth metal, or any combination thereof.

The alkali metal-containing compound may comprise: alkali metal oxides, such as $Li_2O$, $Cs_2O$, and/or $K_2O$; alkali metal halides, such as LiF, NaF, CsF, KF, LiI, NaI, CsI, KI, and/or RbI; or any combination thereof. The alkaline earth metal-containing compound may comprise an alkaline earth metal compound, such as BaO, SrO, CaO, $Ba_xSr_{1-x}O$ (x is a real number satisfying the condition of $0<x<1$), $Ba_xCa_{1-x}O$ (x is a real number satisfying the condition of $0<x<1$), and/or the like. The rare earth metal-containing compound may comprise $YbF_3$, $ScF_3$, $Sc_2O_3$, $Y_2O_3$, $Ce_2O_3$, $GdF_3$, $TbF_3$, $YbI_3$, $ScI_3$, $TbI_3$, or any combination thereof. In one or more embodiments, the rare earth metal-containing compound may comprise lanthanide metal telluride. Non-limiting examples of the lanthanide metal telluride may comprise LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, $Sm_2Te_3$, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, and/or $Lu_2Te_3$.

The alkali metal complex, the alkaline earth-metal complex, and the rare earth metal complex may comprise i) one of metal ions of the alkali metal, the alkaline earth metal, and the rare earth metal, respectively, and ii) a ligand bonded to the metal ion, for example, a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenyl benzimidazole, a hydroxyphenylbenzothiazole, a bipyridine, a phenanthroline, a cyclopentadiene, or any combination thereof.

In one or more embodiments, the electron injection layer may comprise (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In some embodiments, the electron injection layer may further comprise an organic material (for example, a compound represented by Formula 601).

In one or more embodiments, the electron injection layer may comprise (e.g., consist of) i) an alkali metal-containing compound (for example, an alkali metal halide), ii) a) an alkali metal-containing compound (for example, an alkali metal halide); and b) an alkali metal, an alkaline earth metal, a rare earth metal, or any combination thereof. For example, in some embodiments, the electron injection layer may be a KI:Yb co-deposited layer, a RbI:Yb co-deposited layer, a LiF:Yb co-deposited layer, and/or the like.

When the electron injection layer further comprises an organic material, the alkali metal, alkaline earth metal, rare earth metal, alkali metal-containing compound, alkaline earth metal-containing compound, rare earth metal-containing compound, alkali metal complex, alkaline earth-metal complex, rare earth metal complex, or any combination thereof may be substantially homogeneously or non-homogeneously dispersed in a matrix comprising the organic material.

A thickness of the electron injection layer may be in a range of about 1 Å to about 100 Å, and, for example, about 3 Å to about 90 Å. When the thickness of the electron injection layer is within the range described above, satisfactory or suitable electron injection characteristics may be obtained without a substantial increase in driving voltage.

**Second electrode 150**

The second electrode 150 may be located on the interlayer 130 having a structure. In one or more embodiments, the second electrode 150 may be a cathode, which is an electron injection electrode, and as a material for the second electrode 150, a metal, an alloy, an electrically conductive compound, or any combination thereof, each having a low work function, may be utilized.

The second electrode 150 may comprise lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure or a multilayer structure comprising two or more layers.

**Capping layer**

A first capping layer may be located outside the first electrode 110, and/or a second capping layer may be located outside the second electrode 150. In one or more embodiments, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

In some embodiments, light generated in an emission layer of the interlayer 130 of the light-emitting device 10 may be extracted toward the outside through the first electrode 110, which is a semi-transmissive electrode or a transmissive electrode, and the first capping layer. In some embodiments, light generated in an emission layer of the interlayer 130 of the light-emitting device 10 may be extracted toward the outside through the second electrode 150, which is a semi-transmissive electrode or a transmissive electrode, and the second capping layer.

The first capping layer and/or the second capping layer may increase external luminescence efficiency according to the principle of constructive interference. Accordingly, the light extraction efficiency of the light-emitting device 10 is increased, so that the luminescence efficiency of the light-emitting device 10 may be improved.

Each of the first capping layer and second capping layer may comprise a material having a refractive index (e.g., at 589 nm) of 1.6 or more.

The first capping layer and the second capping layer may each independently be an organic capping layer comprising an organic material, an inorganic capping layer comprising an inorganic material, or an organic-inorganic composite capping layer comprising an organic material and an inorganic material.

At least one selected from among the first capping layer and the second capping layer may each independently comprise carbocyclic compounds, heterocyclic compounds, amine group-containing compounds, porphyrin derivatives, phthalocyanine derivatives, naphthalocyanine derivatives, alkali metal complexes, alkaline earth metal complexes, or any combination thereof. In some embodiments, the carbocyclic compound, the heterocyclic compound, and the amine group-containing compound may be optionally substituted with a substituent containing O, N, S, Se, Si, F, Cl, Br, I, or any combination thereof. In one or more embodiments, at least one selected from among the first capping layer and the second capping layer may each independently comprise an amine group-containing compound.

For example, in one or more embodiments, at least one selected from among the first capping layer and the second capping layer may each independently comprise a compound represented by Formula 201, a compound represented by Formula 202, or any combination thereof.

In one or more embodiments, at least one selected from the first capping layer and the second capping layer may each independently comprise at least one selected from among Compounds HT28 to HT33, at least one selected from among Compounds CP1 to CP6, β-NPB, and/or any combination thereof:

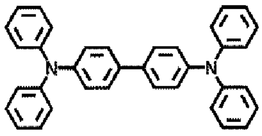
CP1

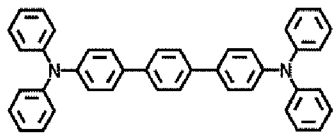
CP2

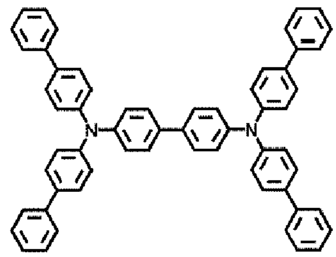
CP3

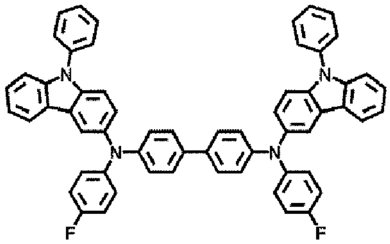
CP4

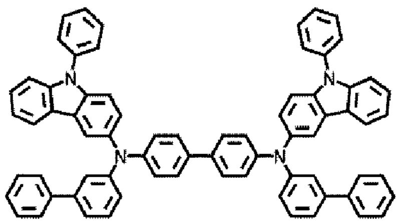
CP5

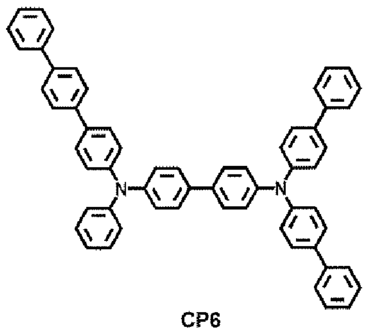
CP6

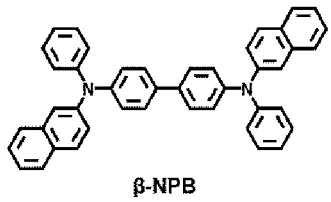
β-NPB

.

### Electronic device

The light-emitting device may be included in one or more suitable electronic devices. For example, the electronic device comprising the light-emitting device may be a light-emitting apparatus, an authentication apparatus, and/or the like.

In one or more embodiments, the electronic device (for example, a light-emitting apparatus) may further comprise, in addition to the light-emitting device, i) a color filter, ii) a color conversion layer, or iii) a color filter and a color conversion layer. The color filter and/or the color conversion layer may be located in at least one travel direction of light emitted from the light-emitting device. For example, in some embodiments, the light emitted from the light-emitting device may be blue light, green light, or white light (e.g., combined white light). The light-emitting device may be the same as described above. In one or more embodiments, the color conversion layer may comprise quantum dots.

The electronic device may comprise a first substrate. The first substrate may comprise a plurality of subpixel areas, the color filter may comprise a plurality of color filter areas respectively corresponding to the subpixel areas, and the color conversion layer may comprise a plurality of color conversion areas respectively corresponding to the subpixel areas.

A pixel-defining layer may be located among the subpixel areas to define each of the subpixel areas.

The color filter may further comprise a plurality of color filter areas and light-shielding patterns located between the color filter areas, and the color conversion layer may comprise a plurality of color conversion areas and light-shielding patterns located between the color conversion areas.

The color filter areas (or the color conversion areas) may comprise a first area to emit first color light, a second area to emit second color light, and/or a third area to emit third color light, and the first color light, the second color light, and/or the third color light may have different maximum emission wavelengths from one another. For example, in some embodiments, the first color light may be red light, the second color light may be green light, and the third color light may be blue light. In one or more embodiments, the color filter areas (or the color conversion areas) may comprise quantum dots. In some embodiments, the first area may comprise red quantum dots to emit red light, the second area may comprise green quantum dots to emit green light, and the third area may not comprise (e.g., may exclude) quantum

dots. The first area, the second area, and/or the third area may each further comprise a scatterer.

In one or more embodiments, the light-emitting device may be to emit first light, the first area may be to absorb the first light to emit first-first color light, the second area may be to absorb the first light to emit second-first color light, and the third area may be to absorb the first light to emit third-first color light. In this regard, the first-first color light, the second-first color light, and the third-first color light may have different maximum emission wavelengths. In some embodiments, the first light may be blue light, the first-first color light may be red light, the second-first color light may be green light, and the third-first color light may be blue light.

In one or more embodiments, the electronic device may further comprise a thin-film transistor, in addition to the light-emitting device as described above. The thin-film transistor may comprise a source electrode, a drain electrode, and an activation layer, wherein one selected from the source electrode and the drain electrode may be electrically connected to the first electrode or the second electrode of the light-emitting device.

The thin-film transistor may further comprise a gate electrode and a gate insulating film.

The activation layer may comprise crystalline silicon, amorphous silicon, organic semiconductor, oxide semiconductor, and/or the like.

In one or more embodiments, the electronic device may further comprise a sealing portion for sealing the light-emitting device. The sealing portion may be located between the color filter and/or the color conversion layer and the light-emitting device. The sealing portion allows light from the light-emitting device to be extracted to the outside, while concurrently (e.g., simultaneously) preventing or reducing ambient air and moisture from penetrating into the light-emitting device. The sealing portion may be a sealing substrate comprising a transparent glass substrate or a plastic substrate. The sealing portion may be a thin-film encapsulation layer comprising at least one layer of an organic layer and/or an inorganic layer. When the sealing portion is a thin-film encapsulation layer, the electronic device may be flexible.

One or more functional layers may be additionally located on the sealing portion, in addition to the color filter and/or the color conversion layer, according to the intended utilization of the electronic device. Non-limiting examples of the functional layers may comprise a touch screen layer and/or a polarizing layer. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, etc.).

The authentication apparatus may further comprise, in addition to the light-emitting device, a biometric information collector.

The electronic device may be applied to one or more of displays, light sources, lighting, personal computers (for example, a mobile personal computer), mobile phones, digital cameras, electronic diaries, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

**Description of FIGS. 2 and 3**

FIG. 2 is a cross-sectional view of a light-emitting apparatus that is one of electronic devices, according to one or more embodiments of the present disclosure.

The light-emitting apparatus of FIG. 2 may comprise a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be formed on the substrate 100. The buffer layer 210 may prevent or reduce penetration of impurities through the substrate 100 and may provide a flat surface on the substrate 100.

A TFT may be located on the buffer layer 210. The TFT may comprise an activation layer 220, a gate electrode 240, a source electrode 260, and a drain electrode 270.

The activation layer 220 may comprise an inorganic semiconductor such as silicon or polysilicon, an organic semiconductor, or an oxide semiconductor, and may comprise a source region, a drain region, and a channel region.

A gate insulating film 230 for insulating the activation layer 220 from the gate electrode 240 may be located on the activation layer 220, and the gate electrode 240 may be located on the gate insulating film 230.

An interlayer insulating film 250 may be on the gate electrode 240. The interlayer insulating film 250 may be placed between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be respectively in

contact with the exposed portions of the source region and the drain region of the activation layer 220.

The TFT may be electrically connected to a light-emitting device to drive the light-emitting device, and may be covered and protected by a passivation layer 280. The passivation layer 280 may comprise an inorganic insulating film, an organic insulating film, or a combination thereof. A light-emitting device may be provided on the passivation layer 280. The light-emitting device may comprise a first electrode 110, an interlayer 130, and a second electrode 150.

The first electrode 110 may be formed on the passivation layer 280. The passivation layer 280 does not completely cover the drain electrode 270 and exposes a portion of the drain electrode 270, and the first electrode 110 may be connected to the exposed portion of the drain electrode 270.

A pixel-defining layer 290 containing an insulating material may be located on the first electrode 110. The pixel-defining layer 290 exposes a region of the first electrode 110, and the interlayer 130 may be formed in the exposed region of the first electrode 110. The pixel-defining layer 290 may be a polyimide or polyacrylic organic film. In some embodiments, at least some layers of the interlayer 130 may extend beyond the upper portion of the pixel-defining layer 290 to be located in the form of a common layer.

The second electrode 150 may be located on the interlayer 130, and a second capping layer 170 may be additionally formed on the second electrode 150. The second capping layer 170 may be formed to cover the second electrode 150.

The encapsulation portion 300 may be located on the second capping layer 170. The encapsulation portion 300 may be located on the light-emitting device to protect the light-emitting device from moisture and/or oxygen. The encapsulation portion 300 may comprise: an inorganic film comprising silicon nitride (SiNx), silicon oxide ($SiO_x$), indium tin oxide, indium zinc oxide, or any combination thereof; an organic film comprising polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or a combination thereof; or a combination of the inorganic film and the organic film.

FIG. 3 is a cross-sectional view of a light-emitting apparatus that is one of electronic apparatuses, according to one or more embodiments of the present disclosure.

The light-emitting apparatus of FIG. 3 is substantially the same as the light-emitting apparatus of FIG. 2, except that a light-shielding pattern 500 and a functional region 400 are additionally disposed above (e.g., on) the encapsulation portion 300. The functional region 400 may be i) a color filter area, ii) a color conversion area, or iii) a combination of the color filter area and the color conversion area. In one or more embodiments, the light-emitting device comprised in the light-emitting apparatus of FIG. 3 may be a tandem light-emitting device.

**Description of FIG. 4**

FIG. 4 is a schematic perspective view of an electronic apparatus 1 comprising a light-emitting device, according to one or more embodiments of the present disclosure. The electronic apparatus 1 may be an apparatus that displays a moving image or a still image, and may be a portable electronic device, such as a mobile phone, a smart phone, a tablet personal computer (PC), a mobile communication terminal, an electronic diary, an electronic book, a portable multimedia player (PMP), a navigation system, or an ultra mobile PC (UMPC), as well as one or more suitable products, such as a TV, a laptop, a monitor, a billboard, or an Internet of things device (IOT), or a part thereof. Also, the electronic apparatus 1 may be a wearable device, such as a smart watch, a watch phone, a glasses-type or kind display, or a head mounted display (HMD), or a part thereof. However, embodiments of the present disclosure are not limited thereto. In one or more embodiments, the electronic apparatus 1 may be a dashboard of a vehicle, a center information display (CID) arranged on a center fascia or dashboard of a vehicle, a room mirror display instead of a side-view mirror of a vehicle, an entertainment display for the back seat of a vehicle, or a display arranged on the back of the front seat of a vehicle, a head up display (HUD) installed in the front of a vehicle or projected on a front window glass, or a computer generated hologram augmented reality head up display (CGH AR HUD). For convenience of explanation, FIG. 4 shows an embodiment in which the electronic apparatus 1 is a smart phone.

The electronic apparatus 1 may comprise a display area DA and a non-display area NDA located outside the display area DA. A display apparatus of the electronic apparatus 1 may implement an image through an array of a plurality of pixels that are two-dimensionally arranged in the display area DA.

The non-display area NDA is an area that does not display an image, and may entirely surround the display area DA. A driver for providing an electrical signal or electric power to display devices arranged in the display area DA and/or the like may be arranged in the non-display area NDA. A pad, which is an area to which an electronic device or a printed circuit board may be electrically connected, may be arranged in the non-display area NDA.

The electronic apparatus 1 may have different lengths in an X-axis direction and a y-axis direction. For example, in some embodiments, as shown in FIG. 4, the length in the x-axis direction may be less than the length in the y-axis direction. In some embodiments, the length in the x-axis direction and the length in the y-axis direction may be identical

to each other. In some embodiments, the length in the x-axis direction may be greater than the length in the y-axis direction.

**Descriptions of FIGs. 5 and 6A to 6C**

FIG. 5 is a schematic view of an exterior of a vehicle 1000 as an electronic apparatus comprising a light-emitting device, according to one or more embodiments of the present disclosure. FIGs. 6A to 6C each are schematic views of an interior of the vehicle 1000, according to one or more embodiments of the present disclosure.

Referring to FIGs. 5, 6A, 6B, and 6C, the vehicle 1000 may refer to one or more suitable apparatuses for moving an object to be transported, such as a human, an object, or an animal, from a departure point to a destination. The vehicle 1000 may comprise a vehicle traveling on a road or a track, a vessel moving over the sea or a river, and an airplane flying in the sky utilizing the action of air.

The vehicle 1000 may travel on a road or a track. The vehicle 1000 may move in a set or predetermined direction according to rotation of at least one wheel. For example, the vehicle 1000 may comprise a three-wheeled or four-wheeled vehicle, a construction vehicle, a two-wheeled vehicle, a prime mover apparatus, a bicycle, or a train traveling on a track.

The vehicle 1000 may comprise a body having interior trims and exterior trims, and a chassis in which mechanical apparatuses necessary for driving are installed as other parts except for the body. The exterior trims of the body may comprise a pillar provided at a boundary between a front panel, a bonnet, a roof panel, a rear panel, a trunk, and doors. The chassis of the vehicle 1000 may comprise a power generating apparatus, a power transmitting apparatus, a driving apparatus, a steering apparatus, a braking apparatus, a suspension apparatus, a transmission apparatus, a fuel apparatus, and front, rear, left and right wheels.

The vehicle 1000 may comprise a side window glass 1100, a front window glass 1200, a side-view mirror 1300, a cluster 1400, a center fascia 1500, a front passenger seat dashboard 1600, and a display apparatus 2.

The side window glass 1100 and the front window glass 1200 may be partitioned by a pillar arranged between the side window glass 1100 and the front window glass 1200.

The side window glass 1100 may be installed on a side of the vehicle 1000. In some embodiments, the side window glass 1100 may be installed on a door of the vehicle 1000. A plurality of side window glasses 1100 may be provided and may face each other. In some embodiments, the side window glass 1100 may comprise a first side window glass 1110 and a second side window glass 1120. In some embodiments, the first side window glass 1110 may be arranged adjacent to the cluster 1400. The second side window glass 1120 may be arranged adjacent to the front passenger seat dashboard 1600.

In one or more embodiments, the side window glasses 1100 may be spaced apart from each other in an x direction or in a -x direction. For example, the first side window glass 1110 and the second side window glass 1120 may be spaced apart from each other in the x direction or in the -x direction. In other words, a virtual straight line L connecting the side window glasses 1100 to each other may extend in the x direction or in the -x direction. For example, the virtual straight line L connecting the first side window glass 1110 to the second side window glass 1120 may extend in the x direction or in the -x direction.

The front window glass 1200 may be installed in the front of the vehicle 1000. The front window glass 1200 may be arranged between the side window glasses 1100 facing each other.

The side-view mirror 1300 may provide a rear view of the vehicle 1000. The side-view mirror 1300 may be installed on the exterior trim of the body. In some embodiments, a plurality of side-view mirrors 1300 may be provided. One of the plurality of side-view mirrors 1300 may be arranged outside the first side window glass 1110. The other among the plurality of side-view mirrors 1300 may be arranged outside the second side window glass 1120.

The cluster 1400 may be located in front of a steering wheel. The cluster 1400 may comprise a tachometer, a speedometer, a coolant thermometer, a fuel gauge, a turn signal indicator light, a high beam indicator light, a warning light, a seat belt warning light, an odometer, an automatic gear selector lever indicator light, a door open warning light, an engine oil warning light, and/or a low fuel warning light.

The center fascia 1500 may comprise a control panel on which a plurality of buttons for adjusting an audio apparatus, an air conditioning apparatus, and/or a heater of a seat are arranged. The center fascia 1500 may be arranged on one side of the cluster 1400.

The front passenger seat dashboard 1600 may be spaced apart from the cluster 1400 with the center fascia 1500 therebetween. In some embodiments, the cluster 1400 may be arranged to correspond to a driver's seat, and the front passenger seat dashboard 1600 may be arranged to correspond to a front passenger seat. In some embodiments, the cluster 1400 may be adjacent to the first side window glass 1110, and the front passenger seat dashboard 1600 may be adjacent to the second side window glass 1120.

In one or more embodiments, the display apparatus 2 may comprise a display panel 3, and the display panel 3 may display an image. The display apparatus 2 may be arranged inside the vehicle 1000. In one embodiment, the display apparatus 2 may be arranged between the side window glasses 1100 facing each other. The display apparatus 2 may be arranged on at least one selected from among the cluster 1400, the center fascia 1500, and the front passenger

seat dashboard 1600.

The display apparatus 2 may comprise an organic light-emitting display, an inorganic electroluminescent (EL) display (inorganic light-emitting display), and a quantum dot display. Hereinafter, an organic light-emitting display comprising a light-emitting device according to one or more embodiments of the present disclosure is described as an example of the display apparatus 2 according to one or more embodiments, but in embodiments of the present disclosure, one or more suitable types (kinds) of display apparatuses as described above may be utilized.

Referring to FIG. 6A, in some embodiments, the display apparatus 2 may be arranged on the center fascia 1500. In one embodiment, the display apparatus 2 may display navigation information. In one embodiment, the display apparatus 2 may display information about audio, video, and/or vehicle settings.

Referring to FIG. 6B, in some embodiments, the display apparatus 2 may be arranged on the cluster 1400. In these embodiments, the cluster 1400 may express driving information and/or the like by the display apparatus 2. In other words, the cluster 1400 may be implemented digitally. The digital cluster 1400 may display vehicle information and driving information as images. For example, a tachometer needle, gauges, and one or more suitable warning light icons may be displayed by digital signals.

Referring to FIG. 6C, in some embodiments, the display apparatus 2 may be arranged on the front passenger seat dashboard 1600. The display apparatus 2 may be embedded in the front passenger seat dashboard 1600 or may be located on the front passenger seat dashboard 1600. In one embodiment, the display apparatus 2 arranged on the front passenger seat dashboard 1600 may display an image related to information displayed on the cluster 1400 and/or information displayed on the center fascia 1500. In one embodiment, the display apparatus 2 arranged on the front passenger seat dashboard 1600 may display information different from information displayed on the cluster 1400 and/or information displayed on the center fascia 1500.

**Manufacture method**

Layers comprised in the hole transport region, the emission layer, and layers comprised in the electron transport region may be formed in a certain region by utilizing one or more suitable methods selected from vacuum deposition, spin coating, casting, Langmuir-Blodgett (LB) deposition, ink-jet printing, laser-printing, and/or laser-induced thermal imaging.

When layers constituting the hole transport region, the emission layer, and layers constituting the electron transport region are formed by vacuum deposition, the deposition may be performed at a deposition temperature of about 100 °C to about 500 °C, a vacuum degree of about $10^{-8}$ torr to about $10^{-3}$ torr, and a deposition speed of about 0.01 Å/sec to about 100 Å/sec, depending on a material to be comprised in a layer to be formed and the structure of a layer to be formed.

**Definition of Terms**

The term "$C_3$-$C_{60}$ carbocyclic group" as utilized herein refers to a cyclic group consisting of carbon only as a ring-forming atom and having three to sixty carbon atoms, and the term "$C_1$-$C_{60}$ heterocyclic group" as utilized herein refers to a cyclic group that has one to sixty carbon atoms and further has, in addition to carbon, a heteroatom as a ring-forming atom. The $C_3$-$C_{60}$ carbocyclic group and the $C_1$-$C_{60}$ heterocyclic group may each be a monocyclic group consisting of one ring or a polycyclic group in which two or more rings are condensed with each other. For example, the $C_1$-$C_{60}$ heterocyclic group may have 3 to 61 ring-forming atoms.

The term "cyclic group" as utilized herein may comprise the $C_3$-$C_{60}$ carbocyclic group and/or the $C_1$-$C_{60}$ heterocyclic group.

The term "π electron-rich $C_3$-$C_{60}$ cyclic group" as utilized herein refers to a cyclic group that has three to sixty carbon atoms and does not comprise *-N=*' as a ring-forming moiety, and the term "π electron-deficient nitrogen-containing $C_1$-$C_{60}$ heterocyclic group" as utilized herein refers to a heterocyclic group that has one to sixty carbon atoms and comprises *-N=*' as a ring-forming moiety.

For example,

the $C_3$-$C_{60}$ carbocyclic group may be i) a group T1 or ii) a condensed cyclic group in which two or more groups T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

the $C_1$-$C_{60}$ heterocyclic group may be i) a group T2, ii) a condensed cyclic group in which two or more groups T2 are condensed with each other, or iii) a condensed cyclic group in which at least one group T2 and at least one group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

the π electron-rich $C_3$-$C_{60}$ cyclic group may be i) a group T1, ii) a condensed cyclic group in which two or more groups T1 are condensed with each other, iii) a group T3, iv) a condensed cyclic group in which two or more groups T3 are condensed with each other, or v) a condensed cyclic group in which at least one group T3 and at least one group T1 are condensed with each other (for example, the $C_3$-$C_{60}$ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.), and

the π electron-deficient nitrogen-containing $C_1$-$C_{60}$ heterocyclic group may be i) a group T4, ii) a condensed cyclic group in which two or more groups T4 are condensed together, iii) a condensed cyclic group in which at least one group T4 and at least one group T1 are condensed together, iv) a condensed cyclic group in which at least one group T4 and at least one group T3 are condensed together, or v) a condensed cyclic group in which at least one group T4, at least one group T1, and at least one group T3 are condensed together (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),

wherein the group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,

the group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,

the group T3 may be a furan group, a thiophene group, a 1H-pyrrole group, a silole group, or a borole group, and

the group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term "cyclic group", "$C_3$-$C_{60}$ carbocyclic group", "$C_1$-$C_{60}$ heterocyclic group", "$\pi$ electron-rich $C_3$-$C_{60}$ cyclic group", or "$\pi$ electron-deficient nitrogen-containing $C_1$-$C_{60}$ heterocyclic group" as utilized herein may refer to a group condensed to any cyclic group, a monovalent group, or a polyvalent group (for example, a divalent group, a trivalent group, a tetravalent group, etc.), according to the structure of a formula in which the corresponding term is utilized. For example, "a benzene group" may be a benzo group, a phenyl group, a phenylene group, and/or the like, which may be easily understood by those of ordinary skill in the art according to the structure of a formula including the "benzene group."

Depending on context, in the present disclosure, a divalent group may refer or be a polyvalent group (e.g., trivalent, tetravalent, etc., and not just divalent) per, e.g., the structure of a formula in connection with which of the terms are utilized.

For example, non-limiting examples of a monovalent $C_3$-$C_{60}$ carbocyclic group and a monovalent $C_1$-$C_{60}$ heterocyclic group may comprise a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group, and non-limiting examples of a divalent $C_3$-$C_{60}$ carbocyclic group and a divalent $C_1$-$C_{60}$ heterocyclic group may comprise a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a substituted or unsubstituted divalent non-aromatic condensed heteropolycyclic group.

The term "$C_1$-$C_{60}$ alkyl group" as utilized herein refers to a linear or branched aliphatic hydrocarbon monovalent group that has one to sixty carbon atoms, and non-limiting examples thereof may comprise a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "$C_1$-$C_{60}$ alkylene group" as utilized herein refers to a divalent group having the same structure as the $C_1$-$C_{60}$ alkyl group.

The term "$C_2$-$C_{60}$ alkenyl group" as utilized herein refers to a monovalent hydrocarbon group having at least one carbon-carbon double bond in the middle or at the terminus of a $C_2$-$C_{60}$ alkyl group, and non-limiting examples thereof may comprise an ethenyl group, a propenyl group, and a butenyl group. The term "$C_2$-$C_{60}$ alkenylene group" as utilized herein refers to a divalent group having the same structure as the $C_2$-$C_{60}$ alkenyl group.

The term "$C_2$-$C_{60}$ alkynyl group" as utilized herein refers to a monovalent hydrocarbon group having at least one carbon-carbon triple bond in the middle or at the terminus of a $C_2$-$C_{60}$ alkyl group, and non-limiting examples thereof may comprise an ethynyl group and a propynyl group. The term "$C_2$-$C_{60}$ alkynylene group" as utilized herein refers to a divalent group having the same structure as the $C_2$-$C_{60}$ alkynyl group.

The term "$C_1$-$C_{60}$ alkoxy group" as utilized herein refers to a monovalent group represented by $-OA_{101}$ (wherein $A_{101}$ is the $C_1$-$C_{60}$ alkyl group), and non-limiting examples thereof may comprise a methoxy group, an ethoxy group, and an isopropyloxy group.

The term "$C_3$-$C_{10}$ cycloalkyl group" as utilized herein refers to a monovalent saturated hydrocarbon cyclic group having 3 to 10 carbon atoms, and non-limiting examples thereof may comprise a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group. The term "$C_3$-$C_{10}$ cycloalkylene group" as utilized herein refers to a divalent group having the same structure as the $C_3$-$C_{10}$ cycloalkyl group.

The term "$C_1$-$C_{10}$ heterocycloalkyl group" as utilized herein refers to a monovalent cyclic group that further comprises, in addition to a carbon atom, at least one heteroatom as a ring-forming atom and has 1 to 10 carbon atoms, and non-limiting examples thereof may comprise a 1,2,3,4-oxatriazolidinyl group, a tetrahydrofuranyl group, and a tetrahydrothiophenyl group. The term "$C_1$-$C_{10}$ heterocycloalkylene group" as utilized herein refers to a divalent group having the same structure as the $C_1$-$C_{10}$ heterocycloalkyl group.

The term "$C_3$-$C_{10}$ cycloalkenyl group" utilized herein refers to a monovalent cyclic group that has three to ten carbon atoms and at least one carbon-carbon double bond in the ring thereof and no aromaticity, and non-limiting examples thereof may comprise a cyclopentenyl group, a cyclohexenyl group, and a cycloheptenyl group. The term "$C_3$-$C_{10}$ cycloalkenylene group" as utilized herein refers to a divalent group having the same structure as the $C_3$-$C_{10}$ cycloalkenyl group.

The term "$C_1$-$C_{10}$ heterocycloalkenyl group" as utilized herein refers to a monovalent cyclic group that has, in addition to a carbon atom, at least one heteroatom as a ring-forming atom, 1 to 10 carbon atoms, and at least one double bond in the cyclic structure thereof. Non-limiting examples of the $C_1$-$C_{10}$ heterocycloalkenyl group may comprise a 4,5-dihydro-1,2,3,4-oxatriazolyl group, a 2,3-dihydrofuranyl group, and a 2,3-dihydrothiophenyl group. The term "$C_1$-$C_{10}$ heterocycloalkenylene group" as utilized herein refers to a divalent group having the same structure as the $C_1$-$C_{10}$ heterocycloalkenyl group.

The term "$C_6$-$C_{60}$ aryl group" as utilized herein refers to a monovalent group having a carbocyclic aromatic system having six to sixty carbon atoms, and the term "$C_6$-$C_{60}$ arylene group" as utilized herein refers to a divalent group having a carbocyclic aromatic system having six to sixty carbon atoms. Non-limiting examples of the $C_6$-$C_{60}$ aryl group may comprise a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the $C_6$-$C_{60}$ aryl group and the $C_6$-$C_{60}$ arylene group each comprise two or more rings, the rings may be condensed with each other.

The term "$C_1$-$C_{60}$ heteroaryl group" as utilized herein refers to a monovalent group having a heterocyclic aromatic system that has, in addition to a carbon atom, at least one heteroatom as a ring-forming atom, and 1 to 60 carbon atoms. The term "$C_1$-$C_{60}$ heteroarylene group" as utilized herein refers to a divalent group having a heterocyclic aromatic system that has, in addition to a carbon atom, at least one heteroatom as a ring-forming atom, and 1 to 60 carbon atoms. Non-limiting examples of the $C_1$-$C_{60}$ heteroaryl group may comprise a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the $C_1$-$C_{60}$ heteroaryl group and the $C_1$-$C_{60}$ heteroarylene group each comprise two or more rings, the rings may be condensed with each other.

The term "monovalent non-aromatic condensed polycyclic group" as utilized herein refers to a monovalent group having two or more rings condensed to each other, only carbon atoms (for example, having 8 to 60 carbon atoms) as ring-forming atoms, and non-aromaticity in its molecular structure when considered as a whole. Non-limiting examples of the monovalent non-aromatic condensed polycyclic group may comprise an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as utilized herein refers to a divalent group having the same structure as a monovalent non-aromatic condensed polycyclic group.

The term "monovalent non-aromatic condensed heteropolycyclic group" as utilized herein refers to a monovalent group having two or more rings condensed to each other, at least one heteroatom other than carbon atoms (for example, having 1 to 60 carbon atoms), as a ring-forming atom, and non-aromaticity in its molecular structure when considered as a whole. Non-limiting examples of the monovalent non-aromatic condensed heteropolycyclic group may comprise a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as utilized herein refers to a divalent group having the same structure as a monovalent non-aromatic condensed heteropolycyclic group.

The term "$C_6$-$C_{60}$ aryloxy group" as utilized herein indicates $-OA_{102}$ (wherein $A_{102}$ is the $C_6$-$C_{60}$ aryl group), and the term "$C_6$-$C_{60}$ arylthio group" as utilized herein indicates $-SA_{103}$ (wherein $A_{103}$ is the $C_6$-$C_{60}$ aryl group).

The term "$C_7$-$C_{60}$ arylalkyl group" as utilized herein refers to $-A_{104}A_{105}$ (where $A_{104}$ may be a $C_1$-$C_{54}$ alkylene group, and $A_{105}$ may be a $C_6$-$C_{59}$ aryl group), and the term "$C_2$-$C_{60}$ heteroarylalkyl group" utilized herein refers to $-A_{106}A_{107}$ (where $A_{106}$ may be a $C_1$-$C_{59}$ alkylene group, and $A_{107}$ may be a $C_1$-$C_{59}$ heteroaryl group).

$R_{10a}$ may be:

deuterium, -F, -Cl, -Br, -I, a hydroxyl group, a cyano group, or a nitro group;

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or any combination thereof;

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_6$o aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or

$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $-P(=O)(Q_{31})(Q_{32})$.

$Q_1$ to $Q_3$, $Q_{11}$ to $Q_{13}$, $Q_{21}$ to $Q_{23}$, and $Q_{31}$ to $Q_{33}$ in the present disclosure may each independently be: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

The term "heteroatom" as utilized herein refers to any atom other than a carbon atom. Non-limiting examples of the heteroatom may comprise O, S, N, P, Si, B, Ge, Se, or any combination thereof.

The term "the transition metal" as utilized herein comprises hafnium (Hf), tantalum (Ta), tungsten (W), rhenium (Re), osmium (Os), iridium (Ir), platinum (Pt), gold (Au), and/or the like.

The term "Ph" as utilized herein refers to a phenyl group, the term "Me" as utilized herein refers to a methyl group, the term "Et" as utilized herein refers to an ethyl group, the term "tert-Bu" or "$Bu^t$" as utilized herein refers to a tert-butyl group, and the term "OMe" as utilized herein refers to a methoxy group.

The term "biphenyl group" as utilized herein refers to "a phenyl group substituted with a phenyl group." In other words, the "biphenyl group" is a substituted phenyl group having a $C_6$-$C_{60}$ aryl group as a substituent.

The term "terphenyl group" as utilized herein refers to "a phenyl group substituted with a biphenyl group". The "terphenyl group" is a substituted phenyl group having, as a substituent, a $C_6$-$C_{60}$ aryl group substituted with a $C_6$-$C_{60}$ aryl group.

*, *' and *" as utilized herein, unless defined otherwise, each refer to a binding site to a neighboring atom in a corresponding formula or moiety.

Hereinafter, compounds and light-emitting devices according to one or more embodiments of the present disclosure will be described in more detail with reference to the following Synthesis Examples and Examples. The wording "B was utilized instead of A," utilized in describing Synthesis Examples, indicates that an identical molar equivalent of B was utilized in place of A.

## Examples

### Synthesis Example 1 (Synthesis of Compound BD01)

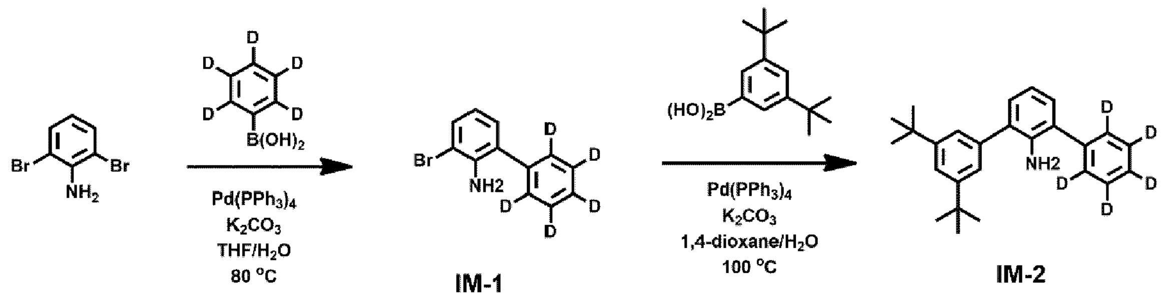


IM-1 IM-2

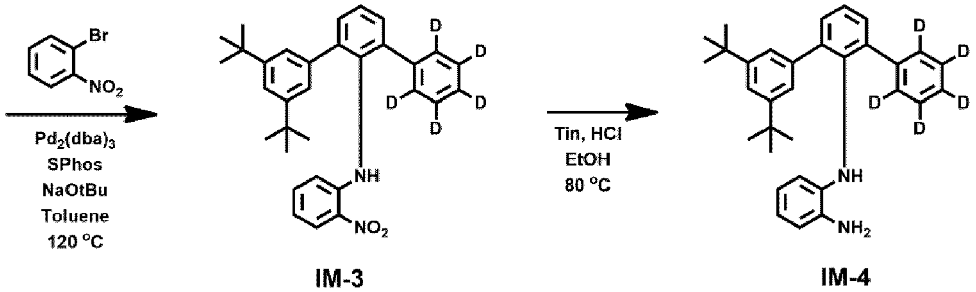


IM-3 IM-4

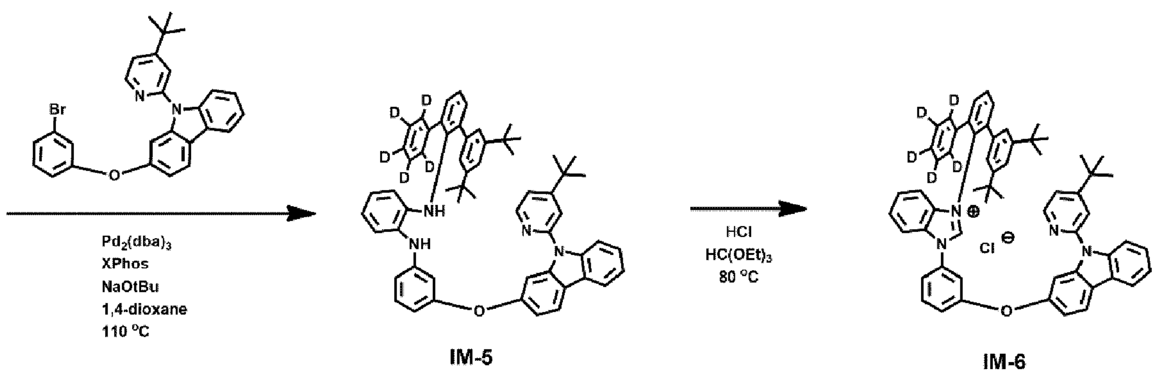


IM-5 IM-6

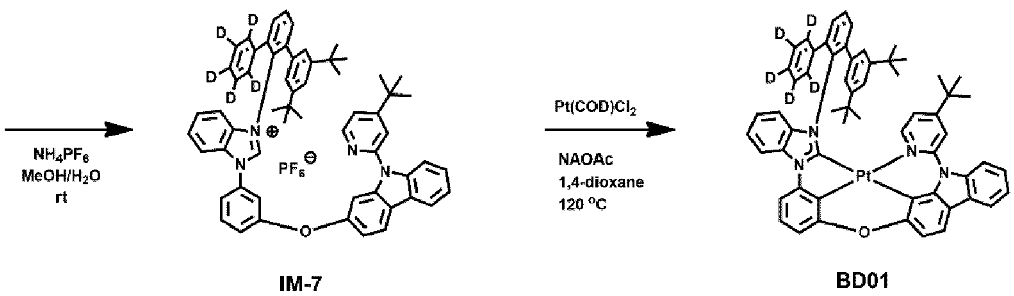


IM-7 BD01

**Synthesis of Intermediate IM-1**

2,6-dibromoaniline (25.0 g, 100.0 mmol), (phenyl-$d_5$)boronic acid (6.4 g, 50.0 mmol), tetrakis(triphenylphosphine)palladium(0) ($Pd(PPh_3)_4$) (2.9 g, 2.5 mmol), and $K_2CO_3$ (13.8 g, 100.0 mmol) were placed in a reaction vessel, suspended in tetrahydrofuran (THF) (200 mL) and $H_2O$ (50 mL) under nitrogen, and then heated and stirred at 80 °C for 12 hours. After the reaction was terminated, the mixture was cooled to room temperature, 150 mL of distilled water was added thereto, an organic layer was extracted therefrom utilizing ethylacetate, and the organic layer thus extracted

therefrom was washed with a saturated sodium chloride aqueous solution and dried utilizing sodium sulfate. The resulting product thus obtained therefrom was subjected to column chromatography to obtain Intermediate IM-1 (16.1 g, 63.6 mmol) in the yield of 65 %.

**Synthesis of Intermediate IM-2**

Intermediate IM-1 (7.8 g, 28.5 mmol), (3,5-di-tert-butylphenyl)boronic acid (10.0 g, 2.3 g), $Pd(PPh_3)_4$ (2.6 g, 2.2 mmol), and $K_2CO_3$ (12.6 g, 90.9 mmol) were placed in a reaction vessel, and suspended in 1,4-dioxane (210 mL) and $H_2O$ (70 mL) under nitrogen, and then heated and stirred at 100 °C for 12 hours. After the reaction was terminated, the mixture was cooled to room temperature, 150 mL of distilled water was added thereto, an organic layer was extracted therefrom utilizing ethylacetate, and the organic layer thus extracted therefrom was washed with a saturated sodium chloride aqueous solution and dried utilizing sodium sulfate. The resulting product thus obtained therefrom was subjected to column chromatography to obtain Intermediate **IM-2** (10.0 g, 27.6 mmol) in the yield of 97 %.

**Synthesis of Intermediate IM-3**

Intermediate **IM-2** (10.0 g, 27.6 mmol), 1-bromo-2-nitrobenzene (8.4 g, 41.4 mmol), tris(dibenzylideneacetone)dipalladium(0) ($Pd_2(dba)_3$) (2.6 g, 2.8 mmol), 2-dicyclohexylphosphino-2',6'-dimethoxybiphenyl (SPhos) (1.7 g, 4.1 mmol), and $NaO^tBu$ (10.6 g, 110.4 mmol) were placed in a reaction vessel, suspended in toluene (250 mL) under nitrogen, and then heated and stirred at 120 °C for 12 hours. After the reaction was terminated, the mixture was cooled to room temperature, 150 mL of distilled water was added thereto, an organic layer was extracted therefrom utilizing ethylacetate, and the organic layer thus extracted therefrom was washed with a saturated sodium chloride aqueous solution and dried utilizing sodium sulfate. The resulting product thus obtained therefrom was subjected to column chromatography to obtain Intermediate **IM-3** (11.6 g, 24.0 mmol) in the yield of 87 %.

**Synthesis of Intermediate IM-4**

A mixture of Intermediate **IM-3** (11.6 g, 24.0 mmol) and tin (8.5 g, 72 mmol) was placed in a reaction vessel, suspended in a mixed solution of ethanol (EtOH) (240 mL) and HCl (37 %, 10.8 mL), and then heated and stirred at 80 °C for 12 hours. After the reaction was terminated, the mixture was cooled to room temperature, 150 mL of distilled water was added thereto, followed by neutralization, an organic layer was extracted therefrom utilizing dichloromethane, and the organic layer thus extracted therefrom was washed with a saturated sodium chloride aqueous solution and dried utilizing sodium sulfate. The resulting product thus obtained therefrom was subjected to column chromatography to obtain Intermediate **IM-4** (9.6 g, 21.1 mmol) in the yield of 88 %.

**Synthesis of Intermediate IM-5**

Intermediate **IM-4** ($N^1$-(3,5-di-tert-butyl-[1,1':3',1"-terphenyl]-2'-yl-2",3",4",5",6"-$d_5$)benzene-1,2-diamine) (5.2 g, 11.4 mmol), 2-(3-bromophenoxy)-9-(4-(tert-butyl)pyridin-2-yl)-9H-carbazole (5.4 g, 11.4 mmol), $Pd_2(dba)_3$ (0.2 g, 0.2 mmol), SPhos (1.9 g, 4.6 mmol), and $NaO^tBu$ (1.7 g, 18.2 mmol) were placed in a reaction vessel, suspended in 114 mL of toluene, and then heated and stirred at 110 °C for 4 hours. After the reaction was terminated, the mixture was cooled to room temperature, 300 mL of distilled water was added thereto, an organic layer was extracted therefrom utilizing ethylacetate, and the organic layer thus extracted therefrom was washed with a saturated sodium chloride aqueous solution and dried utilizing sodium sulfate. The resulting product thus obtained therefrom was subjected to column chromatography to obtain Intermediate **IM-5** (6.2 g, 7.4 mmol) in the yield of 65 %.

**Synthesis of Intermediate IM-6**

Intermediate **IM-5** (6.2 g, 7.4 mmol), HCl (37%), and $HC(OEt)_3$ (0.9 mL, 8.9 mmol) were placed in a reaction vessel, and then heated and stirred at 80 °C for 12 hours. After the reaction was terminated, the mixture was cooled to room temperature, a solid thus generated was subjected to filtration and washed utilizing ether, and then the washed solid was dried to obtain Intermediate **IM-6** (6.3 g, 7.0 mmol) in the yield of 95 %.

**Synthesis of Intermediate IM-7**

Intermediate **IM-6** (6.3 g, 7.7 mmol) and $NH_4PF_6$ (3.8 g, 23.1 mmol) were placed in a reaction vessel and suspended in a mixed solution of 100 mL of methyl alcohol and 50 mL of water, and then stirred at room temperature for 24 hours. After the reaction was terminated, a solid thus generated was subjected to filtration and washed utilizing

ether, and then the washed solid was dried to obtain Intermediate **IM-7** (7.0 g, 7.0 mmol) in the yield of 99 %.

### Synthesis of Compound BD01

Intermediate **IM-7** (6.4 g, 6.9 mmol) and dichloro(1,5-cyclooctadiene)platinum (Pt(COD)$Cl_2$) (2.8 g, 7.6 mmol), and sodium acetate (NaOAc) (1.7 g, 20.7 mmol) were suspended in 150 mL of 1,4-dioxane, and then heated and stirred at 120 °C for 72 hours. After the reaction was terminated, the mixture was cooled to room temperature, 150 mL of distilled water was added thereto, an organic layer was extracted therefrom utilizing ethylacetate, and then, the organic layer thus extracted therefrom was washed with a NaCl aqueous solution and dried utilizing $MgSO_4$. The resulting product thus obtained therefrom was subjected to column chromatography to obtain Compound BD01 (2.2 g, 2.1 mmol) in the yield of 30 %.

### Synthesis Example 2 (Synthesis of Compound BD02)

Compound **BD02** (2.5 g, 2.4 mmol) was obtained in the yield of 33 % by utilizing substantially the same manner as in Synthesis Example 1, except that, during synthesis of Intermediate IM-5, 2-(3-bromophenoxy)-9-(4-(tert-butyl)pyridin-2-yl)-9H-carbazole-5,6,7,8-$d_4$ was utilized instead of 2-(3-bromophenoxy)-9-(4-(tert-butyl)pyridin-2-yl)-9H-carbazole.

### Synthesis Example 3 (Synthesis of Compound BD03)

Compound **BD03** (2.3 g, 2.2 mmol) was obtained in the yield of 32 % by utilizing substantially the same manner as in Synthesis Example 1, except that, during synthesis of Intermediate IM-5, 2-(3-bromophenoxy)-9-(4-(tert-butyl)pyridin-2-yl)-9H-carbazole-3,4,5,6,7,8-$d_6$ was utilized instead of 2-(3-bromophenoxy)-9-(4-(tert-butyl)pyridin-2-yl)-9H-carbazole.

### Synthesis Example 4 (Synthesis of Compound BD07)

Compound **BD07** (2.8 g, 2.5 mmol) was obtained in the yield of 36 % by utilizing substantially the same manner as in Synthesis Example 1, except that, during synthesis of Intermediate IM-5, 2-(3-bromophenoxy)-9-(4-(tert-butyl)pyridin-2-yl)-6-phenyl-9H-carbazole was utilized instead of 2-(3-bromophenoxy)-9-(4-(tert-butyl)pyridin-2-yl)-9H-carbazole.

### Synthesis Example 5 (Synthesis of Compound BD08)

Compound **BD08** (2.6 g, 2.3 mmol) was obtained in the yield of 33 % by utilizing substantially the same manner as in Synthesis Example 1, except that, during synthesis of Intermediate IM-5, 2-(3-bromophenoxy)-9-(4-(tert-butyl)pyridin-2-yl)-6-(phenyl-$d_5$)-9H-carbazole was utilized instead of 2-(3-bromophenoxy)-9-(4-(tert-butyl)pyridin-2-yl)-9H-carbazole.

### Synthesis Example 6 (Synthesis of Compound BD09)

Compound **BD09** (2.5 g, 2.1 mmol) was obtained in the yield of 31 % by utilizing substantially the same manner as in Synthesis Example 1, except that, during synthesis of Intermediate IM-5, 2-(3-bromophenoxy)-9-(4-(tert-butyl)pyridin-2-yl)-6-(phenyl-$d_5$)-9H-carbazole-3,4,5,7,8-$d_5$ was utilized instead of 2-(3-bromophenoxy)-9-(4-(tert-butyl)pyridin-2-yl)-9H-carbazole.

### Synthesis Example 7 (Synthesis of Compound BD10)

Compound **BD10** (2.5 g, 2.2 mmol) was obtained in the yield of 32 % by utilizing substantially the same manner as in Synthesis Example 1, except that, during synthesis of Intermediate IM-5, 2-(3-bromophenoxy)-9-(4-(tert-butyl)pyridin-2-yl-3,5,6-$d_3$)-6-(phenyl-$d_5$)-9H-carbazole was utilized instead of 2-(3-bromophenoxy)-9-(4-(tert-butyl)pyridin-2-yl)-9H-carbazole.

### Synthesis Example 8 (Synthesis of Compound BD15)

Compound **BD15** (2.3 g, 2.3 mmol) was obtained in the yield of 33 % by utilizing substantially the same manner as in Synthesis Example 1, except that, during synthesis of Intermediate IM-2, (3-(tert-butyl)phenyl)boronic acid was

utilized instead of (3,5-di-tert-butylphenyl)boronic acid.

**Synthesis Example** 9 **(Synthesis of Compound BD16)**

Compound **BD16** (2.3 g, 2.3 mmol) was obtained in the yield of 36 % by utilizing substantially the same manner as in Synthesis Example 1, except that, i) during synthesis of Intermediate IM-2, (3-(tert-butyl)phenyl)boronic acid was utilized instead of (3,5-di-tert-butylphenyl)boronic acid, and ii) during synthesis of Intermediate IM-5, 2-(3-bromophenoxy)-9-(4-(tert-butyl)pyridin-2-yl)-9H-carbazole-5,6,7,8-$d_4$ was utilized instead of 2-(3-bromophenoxy)-9-(4-(tert-butyl)pyridin-2-yl)-9H-carbazole.

**Synthesis Example 10 (Synthesis of Compound BD17)**

Compound **BD17** (2.4 g, 2.4 mmol) was obtained in the yield of 35 % by utilizing substantially the same manner as in Synthesis Example 1, except that, i) during synthesis of Intermediate IM-2, (3-(tert-butyl)phenyl)boronic acid was utilized instead of (3,5-di-tert-butylphenyl)boronic acid, and ii) during synthesis of Intermediate IM-5, 2-(3-bromophenoxy)-9-(4-(tert-butyl)pyridin-2-yl)-9H-carbazole-3,4,5,6,7,8-$d_6$ was utilized instead of 2-(3-bromophenoxy)-9-(4-(tert-butyl)pyridin-2-yl)-9H-carbazole.

**Synthesis Example 11 (Synthesis of Compound BD21)**

Compound **BD21** (2.3 g, 2.1 mmol) was obtained in the yield of 31 % by utilizing substantially the same manner as in Synthesis Example 1, except that, i) during synthesis of Intermediate IM-2, (3-(tert-butyl)phenyl)boronic acid was utilized instead of (3,5-di-tert-butylphenyl)boronic acid, and ii) during synthesis of Intermediate IM-5, 2-(3-bromophenoxy)-9-(4-(tert-butyl)pyridin-2-yl)-6-phenyl-9H-carbazole was utilized instead of 2-(3-bromophenoxy)-9-(4-(tert-butyl)pyridin-2-yl)-9H-carbazole.

**Synthesis Example 12 (Synthesis of Compound BD22)**

Compound **BD22** (2.4 g, 2.3 mmol) was obtained in the yield of 33 % by utilizing substantially the same manner as in Synthesis Example 1, except that, i) during synthesis of Intermediate IM-2, (3-(tert-butyl)phenyl)boronic acid was utilized instead of (3,5-di-tert-butylphenyl)boronic acid, and ii) during synthesis of Intermediate IM-5, 2-(3-bromophenoxy)-9-(4-(tert-butyl)pyridin-2-yl)-6-(phenyl-$d_5$)-9H-carbazole was utilized instead of 2-(3-bromophenoxy)-9-(4-(tert-butyl)pyridin-2-yl)-9H-carbazole.

**Synthesis Example 13 (Synthesis of Compound BD23)**

Compound **BD23** (2.4 g, 2.2 mmol) was obtained in the yield of 32 % by utilizing substantially the same manner as in Synthesis Example 1, except that, i) during synthesis of Intermediate IM-2, (3-(tert-butyl)phenyl)boronic acid was utilized instead of (3,5-di-tert-butylphenyl)boronic acid, and ii) during synthesis of Intermediate IM-5, 2-(3-bromophenoxy)-9-(4-(tert-butyl)pyridin-2-yl)-6-(phenyl-$d_5$)-9H-carbazole-3,4,5,7,8-$d_5$ was utilized instead of 2-(3-bromophenoxy)-9-(4-(tert-butyl)pyridin-2-yl)-9H-carbazole.

**Synthesis Example 14 (Synthesis of Compound BD24)**

Compound **BD24** (2.4 g, 2.3 mmol) was obtained in the yield of 33 % by utilizing substantially the same manner as in Synthesis Example 1, except that, i) during synthesis of Intermediate IM-2, (3-(tert-butyl)phenyl)boronic acid was utilized instead of (3,5-di-tert-butylphenyl)boronic acid, and ii) during synthesis of Intermediate IM-5, 2-(3-bromophenoxy)-9-(4-(tert-butyl)pyridin-2-yl-3,5,6-$d_3$)-6-(phenyl-$d_5$)-9H-carbazole was utilized instead of 2-(3-bromophenoxy)-9-(4-(tert-butyl)pyridin-2-yl)-9H-carbazole.

**Synthesis Example 15 (Synthesis of Compound BD113)**

Compound **BD113** (1.8 g, 1.7 mmol) was obtained in the yield of 25 % by utilizing substantially the same manner as in Synthesis Example 1, except that, during synthesis of Intermediate IM-1, phenylboronic acid was utilized instead of (phenyl-$d_5$)boronic acid.

**Synthesis Example 16 (Synthesis of Compound BD119)**

Compound BD119 (3.0 g, 2.8 mmol) was obtained in the yield of 33 % by utilizing substantially the same manner as in Synthesis Example 1, except that, during synthesis of Intermediate IM-5, 2-(3-bromophenoxy)-9-(4-(tert-butyl)pyridin-2-yl)-6-(methyl-$d_3$)-9H-carbazole was utilized instead of 2-(3-bromophenoxy)-9-(4-(tert-butyl)pyridin-2-yl)-9H-carbazole.

Measurement results of $^1$H NMR and high-resolution mass (HR-MS) of the compounds synthesized in Synthesis Examples 1 to 16 are shown in Table 2. Synthesis methods of compounds other than the compounds synthesized in Synthesis Examples 1 to 16 may be easily recognized by those skilled in the art by referring to the synthesis paths and source materials.

Table 2

| Compound | $^1$H NMR ($CDCl_3$, 500 MHz) | HR-MS (m/z) [$M^+$] | |
|---|---|---|---|
| | | Found | calc. |
| IM-1 | δ 7.41 (dd, $^3J_{H-H}$ = 7.6 Hz, $^4J_{H-H}$ = 1.4 Hz, 1H), 7.05 (dd, $^3J_{H-H}$ = 7.6 Hz, $^4J_{H-H}$ = 1.4 Hz, 1H), 6.67 (t, $^3J_{H-H}$ = 7.6 Hz, 1H), 4.20 (br, 2H). | 252.03412 | 252.03105 |
| IM-2 | δ 7.41 (t, $^4J_{H-H}$ = 1.8 Hz, 1H), 7.35 (d, $^4J_{H-H}$ = 1.8 Hz, 2H), 7.17 (dd, $^3J_{H-H}$ = 7.5 Hz, $^4J_{H-H}$ = 1.6 Hz, 1H), 7.12 (dd, $^3J_{H-H}$ = 7.5 Hz, $^4J_{H-H}$ = 1.6 Hz, 1H), 6.89 (t, $^3J_{H-H}$ = 7.5 Hz, 1H), 3.90 (br, 2H), 1.36 (s, 18H). | 362.27912 | 362.27703 |
| IM-3 | δ 9.14 (s, 1H), 7.87 (dd, $^3J_{H-H}$ = 8.6 Hz, $^4J_{H-H}$ = 1.5 Hz, 1H), 7.49-7.44 (m, 3H), 7.22 (t, $^4J_{H-H}$ = 1.7 Hz, 1H), 7.12 (d, $^4J_{H-H}$ = 1.7 Hz, 2H), 7.01 (td, $^3J_{H-H}$ = 8.2 Hz, $^4J_{H-H}$ = 1.3 Hz, 1H), 6.51 (dd, $^3J_{H-H}$ = 8.2 Hz, $^4J_{H-H}$ = 1.3 Hz, 1H), 6.44 (td, $^3J_{H-H}$ = 8.2 Hz, $^4J_{H-H}$ = 1.3 Hz, 1H), 1.18 (s, 18H). | 483.29372 | 483.29341 |
| IM-4 | δ 7.33 (dd, $^3J_{H-H}$ = 7.5 Hz, $^4J_{H-H}$ = 1.8 Hz, 1H), 7.28 (dd, $^3J_{H-H}$ = 7.5 Hz, $^4J_{H-H}$ = 1.8 Hz, 1H), 7.23 (t, $^4J_{H-H}$ = 1.8 Hz, 1H), 7.21 (t, $^3J_{H-H}$ = 7.5 Hz, $^4J_{H-H}$ = 1.6 Hz, 1H), 7.17 (d, $^4J_{H-H}$ = 1.8 Hz, 2H), 6.55-6.53 (m, 2H), 6.42-6.39 (m, 1H), 6.37 (dd, $^3J_{H-H}$ = 7.8 Hz, $^4J_{H-H}$ = 1.2 Hz, 1H), 3.33 (br, 3H), 1.22 (s, 18H). | 453.31945 | 453.31923 |
| IM-5 | δ 8.56 (d, $^3J_{H-H}$ = 5.4 Hz, 1H), 8.10-8.02 (m, 3H), 7.54 (d, $^4J_{H-H}$ = 1.2 Hz, 1H), 7.46 (d, $^4J_{H-H}$ = 2.1 Hz, 1H), 7.35 (dd, $^3J_{H-H}$ = 7.3 Hz, $^4J_{H-H}$ = 1.9 Hz, 1H), 7.32 (dd, $^3J_{H-H}$ = 7.6 Hz, $^4J_{H-H}$ = 1.9 Hz, 1H), 7.28 (d, $^3J_{H-H}$ = 7.5 Hz, 1H), 7.26-7.25 (m, 2H), 7.22-7.18 (m, 2H), 7.11 (d, $^4J_{H-H}$ = 1.8 Hz, 2H), 7.02 (t, $^3J_{H-H}$ = 8.1 Hz, 1H), 7.00 (d, $^3J_{H-H}$ = 8.5 Hz, 1H), 6.89 (dd, $^3J_{H-H}$ = 7.8 Hz, $^4J_{H-H}$ = 1.1 Hz, 1H), 6.66 (td, $^3J_{H-H}$ = 7.6 Hz, $^4J_{H-H}$ = 1.1 Hz, 1H), 6.55 (dd, $^3J_{H-H}$ = 7.6 Hz, $^4J_{H-H}$ = 1.3 Hz, 1H), 6.52 (d, $^3J_{H-H}$ = 7.8 Hz, 1H), 6.43 (dd, $^3J_{H-H}$ = 7.5 Hz, $^4J_{H-H}$ = 1.8 Hz, 1H), 6.40 (t, $^4J_{H-H}$ = 2.2 Hz, 1H), 6.30 (dd, $^3J_{H-H}$ = 8.1 Hz, $^4J_{H-H}$ = 1.5 Hz, 1H), 5.36 (s, 1H), 4.96 (s, 1H), 1.34 (s, 9H), 1.18 (s, 18H). | 843.49276 | 843.49245 |
| IM-6 | δ 12.1 (s, 1H), 8.59 (d, $^3J_{H-H}$ = 5.3 Hz, 1H), 8.11 (d, $^3J_{H-H}$ = 8.4 Hz, 1H), 8.10 (d, $^3J_{H-H}$ = 7.8 Hz, 1H), 7.75 (t, $^3J_{H-H}$ = 7.7 Hz, 1H), 7.72 (d, $^3J_{H-H}$ = 8.2 Hz, 1H), 7.65-7.60 (m, 4H), 7.51 (d, $^3J_{H-H}$ = 7.6 Hz, 1H), 7.48-7.43 (m, 2H), 7.39-7.31 (m, 4H), 7.20-7.12 (m, 4H), 7.07 (dd, $^3J_{H-H}$ = 8.4 Hz, $^4J_{H-H}$ = 2.1 Hz, 1H), 7.01 (d, $^4J_{H-H}$ = 1.5 Hz, 1H), 6.84 (t, $^4J_{H-H}$ = 2.1 Hz, 1H), 1.40 (s, 9H), 1.02 (s, 18H). | - | - |
| IM-7 | δ 9.18 (s, 1H), 8.59 (d, $^3J_{H-H}$ = 5.4 Hz, 1H), 8.13 (d, $^3J_{H-H}$ = 8.4 Hz, 1H), 8.11 (d, $^3J_{H-H}$ = 7.7 Hz, 1H), 7.80 (t, $^3J_{H-H}$ = 7.8 Hz, 1H), 7.72 (d, $^3J_{H-H}$ = 8.3 Hz, 1H), 7.69-7.61 (m, 4H), 7.52 (d, $^3J_{H-H}$ = 8.2 Hz, 1H), 7.47-7.42 (m, 3H), 7.40 (td, $^3J_{H-H}$ = 7.8 Hz, $^4J_{H-H}$ = 1.0 Hz, 1H), 7.34 (td, $^3J_{H-H}$ = 7.5 Hz, $^4J_{H-H}$ = 0.7 Hz, 1H), 7.32 (dd, $^3J_{H-H}$ = 5.4 Hz, $^4J_{H-H}$ = 1.8 Hz, 1H), 7.26-7.24 (m, 2H), 7.19-7.17 (m, 1H), 7.07 (dd, $^3J_{H-H}$ = 8.4 Hz, $^4J_{H-H}$ = 2.2 Hz, 1H), 6.90 (d, $^4J_{H-H}$ = 1.3 Hz, 1H), 6.68 (t, $^4J_{H-H}$ = 1.8 Hz, 1H), 6.67-6.66 (m, 1H), 1.39 (s, 9H), 1.01 (s, 18H). | - | - |

(continued)

| Compound | $^1$H NMR ($CDCl_3$, 500 MHz) | HR-MS (m/z) [$M^+$] | |
|---|---|---|---|
| | | Found | calc. |
| BD01 | δ 9.10 (d, $^3J_{H-H}$ = 6.2 Hz, 1H), 8.08-8.05 (m, 3H), 7.94 (d, $^3J_{H-H}$ = 8.3 Hz, 1H), 7.76 (d, $^3J_{H-H}$ = 8.2 Hz, 1H), 7.59 (br s, 1H) 7.48 (t, $^3J_{H-H}$ = 7.7 Hz, 2H), 7.43-7.38 (m, 3H), 7.31 (d, $^3J_{H-H}$ = 8.2 Hz, 1H), 7.22-7.18 (m, 2H), 7.08 (br s, 3H), 7.05 (d, $^3J_{H-H}$ = 7.6 Hz, 1H), 6.99 (t, $^3J_{H-H}$ = 7.8 Hz, 1H), 6.85 (d, $^3J_{H-H}$ = 8.1 Hz, 1H), 6.23 (dd, $^3J_{H-H}$ = 6.3 Hz, $^4J_{H-H}$ = 2.0 Hz, 1H), 1.28 (s, 9H), 0.91 (br s, 18H). | 1046.42557 | 1046.42592 |
| BD02 | δ 9.10 (d, $^3J_{H-H}$ = 6.2 Hz, 1H), 8.07 (d, $^4J_{H-H}$ = 1.9 Hz, 1H), 7.94 (d, $^3J_{H-H}$ = 8.3 Hz, 1H), 7.76 (d, $^3J_{H-H}$ = 8.2 Hz, 1H), 7.59 (br s, 1H) 7.48 (t, $^3J_{H-H}$ = 7.7 Hz, 2H), 7.42 (d, $^3J_{H-H}$ = 7.5 Hz, 1H), 7.36 (br s, 1H), 7.31 (d, $^3J_{H-H}$ = 8.2 Hz, 1H), 7.22-7.18 (m, 2H), 7.08 (br s, 2H), 7.05 (d, $^3J_{H-H}$ = 7.6 Hz, 1H), 6.99 (t, $^3J_{H-H}$ = 7.8 Hz, 1H), 6.85 (d, $^3J_{H-H}$ = 8.1 Hz, 1H), 6.23 (dd, $^3J_{H-H}$ = 6.3 Hz, $^4J_{H-H}$ = 2.0 Hz, 1H), 1.28 (s, 9H), 0.91 (br s, 18H). | 1050.44970 | 1050.45103 |
| BD03 | δ 9.10 (d, $^3J_{H-H}$ = 6.2 Hz, 1H), 8.07 (d, $^4J_{H-H}$ = 1.9 Hz, 1H), 7.94 (d, $^3J_{H-H}$ = 8.3 Hz, 1H), 7.59 (br s, 1H) 7.48 (t, $^3J_{H-H}$ = 7.7 Hz, 2H), 7.36 (br s, 1H), 7.31 (d, $^3J_{H-H}$ = 8.2 Hz, 1H), 7.22-7.18 (m, 2H), 7.08 (br s, 2H), 7.05 (d, $^3J_{H-H}$ = 7.6 Hz, 1H), 6.99 (t, $^3J_{H-H}$ = 7.8 Hz, 1H), 6.85 (d, $^3J_{H-H}$ = 8.1 Hz, 1H), 6.23 (dd, $^3J_{H-H}$ = 6.3 Hz, $^4J_{H-H}$ = 2.0 Hz, 1H), 1.28 (s, 9H), 0.91 (br s, 18H). | 1052.46365 | 1052.46358 |
| BD07 | δ 9.07 (d, $^3J_{H-H}$ = 6.1 Hz, 1H), 8.29 (d, $^4J_{H-H}$ = 1.7 Hz, 1H), 8.11 (d, $^3J_{H-H}$ = 8.4 Hz, 1H), 8.09 (d, $^4J_{H-H}$ = 1.8 Hz, 1H), 7.94 (d, $^3J_{H-H}$ = 8.3 Hz, 1H), 7.83-7.80 (m, 3H), 7.73 (dd, $^3J_{H-H}$ = 8.4 Hz, $^4J_{H-H}$ = 1.7 Hz, 1H), 7.60 (br s, 2H), 7.53 (t, $^3J_{H-H}$ = 7.6 Hz, 2H), 7.49 (t, $^3J_{H-H}$ = 7.6 Hz, 1H), 7.43 (d, $^3J_{H-H}$ = 7.6 Hz, 1H), 7.40 (t, $^3J_{H-H}$ = 7.4 Hz, 1H), 7.33 (d, $^3J_{H-H}$ = 8.2 Hz, 1H), 7.30-7.26 (m, 2H), 7.21 (q, $^3J_{H-H}$ = 7.9 Hz, 2H), 7.08 (br s, 1H), 7.06 (d, $^3J_{H-H}$ = 8.0 Hz, 1H), 7.00 (t, $^3J_{H-H}$ = 7.8 Hz, 1H), 6.85 (d, $^3J_{H-H}$ = 8.1 Hz, 1H), 6.25 (d, $^3J_{H-H}$ = 6.2 Hz, $^4J_{H-H}$ = 1.9 Hz, 1H), 1.30 (s, 9H), 0.94 (br s, 18H). | 1123.46461 | 1123.46450 |
| BD08 | δ 9.07 (d, $^3J_{H-H}$ = 6.1 Hz, 1H), 8.29 (d, $^4J_{H-H}$ = 1.7 Hz, 1H), 8.11 (d, $^3J_{H-H}$ = 8.4 Hz, 1H), 8.09 (d, $^4J_{H-H}$ = 1.8 Hz, 1H), 7.94 (d, $^3J_{H-H}$ = 8.3 Hz, 1H), 7.81 (d, $^3J_{H-H}$ = 8.2 Hz, 1H), 7.73 (dd, $^3J_{H-H}$ = 8.4 Hz, $^4J_{H-H}$ = 1.7 Hz, 1H), 7.60 (br s, 2H), 7.49 (t, $^3J_{H-H}$ = 7.6 Hz, 1H), 7.43 (d, $^3J_{H-H}$ = 7.6 Hz, 1H), 7.33 (d, $^3J_{H-H}$ = 8.2 Hz, 1H), 7.30-7.26 (m, 2H), 7.21 (q, $^3J_{H-H}$ = 7.9 Hz, 2H), 7.08 (br s, 1H), 7.06 (d, $^3J_{H-H}$ = 8.0 Hz, 1H), 7.00 (t, $^3J_{H-H}$ = 7.8 Hz, 1H), 6.85 (d, $^3J_{H-H}$ = 8.1 Hz, 1H), 6.25 (d, $^3J_{H-H}$ = 6.2 Hz, $^4J_{H-H}$ = 1.9 Hz, 1H), 1.30 (s, 9H), 0.94 (br s, 18H). | 1127.48908 | 1127.48860 |
| BD09 | δ 9.07 (d, $^3J_{H-H}$ = 6.1 Hz, 1H), 8.09 (d, $^4J_{H-H}$ = 1.8 Hz, 1H), 7.94 (d, $^3J_{H-H}$ = 8.3 Hz, 1H), 7.81 (d, $^3J_{H-H}$ = 8.2 Hz, 1H), 7.60 (br s, 2H), 7.49 (t, $^3J_{H-H}$ = 7.6 Hz, 1H), 7.33 (d, $^3J_{H-H}$ = 8.2 Hz, 1H), 7.30-7.26 (m, 2H), 7.21 (q, $^3J_{H-H}$ = 7.9 Hz, 1H), 7.08 (br s, 1H), 7.06 (d, $^3J_{H-H}$ = 8.0 Hz, 1H), 7.00 (t, $^3J_{H-H}$ = 7.8 Hz, 1H), 6.85 (d, $^3J_{H-H}$ = 8.1 Hz, 1H), 6.25 (d, $^3J_{H-H}$ = 6.2 Hz, $^4J_{H-H}$ = 1.9 Hz, 1H), 1.30 (s, 9H), 0.94 (br s, 18H). | 1130.50590 | 1131.51316 |
| BD10 | δ 8.29 (d, $^4J_{H-H}$ = 1.7 Hz, 1H), 8.11 (d, $^3J_{H-H}$ = 8.4 Hz, 1H), 7.94 (d, $^3J_{H-H}$ = 8.3 Hz, 1H), 7.81 (d, $^3J_{H-H}$ = 8.2 Hz, 1H), 7.73 (dd, $^3J_{H-H}$ = 8.4 Hz, $^4J_{H-H}$ = 1.7 Hz, 1H), 7.60 (br s, 2H), 7.49 (t, $^3J_{H-H}$ = 7.6 Hz, 1H), 7.43 (d, $^3J_{H-H}$ = 7.6 Hz, 1H), 7.33 (d, $^3J_{H-H}$ = 8.2 Hz, 1H), 7.30-7.26 (m, 2H), 7.21 (q, $^3J_{H-H}$ = 7.9 Hz, 2H), 7.08 (br s, 1H), 7.06 (d, $^3J_{H-H}$ = 8.0 Hz, 1H), 7.00 (t, $^3J_{H-H}$ = 7.8 Hz, 1H), 6.85 (d, $^3J_{H-H}$ = 8.1 Hz, 1H), 1.30 (s, 9H), 0.94 (br s, 18H). | 1130.49964 | 1130.50689 |

(continued)

| Compound | $^1$H NMR ($CDCl_3$, 500 MHz) | HR-MS (m/z) [$M^+$] | |
|---|---|---|---|
| | | Found | calc. |
| BD15 | δ 9.06 (d, $^3J_{H-H}$ = 6.3 Hz, 1H), 8.08-8.03 (m, 3H), 7.94 (d, $^3J_{H-H}$ = 8.3 Hz, 1H), 7.76-7.71 (m, 2H), 7.53 (t, $^3J_{H-H}$ = 7.7 Hz, 1H), 7.47-7.38 (m, 5H), 7.33-7.28 (m, 3H), 7.24-7.17 (m, 3H), 7.06-7.00 (m, 2H), 6.95 (t, $^3J_{H-H}$ = 8.1 Hz, 1H), 6.23 (dd, $^3J_{H-H}$ = 6.3 Hz, $^4J_{H-H}$ = 2.0 Hz, 1H), 1.31 (s, 9H), 1.29 (s, 9H). | 990.36337 | 990.36332 |
| BD16 | δ 9.06 (d, $^3J_{H-H}$ = 6.3 Hz, 1H), 8.07 (d, $^4J_{H-H}$ = 1.6 Hz, 1H), 7.94 (d, $^3J_{H-H}$ = 8.3 Hz, 1H), 7.76-7.71 (m, 2H), 7.53 (t, $^3J_{H-H}$ = 7.7 Hz, 1H), 7.47-7.39 (m, 3H), 7.33-7.28 (m, 3H), 7.24-7.17 (m, 3H), 7.06-7.00 (m, 2H), 6.95 (t, $^3J_{H-H}$ = 8.1 Hz, 1H), 6.23 (dd, $^3J_{H-H}$ = 6.3 Hz, $^4J_{H-H}$ = 2.0 Hz, 1H), 1.31 (s, 9H), 1.29 (s, 9H). | 994.38823 | 994.38788 |
| BD17 | δ 9.06 (d, $^3J_{H-H}$ = 6.3 Hz, 1H), 8.07 (d, $^4J_{H-H}$ = 1.6 Hz, 1H), 7.94 (d, $^3J_{H-H}$ = 8.3 Hz, 1H), 7.76-7.71 (m, 1H), 7.53 (t, $^3J_{H-H}$ = 7.7 Hz, 1H), 7.47-7.39 (m, 2H), 7.33-7.28 (m, 3H), 7.24-7.17 (m, 3H), 7.06-7.00 (m, 2H), 6.95 (t, $^3J_{H-H}$ = 8.1 Hz, 1H), 6.23 (dd, $^3J_{H-H}$ = 6.3 Hz, $^4J_{H-H}$ = 2.0 Hz, 1H), 1.31 (s, 9H), 1.29 (s, 9H). | 996.40102 | 996.40098 |
| BD21 | δ 9.07 (d, $^3J_{H-H}$ = 6.1 Hz, 1H), 8.29 (d, $^4J_{H-H}$ = 1.7 Hz, 1H), 8.11 (d, $^3J_{H-H}$ = 8.4 Hz, 1H), 8.09 (d, $^4J_{H-H}$ = 1.8 Hz, 1H), 7.94 (d, $^3J_{H-H}$ = 8.3 Hz, 1H), 7.83-7.80 (m, 3H), 7.73 (dd, $^3J_{H-H}$ = 8.4 Hz, $^4J_{H-H}$ = 1.7 Hz, 1H), 7.60 (br s, 2H), 7.53 (t, $^3J_{H-H}$ = 7.6 Hz, 2H), 7.49 (t, $^3J_{H-H}$ = 7.6 Hz, 1H), 7.43 (d, $^3J_{H-H}$ = 7.6 Hz, 1H), 7.40 (t, $^3J_{H-H}$ = 7.4 Hz, 1H), 7.33 (d, $^3J_{H-H}$ = 8.2 Hz, 1H), 7.30-7.26 (m, 3H), 7.21 (q, $^3J_{H-H}$ = 7.9 Hz, 2H), 7.08 (br s, 1H), 7.06 (d, $^3J_{H-H}$ = 8.0 Hz, 1H), 7.00 (t, $^3J_{H-H}$ = 7.8 Hz, 1H), 6.85 (d, $^3J_{H-H}$ = 8.1 Hz, 1H), 6.25 (d, $^3J_{H-H}$ = 6.2 Hz, $^4J_{H-H}$ = 1.9 Hz, 1H), 1.31 (s, 9H), 1.29 (s, 9H). | 1066.39460 | 1066.39462 |
| BD22 | δ 9.07 (d, $^3J_{H-H}$ = 6.1 Hz, 1H), 8.29 (d, $^4J_{H-H}$ = 1.7 Hz, 1H), 8.11 (d, $^3J_{H-H}$ = 8.4 Hz, 1H), 8.09 (d, $^4J_{H-H}$ = 1.8 Hz, 1H), 7.94 (d, $^3J_{H-H}$ = 8.3 Hz, 1H), 7.81 (d, $^3J_{H-H}$ = 8.2 Hz, 1H), 7.73 (dd, $^3J_{H-H}$ = 8.4 Hz, $^4J_{H-H}$ = 1.7 Hz, 1H), 7.60 (br s, 2H), 7.49 (t, $^3J_{H-H}$ = 7.6 Hz, 1H), 7.43 (d, $^3J_{H-H}$ = 7.6 Hz, 1H), 7.33 (d, $^3J_{H-H}$ = 8.2 Hz, 1H), 7.30-7.26 (m, 3H), 7.21 (q, $^3J_{H-H}$ = 7.9 Hz, 2H), 7.08 (br s, 1H), 7.06 (d, $^3J_{H-H}$ = 8.0 Hz, 1H), 7.00 (t, $^3J_{H-H}$ = 7.8 Hz, 1H), 6.85 (d, $^3J_{H-H}$ = 8.1 Hz, 1H), 6.25 (d, $^3J_{H-H}$ = 6.2 Hz, $^4J_{H-H}$ = 1.9 Hz, 1H), 1.31 (s, 9H), 1.29 (s, 9H). | 1071.42603 | 1071.42600 |
| BD23 | δ 9.07 (d, $^3J_{H-H}$ = 6.1 Hz, 1H), 8.09 (d, $^4J_{H-H}$ = 1.8 Hz, 1H), 7.94 (d, $^3J_{H-H}$ = 8.3 Hz, 1H), 7.81 (d, $^3J_{H-H}$ = 8.2 Hz, 1H), 7.60 (br s, 2H), 7.49 (t, $^3J_{H-H}$ = 7.6 Hz, 1H), 7.33 (d, $^3J_{H-H}$ = 8.2 Hz, 1H), 7.30-7.26 (m, 3H), 7.21 (q, $^3J_{H-H}$ = 7.9 Hz, 1H), 7.08 (br s, 1H), 7.06 (d, $^3J_{H-H}$ = 8.0 Hz, 1H), 7.00 (t, $^3J_{H-H}$ = 7.8 Hz, 1H), 6.85 (d, $^3J_{H-H}$ = 8.1 Hz, 1H), 6.25 (d, $^3J_{H-H}$ = 6.2 Hz, $^4J_{H-H}$ = 1.9 Hz, 1H), 1.31 (s, 9H), 1.29 (s, 9H). | 1076.45751 | 1076.45739 |
| BD24 | δ 8.29 (d, $^4J_{H-H}$ = 1.7 Hz, 1H), 8.11 (d, $^3J_{H-H}$ = 8.4 Hz, 1H), 7.94 (d, $^3J_{H-H}$ = 8.3 Hz, 1H), 7.81 (d, $^3J_{H-H}$ = 8.2 Hz, 1H), 7.73 (dd, $^3J_{H-H}$ = 8.4 Hz, $^4J_{H-H}$ = 1.7 Hz, 1H), 7.60 (br s, 2H), 7.49 (t, $^3J_{H-H}$ = 7.6 Hz, 1H), 7.43 (d, $^3J_{H-H}$ = 7.6 Hz, 1H), 7.33 (d, $^3J_{H-H}$ = 8.2 Hz, 1H), 7.30-7.26 (m, 3H), 7.21 (q, $^3J_{H-H}$ = 7.9 Hz, 2H), 7.08 (br s, 1H), 7.06 (d, $^3J_{H-H}$ = 8.0 Hz, 1H), 7.00 (t, $^3J_{H-H}$ = 7.8 Hz, 1H), 6.85 (d, $^3J_{H-H}$ = 8.1 Hz, 1H), 1.31 (s, 9H), 1.29 (s, 9H). | 1074.44491 | 1074.44483 |

(continued)

| Compound | $^1$H NMR ($CDCl_3$, 500 MHz) | HR-MS (m/z) [$M^+$] | |
|---|---|---|---|
| | | Found | calc. |
| BD113 | δ 9.10 (d, $^3J_{H-H}$ = 6.2 Hz, 1H), 8.08-8.05 (m, 3H), 7.94 (d, $^3J_{H-H}$ = 8.3 Hz, 1H), 7.76 (d, $^3J_{H-H}$ = 8.2 Hz, 1H), 7.59 (br s, 1H) 7.48 (t, $^3J_{H-H}$ = 7.7 Hz, 2H), 7.43-7.36 (m, 4H), 7.31 (d, $^3J_{H-H}$ = 8.2 Hz, 1H), 7.23-7.17 (m, 6H), 7.08 (br s, 3H), 7.05 (d, $^3J_{H-H}$ = 7.6 Hz, 1H), 6.99 (t, $^3J_{H-H}$ = 7.8 Hz, 1H), 6.85 (d, $^3J_{H-H}$ = 8.1 Hz, 1H), 6.23 (dd, $^3J_{H-H}$ = 6.3 Hz, $^4J_{H-H}$ = 2.0 Hz, 1H), 1.28 (s, 9H), 0.91 (br s, 18H). | 1041.39512 | 1041.39454 |
| BD119 | δ 9.04 (*d*, $^3J_{H-H}$ = 6.3 Hz, 1H), 7.93 (*d*, $3J_{H-H}$ = 8.3 Hz, $^4J_{H-H}$ = 2.0 Hz, 1H), 7.86 (*d*, $^4J_{H-H}$ = 1.5 Hz, 1H), 7.72 (d, $^3J_{H-H}$ = 8.2 Hz, 1H), 7.60 (br s, 1H), 7.48 (*t*, $^3J_{H-H}$ = 7.7 Hz, 2H), 7.42 (*d*, $^3J_{H-H}$ = 7.4 Hz, 1H), 7.35 (br s, 1H), 7.29 - 7.28 (*m*, 3H), 7.22 - 7.18 (*m*, 3H), 7.06 (br s, 2H), 7.04 (*dd*, $^3J_{H-H}$ = 8.1 Hz, $^4J_{H-H}$ = 0.8 Hz, 1H), 6.99 (*t*, $^3J_{H-H}$ = 7.6 Hz, 1H), 6.84 (*d*, $^3J_{H-H}$ = 8.1 Hz, 1H), 6.20 (*dd*, $^3J_{H-H}$ = 6.3 Hz, $^4J_{H-H}$ = 2.0 Hz, 1H), 1.28 (s, 9H), 0.92 (br s, 18H). | 1064.46750 | 1064.46768 |

**Evaluation Example 1**

According to the methods of Table 3, HOMO and LUMO energy levels of each of Compounds BD01, BD02, BD03, BD07, BD08, BD09, BD10, BD15, BD16, BD17, BD21, BD22, BD23, BD24, BD113, BD119, and A to G were evaluated, and results thereof are shown in Table 4.

Table 3

| | |
|---|---|
| HOMO energy level evaluation method | By utilizing cyclic voltammetry (CV) (electrolyte: 0.1 M $Bu_4NPF_6$ / solvent: dimethylformamide (DMF) / electrode: 3-electrode system (working electrode: glassy carbon (GC), reference electrode: Ag/AgCl, and auxiliary electrode: Pt)), the potential (V)-current (A) graph of each compound was obtained, and then, from the oxidation onset of the graph, the HOMO energy level of each compound was calculated. |
| LUMO energy level evaluation method | By utilizing cyclic voltammetry (CV) (electrolyte: 0.1 M $Bu_4NPF_6$ / solvent: dimethylformamide (DMF) / electrode: 3-electrode system (working electrode: glassy carbon (GC), reference electrode: Ag/AgCl, and auxiliary electrode: Pt)), the potential (V)-current (A) graph of each compound was obtained, and then, from the reduction onset of the graph, the LUMO energy level of each compound was calculated. |

.

Table 4

| Compound No. | HOMO (eV) | LUMO (eV) |
|---|---|---|
| BD01 | -5.29 | -2.03 |
| BD02 | -5.29 | -2.03 |
| BD03 | -5.29 | -2.03 |
| BD07 | -5.30 | -1.99 |
| BD08 | -5.30 | -1.99 |
| BD09 | -5.30 | -1.99 |
| BD10 | -5.30 | -1.99 |
| BD15 | -5.23 | -2.01 |
| BD16 | -5.23 | -2.01 |
| BD17 | -5.23 | -2.01 |

(continued)

| Compound No. | HOMO (eV) | LUMO (eV) |
|---|---|---|
| BD21 | -5.28 | -2.00 |
| BD22 | -5.28 | -2.00 |
| BD23 | -5.28 | -2.00 |
| BD24 | -5.28 | -2.00 |
| BD113 | -5.29 | -2.03 |
| BD119 | -5.29 | -2.00 |
| A | -5.30 | -2.18 |
| B | -5.26 | -1.89 |
| C | -5.28 | -2.00 |
| D | -5.31 | -2.23 |
| E | -5.32 | -2.23 |
| F | -5.28 | -2.24 |
| G | -5.30 | -2.02 |

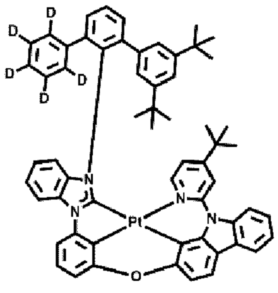

BD01

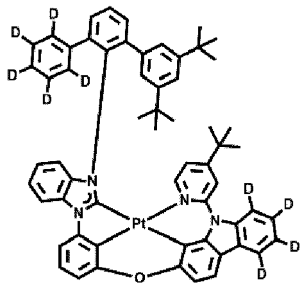

BD02

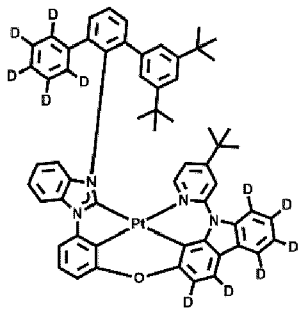

BD03

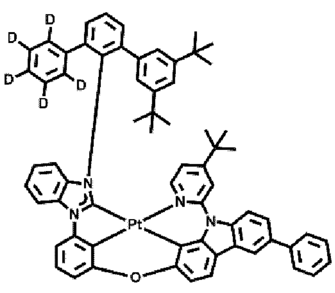

BD07

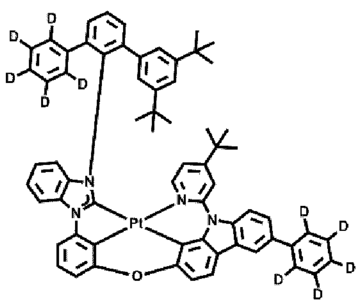

BD08

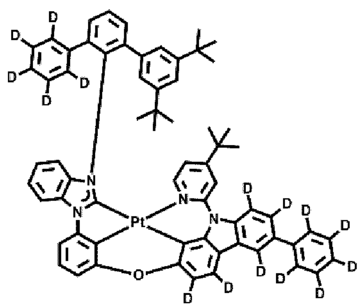

BD09

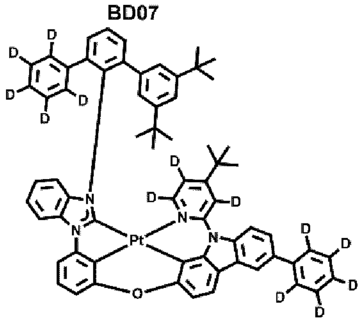

BD10

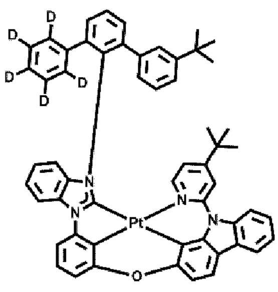

BD15

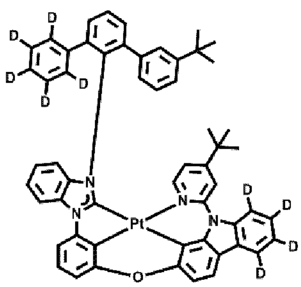

BD16

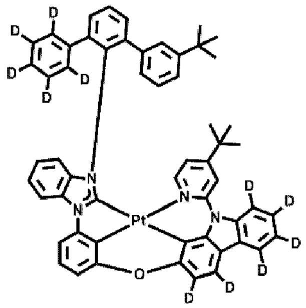

BD17

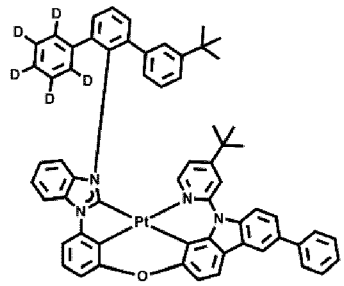

BD21

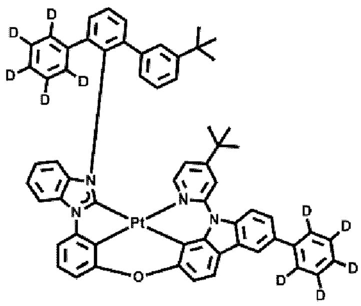

BD22

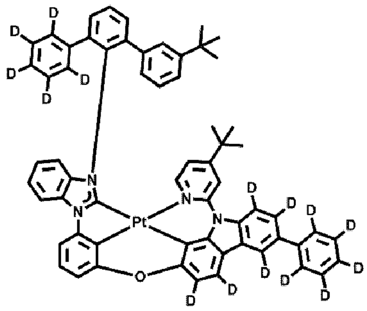

BD23

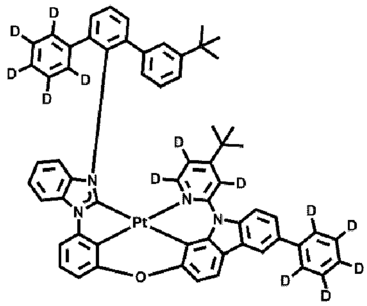

BD24

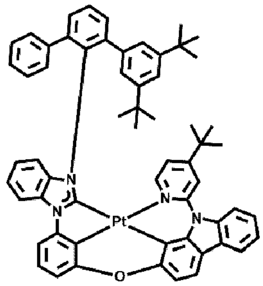

BD113

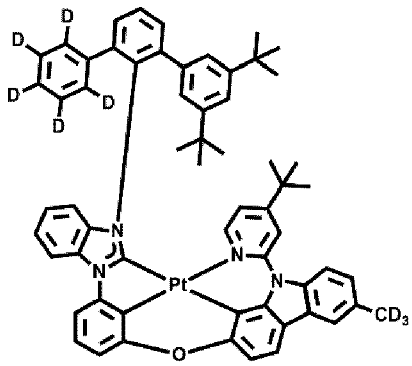

**BD119**

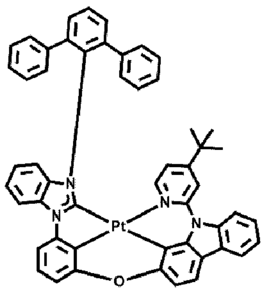

A

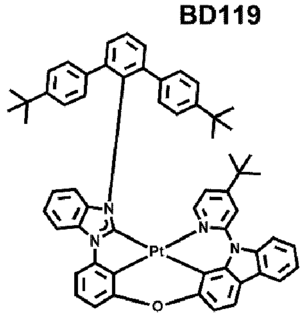

B

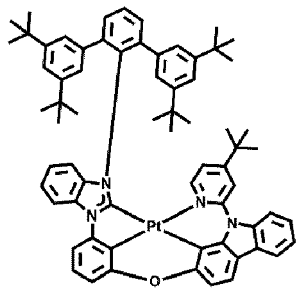

C

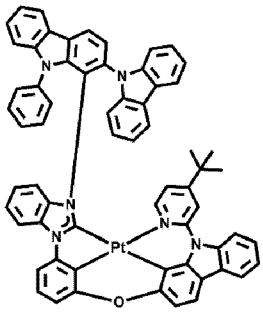

D

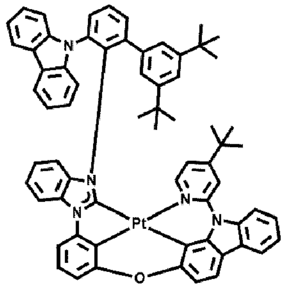

E

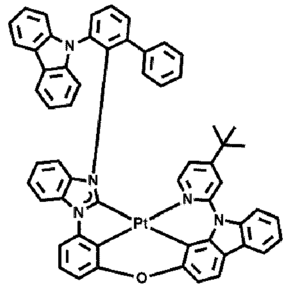

F

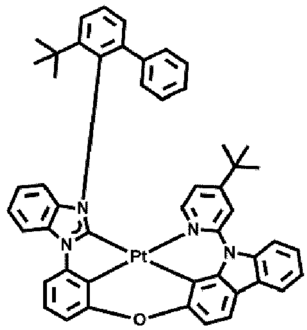

G .

**Evaluation Example 2**

PMMA in $CH_2Cl_2$ solution and Compound BD01 (4 wt% to PMMA) were mixed, and then, the resulting product thus obtained therefrom was coated on a quartz substrate by utilizing a spin coater, and then heat-treated in an oven at 80 °C, followed by cooling to room temperature, to manufacture Film BD01 having a thickness of 40 nm. Next, Films BD02, BD03, BD07, BD08, BD09, BD10, BD15, BD16, BD17, BD21, BD22, BD23, BD24, BD113, BD119, and A to G each were manufactured in substantially the same manner as in the method of manufacturing Film BD01, except that each of Compounds BD02, BD03, BD07, BD08, BD09, BD10, BD15, BD16, BD17, BD21, BD22, BD23, BD24, BD113, BD119, and A to G was utilized instead of Compound BD01.

A photoluminescence (PL) spectrum of each of Films BD01, BD02, BD03, BD07, BD08, BD09, BD10, BD15, BD16, BD17, BD21, BD22, BD23, BD24, BD113, BD119, and A to G was measured by utilizing a Quantaurus-QY Absolute PL quantum yield spectrometer (equipped with a xenon light source, a monochromator, a photonic multichannel analyzer, and an integrating sphere, and utilizing a PLQY measurement software (Hamamatsu Photonics, Ltd., Shizuoka, Japan)) manufactured by Hamamatsu Company. During the measurement, an excitation wavelength was scanned from 320 nm to 380 nm at intervals of 10 nm, and a photoluminescence spectrum measured at the excitation wavelength of 340 nm was taken to obtain a maximum emission wavelength (emission peak wavelength) and FWHM of an organometallic compound comprised in each Film, which are shown in Table 5.

Next, a photoluminescence quantum yield of each of Films BD01, BD02, BD03, BD07, BD08, BD09, BD10, BD15, BD16, BD17, BD21, BD22, BD23, BD24, BD113, BD119, and A to G was measured by scanning an excitation wavelength from 300 nm to 380 nm at intervals of 10 nm by utilizing the Quantaurus-QY Absolute PL quantum yield spectrometer manufactured by Hamamatsu Company, and a photoluminescence quantum yield (PLQY) measured at the excitation wavelength of 330 nm was taken to obtain a photoluminescence quantum yield of the organometallic compound comprised in each Film, which are shown in Table 5.

Table 5

| Film No. | Film composition (4 wt% in PMMA) | Maximum emission wavelength (nm) | FWHM (nm) | PLQY (%) |
|---|---|---|---|---|
| BD01 | BD01 | 455 | 37 | 92 |
| BD02 | BD02 | 455 | 37 | 93 |
| BD03 | BD03 | 455 | 37 | 93 |

(continued)

| Film No. | Film composition (4 wt% in PMMA) | Maximum emission wavelength (nm) | FWHM (nm) | PLQY (%) |
|---|---|---|---|---|
| BD07 | BD07 | 456 | 20 | 96 |
| BD08 | BD08 | 456 | 20 | 95 |
| BD09 | BD09 | 456 | 20 | 94 |
| BD10 | BD10 | 456 | 20 | 95 |
| BD15 | BD15 | 455 | 37 | 91 |
| BD16 | BD16 | 455 | 37 | 91 |
| BD17 | BD17 | 455 | 37 | 92 |
| BD21 | BD21 | 456 | 21 | 95 |
| BD22 | BD22 | 456 | 21 | 96 |
| BD23 | BD23 | 456 | 21 | 96 |
| BD24 | BD24 | 456 | 21 | 96 |
| BD113 | BD113 | 455 | 37 | 91 |
| BD119 | BD119 | 457 | 20 | 90 |
| A | A | 456 | 41 | 83 |
| B | B | 454 | 39 | 93 |
| C | C | 457 | 42 | 89 |
| D | D | 451 | 41 | 65 |
| E | E | 453 | 40 | 72 |
| F | F | 453 | 44 | 70 |
| G | G | 454 | 20 | 80 |

From Table 5, it was found that Compounds BD01, BD02, BD03, BD07, BD08, BD09, BD10, BD15, BD16, BD17, BD21, BD22, BD23, BD24, BD113, and BD119 had an equal PLQY to or better PLQY than that of Compounds A to G, and emitted blue light having relatively equal FWHM to or smaller FWHM than that of Compounds A to G.

**Evaluation Example 3**

For each of Films BD01, BD02, BD03, BD07, BD08, BD09, BD10, BD15, BD16, BD17, BD21, BD22, BD23, BD24, BD113, BD119, and A to G, a PL spectrum was evaluated at room temperature by utilizing Fluotime 300, which is a time-resolved photoluminescence (TRPL) measurement system manufactured by PicoQuant Inc., and PLS340 (excitation wavelength = 340 nm, spectral width = 20 nm), which has a pumping source manufactured by PicoQuant Inc., a wavelength of a main peak of the spectrum was determined, and then, the number of photons emitted at the wavelength of the main peak from each Film excited by photon pulse (pulse width = 500 picoseconds) applied by PLS340 to each Film was repeatedly measured based on time-correlated single photon counting (TCSPC) according to time, to obtain a TRPL curve sufficient for fitting. The result thus obtained therefrom was fitted with at least one exponential decay function to obtain $T_{decay}$(Ex), that is, decay time (e.g., emission decay time), of each of Films BD01, BD02, BD03, BD07, BD08, BD09, BD10, BD15, BD16, BD17, BD21, BD22, BD23, BD24, BD113, BD119, and A to G, and results thereof are shown in Table 6. A function utilized for fitting is as shown in Equation 20, and from among $T_{decay}$ values obtained from each exponential decay function utilized for fitting, the largest $T_{decay}$ was obtained as $T_{decay}$ (Ex). In this regard, the same measurement was performed during the same measurement time as that for obtaining TRPL curve in the dark state (in which pumping signals entering a film are blocked) to obtain a baseline or a background signal curve for utilization as a baseline for fitting.

## Equation 20

$$f(t) = \sum_{i=1}^{n} A_i \, exp\left(-t/T_{decay,i}\right)$$

Table 6

| Film No. | Film composition (4 wt% in PMMA) | $\tau(\mu s)$ |
|---|---|---|
| BD01 | BD01 | 2.43 |
| BD02 | BD02 | 2.44 |
| BD03 | BD03 | 2.44 |
| BD07 | BD07 | 2.56 |
| BD08 | BD08 | 2.55 |
| BD09 | BD09 | 2.56 |
| BD10 | BD10 | 2.56 |
| BD15 | BD15 | 2.41 |
| BD16 | BD16 | 2.41 |
| BD17 | BD17 | 2.42 |
| BD21 | BD21 | 2.48 |
| BD22 | BD22 | 2.49 |
| BD23 | BD23 | 2.49 |
| BD24 | BD24 | 2.49 |
| BD113 | BD113 | 2.34 |
| BD119 | BD119 | 2.48 |
| A | A | 2.25 |
| B | B | 2.45 |
| C | C | 2.42 |
| D | D | 1.95 |
| E | E | 2.12 |
| F | F | 2.05 |
| G | G | 2.26 |

From Table 6, it was found that Compounds BD01, BD02, BD03, BD07, BD08, BD09, BD10, BD15, BD16, BD17, BD21, BD22, BD23, BD24, BD113, and BD119 had an equal emission decay time to or longer emission decay time (that is, higher radiative decay rate (Kr)) than that of Compounds A to G.

**Evaluation Example 4**

A phase transition diagram of each of Compounds A, BD15, BD01, BD16, BD02, and BD119 was evaluated by utilizing SETSYS evolution TG-DTA manufactured by Setaram Inc., and a temperature of each of Compounds A, BD15, BD01, BD16, BD02, and BD119 at a vaporization (or, sublimation) pressure (at 6.4 x $10^{-4}$ torr) was evaluated therefrom and is shown in Table 7. A phase transition diagram of each of Compounds A, BD16, BD02, and BD119 is shown in FIG. 7.

Table 7

| Compound No. | Temperature at a vaporization pressure (at 6.4 x $10^{-4}$ torr) (°C) |
|---|---|
| A | 326 |
| BD15 | 298 |
| BD01 | 272 |
| BD16 | 302 |
| BD02 | 277 |
| BD119 | 293 |

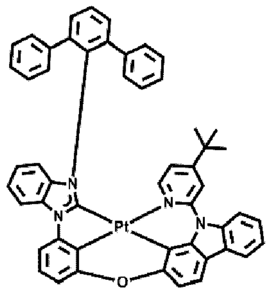

A

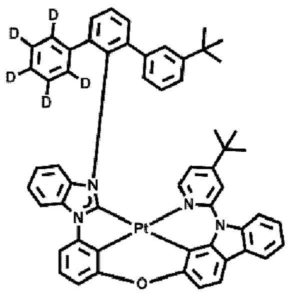

BD15

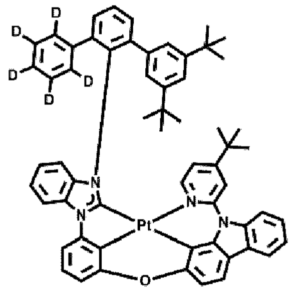

BD01

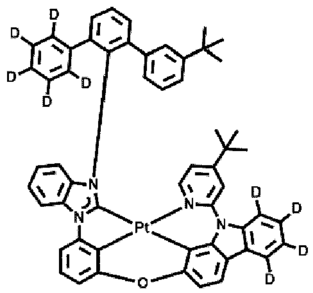

BD16

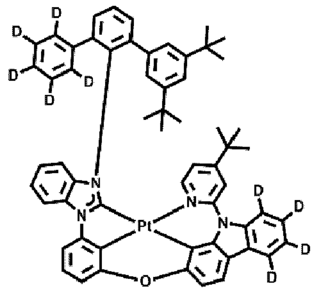

BD02

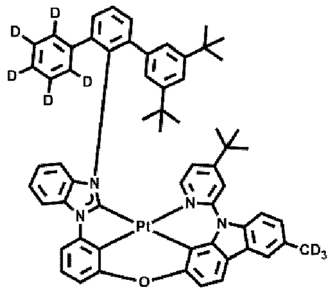

BD119

From Table 7 and FIG. 7, it was found that each of Compounds BD15, BD01, BD16, BD02, and BD119 had a lower temperature at a vaporization pressure (at 6.4 x $10^{-4}$ torr) (a lower phase transition temperature) than that of Compound A, and thus, had excellent or suitable processibility that can be deposited at relatively lower deposition temperature without decomposition thereof.

**Evaluation Example 5**

The purity of each of Compounds A, BD15, BD01, BD16, BD02, and BD119 was measured by utilizing HPLC to evaluate P(0Hr) (%) of each Compound.

Next, each of Compounds A, BD15, BD01, BD16, BD02, and BD119 was heat-treated for 360 hours in a chamber in which an internal temperature at a vaporization pressure (at 6.4 x $10^{-4}$ torr) were maintained, and then collected, and then, purity evaluation utilizing HPLC was performed again to evaluate P(360Hr) (%) of each Compound.

From this, P(360Hr) - P(0Hr) (%), which is a purity change amount after heat treatment for each Compound, was evaluated, and results thereof are shown in Table 8.

Table 8

| Compound No. | P(0Hr) (%) | P(360Hr) (%) | Purity change amount after heat treatment (%) |
|---|---|---|---|
| A | 99.952 | 96.847 | -3.105 |
| BD15 | 99.956 | 99.746 | -0.210 |
| BD01 | 99.954 | 99.951 | -0.003 |
| BD16 | 99.953 | 99.745 | -0.208 |
| BD02 | 99.960 | 99.958 | -0.002 |
| BD119 | 99.958 | 99.957 | -0.001 |

From Table 8, it was found that each of Compounds BD15, BD01, BD16, BD02, and BD119 had a smaller absolute value of the purity change amount after heat treatment than that of Compound A, and thus, had excellent or suitable heat resistance.

**Example 1**

As an anode, a glass substrate (product of Corning Inc.) with a 15 $\Omega/cm^2$ (1,200 Å) ITO formed thereon was cut to a size of 50 mm x 50 mm x 0.7 mm, sonicated in isopropyl alcohol and pure water each for 5 minutes, cleaned by irradiation of ultraviolet rays and exposure of ozone thereto for 30 minutes, and then mounted on a vacuum deposition apparatus.

2-TNATA was vacuum-deposited on the anode to form a hole injection layer having a thickness of 600 Å, and 4,4'-bis[N-(1-naphthyl)-N-phenylamino]biphenyl (hereinafter, referred as "NPB") was vacuum-deposited on the hole injection layer to form a hole transport layer having a thickness of 300 Å.

Compound BD01 (organometallic compound represented by Formula 1), Compound ETH2 (second compound), and Compound HTH29 (third compound) were vacuum-deposited on the hole transport layer to form an emission layer having a thickness of 350 Å. In this regard, an amount of Compound BD01 was 13 wt% based on the total weight (100 wt%) of the emission layer, and a weight ratio of Compound ETH2 to Compound HTH29 was adjusted to 3.5 : 6.5.

Compound ETH34 was vacuum-deposited on the emission layer to form a hole blocking layer having a thickness of 50 Å, and ET46 and LiQ were vacuum-deposited on the hole blocking layer at a weight ratio of 4 : 6 to form an electron transport layer having a thickness of 310 Å. Next, Yb was vacuum-deposited on the electron transport layer to form an electron injection layer having a thickness of 15 Å, and then Mg was vacuum-deposited thereon to form a cathode having a thickness of 800 Å, thereby completing manufacture of an organic light-emitting device.

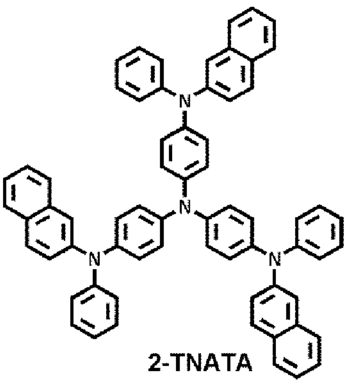

2-TNATA

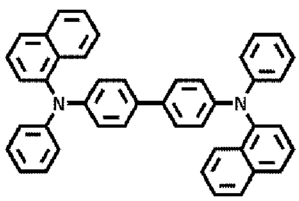

NPB

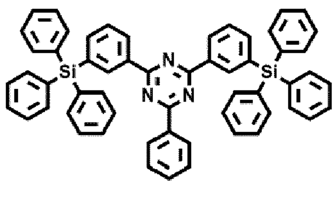

ETH34

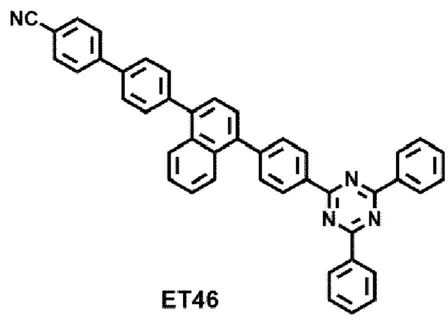

ET46

**Examples 2 to 18**

Organic light-emitting devices were manufactured in substantially the same manner as in Example 1, except that, in forming the emission layer, the organometallic compound represented by Formula 1, the second compound, the third compound, and/or the fourth compound, and amounts of these compounds were changed and utilized as described in Table 9. In Table 9, the weight in parentheses indicates the weight of the corresponding compound based on 100 wt% of the emission layer.

**Evaluation Example 6**

The driving voltage (V) at 1,000 cd/m$^2$, color purity (CIE(x,y)), luminescence efficiency (cd/A), color conversion efficiency (cd/A/y), maximum emission wavelength (nm), and lifespan ($T_{95}$) of the organic light-emitting devices manufactured in Examples 1 to 18 were each measured utilizing Keithley SMU 236 and a luminance meter PR650, and results thereof are shown in Table 10. In Table 10, the lifespan ($T_{95}$) indicates a time (Hr) (i.e., hours) taken for the luminance to reach 95 % of the initial luminance. Meanwhile, an electroluminescence spectrum, a (blue conversion) luminescence efficiency-luminance graph, and a luminance-time graph of the organic light-emitting devices manufactured in Examples 1 to 7, 16, and 17 are shown in FIGs. 8, 9, and 10, respectively.

Table 9

| No. | Organometallic compound represented by Formula 1 | Second compound | Third compound | Fourth compound | Weight ratio of second compound to third compound |
|---|---|---|---|---|---|
| Example 1 | BD01 (13 wt%) | ETH2 | HTH29 | - | 3.5 : 6.5 |
| Example 2 | BD02 (13 wt%) | ETH2 | HTH29 | - | 3.5 : 6.5 |
| Example 3 | BD03 (13 wt%) | ETH2 | HTH29 | - | 3.5 : 6.5 |
| Example 4 | BD07 (13 wt%) | ETH2 | HTH29 | - | 3.5 : 6.5 |
| Example 5 | BD08 (13 wt%) | ETH2 | HTH29 | - | 3.5 : 6.5 |
| Example 6 | BD09 (13 wt%) | ETH2 | HTH29 | - | 3.5 : 6.5 |
| Example 7 | BD10 (13 wt%) | ETH2 | HTH29 | - | 3.5 : 6.5 |
| Example 8 | BD15 (13 wt%) | ETH2 | HTH29 | - | 3.5 : 6.5 |
| Example 9 | BD16 (13 wt%) | ETH2 | HTH29 | - | 3.5 : 6.5 |

(continued)

| No. | Organometallic compound represented by Formula 1 | Second compound | Third compound | Fourth compound | Weight ratio of second compound to third compound |
|---|---|---|---|---|---|
| Example 10 | BD17 (13 wt%) | ETH2 | HTH29 | - | 3.5 : 6.5 |
| Example 11 | BD21 (13 wt%) | ETH2 | HTH29 | - | 3.5 : 6.5 |
| Example 12 | BD22 (13 wt%) | ETH2 | HTH29 | - | 3.5 : 6.5 |
| Example 13 | BD23 (13 wt%) | ETH2 | HTH29 | - | 3.5 : 6.5 |
| Example 14 | BD24 (13 wt%) | ETH2 | HTH29 | - | 3.5 : 6.5 |
| Example 15 | BD02 (13 wt%) | ETH18 | HTH29 | - | 4: 6 |
| Example 16 | BD02 (13 wt%) | ETH2 | HTH29 | DFD7 (0.4 wt%) | 3.5 : 6.5 |
| Example 17 | BD02 (13 wt%) | ETH2 | HTH29 | DFD29 (1.2 wt%) | 3.5 : 6.5 |
| Example 18 | BD119 (13 wt%) | ETH2 | HTH29 | - | 3.5 : 6.5 |

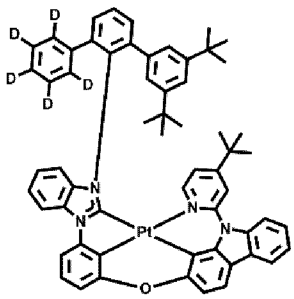

BD01

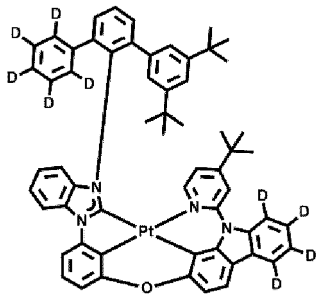

BD02

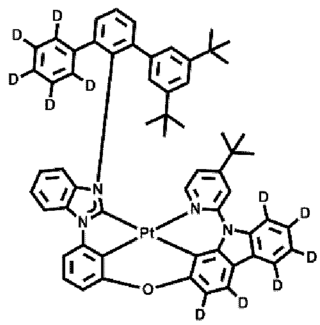

BD03

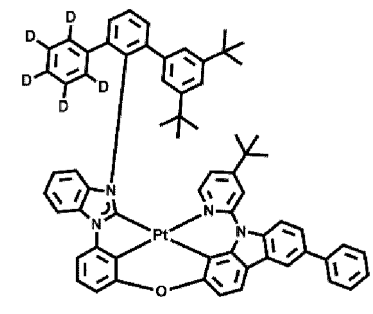

BD07

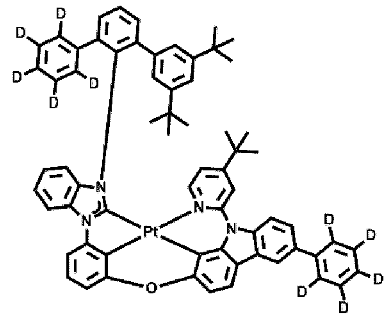

BD08

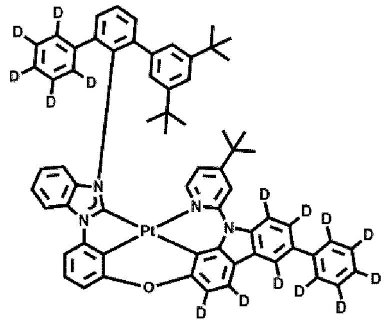

BD09

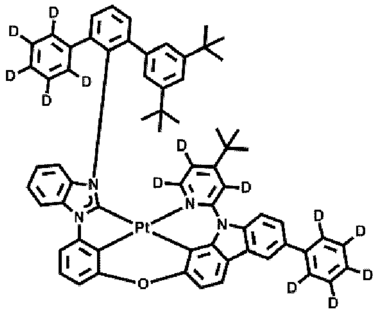

BD10

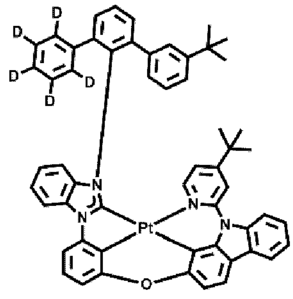

BD15

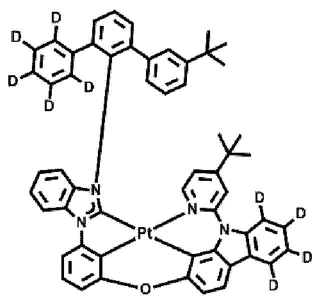

BD16

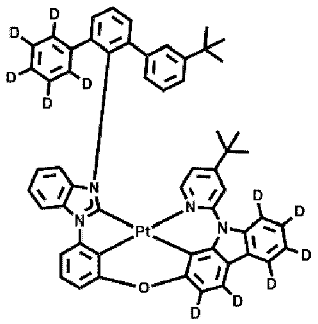

BD17

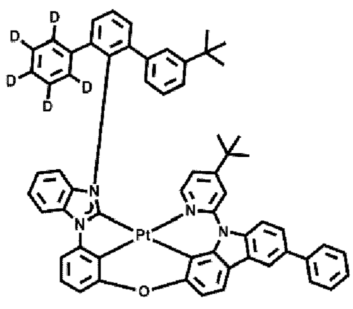

BD21

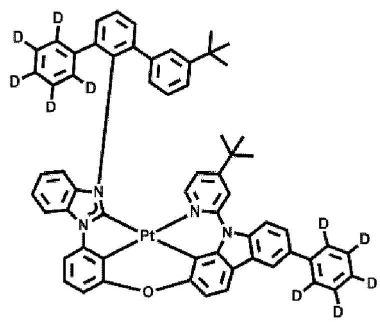

BD22

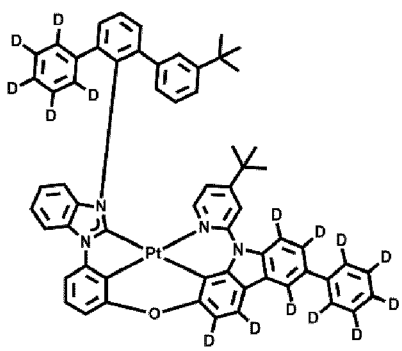

BD23

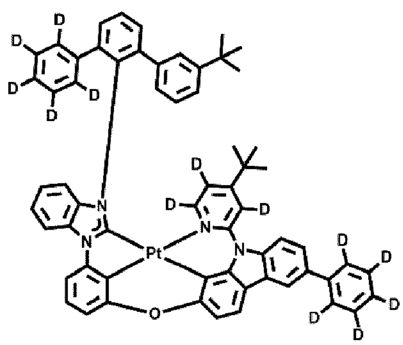

BD24

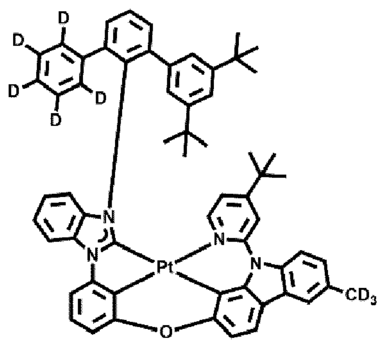

BD119

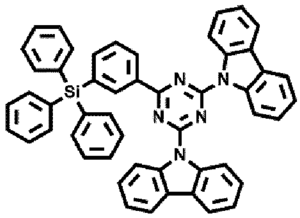

ETH2

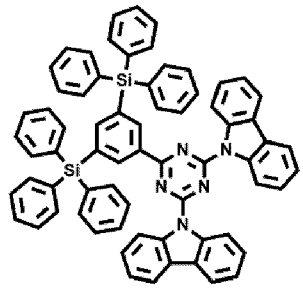

ETH18

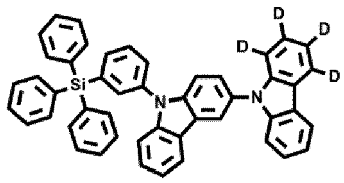

HTH29

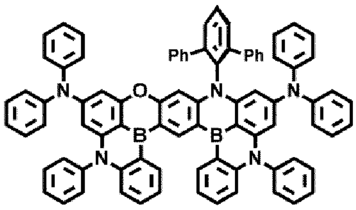

DFD7

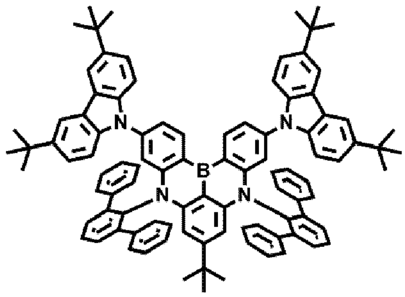

DFD29

Table 10

| No. | Organometallic compound represented by Formula 1 | Fourth compound | Driving voltage (V) | CIE(x, y) | Luminesc ence efficiency (cd/A) | Color conversion efficiency (cd/A/y) | Maximum Emission Wavelength (nm) | Lifespan ($T_{95}$, Hr) |
|---|---|---|---|---|---|---|---|---|
| Example 1 | BD01 | - | 4.2 | 0.135, 0.180 | 23.0 | 128.3 | 463 | 141.0 |
| Example 2 | BD02 | - | 4.4 | 0.135, 0.188 | 23.4 | 124.9 | 463 | 178.0 |
| Example 3 | BD03 | - | 4.2 | 0.136, 0.195 | 23.7 | 121.7 | 463 | 185.9 |
| Example 4 | BD07 | - | 4.0 | 0.136, 0.206 | 23.4 | 113.7 | 463 | 164.0 |
| Example 5 | BD08 | - | 4.2 | 0.133, 0.196 | 24.3 | 124.2 | 464 | 173.5 |
| Example 6 | BD09 | - | 4.2 | 0.133, 0.192 | 23.5 | 122.1 | 463 | 178.7 |
| Example 7 | BD10 | - | 4.3 | 0.134, 0.200 | 23.1 | 115.2 | 463 | 199.7 |
| Example 8 | BD15 | - | 4.1 | 0.133, 0.148 | 23.1 | 156.1 | 462 | 162.0 |
| Example 9 | BD16 | - | 4.1 | 0.134, 0.164 | 23.3 | 142.2 | 462 | 168.8 |
| Example 10 | BD17 | - | 4.0 | 0.137, 0.157 | 22.2 | 141.0 | 462 | 162.2 |
| Example 11 | BD21 | - | 4.1 | 0.132, 0.154 | 22.1 | 142.9 | 463 | 168.0 |
| Example 12 | BD22 | - | 4.1 | 0.134, 0.164 | 23.2 | 141.8 | 463 | 164.0 |
| Example 13 | BD23 | - | 4.1 | 0.133, 0.147 | 22.8 | 154.7 | 463 | 166.4 |
| Example 14 | BD24 | - | 4.1 | 0.133, 0.147 | 22.8 | 154.7 | 463 | 166.4 |

(continued)

| No. | Organometallic compound represented by Formula 1 | Fourth compound | Driving voltage (V) | CIE(x, y) | Luminesc ence efficiency (cd/A) | Color conversion efficiency (cd/A/y) | Maximum Emission Wavelength (nm) | Lifespan ($T_{95}$, Hr) |
|---|---|---|---|---|---|---|---|---|
| Example 15 | BD02 | - | 4.1 | 0.133, 0.147 | 22.8 | 154.7 | 462 | 170.4 |
| Example 16 | BD02 | DFD7 | 4.1 | 0.136, 0.119 | 23.8 | 171.1 | 461 | 201.7 |
| Example 17 | BD02 | DFD29 | 4.1 | 0.132, 0.121 | 25.2 | 177.9 | 464 | 220.2 |
| Example 18 | BD119 | - | 4.1 | 0.137, 0.200 | 23.2 | 155.6 | 463 | 180.6 |

From Table 10, it was found that the organic light-emitting devices of Examples 1 to 18 emitted deep blue light and had excellent or suitable driving voltage, excellent or suitable color purity, excellent or suitable luminescence efficiency, excellent or suitable color conversion efficiency, and excellent or suitable lifespan characteristics.

**Example 19 and Comparative Examples A to G**

Organic light-emitting devices were manufactured in substantially the same manner as in Example 1, except that, in forming the emission layer, the organometallic compound represented by Formula 1 was changed as described in Table 11.

**Evaluation Example 7**

The driving voltage (V) at 1,000 cd/m$^2$, color purity (CIEx,y), luminescence efficiency (cd/A), maximum emission wavelength (nm), and lifespan ($T_{95}$) of the organic light-emitting devices manufactured in Example 19 and Comparative Examples A to C and G were each measured by utilizing the method as described in Evaluation Example 6, and results thereof are shown in Table 11. In Table 11, the lifespan ($T_{95}$) indicates a time (Hr) taken for the luminance to reach 95 % of the initial luminance. In some embodiments, it was not possible to measure the performance of the organic light-emitting devices manufactured in Comparative Examples D to F, which is attributed to the denaturation of Compounds D to F, occurred during a deposition process for manufacturing the organic light-emitting devices, and/or the relatively small decay time of Compounds D to F.

Table 11

| No. | Organometallic compound | Driving voltage (V) | CIE(x, y) | Luminesc ence efficiency (cd/A) | Maximum Emission wavelength (nm) | Lifespan ($T_{95}$, Hr) |
|---|---|---|---|---|---|---|
| Example 19 | BD113 | 4.2 | 0.135, 0.180 | 21.8 | 463 | 93.0 |
| Comparative Example A | A | 4.1 | 0.136, 0.198 | 23.6 | 463 | 78.0 |
| Comparative Example B | B | 4.8 | 0.135, 0.171 | 21.8 | 462 | 75.0 |
| Comparative Example C | C | 4.2 | 0.131, 0.165 | 21.1 | 462 | 76.0 |
| Comparative Example G | G | 4.8 | 0.140, 0.131 | 18.9 | 457 | 45.0 |

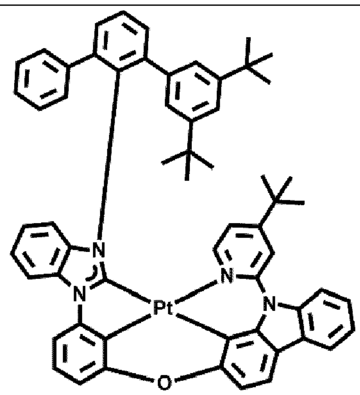

BD113

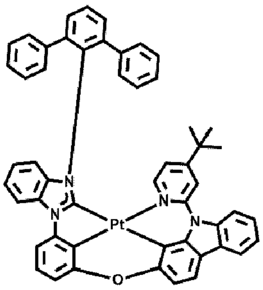 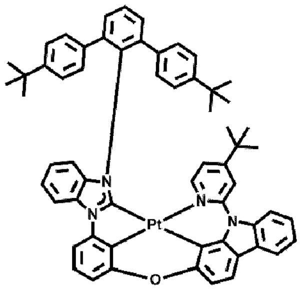 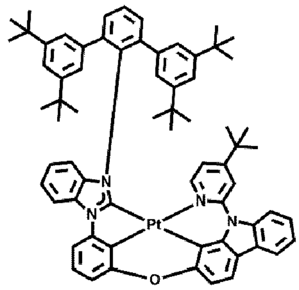

A B C

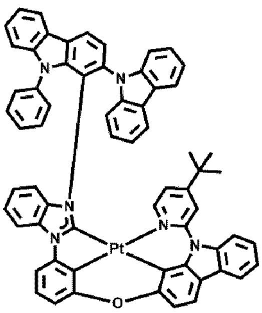 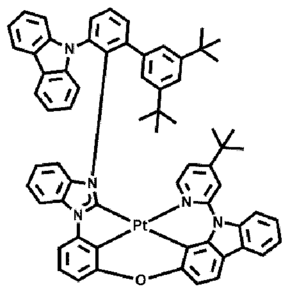 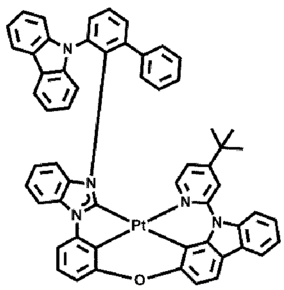

D E F

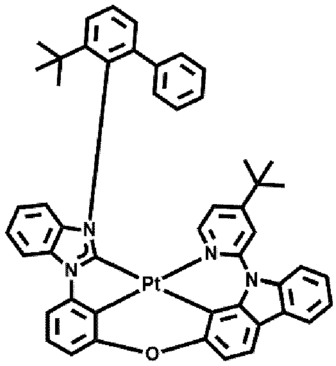

G

From Table 11, it was found that the organic light-emitting device of Example 19 emitted deep blue light and concurrently (e.g., simultaneously) had improved driving voltage, improved color purity, improved luminescence efficiency, and improved lifespan characteristics, compared to the organic light-emitting devices of Comparative Examples A to G.

**Comparative Example A-heat and Examples 8-heat, 1-heat, 9-heat, 2-heat, and 18-heat**

Organic light-emitting devices were manufactured in substantially the same manner as in Example 1, except that, in forming the emission layer, the organometallic compound represented by Formula 1 was changed as described in Table 12. The expression "heat-treated compound" in Table 12 refers to a "compound collected after heat treatment for 360 hours in a chamber in which an internal temperature at a vaporization pressure (at 6.4 x $10^{-4}$ torr) are maintained" as in Evaluation Example 5.

**Evaluation Example 8**

The luminescence efficiency (cd/A) at 1,000 cd/$m^2$ and lifespan ($T_{95}$) of the organic light-emitting devices manufactured in Comparative Example A-heat and Examples 8-heat, 1-heat, 9-heat, 2-heat, and 18-heat were each measured by utilizing the method as described in Evaluation Example 6, and results thereof are shown in Table 12. In

Table 12, the lifespan ($T_{95}$) indicates a time (Hr) taken for the luminance to reach 95 % of the initial luminance.

Next, "(luminescence efficiency of Comparative Example A-heat - luminescence efficiency of Comparative Example A) / luminescence efficiency of Comparative Example A x 100" (%) and "(lifespan of Comparative Example A-heat - lifespan of Comparative Example A) / lifespan of Comparative Example A x 100" (%) were each calculated to evaluate luminescence efficiency change rate (%) and lifespan change rate (%) after heat treatment of an organic light-emitting device comprising Compound A, and results thereof are shown in Table 12. This evaluation was repeated for each of organic light-emitting devices comprising Compounds BD15, BD01, BD16, BD02, and BD119, and results thereof are shown in Table 12.

Table 12

| No. | Comparative Example A | Example 8 | Example 1 | Example 9 | Example 2 | Example 18 |
|---|---|---|---|---|---|---|
| Compound No. | A | BD15 | BD01 | BD16 | BD02 | BD119 |
| Luminescence efficiency (cd/A) | 21.8 | 23.1 | 23 | 23.3 | 23.4 | 23.2 |
| Lifespan ($T_{95}$,Hr) | 93 | 162 | 141 | 168.8 | 178 | 180.6 |
| No. | Comparative Example A-heat | Example 8-heat | Example 1-heat | Example 9-heat | Example 2-heat | Example 18-heat |
| Compound No. | Heat-treated A | Heat-treated BD15 | Heat-treated BD01 | Heat-treated BD16 | Heat-treated BD02 | Heat-treated BD119 |
| Luminescenc Efficiency (cd/A) | 18.5 | 22.6 | 23 | 22.8 | 23.4 | 23.2 |
| Lifespan ($T_{95}$, Hr) | 74 | 152 | 139.6 | 160.4 | 178 | 180.6 |
| Luminescence efficiency change rate after heat treatment (%) | -15 | -2 | 0 | -2 | 0 | 0 |
| Lifespan change rate after heat treatment (%) | -20 | -6 | -1 | -5 | 0 | 0 |

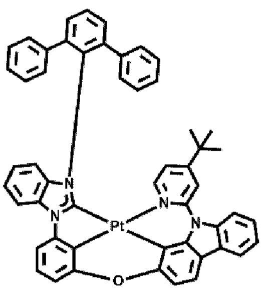

A

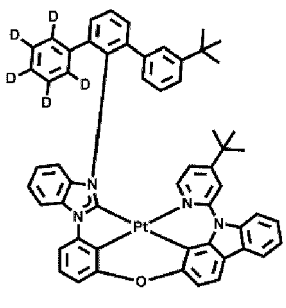

BD15

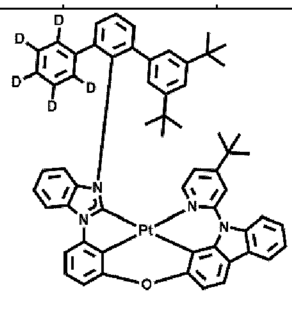

BD01

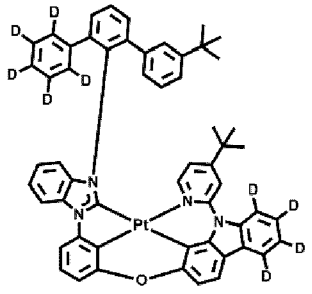

BD16

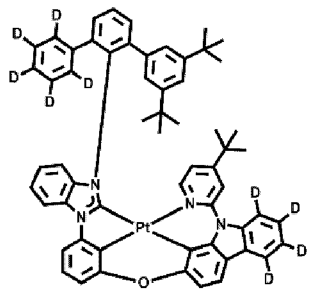

BD02

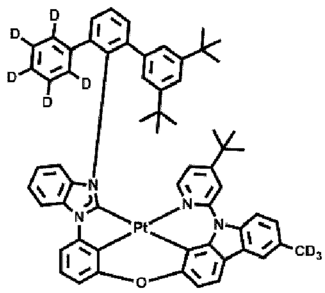

BD119

From Table 12, it was found that the organic light-emitting device comprising each of Compounds BD15, BD01, BD16, BD02, and BD119 had a smaller absolute value of the luminescence efficiency change rate after heat treatment and a smaller absolute value of the lifespan change rate after heat treatment than those of an organic light-emitting device comprising Compound A, and thus, it was found that an organic light-emitting device manufactured by utilizing the organometallic compound represented by Formula 1 (for example, manufactured by utilizing a deposition process) may have excellent or suitable luminescence efficiency and lifespan characteristics concurrently (e.g., at the same time).

Because the organometallic compound has excellent or suitable processibility, excellent or suitable heat resistance, and excellent or suitable electric characteristics, a light-emitting device comprising the organometallic compound may have improved color purity, improved luminescence efficiency, and improved lifespan.

In the present disclosure, it will be understood that the terms "comprise(s)," "comprise(s)," or "have/has" specify the presence of stated features, integers, steps, operations, elements, and/or components, but do not preclude the presence or addition of one or more other features, integers, steps, operations, elements, components, and/or groups thereof.

Throughout the present disclosure, when a component such as a layer, a film, a region, or a plate is mentioned to be placed "on" another component, it will be understood that it may be directly on another component or that another component may be interposed therebetween. In some embodiments, "directly on" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

In the present disclosure, although the terms "first," "second," etc., may be utilized herein to describe one or more elements, components, regions, and/or layers, these elements, components, regions, and/or layers should not be limited by these terms. These terms are only utilized to distinguish one component from another component.

As utilized herein, the singular forms "a," "an," "one," and "the" are intended to comprise the plural forms as well, unless the context clearly indicates otherwise. Further, the use of "may" when describing embodiments of the present disclosure refers to "one or more embodiments of the present disclosure".

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm$ 30%, 20%, 10%, 5% of the stated value.

Any numerical range recited herein is intended to comprise all sub-ranges of the same numerical precision subsumed within the recited range. For example, a range of "1.0 to 10.0" is intended to comprise all subranges between (and comprising) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to comprise all lower numerical limitations subsumed therein and any minimum numerical limitation recited in this specification is intended to comprise all higher numerical limitations subsumed therein. Accordingly, Applicant reserves the right to amend this specification, comprising the claims, to expressly recite any sub-range subsumed within the ranges expressly recited herein.

The light-emitting device, the display device, the electronic apparatus, the electronic device, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented

on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the drawings, it will be understood by those of ordinary skill in the art that one or more suitable changes in form and details may be made therein without departing from the spirit and scope as defined by the following claims and equivalents thereof.

## Claims

**1.** A composition comprising:

an organometallic compound represented by Formula 1; and
a second compound comprising at least one $\pi$ electron-deficient nitrogen-containing $C_1$-$C_{60}$ heterocyclic group, a third compound comprising a group represented by Formula 3, a fourth compound capable of emitting delayed fluorescence, or any combination thereof,
wherein each of the organometallic compound, the second compound, the third compound, and the fourth compound are different from each other:

Formula 1

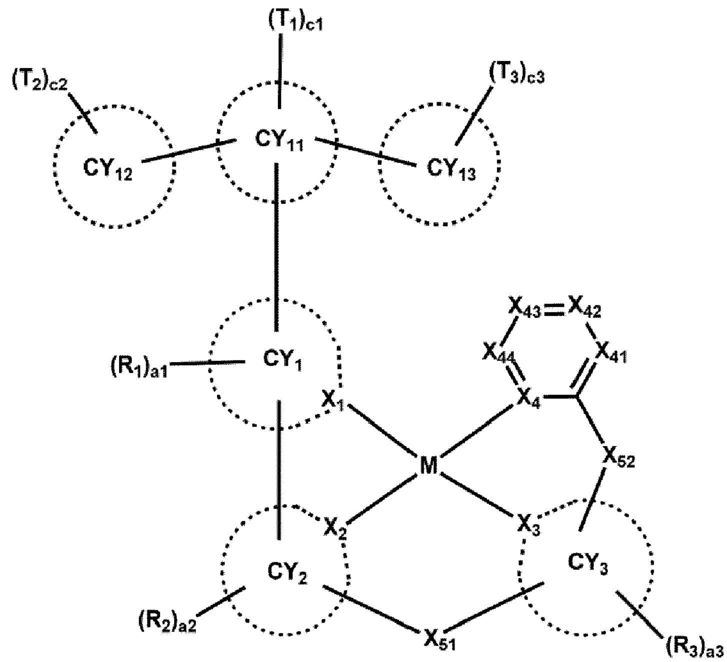

,

wherein, in Formula 1,
M is platinum (Pt), palladium (Pd), gold (Au), nickel (Ni), silver (Ag), or copper (Cu),
$X_1$ to $X_4$ are each independently C or N,
i) a bond between $X_1$ and M is a coordinate bond, ii) one selected from among a bond between $X_2$ and M, a bond between $X_3$ and M, and a bond between $X_4$ and M is a coordinate bond, and the other two are each a

covalent bond,
ring $CY_1$ and ring $CY_2$ are each independently a $C_3$-$C_{60}$ carbocyclic group or a $C_1$-$C_{60}$ heterocyclic group,
ring $CY_3$ is a $C_2$-$C_8$ monocyclic group or a $C_4$-$C_{20}$ polycyclic group in which two or three $C_2$-$C_8$ monocyclic groups are condensed together,
$X_{41}$ is $C(R_{41})$ or N, $X_{42}$ is $C(R_{42})$ or N, $X_{43}$ is $C(R_{43})$ or N, and $X_{44}$ is $C(R_{44})$ or N,
each of ring $CY_{11}$, ring $CY_{12}$, and ring $CY_{13}$ is a $C_2$-$C_8$ monocyclic group,
$X_{51}$ is a single bond, $*-N(Z_{51a})-*'$, $*-B(Z_{51a})-*'$, $*-P(Z_{51a})-*'$, $*-C(Z_{51a})(Z_{51b})-*'$, $*-Si(Z_{51a})(Z_{51b})-*'$, $*-Ge(Z_{51a})(Z_{51b})-*'$, *-S-*', *-Se-*', *-O-*', *-C(=O)-*', *-S(=O)-*', $*-S(=O)_2-*'$, $*-C(Z_{51a})=*'$, $*=C(Z_{51a})-*'$, $*-C(Z_{51a})=C(Z_{51b})-*'$, *-C(=S)-*', or *-C≡C-*',
$X_{52}$ is a single bond, $*-N(Z_{52a})-*'$, $*-B(Z_{52a})-*'$, $*-P(Z_{52a})-*'$, $*-C(Z_{52a})(Z_{52b})-*'$, $*-Si(Z_{52a})(Z_{52b})-*'$, $*-Ge(Z_{52a})(Z_{52b})-*'$, *-S-*', *-Se-*', *-O-*', *-C(=O)-*', *-S(=O)-*', $*-S(=O)_2-*'$, $*-C(Z_{52a})=*'$, $*=C(Z_{52a})-*'$, $*-C(Z_{52a})=C(Z_{52b})-*'$, *-C(=S)-*', or *-C≡C-*',
$R_1$ to $R_3$, $R_{41}$, $R_{42}$, $R_{44}$, $Z_{51a}$, $Z_{51b}$, $Z_{52a}$, $Z_{52b}$, and $T_1$ to $T_3$ are each independently hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, a $C_6$-$C_{60}$ aryloxy group that is unsubstituted or substituted with at least one $R_{10a}$, a $C_6$-$C_{60}$ arylthio group that is unsubstituted or substituted with at least one $R_{10a}$, a $C_7$-$C_{60}$ aryl alkyl group that is unsubstituted or substituted with at least one $R_{10a}$, a $C_2$-$C_{60}$ heteroaryl alkyl group that is unsubstituted or substituted with at least one $R_{10a}$, $-C(Q_1)(Q_2)(Q_3)$, $-Si(Q_1)(Q_2)(Q_3)$, $-N(Q_1)(Q_2)$, $-B(Q_1)(Q_2)$, $-C(=O)(Q_1)$, $-S(=O)_2(Q_1)$, or-$P(=O)(Q_1)(Q_2)$,
$R_{43}$ is hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, $-C(Q_1)(Q_2)(Q_3)$, $-Si(Q_1)(Q_2)(Q_3)$, $-N(Q_1)(Q_2)$, - $B(Q_1)(Q_2)$, $-C(=O)(Q_1)$, $-S(=O)_2(Q_1)$, or-$P(=O)(Q_1)(Q_2)$,
a1, a2, a3, c2, and c3 are each independently an integer selected from 0 to 10,
c1 is an integer selected from 0 to 5,
a group represented by

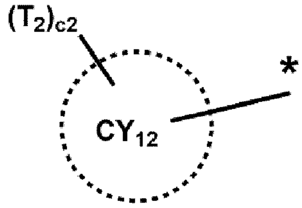

and a group represented by

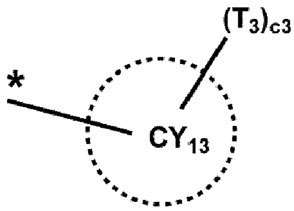

are different from each other,
i) two or more of a1 $R_1$(s) when a1 is two or more, ii) two or more of a2 $R_2$(s) when a2 is two or more, iii) two or more of $R_{41}$ to $R_{44}$, and iv) two or more of $R_1$ to $R_3$, $R_{41}$ to $R_{44}$, $Z_{51a}$, $Z_{51b}$, $Z_{52a}$, and $Z_{52b}$ are each optionally bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
two or more of a3 $R_3$(s) when a3 is two or more are not linked together,
two or more of $T_1$ to $T_3$ are not linked together,
$R_{10a}$ is:

deuterium, -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or any combination thereof;
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or $-P(=O)(Q_{31})(Q_{32})$, and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof,

Formula 3

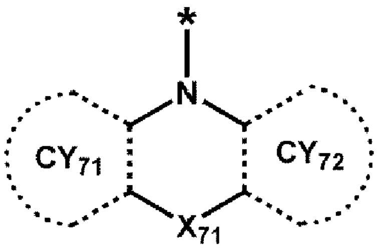

,

wherein, in Formula 3,
ring $CY_{71}$ and ring $CY_{72}$ are each independently a $\pi$ electron-rich $C_3$-$C_{60}$ cyclic group or a pyridine group,
$X_{71}$ is a single bond, or a linking group comprising O, S, N, B, C, Si, or any combination thereof, and
* indicates a binding site to an atom comprised in a remainder of the third compound, other than Formula 3.

**2.** A light-emitting device comprising:

a first electrode;
a second electrode facing the first electrode;
an interlayer between the first electrode and the second electrode and comprising an emission layer; and
an organometallic compound represented by Formula 1:

Formula 1

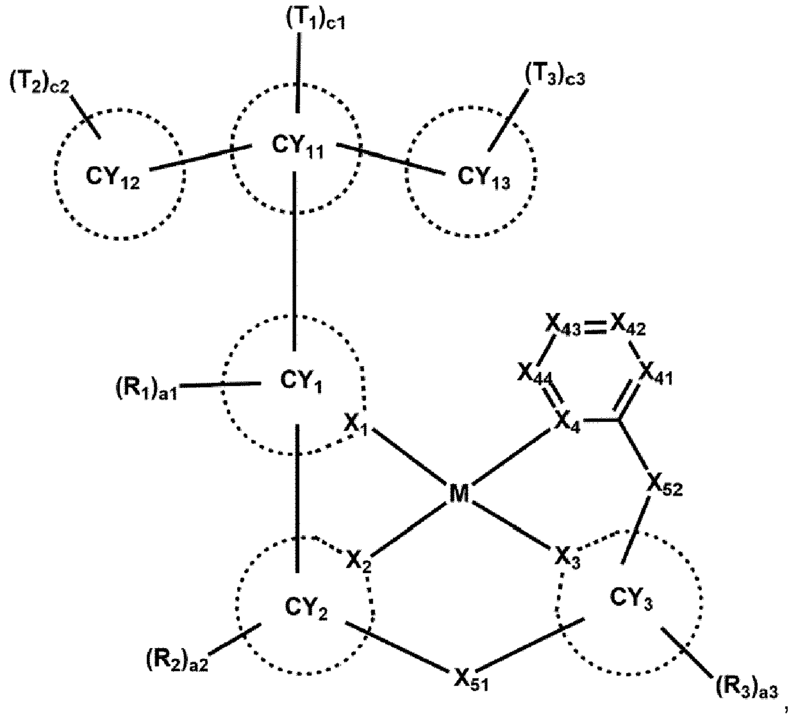

wherein, in Formula 1,

M is platinum (Pt), palladium (Pd), gold (Au), nickel (Ni), silver (Ag), or copper (Cu),

$X_1$ to $X_4$ are each independently C or N,

i) a bond between $X_1$ and M is a coordinate bond, ii) one selected from among a bond between $X_2$ and M, a bond between $X_3$ and M, and a bond between $X_4$ and M is a coordinate bond, and the other two are each a covalent bond,

ring $CY_1$ and ring $CY_2$ are each independently a $C_3$-$C_{60}$ carbocyclic group or a $C_1$-$C_{60}$ heterocyclic group,

ring $CY_3$ is a $C_2$-$C_8$ monocyclic group or a $C_4$-$C_{20}$ polycyclic group in which two or three $C_2$-$C_8$ monocyclic groups are condensed together,

$X_{41}$ is $C(R_{41})$ or N, $X_{42}$ is $C(R_{42})$ or N, $X_{43}$ is $C(R_{43})$ or N, and $X_{44}$ is $C(R_{44})$ or N,

each of ring $CY_{11}$, ring $CY_{12}$, and ring $CY_{13}$ is a $C_2$-$C_8$ monocyclic group,

$X_{51}$ is a single bond, *-N($Z_{51a}$)-*', *-B($Z_{51a}$)-*', *-P($Z_{51a}$)-*', *-C($Z_{51a}$)($Z_{51b}$)-*', *-Si($Z_{51a}$)($Z_{51b}$)-*', *-Ge($Z_{51a}$)($Z_{51b}$)-*', *-S-*', *-Se-*', *-O-*', *-C(=O)-*', *-S(=O)-*', *-S(=O)$_2$-*', *-C($Z_{51a}$)=*', *=C($Z_{51a}$)-*', *-C($Z_{51a}$)=C($Z_{51b}$)-*', *-C(=S)-*', or *-C≡C-*',

$X_{52}$ is a single bond, *-N($Z_{52a}$)-*', *-B($Z_{52a}$)-*', *-P($Z_{52a}$)-*', *-C($Z_{52a}$)($Z_{52b}$)-*', *-Si($Z_{52a}$)($Z_{52b}$)-*', *-Ge($Z_{52a}$)($Z_{52b}$)-*', *-S-*', *-Se-*', *-O-*', *-C(=O)-*', *-S(=O)-*', *-S(=O)$_2$-*', *-C($Z_{52a}$)=*', *=C($Z_{52a}$)-*', *-C($Z_{52a}$)=C($Z_{52b}$)-*', *-C(=S)-*', or *-C≡C-*',

$R_1$ to $R_3$, $R_{41}$, $R_{42}$, $R_{44}$, $Z_{51a}$, $Z_{51b}$, $Z_{52a}$, $Z_{52b}$, and $T_1$ to $T_3$ are each independently hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, a $C_6$-$C_{60}$ aryloxy group that is unsubstituted or substituted with at least one $R_{10a}$, a $C_6$-$C_{60}$ arylthio group that is unsubstituted or substituted with at least one $R_{10a}$, a $C_7$-$C_{60}$ aryl alkyl group that is unsubstituted or substituted with at least one $R_{10a}$, a $C_2$-$C_{60}$ heteroaryl alkyl group that is unsubstituted or substituted with at least one $R_{10a}$, -C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$), or-P(=O)($Q_1$)($Q_2$),

$R_{43}$ is hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, -C($Q_1$)($Q_2$)($Q_3$), -Si($Q_1$)($Q_2$)($Q_3$), -N($Q_1$)($Q_2$), - B($Q_1$)($Q_2$), -C(=O)($Q_1$), -S(=O)$_2$($Q_1$), or -P(=O)($Q_1$)($Q_2$),

a1, a2, a3, c2, and c3 are each independently an integer selected from 0 to 10,

c1 is an integer selected from 0 to 5,
a group represented by

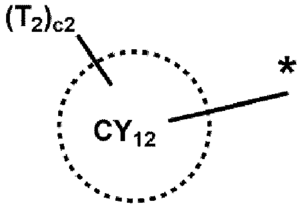

and a group represented by

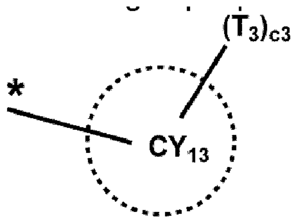

are different from each other,
i) two or more of a1 $R_1$(s) when a1 is two or more, ii) two or more of a2 $R_2$(s) when a2 is two or more, iii) two or more of $R_{41}$ to $R_{44}$, and iv) two or more of $R_1$ to $R_3$, $R_{41}$ to $R_{44}$, $Z_{51a}$, $Z_{51b}$, $Z_{52a}$, and $Z_{52b}$ are each optionally bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
two or more of a3 $R_3$(s) when a3 is two or more are not linked together,
two or more of $T_1$ to $T_3$ are not linked together,
$R_{10a}$ is:

deuterium, -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, - $P(=O)(Q_{11})(Q_{12})$, or any combination thereof;
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, - $Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or any combination thereof; or
$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or - $P(=O)(Q_{31})(Q_{32})$, and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

**3.** The light-emitting device of claim 2, further comprising a second compound comprising at least one $\pi$ electron-deficient nitrogen-containing $C_1$-$C_{60}$ heterocyclic group, a third compound comprising a group represented by Formula 3, a fourth compound capable of emitting delayed fluorescence, or any combination thereof,

wherein the organometallic compound, the second compound, the third compound, and the fourth compound are different from each other:

Formula 3

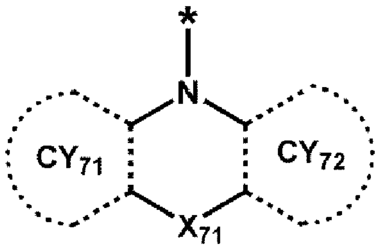

,

wherein, in Formula 3,
ring $CY_{71}$ and ring $CY_{72}$ are each independently a $\pi$ electron-rich $C_3$-$C_{60}$ cyclic group or a pyridine group,
$X_{71}$ is a single bond, or a linking group comprising O, S, N, B, C, Si, or any combination thereof, and
* indicates a binding site to an atom comprised in a remainder of the third compound, other than Formula 3.

**4.** The light-emitting device of claim 3, wherein:

(A) the second compound comprises a pyridine group, a pyrimidine group, a pyrazine group, a pyridazine group, a triazine group, or any combination thereof, and
the fourth compound comprises at least one cyclic group comprising both boron (B) and nitrogen (N) as ring-forming atoms;
AND/OR
(B) the emission layer comprises:

i) the organometallic compound; and
ii) the second compound, the third compound, the fourth compound, or any combination thereof, and

the emission layer is to emit blue light;
AND/OR
(C) further comprising the second compound and the third compound,

wherein at least one selected from among the second compound and the third compound comprises at least one deuterium, at least one silicon, or a combination thereof.

**5.** An electronic device comprising the light-emitting device of any one of claims 2 to 4; or
an electronic device comprising the light-emitting device of any one of claims 2 to 4 and further comprising a color filter, a color conversion layer, a touch screen layer, a polarizing layer, or any combination thereof.

**6.** An electronic apparatus comprising the light-emitting device of any one of claims 2 to 4; or
an electronic apparatus comprising the light-emitting device of any one of claims 2 to 4, wherein the electronic apparatus is at least one selected from a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality or augmented reality display, a vehicle, a video wall with multiple displays tiled together, a theater or stadium screen, a phototherapy device, and a signboard.

**7.** An organometallic compound represented by Formula 1:

Formula 1

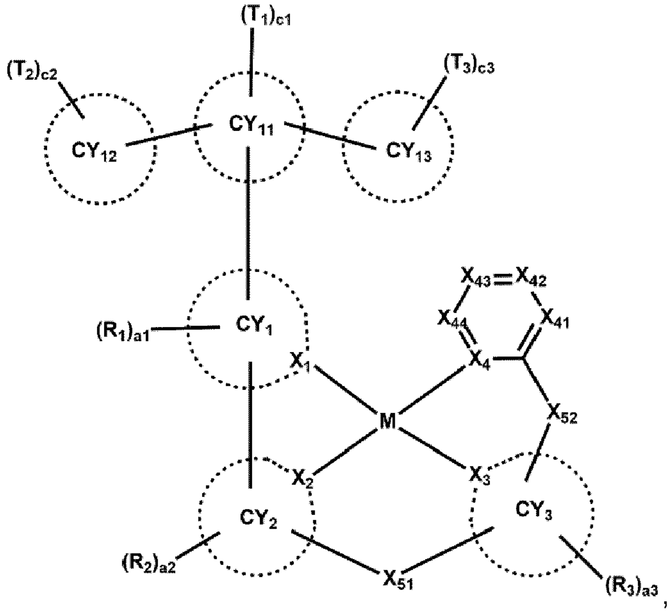

wherein, in Formula 1,

M is platinum (Pt), palladium (Pd), gold (Au), nickel (Ni), silver (Ag), or copper (Cu),

$X_1$ to $X_4$ are each independently C or N,

i) a bond between $X_1$ and M is a coordinate bond, ii) one selected from among a bond between $X_2$ and M, a bond between $X_3$ and M, and a bond between $X_4$ and M is a coordinate bond, and the other two are each a covalent bond,

ring $CY_1$ and ring $CY_2$ are each independently a $C_3$-$C_{60}$ carbocyclic group or a $C_1$-$C_{60}$ heterocyclic group,

ring $CY_3$ is a $C_2$-$C_8$ monocyclic group or a $C_4$-$C_{20}$ polycyclic group in which two or three $C_2$-$C_8$ monocyclic groups are condensed together,

$X_{41}$ is $C(R_{41})$ or N, $X_{42}$ is $C(R_{42})$ or N, $X_{43}$ is $C(R_{43})$ or N, and $X_{44}$ is $C(R_{44})$ or N,

each of ring $CY_{11}$, ring $CY_{12}$, and ring $CY_{13}$ is a $C_2$-$C_8$ monocyclic group,

$X_{51}$ is a single bond, *-N($Z_{51a}$)-*', *-B($Z_{51a}$)-*', *-P($Z_{51a}$)-*', *-C($Z_{51a}$)($Z_{51b}$)-*', *-Si($Z_{5ia}$)($Z_{5ib}$)-*', *-Ge($Z_{51a}$)($Z_{51b}$)-*', *-S-*', *-Se-*', *-O-*', *-C(=O)-*', *-S(=O)-*', *-S(=O)$_2$-*', *-C($Z_{51a}$)=*', *=C($Z_{51a}$)-*', *-C($Z_{51a}$)=C($Z_{51b}$)-*', *-C(=S)-*', or *-C≡C-*',

$X_{52}$ is a single bond, *-N($Z_{52a}$)-*', *-B($Z_{52a}$)-*', *-P($Z_{52a}$)-*', *-C($Z_{52a}$)($Z_{52b}$)-*', *-Si($Z_{52a}$)($Z_{52b}$)-*', *-Ge($Z_{52a}$)($Z_{52b}$)-*', *-S-*', *-Se-*', *-O-*', *-C(=O)-*', *-S(=O)-*', *-S(=O)$_2$-*', *-C($Z_{52a}$)=*', *=C($Z_{52a}$)-*', *-C($Z_{52a}$)=C($Z_{52b}$)-*', *-C(=S)-*', or *-C≡C-*',

$R_1$ to $R_3$, $R_{41}$, $R_{42}$, $R_{44}$, $Z_{51a}$, $Z_{51b}$, $Z_{52a}$, $Z_{52b}$, and $T_1$ to $T_3$ are each independently hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, a $C_3$-$C_{60}$ carbocyclic group that is unsubstituted or substituted with at least one $R_{10a}$, a $C_1$-$C_{60}$ heterocyclic group that is unsubstituted or substituted with at least one $R_{10a}$, a $C_6$-$C_{60}$ aryloxy group that is unsubstituted or substituted with at least one $R_{10a}$, a $C_6$-$C_{60}$ arylthio group that is unsubstituted or substituted with at least one $R_{10a}$, a $C_7$-$C_{60}$ aryl alkyl group that is unsubstituted or substituted with at least one $R_{10a}$, a $C_2$-$C_{60}$ heteroaryl alkyl group that is unsubstituted or substituted with at least one $R_{10a}$, -C($Q_1$)($Q_2$)($Q_3$), -Si($Q_1$)($Q_2$)($Q_3$), -N($Q_1$)($Q_2$), -B($Q_1$)($Q_2$), -C(=O)($Q_1$), -S(=O)$_2$($Q_1$), or-P(=O)($Q_1$)($Q_2$),

$R_{43}$ is hydrogen, deuterium, -F, -Cl, -Br, -I, a hydroxyl group, a cyano group, a nitro group, a $C_1$-$C_{60}$ alkyl group that is unsubstituted or substituted with at least one $R_{10a}$, a $C_2$-$C_{60}$ alkenyl group that is unsubstituted or substituted with at least one $R_{10a}$, a $C_2$-$C_{60}$ alkynyl group that is unsubstituted or substituted with at least one $R_{10a}$, a $C_1$-$C_{60}$ alkoxy group that is unsubstituted or substituted with at least one $R_{10a}$, -C($Q_1$)($Q_2$)($Q_3$), -Si($Q_1$)($Q_2$)($Q_3$), -N($Q_1$)($Q_2$), - B($Q_1$)($Q_2$), -C(=O)($Q_1$), -S(=O)$_2$($Q_1$), or -P(=O)($Q_1$)($Q_2$),

a1, a2, a3, c2, and c3 are each independently an integer selected from 0 to 10,

c1 is an integer selected from 0 to 5,

a group represented by

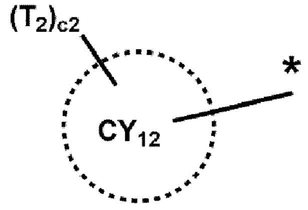

and a group represented by

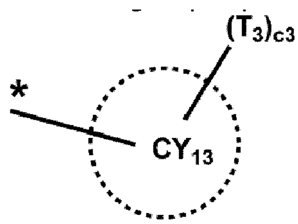

are different from each other,
i) two or more of a1 $R_1$(s) when a1 is two or more, ii) two or more of a2 $R_2$(s) when a2 is two or more, iii) two or more of $R_{41}$ to $R_{44}$, and iv) two or more of $R_1$ to $R_3$, $R_{41}$ to $R_{44}$, $Z_{51a}$, $Z_{51b}$, $Z_{52a}$, and $Z_{52b}$ are each optionally bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
two or more of a3 $R_3$(s) when a3 is two or more are not linked together,
two or more of $T_1$ to $T_3$ are not linked together,
$R_{10a}$ is:

deuterium, -F, -Cl, -Br, -I, a hydroxyl group, a cyano group, or a nitro group;
a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, -Si($Q_{11}$)($Q_{12}$)($Q_{13}$), -N($Q_{11}$)($Q_{12}$), -B($Q_{11}$)($Q_{12}$), -C(=O)($Q_{11}$), -S(=O)$_2$($Q_{11}$), - P(=O)($Q_{11}$)($Q_{12}$), or any combination thereof;
a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, or a $C_2$-$C_{60}$ heteroaryl alkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ aryl alkyl group, a $C_2$-$C_{60}$ heteroaryl alkyl group, - Si($Q_{21}$)($Q_{22}$)($Q_{23}$), -N($Q_{21}$)($Q_{22}$), -B($Q_{21}$)($Q_{22}$), -C(=O)($Q_{21}$), -S(=O)$_2$($Q_{21}$), -P(=O)($Q_{21}$)($Q_{22}$), or any combination thereof; or
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), or - P(=O)($Q_{31}$)($Q_{32}$), and
Q1 to Q3, Q11 to Q13, Q21 to Q23, and Q31 to Q33 are each independently: hydrogen; deuterium; -F; -Cl; -Br; -I; a hydroxyl group; a cyano group; a nitro group; or a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or any combination thereof.

**8.** The organometallic compound of claim 7, wherein $X_1$ is C, and

ring $CY_1$ is an imidazole group, a triazole group, a benzimidazole group, a naphthoimidazole group, or an imidazopyridine group; and/or
wherein ring $CY_{11}$, ring $CY_{12}$, and ring $CY_{13}$ are identical to each other.

**9.** The organometallic compound of claim 7 or 8, wherein $R_1$ to $R_3$, $R_{41}$, $R_{42}$, $R_{44}$, $Z_{51a}$, $Z_{51b}$, $Z_{52a}$, $Z_{52b}$, and $T_1$ to $T_3$ are each independently:

hydrogen, deuterium, -F, or a cyano group;
a $C_1$-$C_{20}$ alkyl group that is unsubstituted or substituted with deuterium, -F, a cyano group, a phenyl group, a

deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, or any combination thereof; or a $C_3$-$C_{10}$ cycloalkyl group, a phenyl group, a naphthyl group, a dibenzofuranyl group, or a dibenzothiophenyl group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a phenyl group, a deuterated phenyl group, a fluorinated phenyl group, a ($C_1$-$C_{20}$ alkyl) phenyl group, a biphenyl group, a deuterated biphenyl group, a fluorinated biphenyl group, a ($C_1$-$C_{20}$ alkyl)biphenyl group, or any combination thereof, and

$R_{43}$ is:

hydrogen, deuterium, -F, or a cyano group; or

a $C_1$-$C_{20}$ alkyl group that is unsubstituted or substituted with deuterium, -F, a cyano group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, or any combination thereof.

**10.** The organometallic compound of any one of claims 7 to 9, wherein the organometallic compound comprises at least one deuterium.

**11.** The organometallic compound of any one of claims 7 to 10, wherein a group represented by

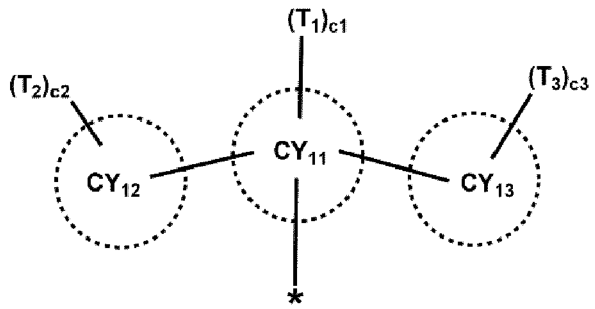

in Formula 1 is a group represented by Formula AS1:

Formula AS1

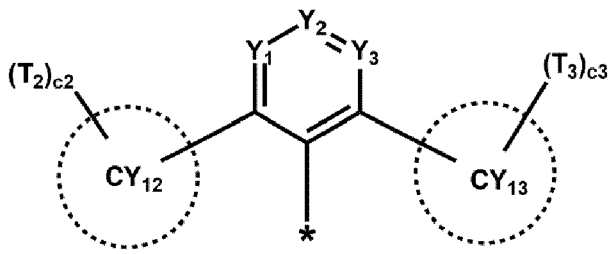

,

and

wherein, in Formula AS1,

ring $CY_{12}$, ring $CY_{13}$, $T_2$, $T_3$, c2, and c3 are each defined as in Formula 1,

$Y_1$ is $C(T_{11})$ or N, $Y_2$ is $C(T_{12})$ or N, and $Y_3$ is $C(T_{13})$ or N,

$T_{11}$ to $T_{13}$ are each the same as defined with respect to $T_1$ in Formula 1,

* is a binding site to ring $CY_1$ in Formula 1.

**12.** The organometallic compound of any one of claims 7 to 11, wherein i) c2 and c3 are different from each other, or ii) each of c2 and c3 is not 0, and one of c2 $T_2$ and one of c3 $T_3$ are different from each other.

**13.** The organometallic compound of any one of claims 7 to 12, wherein in Formula 1, a group represented by

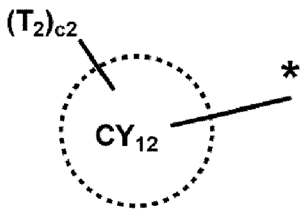

is a group represented by Formula AS2,

a group represented by

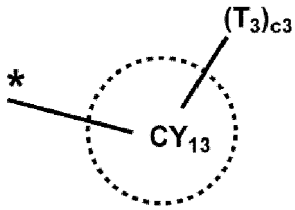

is a group represented by Formula AS3, and
i) Condition C1 is satisfied, or ii) at least one selected from among Condition C2 to Condition C6 is satisfied:

Formula AS2

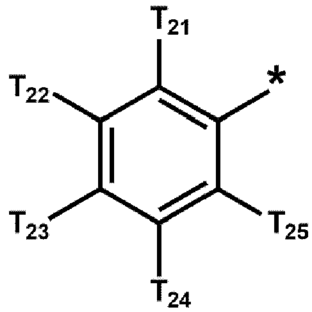

Formula AS3

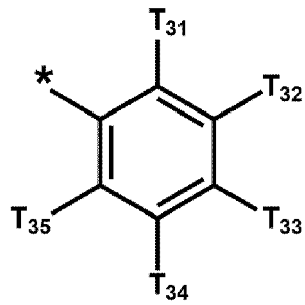

,

and
wherein $T_{21}$ to $T_{25}$ in Formula AS2 are each the same as defined with respect to $T_2$ in Formula 1, and * indicates a binding site to ring $CY_{11}$, and
$T_{31}$ to $T_{35}$ in Formula AS3 are each the same as defined with respect to $T_3$ in Formula 1, and * indicates a binding site to ring $CY_{11}$:
Condition C1
a number of groups that are not hydrogen among $T_{21}$ to $T_{25}$ in Formula AS2 and a number of groups that are not hydrogen among $T_{31}$ to $T_{35}$ in Formula AS3 are different from each other;
Condition C2
$T_{21}$ and $T_{31}$ are different from each other;
Condition C3
$T_{22}$ and $T_{32}$ are different from each other;
Condition C4
$T_{23}$ and $T_{33}$ are different from each other;
Condition C5
$T_{24}$ and $T_{34}$ are different from each other; and
Condition C6
$T_{25}$ and $T_{35}$ are different from each other.

**14.** The organometallic compound of claim 13, wherein each of $T_{21}$ to $T_{25}$ in Formula AS2 is not hydrogen, and Formula AS3 satisfies Condition D1 or Condition D2:

Condition D1
each of $T_{31}$, $T_{33}$, and $T_{35}$ is hydrogen, and each of $T_{32}$ and $T_{34}$ is not hydrogen; or
Condition D2
each of $T_{31}$, $T_{33}$, $T_{34}$, and $T_{35}$ is hydrogen, and $T_{32}$ is not hydrogen.

**15.** The organometallic compound of any one of claims 7 to 14, wherein the organometallic compound is represented by Formula 1-1 or 1-2:

Formula 1-1

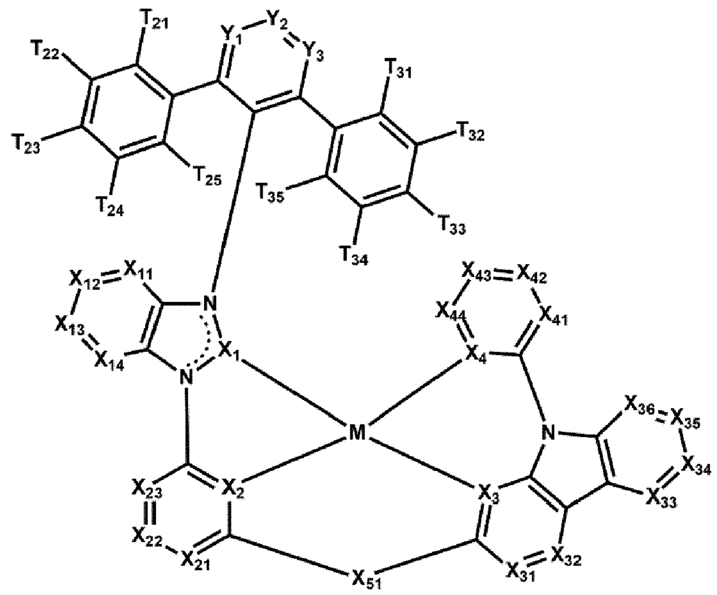

Formula 1-2

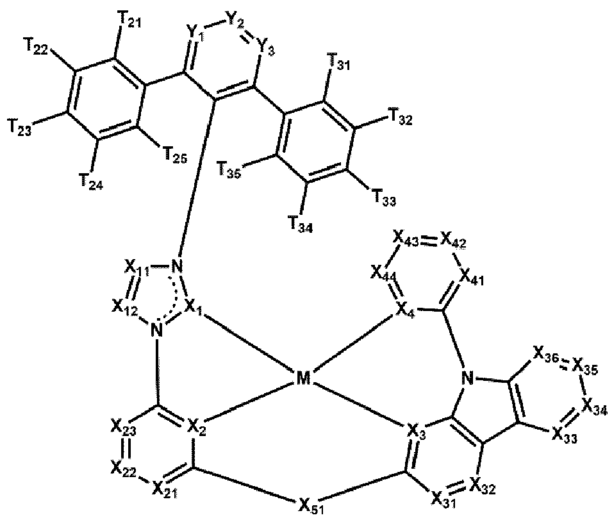

,

and

wherein, in Formulae 1-1 and 1-2,
M, $X_1$ to $X_4$, $X_{41}$ to $X_{44}$, and $X_{51}$ are each defined as in Formula 1,
$X_{11}$ is $C(R_{11})$ or N, $X_{12}$ is $C(R_{12})$ or N, $X_{13}$ is $C(R_{13})$ or N, and $X_{14}$ is $C(R_{14})$ or N,
$R_{11}$ to $R_{14}$ are each the same as defined with respect to $R_1$ in Formula 1, and two or more of $R_{11}$ to $R_{14}$ are optionally bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,

$X_{21}$ is $C(R_{21})$ or N, $X_{22}$ is $C(R_{22})$ or N, and $X_{23}$ is $C(R_{23})$ or N,
$R_{21}$ to $R_{23}$ are each the same as defined with respect to $R_2$ in Formula 1, and two or more of $R_{21}$ to $R_{23}$ are optionally bonded together to form a $C_3$-$C_{60}$ carbocyclic group that is unsubstituted or substituted with at least one $R_{10a}$ or a $C_1$-$C_{60}$ heterocyclic group that is unsubstituted or substituted with at least one $R_{10a}$,
$X_{31}$ is $C(R_{31})$ or N, $X_{32}$ is $C(R_{32})$ or N, $X_{33}$ is $C(R_{33})$ or N, $X_{34}$ is $C(R_{34})$ or N, $X_{35}$ is $C(R_{35})$ or N, and $X_{36}$ is $C(R_{36})$ or N,
$R_{31}$ to $R_{36}$ are each the same as defined with respect to $R_3$ in Formula 1, and two or more of $R_{31}$ to $R_{36}$ are not linked together,
$Y_1$ is $C(T_{11})$ or N, $Y_2$ is $C(T_{12})$ or N, and $Y_3$ is $C(T_{13})$ or N,
$T_{11}$ to $T_{13}$ are each the same as defined with respect to $T_1$ in Formula 1,
$T_{21}$ to $T_{25}$ are each the same as defined with respect to $T_2$ in Formula 1,
$T_{31}$ to $T_{35}$ are each the same as defined with respect to $T_3$ in Formula 1,
two or more of $T_{11}$ to $T_{13}$, $T_{21}$ to $T_{25}$, and $T_{31}$ to $T_{35}$ are not linked together, and
a group represented by

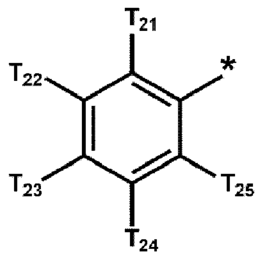

and a group represented by

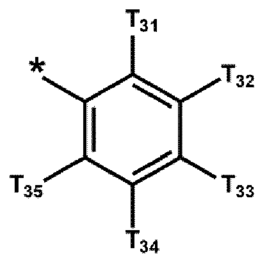

are different from each other.

FIG. 1

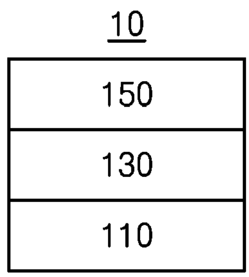

FIG. 2

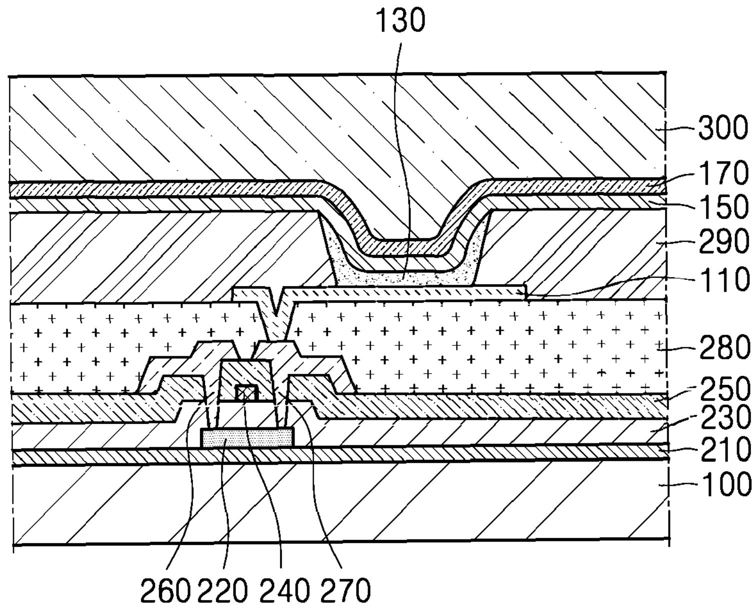
130
300
170
150
290
110
280
250
230
210
100
260
220
240
270

FIG. 3

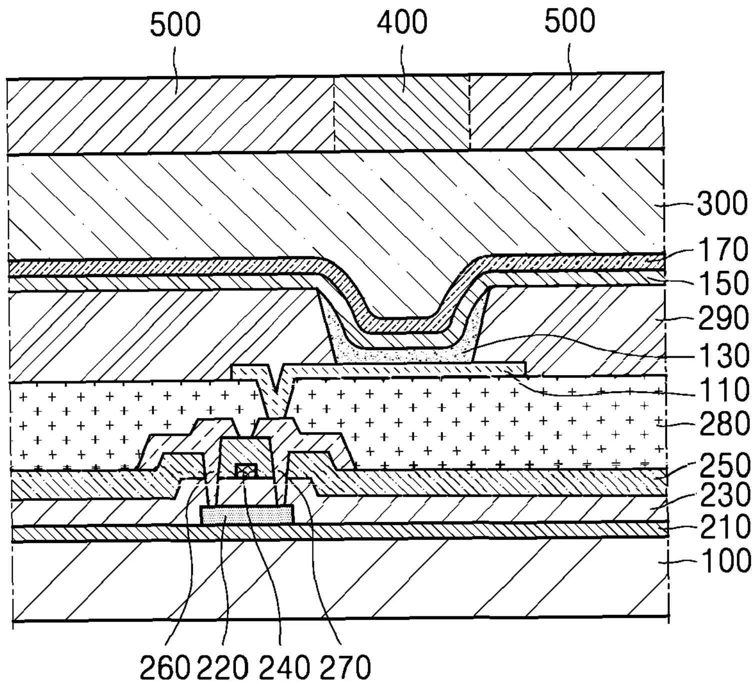
500
400
500
300
170
150
290
130
110
280
250
230
210
100
260
220
240
270

FIG. 4

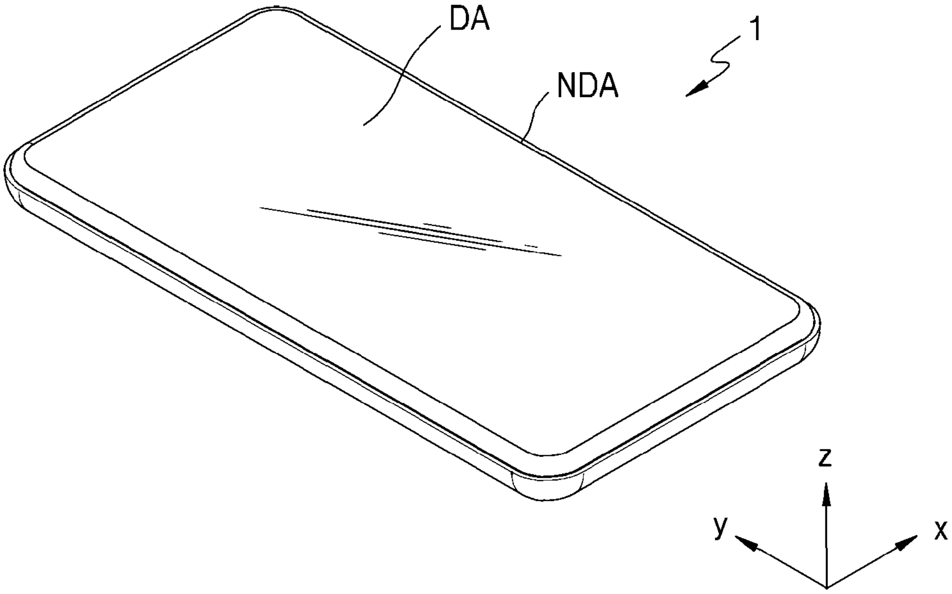


FIG. 5

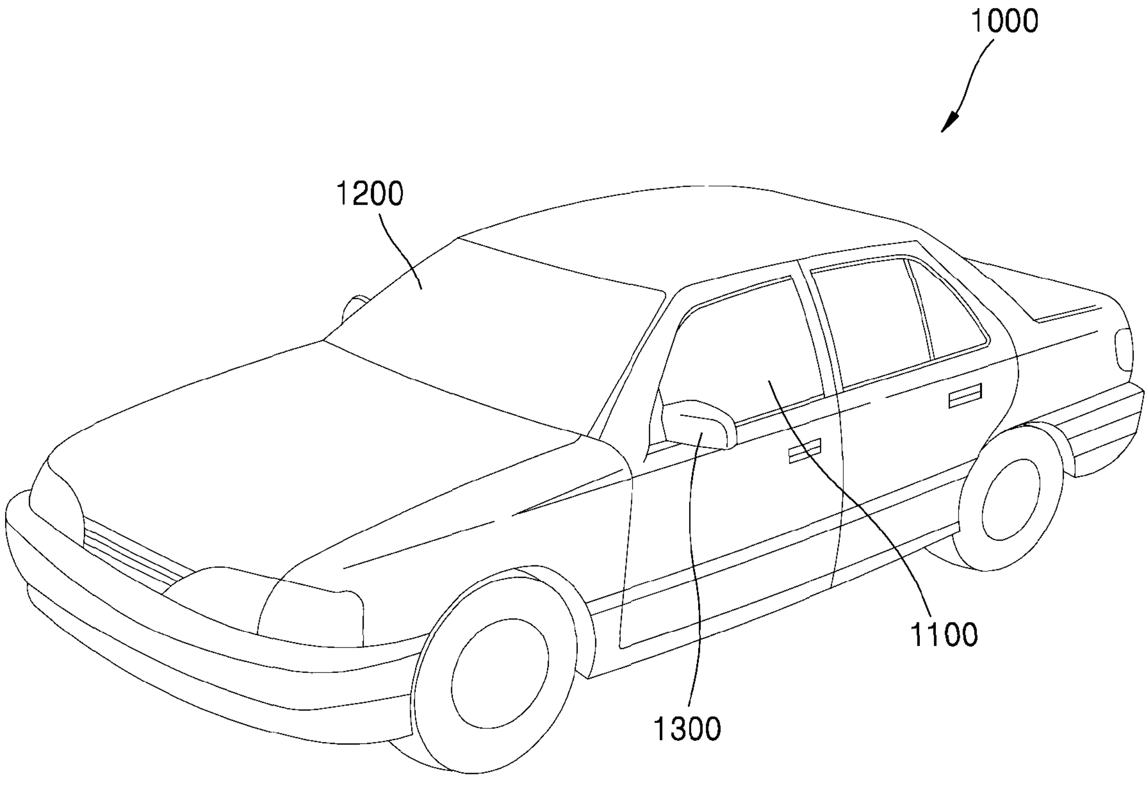

FIG. 6A

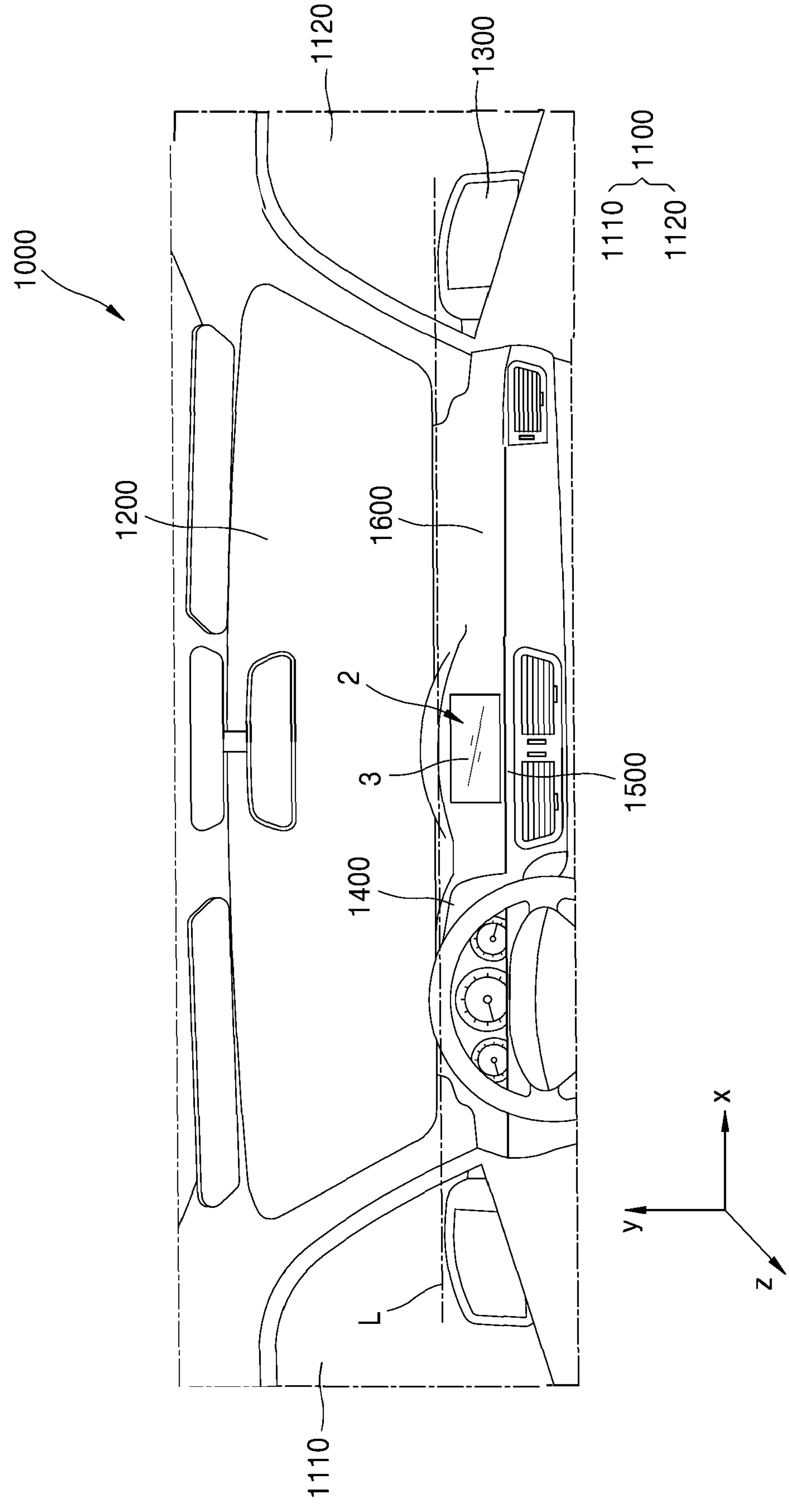
1000
1120
1300
1100
1110
1120
1200
1600
2
3
1500
1400
L
1110
x
y
z

FIG. 6B

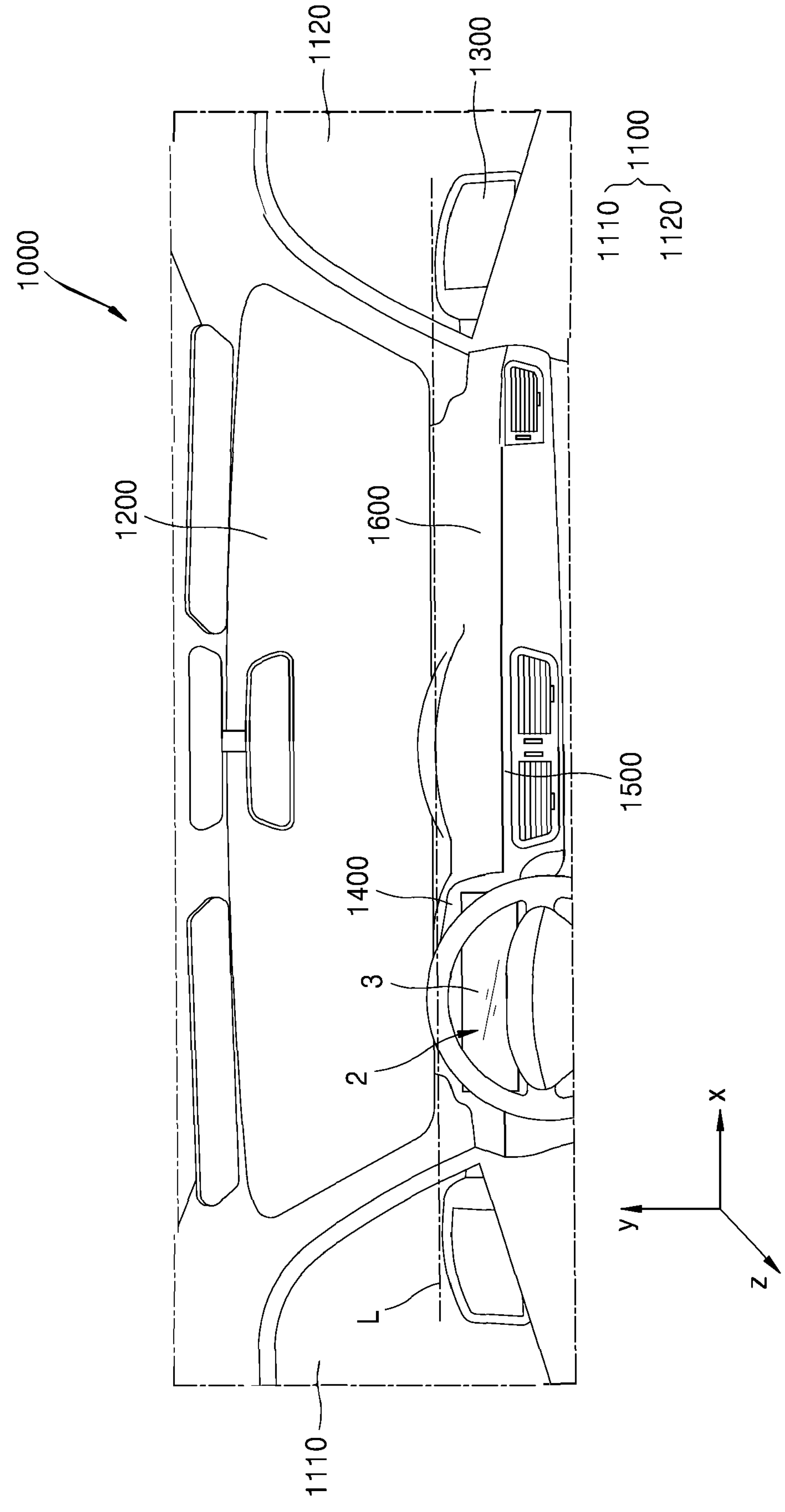
1000
1120
1300
1100
1110
1120
1200
1600
1500
1400
3
2
L
1110
x
y
z

FIG. 6C

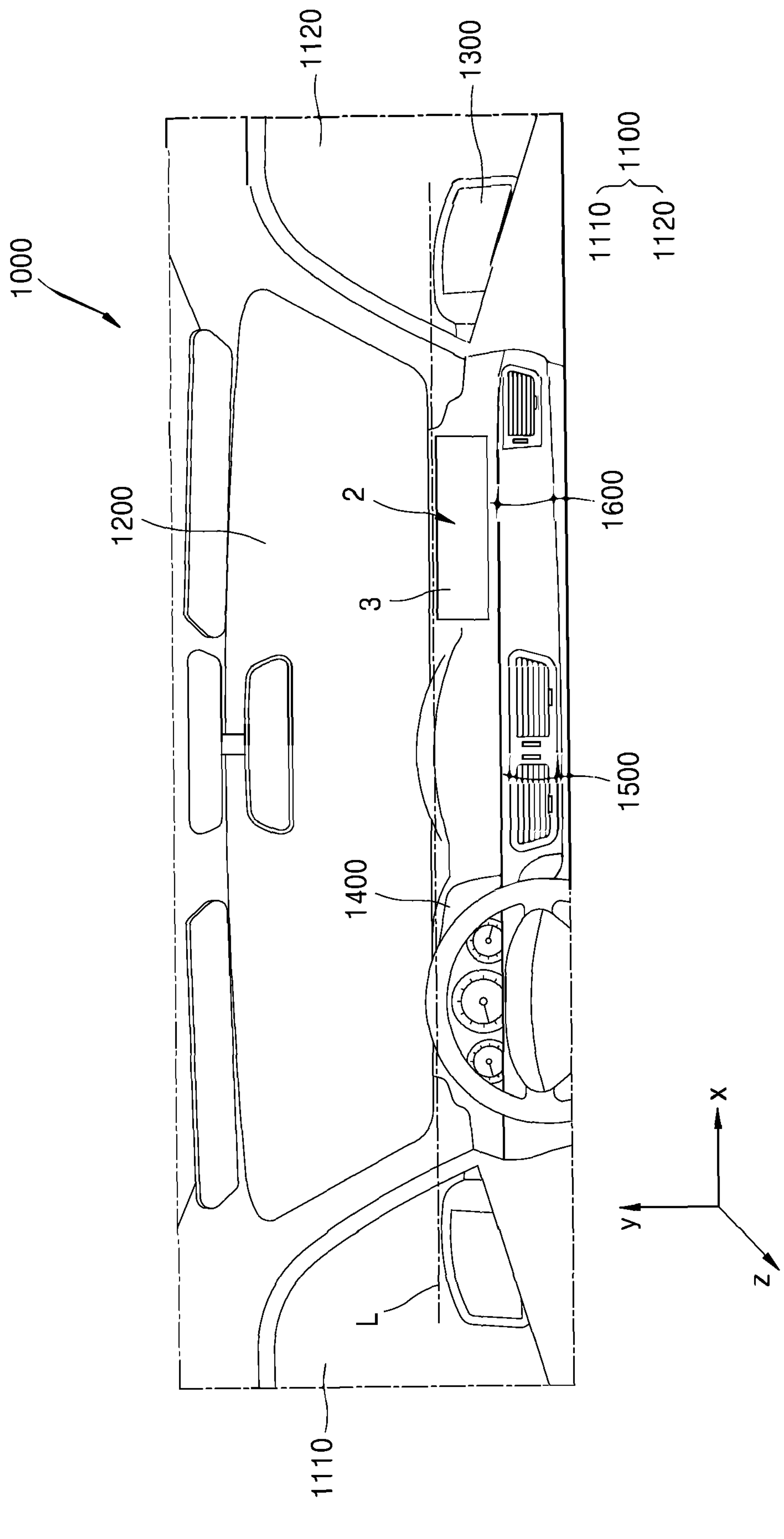
1000
1120
1300
1100
1110
1120
1200
2
3
1600
1500
1400
L
1110
x
y
z

FIG. 7

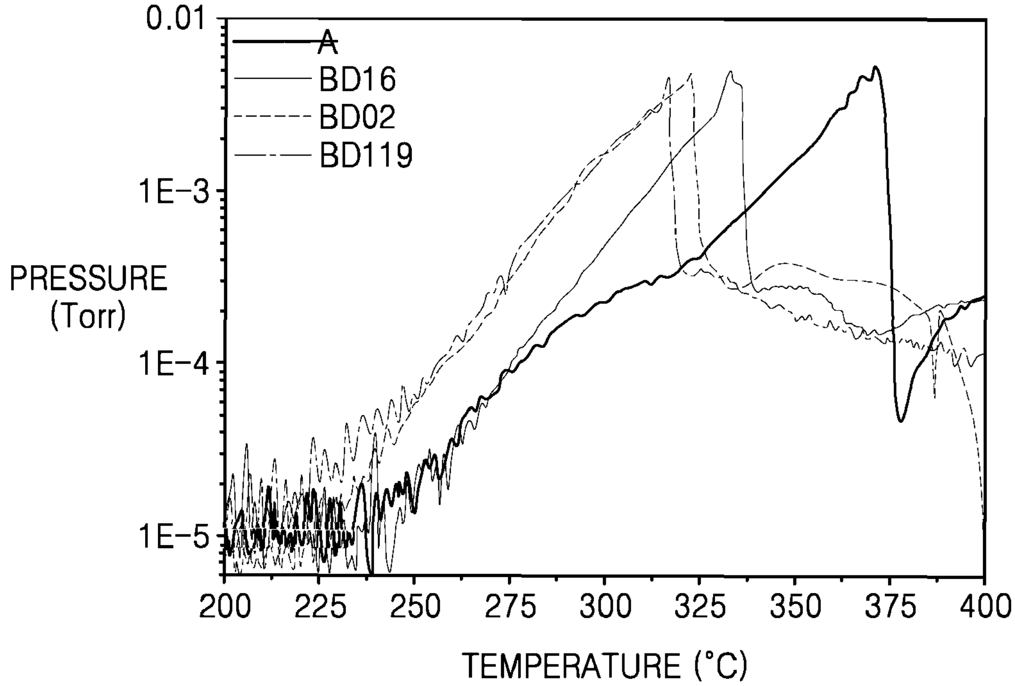
0.01
1E-3
1E-4
1E-5
PRESSURE
(Torr)
A
BD16
BD02
BD119
200
225
250
275
300
325
350
375
400
TEMPERATURE (°C)

FIG. 8

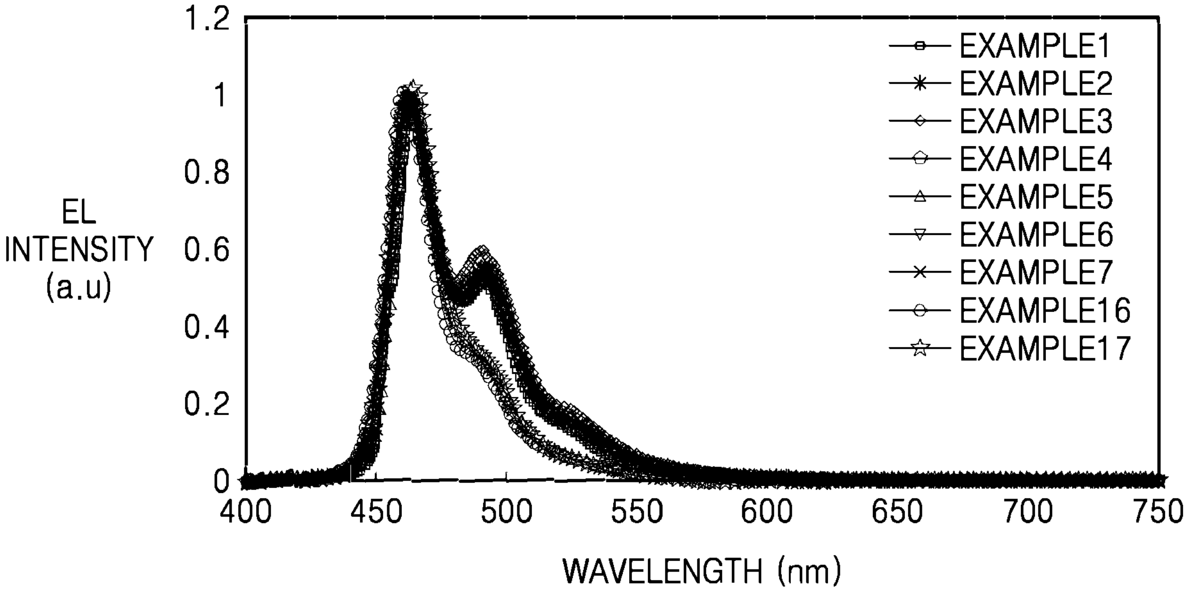
1.2
1
0.8
0.6
0.4
0.2
0
EL
INTENSITY
(a.u)
EXAMPLE1
EXAMPLE2
EXAMPLE3
EXAMPLE4
EXAMPLE5
EXAMPLE6
EXAMPLE7
EXAMPLE16
EXAMPLE17
400
450
500
550
600
650
700
750
WAVELENGTH (nm)

FIG. 9

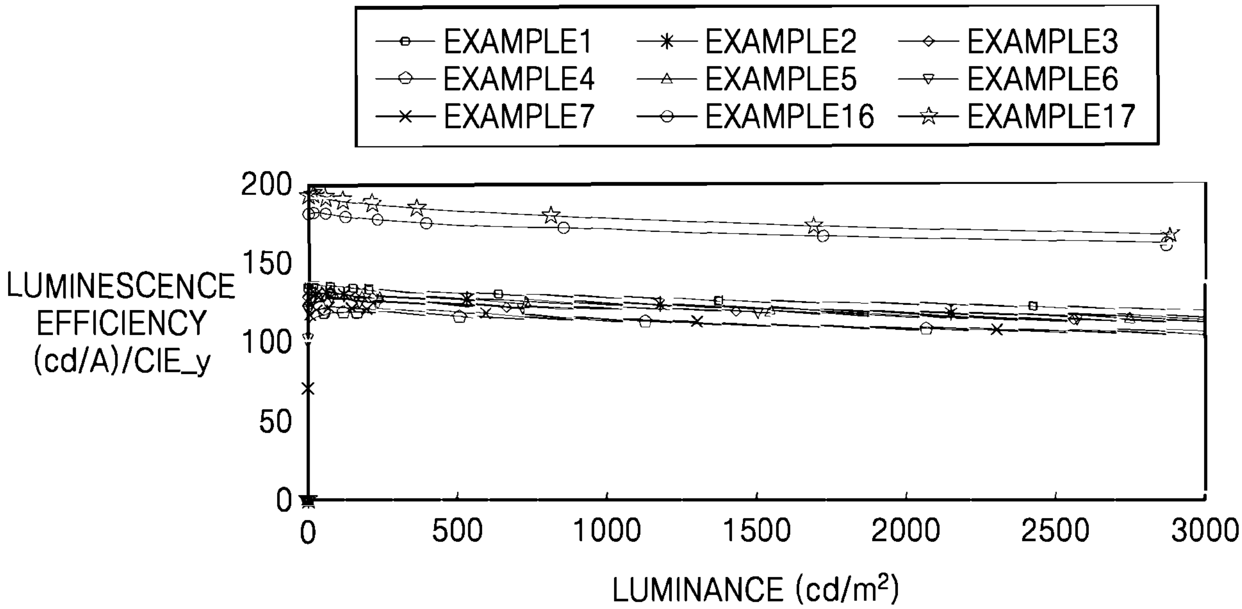
EXAMPLE1
EXAMPLE2
EXAMPLE3
EXAMPLE4
EXAMPLE5
EXAMPLE6
EXAMPLE7
EXAMPLE16
EXAMPLE17
LUMINESCENCE EFFICIENCY (cd/A)/CIE_y
0
50
100
150
200
0
500
1000
1500
2000
2500
3000
LUMINANCE (cd/m2)

FIG. 10

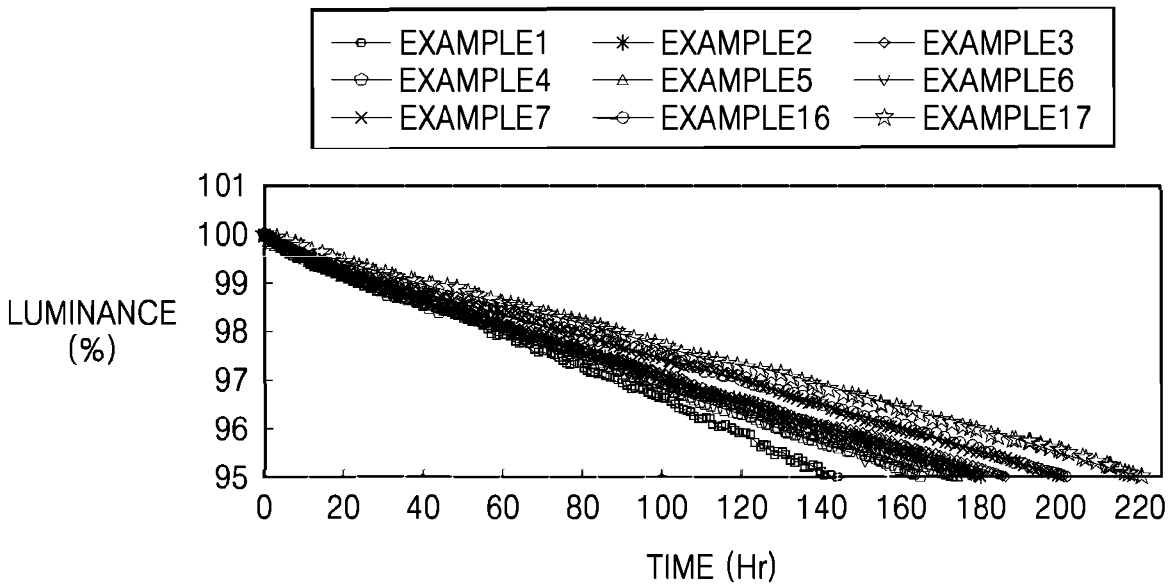
EXAMPLE1
EXAMPLE2
EXAMPLE3
EXAMPLE4
EXAMPLE5
EXAMPLE6
EXAMPLE7
EXAMPLE16
EXAMPLE17
LUMINANCE (%)
95
96
97
98
99
100
101
0
20
40
60
80
100
120
140
160
180
200
220
TIME (Hr)

Europäisches Patentamt
European Patent Office
Office européen des brevets

# EUROPEAN SEARCH REPORT

Application Number
EP 23 18 6328

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/119312 A1 (CHEN HSIAO-FAN [US] ET AL) 25 April 2019 (2019-04-25) * claims; table 1; compounds 87897, 95067, 88227, 1249509383 * * paragraphs [0238] - [0239] * | 1-15 | INV. C09K11/06 C07F15/00 |
| X | US 2020/140471 A1 (CHEN HSIAO-FAN [US] ET AL) 7 May 2020 (2020-05-07) * claims; table 1 * * paragraphs [0258] - [0260] * | 1-15 | |
| A,P | EP 4 123 000 A1 (SAMSUNG ELECTRONICS CO LTD [KR]) 25 January 2023 (2023-01-25) * compounds 49-64,113-128,141-144,177-180,189-192,201-204,213-216; claims * | 1-15 | |

TECHNICAL FIELDS SEARCHED (IPC)

C09K
H05B
C07F

The present search report has been drawn up for all claims

1

| Place of search | Date of completion of the search | Examiner |
|---|---|---|
| The Hague | 14 December 2023 | Schoenhentz, Jérôme |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 23 18 6328

This annex lists the patent family members relating to the patent documents cited in the above-mentioned European search report. The members are as contained in the European Patent Office EDP file on The European Patent Office is in no way liable for these particulars which are merely given for the purpose of information.

14-12-2023

| Patent document cited in search report | Publication date | Patent family member(s) | Publication date |
|---|---|---|---|
| US 2019119312 A1 | 25-04-2019 | NONE | |
| US 2020140471 A1 | 07-05-2020 | NONE | |
| EP 4123000 A1 | 25-01-2023 | CN 115677782 A | 03-02-2023 |
| | | EP 4123000 A1 | 25-01-2023 |
| | | KR 20230015230 A | 31-01-2023 |
| | | US 2023104013 A1 | 06-04-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020220089879
- KR 1020230092594